# EUROPEAN PATENT APPLICATION

(11) **EP 4 588 922 A1**
(43) Date of publication of application: **23.07.2025**
(21) Application number: 25151973.2
(22) Date of filing: 15.01.2025
(51) Int. Cl.: C07F 5/02, C07F 7/08, C09K 11/06, H10K 50/11, H10K 50/15, H10K 85/60, H10K 101/20

(54) **LIGHT EMITTING ELEMENT, FUSED POLYCYCLIC COMPOUND FOR THE LIGHT EMITTING ELEMENT, AND DISPLAY DEVICE INCLUDING THE LIGHT EMITTING ELEMENT**

(30) Priority: 17.01.2024 KR 20240007391
(71) Applicant: Samsung Display Co., Ltd., Yongin-si, Gyeonggi-do 17113 (KR)
(72) Inventor: Sim, Mun-Ki, 17113 Yongin-si, Gyeonggi-Do (KR); Kim, Taeil, 17113 Yongin-si, Gyeonggi-Do (KR); Pak, Sun Young, 17113 Yongin-si, Gyeonggi-Do (KR); Park, Junha, 17113 Yongin-si, Gyeonggi-Do (KR); Sung, MinJae, 17113 Yongin-si, Gyeonggi-Do (KR); Ryoo, Chihyun, 17113 Yongin-si, Gyeonggi-Do (KR); Han, Giwoong, 17113 Yongin-si, Gyeonggi-Do (KR)
(74) Representative: Gulde & Partner

(57) **Abstract**

A light emitting element including a first electrode, a second electrode on the first electrode, and an emission layer between the first electrode and the second electrode and including a first compound represented by Formula 1 below. Accordingly, the light emitting element of one or more embodiments may exhibit high efficiency and long service life characteristics.

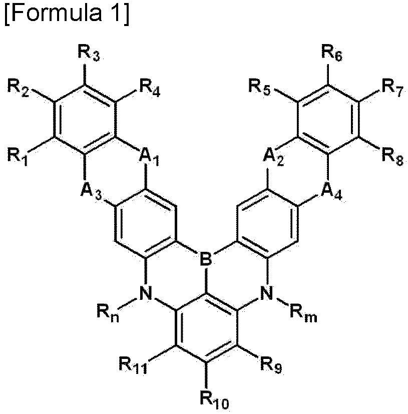

## Description

### BACKGROUND

### 1. Field

Embodiments of the present disclosure described herein are related to a light emitting element, a fused polycyclic compound used in the light emitting element, and a display device including the light emitting element.

### 2. Description of the Related Art

Recently, the development of an organic electroluminescence display device as an image display device is being actively conducted or pursued. The organic electroluminescence display device includes a self-luminescent light emitting element in which holes and electrons injected from a first electrode and a second electrode combine in an emission layer, and thus a luminescent material of the emission layer emits light to implement display (e.g., display an image).

In the application of a light emitting element to a display device, there is a demand or desire for a light emitting element having improved light efficiency and improved service life, and there is a desire or requirement for development of materials for a light emitting element capable of stably attaining such characteristics.

### SUMMARY

The invention is defined by the appended claims. The description that follows is subjected to this limitation. Any disclosure lying outside the scope of said claims is only intended for illustrative as well as comparative purposes.

Aspects according to one or more embodiments of the present disclosure are directed toward a light emitting element having improved light efficiency and service life and a display device including the light emitting element.

Aspects according to one or more embodiments of the present disclosure are directed toward a fused polycyclic compound which is a material for a light emitting element to improve light efficiency and service life.

Additional aspects will be set forth in part in the description which follows and, in part, will be apparent from the description, or may be learned by practice of the presented embodiments of the disclosure.

According to one or more embodiments of the present disclosure includes a light emitting element including: a first electrode; a second electrode arranged on the first electrode; and an emission layer which is arranged between the first electrode and the second electrode and includes a first compound represented by Formula 1:

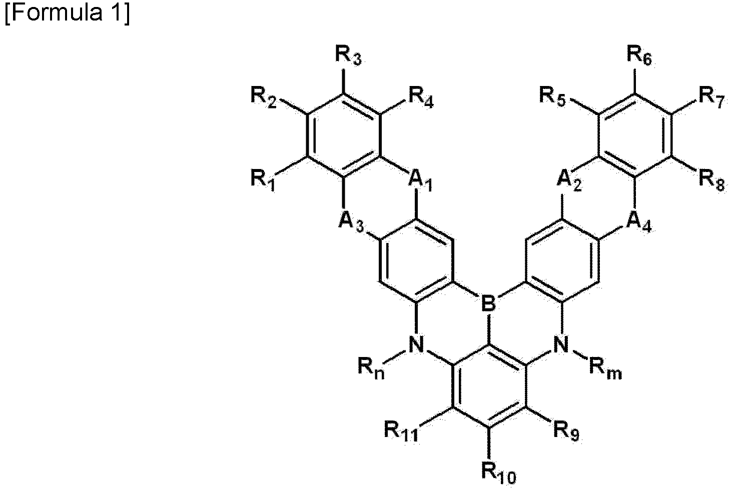

In Formula 1 above, A₁ and A₂ are each independently NR_{b1}, O, S, CR_{b2}R_{b3}, or SiR_{b4}R_{b5}, A₃ and A₄ are each independently a direct linkage, NR_{b6}, O, S, CR_{b7}R_{b8}, or SiR_{b9}R_{b10}, if (e.g., when) A₁ is CR_{b2}R_{b3}, A₃ is a direct linkage, NR_{b6}, O, S, or SiR_{b9}R_{b10}, R_{b1} to R_{b10} are each independently a substituted or unsubstituted alkyl group having 1 to 30 carbon atoms, a substituted or unsubstituted aryl group having 6 to 30 ring-forming carbon atoms, or a substituted or unsubstituted heteroaryl group having 2 to 30 ring-forming carbon atoms, and/or are bonded to an adjacent group to form a ring, R₁ to R₁₁ are each independently a hydrogen atom, a deuterium atom, a cyano group, a substituted or unsubstituted amine group, a substituted or unsubstituted thio group, a substituted or unsubstituted oxy group, a substituted or unsubstituted silyl group, a substituted or unsubstituted alkyl group having 1 to 30 carbon atoms, a substituted or unsubstituted alkenyl group having 2 to 30 carbon atoms, a substituted or unsubstituted aryl group having 6 to 30 ring-forming carbon atoms, or a substituted or unsubstituted heteroaryl group having 2 to 30 ring-forming carbon atoms, and/or are bonded to an adjacent group to form a ring, Rₙ is represented by Formula 2, and Rₘ is represented by Formula 3:

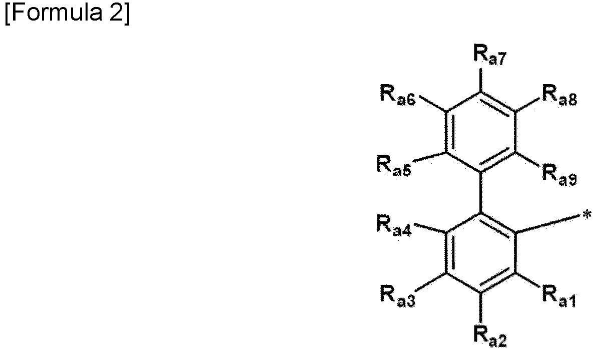

In Formula 2 above, Rₐ₁ to Rₐ₉ are each independently a hydrogen atom, a deuterium atom, a cyano group, a substituted or unsubstituted amine group, a substituted or unsubstituted thio group, a substituted or unsubstituted oxy group, a substituted or unsubstituted silyl group, a substituted or unsubstituted alkyl group having 1 to 30 carbon atoms, a substituted or unsubstituted alkenyl group having 2 to 30 carbon atoms, a substituted or unsubstituted aryl group having 6 to 30 ring-forming carbon atoms, or a substituted or unsubstituted heteroaryl group having 2 to 30 ring-forming carbon atoms, and/or are bonded to an adjacent group to form a ring.

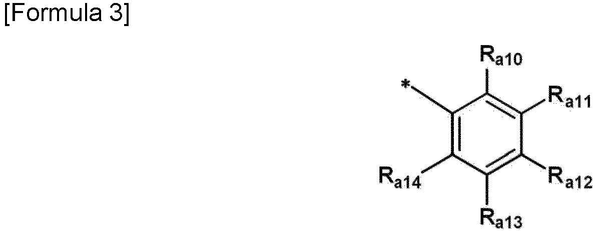

In Formula 3 above, Rₐ₁₀ to Rₐ₁₄ are each independently a hydrogen atom, a deuterium atom, a cyano group, a substituted or unsubstituted amine group, a substituted or unsubstituted thio group, a substituted or unsubstituted oxy group, a substituted or unsubstituted silyl group, a substituted or unsubstituted alkyl group having 1 to 30 carbon atoms, a substituted or unsubstituted alkenyl group having 2 to 30 carbon atoms, a substituted or unsubstituted aryl group having 6 to 30 ring-forming carbon atoms, or a substituted or unsubstituted heteroaryl group having 2 to 30 ring-forming carbon atoms, and/or are bonded to an adjacent group to form a ring.

In one or more embodiments, the emission layer may further include at least one of a second compound represented by Formula HT-1, a third compound represented by Formula ET-1, or a fourth compound represented by Formula D-1:

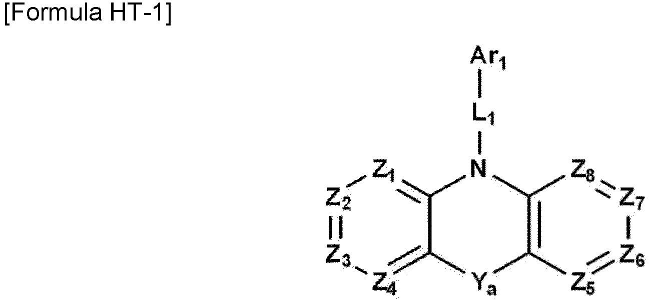

In Formula HT-1 above, Z₁ to Z₈ are each independently N or CR₅₁, L₁ is a direct linkage, a substituted or unsubstituted arylene group having 6 to 30 ring-forming carbon atoms, or a substituted or unsubstituted heteroarylene group having 2 to 30 ring-forming carbon atoms, Yₐ is a direct linkage, CR₅₂R₅₃, or SiR₅₄R₅₅, Ar₁ is a substituted or unsubstituted aryl group having 6 to 30 ring-forming carbon atoms, or a substituted or unsubstituted heteroaryl group having 2 to 30 ring-forming carbon atoms, and R₅₁ to R₅₅ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, and/or are bonded to an adjacent group to form a ring.

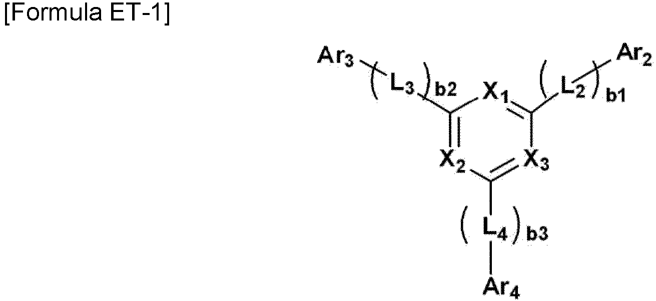

In Formula ET-1 above, at least one selected from among X₁ to X₃ is N, the rest are CR₅₆, R₅₆ is a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, b1 to b3 are each independently an integer of 0 to 10, Ar₂ to Ar₄ are each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and L₂ to L₄ are each independently a direct linkage, a substituted or unsubstituted arylene group having 6 to 30 ring-forming carbon atoms, or a substituted or unsubstituted heteroarylene group having 2 to 30 ring-forming carbon atoms.

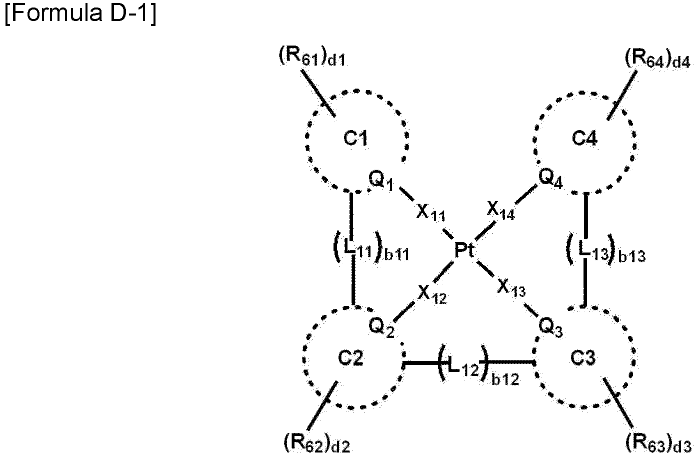

In Formula D-1 above, Q₁ to Q₄ are each independently C or N, C1 to C4 are each independently a substituted or unsubstituted hydrocarbon ring having 5 to 30 ring-forming carbon atoms, a substituted or unsubstituted aryl group having 6 to 30 ring-forming carbon atoms, a substituted or unsubstituted heterocycle having 2 to 30 ring-forming carbon atoms, X₁₁ to X₁₄ are each independently a direct linkage or *-O-* , L₁₁ to L₁₃ may each independently be a direct linkage, *-O-*, *-S-*. 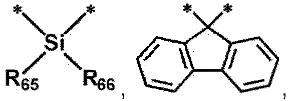 a substituted or unsubstituted alkylene group having 1 to 20 carbon atoms, a substituted or unsubstituted arylene group having 6 to 30 ring-forming carbon atoms, or a substituted or unsubstituted heteroarylene group having 2 to 30 ring-forming carbon atoms, b11 to b13 are each independently 0 or 1, R₆₁ to R₆₆ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, and/or are bonded to an adjacent group to form a ring, and d1 to d4 are each independently an integer of 0 to 4.

In one or more embodiments, Formula 1 above may be represented by Formula 1-1 or Formula 1-2.

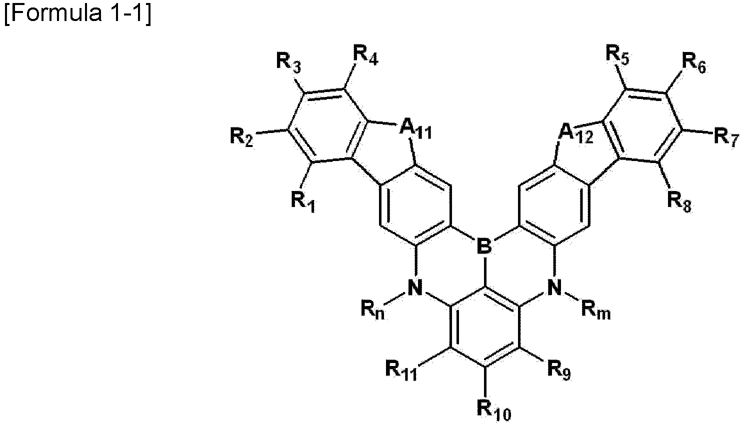

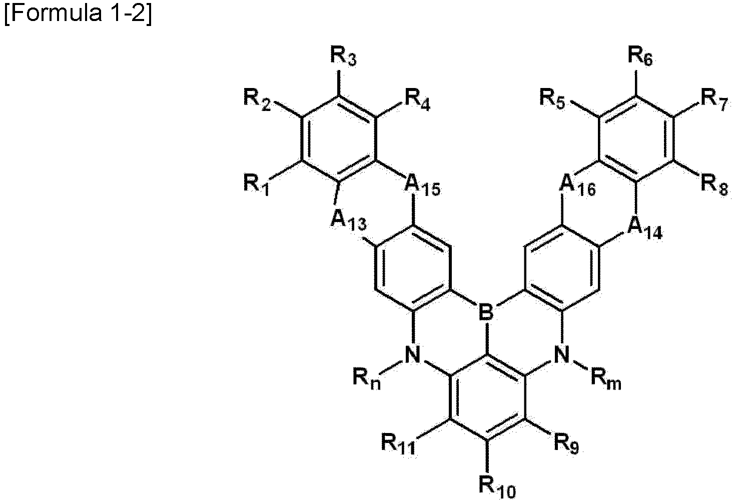

In Formula 1-1 above, A₁₁ and A₁₂ are each independently NR_{b1}, O, S, CR_{b2}R_{b3}, or SiR_{b4}R_{b5}, in Formula 1-2 above, A₁₃ to A₁₆ are each independently NR_{b6}, O, S, CR_{b7}R_{b8}, or SiR_{b9}R_{b10}, and if (e.g., when) A₁₅ is CR_{b7}R_{b8}, A₁₃ is NR_{b6}, O, S, or SiR_{b9}R_{b10}, and in Formula 1-1 and Formula 1-2, R₁ to R₁₁, R_{b1} to R_{b10}, Rₙ, and Rₘ are each independently be the same as defined in Formula 1 above.

In one or more embodiments, Formula 1-1 above may be represented by any one selected from among Formula 1-1A to Formula 1-1D:

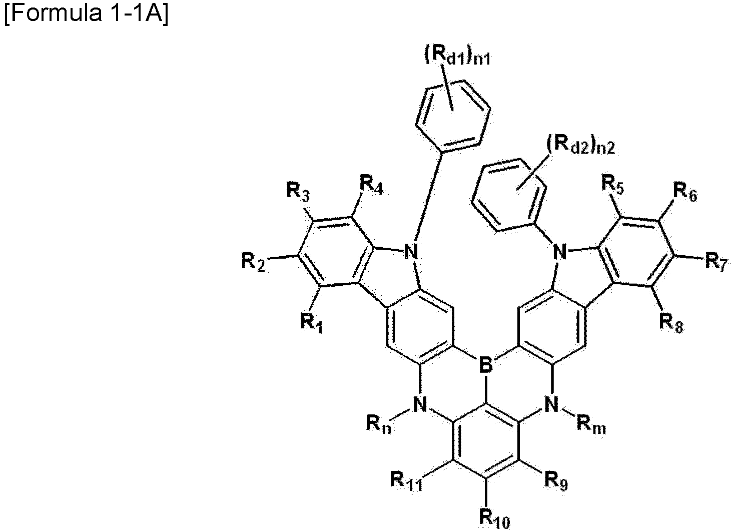

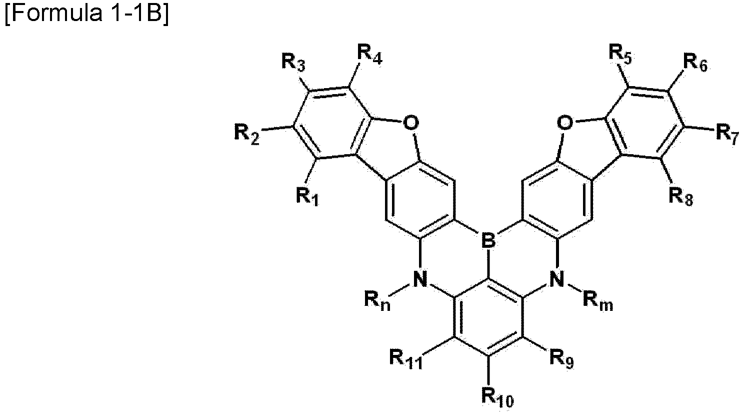

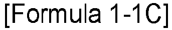

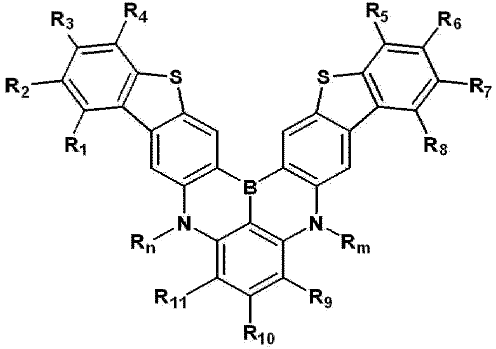

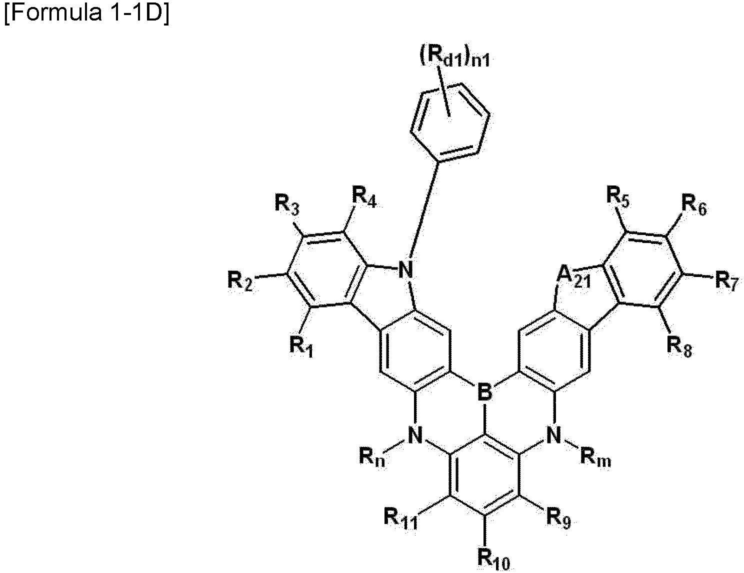

In Formula 1-1A and Formula 1-1D above, n1 and n2 are each independently an integer of 0 to 5, R_{d1} and R_{d2} are each independently a hydrogen atom, a deuterium atom, or a substituted or unsubstituted aryl group having 6 to 30 ring-forming carbon atoms, in Formula 1-1D above, A₂₁ is O, S, or CR_{b2}R_{b3}, and in Formula 1-1A to Formula 1-1D above, R₁ to R₁₁, R_{b2}, R_{b3}, Rₙ, and Rₘ are independently be the same as defined in Formula 1-1 above.

In one or more embodiments, in Formula 1-1D above, A₂₁ may be CR_{b2}R_{b3}, and R_{b2} and R_{b3} may each independently be a substituted or unsubstituted methyl group, or a substituted or unsubstituted phenyl group.

In one or more embodiments, in Formula 1 above, A₁ may be O, A₂ may be S, CR_{b2}R_{b3}, or SiR_{b4}R_{b5}, and R_{b2} to R_{b5} may each independently be a substituted or unsubstituted methyl group, or a substituted or unsubstituted phenyl group

In one or more embodiments, Formula 2 and Formula 3 above may each independently be represented by any one selected from among Formula RA-1 to Formula RA-19:

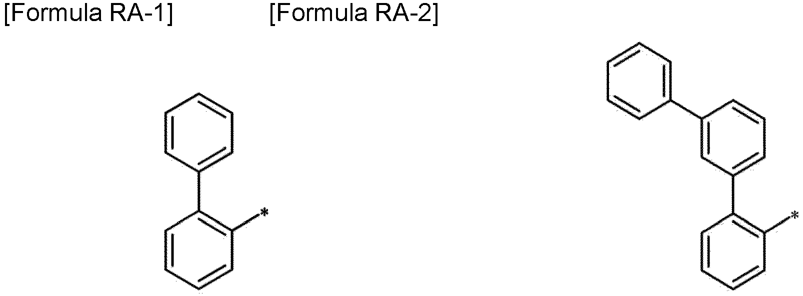

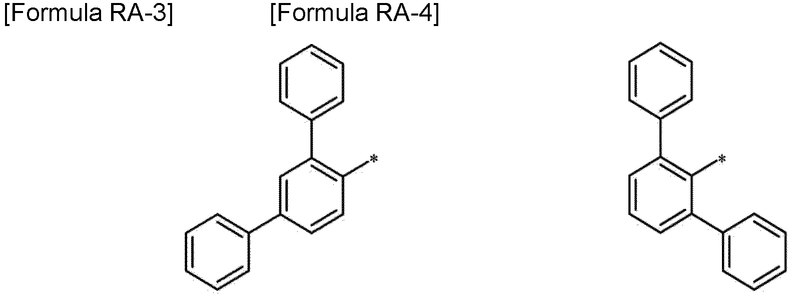

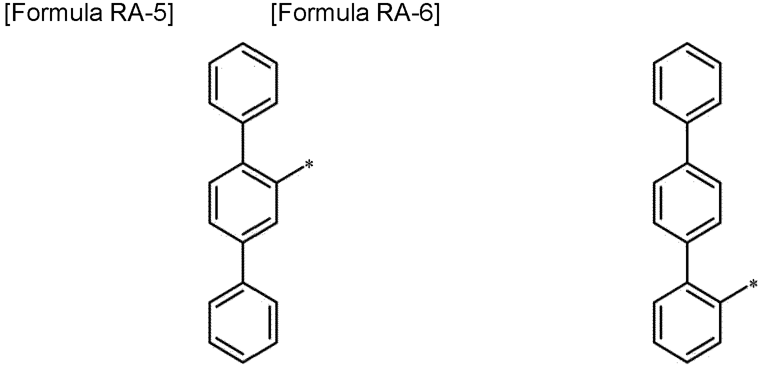

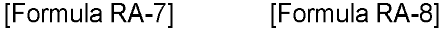

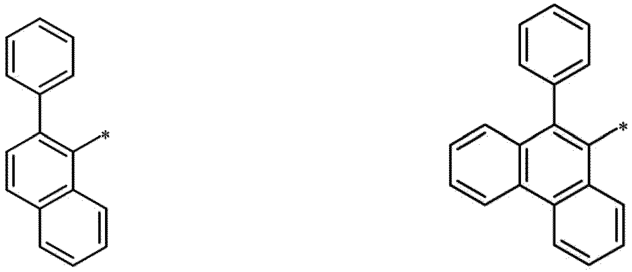

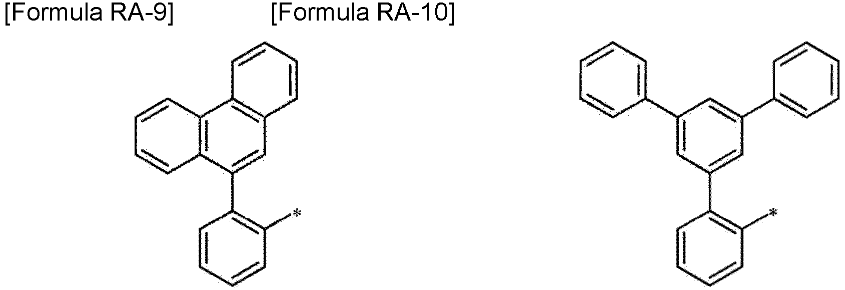

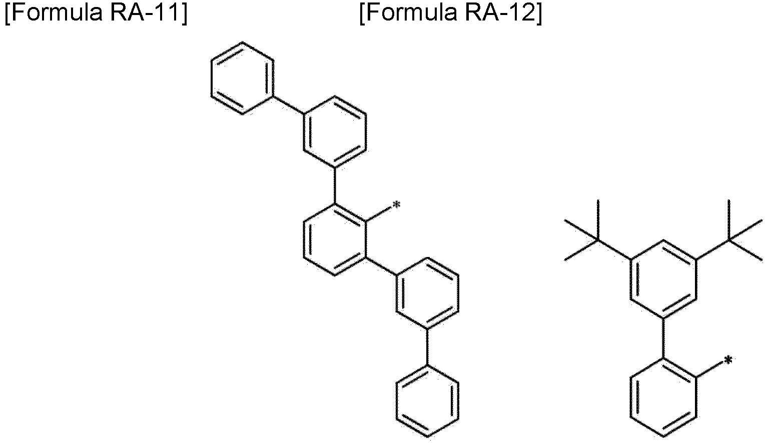

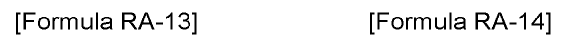

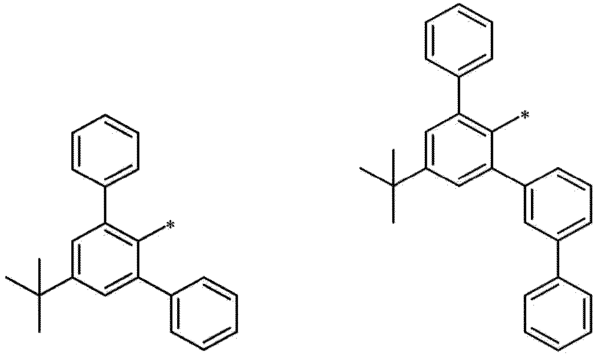

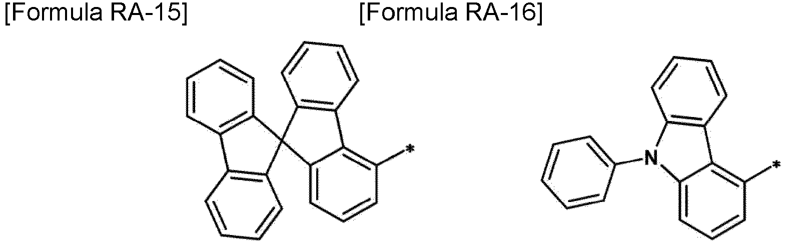

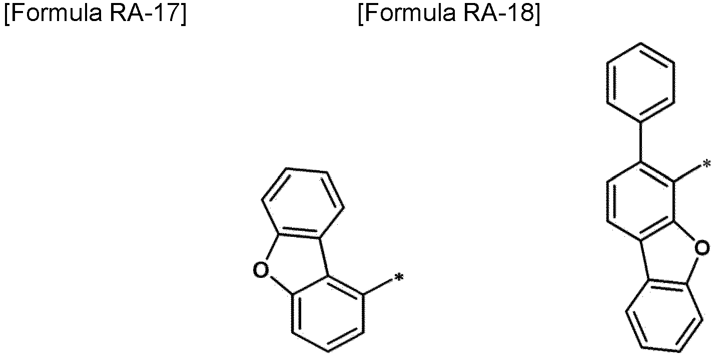

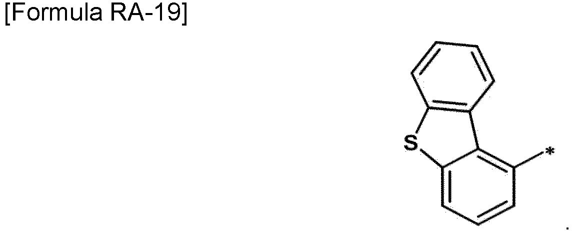

In one or more embodiments, in Formula 1 above, R₂, R₃, R₆, and R₇ may each independently be a hydrogen atom or represented by any one selected from among R-1 to R-7.

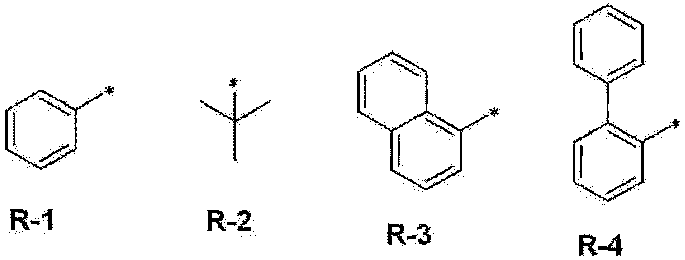

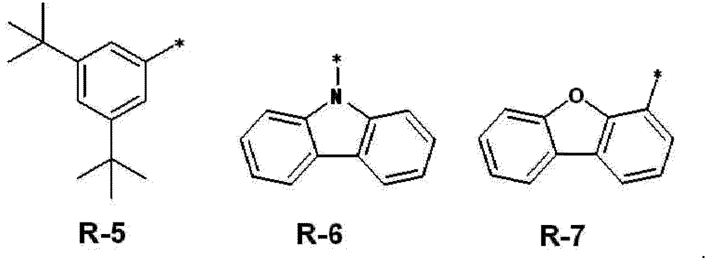

In one or more embodiments, in Formula 1 above, R₁₀ may be a hydrogen atom or represented by any one selected from among R10-1 to R10-32:

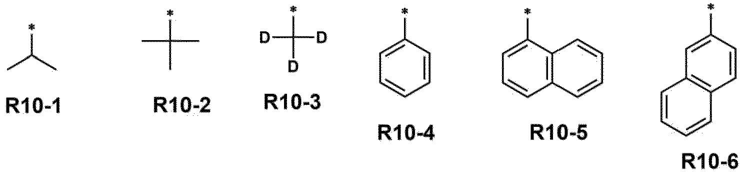

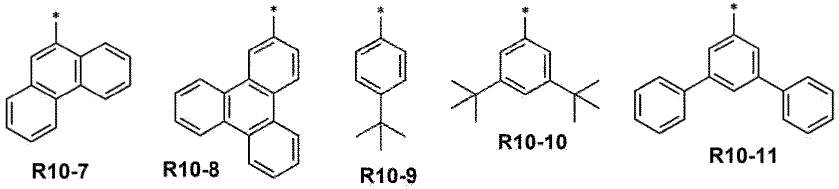

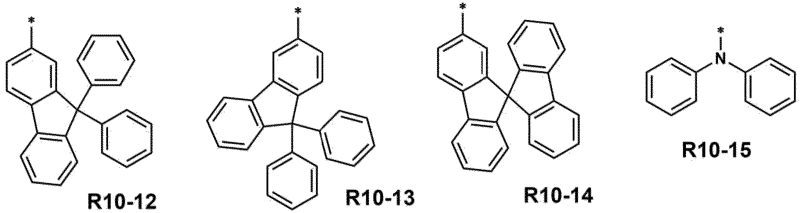

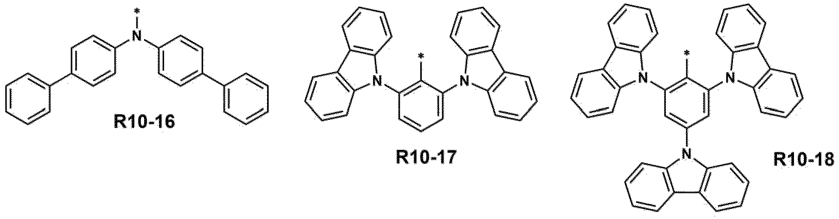

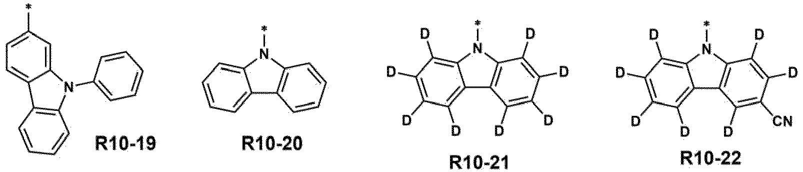

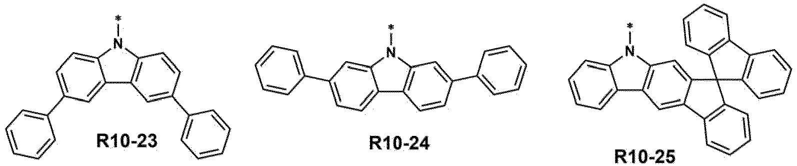

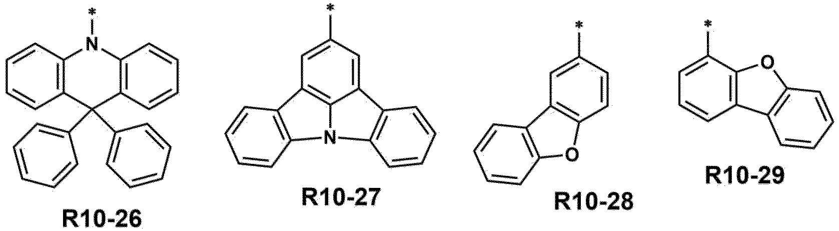

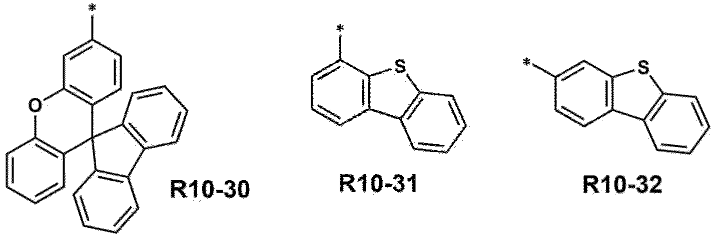

In R10-3, R10-21 and R10-22 above, D is a deuterium atom.

In one or more embodiments of the present disclosure, a fused polycyclic compound is represented by Formula 1 above.

In one or more embodiments of the present disclosure, a display device includes a base layer; a circuit layer arranged on the base layer; and a display element layer which is arranged on the circuit layer and includes a light emitting element, wherein the light emitting element includes a first electrode, a second electrode arranged on the first electrode, and an emission layer which is arranged between the first electrode and the second electrode, and includes the fused polycyclic compound represented by Formula 1 above.

In one or more embodiments, the light emitting element may be configured to emit green light.

In one or more embodiments, the display device may further include a light control layer which is arranged on the display element layer and includes quantum dots.

### BRIEF DESCRIPTION OF THE DRAWINGS

The accompanying drawings are included to provide a further understanding of the present disclosure, and are incorporated in and constitute a part of this specification. The drawings illustrate example embodiments of the present disclosure and, together with the description, serve to explain principles of the present disclosure. In the drawings:
FIG. 1 is a plan view illustrating a display device according to one or more embodiments of the present disclosure;
FIG. 2 is a cross-sectional view illustrating a portion taken along the line I-I' of FIG. 1;
FIG. 3 is a cross-sectional view schematically illustrating a light emitting element of one or more embodiments of the present disclosure;
FIG. 4 is a cross-sectional view schematically illustrating a light emitting element of one or more embodiments of the present disclosure;
FIG. 5 is a cross-sectional view schematically illustrating a light emitting element of one or more embodiments of the present disclosure;
FIG. 6 is a cross-sectional view schematically illustrating a light emitting element of one or more embodiments of the present disclosure;
FIG. 7 is a cross-sectional view illustrating a display device according to one or more embodiments of the present disclosure;
FIG. 8 is a cross-sectional view illustrating a display device according to one or more embodiments of the present disclosure;
FIG. 9 is a cross-sectional view illustrating a display device according to one or more embodiments of the present disclosure;
FIG. 10 is a cross-sectional view illustrating a display device according to one or more embodiments of the present disclosure; and
FIG. 11 is a view illustrating the inside of a vehicle in which display devices of embodiments are arranged.

### DETAILED DESCRIPTION

The accompanying drawings are included to provide a further understanding of the present disclosure, and are incorporated in and constitute a part of this specification. The present disclosure may, however, be embodied in different forms and should not be construed as limited to one or more embodiments set forth herein. Rather, these embodiments are provided so that this disclosure will be thorough and complete, and will fully convey the scope of the present disclosure to those skilled in the art.

In this specification, it will be understood that if (e.g., when) an element (or a region, a layer, a portion, and/or the like) is referred to as being "on", "connected to" or "coupled to" another element, it may be directly arranged on, connected or coupled to the other element, or intervening elements may be arranged therebetween.

As used herein, the term "and/or" includes any and all combinations of one or more of the associated listed items. Throughout the disclosure, the expression "at least one of a, b or c" indicates only a, only b, only c, both (e.g., simultaneously) a and b, both (e.g., simultaneously) a and c, both (e.g., simultaneously) b and c, all of a, b, and c, or variations thereof.

In the present specification, "A and/or B", etc., represents A or B, or A and B.

As used herein, the term "substantially," "about," and similar terms are used as terms of approximation and not as terms of degree, and are intended to account for the inherent deviations in measured or calculated values that would be recognized by those of ordinary skill in the art. "Substantially" as used herein, is inclusive of the stated value and means within an acceptable range of deviation for the particular value as determined by one of ordinary skill in the art, considering the measurement in question and the error associated with measurement of the particular quantity (i.e., the limitations of the measurement system).

Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

Further, the use of "may" when describing embodiments of the present disclosure refers to "one or more embodiments of the present disclosure."

As used herein, the singular forms "a," "an" and "the" are intended to include the plural forms as well, unless the context clearly indicates otherwise.

In the context of the present application and unless otherwise defined, the terms "use," "using," and "used" may be considered synonymous with the terms "utilize," "utilizing," and "utilized," respectively.

Like reference numerals or symbols refer to like elements throughout, and duplicative descriptions thereof may not be provided. In the drawings, the thickness, the ratio, and the size of the element are exaggerated for effective description of the technical contents.

It will be understood that, although the terms first, second, and/or the like may be used herein to describe one or more suitable elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed herein could be termed a second element, component, region, layer or section without departing from the scope of the present disclosure. Similarly, a second element, component, region, layer or section may be termed a first element, component, region, layer or section. As used herein, the singular forms, "a", "an" and "the" are intended to include the plural forms as well, unless the context clearly indicates otherwise.

Also, terms of "below", "on lower side", "above", "on upper side", and/or the like may be used to describe the relationships of the elements illustrated in the drawings. These terms have relative concepts and are described on the basis of the directions indicated in the drawings.

It will be further understood that the terms "includes" and/or "have", if (e.g., when) used in this specification, specify the presence of stated features, integers, steps, operations, elements, components, and/or groups thereof, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In the specification, the term "substituted" refers to the replacement of at least one hydrogen of a substituent by a deuterium atom, a halogen atom, a cyano group, a nitro group, an amine group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, or a heterocyclic group.

In the specification, the phrase "bonded to an adjacent group to form a ring" may refer to a group that is bonded to an adjacent group to form a substituted or unsubstituted hydrocarbon ring, or a substituted or unsubstituted heterocycle. The hydrocarbon ring includes an aliphatic hydrocarbon ring and an aromatic hydrocarbon ring. The heterocycle includes an aliphatic heterocycle and an aromatic heterocycle. The hydrocarbon ring and the heterocycle may be monocyclic or polycyclic. In addition, the rings formed by being bonded to each other may be connected to another ring to form a spiro structure.

In the specification, the term "adjacent group" may refer to a substituent substituted for an atom which is directly linked to an atom substituted with a corresponding substituent, another substituent substituted for an atom which is substituted with a corresponding substituent, or a substituent sterically positioned at the nearest position to a corresponding substituent. For example, two methyl groups in 1,2-dimethylbenzene may be interpreted as "adjacent groups" to each other and two ethyl groups in 1,1-diethylcyclopentane may be interpreted as "adjacent groups" to each other. In addition, two methyl groups in 4,5-dimethylphenanthrene may be interpreted as "adjacent groups" to each other.

In the specification, examples of the halogen atom may include a fluorine atom, a chlorine atom, a bromine atom, or an iodine atom.

In the specification, the alkyl group may be linear or branched. The number of carbons in the alkyl group is 1 to 50, 1 to 30, 1 to 20, 1 to 10, or 1 to 6. Examples of the alkyl group may include a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-henicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, and/or the like, but one or more embodiments of the present disclosure is not limited thereto.

In the specification, a cycloalkyl group may refer to a cyclic alkyl group. The number of carbons in the cycloalkyl group is 3 to 50, 3 to 30, 3 to 20, or 3 to 10. Examples of the cycloalkyl group may include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, and/or the like, but one or more embodiments of the present disclosure is not limited thereto.

In the specification, an alkenyl group refers to a hydrocarbon group including at least one carbon double bond in the middle or terminal of an alkyl group having 2 or more carbon atoms. The alkenyl group may be linear or branched. The number of carbon atoms in the alkenyl group is not specifically limited, but is 2 to 30, 2 to 20, or 2 to 10. Examples of the alkenyl group include a vinyl group, a 1-butenyl group, a 1-pentenyl group, a 1,3-butadienyl aryl group, a styrenyl group, a styryl vinyl group, and/or the like., but one or more embodiments of the present disclosure is not limited thereto.

In the specification, an alkynyl group refers to a hydrocarbon group including at least one carbon triple bond in the middle or terminal of an alkyl group having 2 or more carbon atoms. The alkynyl group may be linear or branched. Although the number of carbon atoms is not specifically limited, it is 2 to 30, 2 to 20, or 2 to 10. Specific examples of the alkynyl group may include an ethynyl group, a propynyl group, and/or the like, but are not limited thereto.

In the specification, the hydrocarbon ring group refers to any functional group or substituent derived from an aliphatic hydrocarbon ring. The hydrocarbon ring group may be a saturated hydrocarbon ring group having 5 to 20 ring-forming carbon atoms.

In the specification, an aryl group refers to any functional group or substituent derived from an aromatic hydrocarbon ring. The aryl group may be a monocyclic aryl group or a polycyclic aryl group. The number of ring-forming carbon atoms in the aryl group may be 6 to 60, 6 to 30, 6 to 20, or 6 to 15. Examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, and/or the like, but one or more embodiments of the present disclosure is not limited thereto.

In the specification, the fluorenyl group may be substituted, and two substituents may be bonded to each other to form a spiro structure. Examples of the substituted fluorenyl group are as follows. However, one or more embodiments of the present disclosure is not limited thereto.

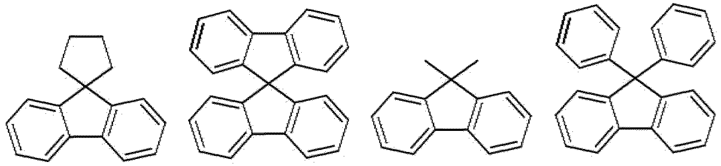

The heterocyclic group herein refers to any functional group or substituent derived from a ring containing at least one of B, O, N, P, Si, or S as a heteroatom. The heterocyclic group includes an aliphatic heterocyclic group and an aromatic heterocyclic group. The aromatic heterocyclic group may be a heteroaryl group. The aliphatic heterocycle and the aromatic heterocycle may be monocyclic or polycyclic.

In the specification, the heterocyclic group may contain at least one of B, O, N, P, Si or S as a heteroatom. If the heterocyclic group contains two or more heteroatoms, the two or more heteroatoms may be the same as or different from each other. The heterocyclic group may be a monocyclic heterocyclic group or a polycyclic heterocyclic group, and includes a heteroaryl group. The number of ring-forming carbon atoms in the heterocyclic group may be 2 to 60, 2 to 30, 2 to 20, or 2 to 10.

In the specification, the aliphatic heterocyclic group may include at least one of B, O, N, P, Si, or S as a heteroatom. The number of ring-forming carbon atoms in the aliphatic heterocyclic group may be 2 to 60, 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, and/or the like, but one or more embodiments of the present disclosure is not limited thereto.

In the specification, the heteroaryl group may contain at least one of B, O, N, P, Si, or S as a heteroatom. If the heteroaryl group contains two or more heteroatoms, the two or more heteroatoms may be the same as or different from each other. The heteroaryl group may be a monocyclic heterocyclic group or a polycyclic heterocyclic group. The number of ring-forming carbon atoms in the heteroaryl group may be 2 to 60, 2 to 30, 2 to 20, or 2 to 10. Examples of the heteroaryl group may include a thiophene group, a furan group, a pyrrole group, an imidazole group, a pyridine group, a bipyridine group, a pyrimidine group, a triazine group, a triazole group, an acridyl group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, and/or the like, but one or more embodiments of the present disclosure is not limited thereto.

In the specification, the above description of the aryl group may be applied to an arylene group except that the arylene group is a divalent group. The above description of the heteroaryl group may be applied to a heteroarylene group except that the heteroarylene group is a divalent group.

In the specification, the silyl group includes an alkylsilyl group and an arylsilyl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and/or the like, but one or more embodiments of the present disclosure is not limited thereto.

In the specification, the number of ring-forming carbon atoms in the carbonyl group is not specifically limited, but may be 1 to 40, 1 to 30, or 1 to 20. For example, the carbonyl group may have the following structures, but one or more embodiments of the present disclosure is not limited thereto.

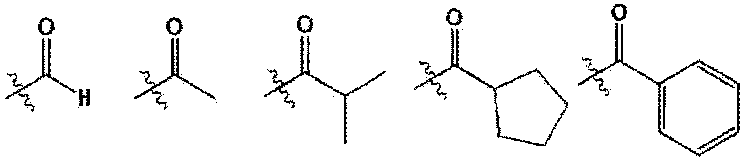

In the specification, the number of carbon atoms in the sulfinyl group and the sulfonyl group is not particularly limited, but may be 1 to 30. The sulfinyl group may include an alkyl sulfinyl group and an aryl sulfinyl group. The sulfonyl group may include an alkyl sulfonyl group and an aryl sulfonyl group.

In the specification, the thio group may include an alkylthio group and an arylthio group. The thio group may refer to that a sulfur atom is bonded to the alkyl group or the aryl group as defined above. Examples of the thio group may include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, but one or more embodiments of the present disclosure is not limited thereto.

In the specification, an oxy group may refer to that an oxygen atom is bonded to the alkyl group or the aryl group as defined above. The oxy group may include an alkoxy group and an aryl oxy group. The alkoxy group may be a linear chain, a branched chain or a ring chain. The number of carbon atoms in the alkoxy group is not specifically limited, but may be, for example, 1 to 20 or 1 to 10. Examples of the oxy group may include methoxy, ethoxy, n-propoxy, isopropoxy, butoxy, pentyloxy, hexyloxy, octyloxy, nonyloxy, decyloxy, benzyloxy, and/or the like, but one or more embodiments of the present disclosure is not limited thereto.

The boron group herein may refer to a boron atom that is bonded to the alkyl group or the aryl group as defined above. The boron group includes an alkyl boron group and an aryl boron group. Examples of the boron group may include a dimethylboron group, a t-butylmethylboron group, a diphenylboron group, a phenylboron group, and/or the like, but one or more embodiments of the present disclosure is not limited thereto.

In the specification, the number of carbon atoms in an amine group is not specifically limited, but may be 1 to 30. The amine group may include an alkyl amine group and an aryl amine group. Examples of the amine group may include a methylamine group, a dimethylamine group, a phenylamine group, a diphenylamine group, a naphthylamine group, a 9-methyl-anthracenylamine group, and/or the like, but one or more embodiments of the present disclosure is not limited thereto.

In the specification, the alkyl group selected from among an alkylthio group, an alkylsulfoxy group, an alkylaryl group, an alkylamino group, an alkyl boron group, an alkyl silyl group, and an alkyl amine group is the same as the examples of the alkyl group described above.

In the specification, the aryl group selected from among an aryloxy group, an arylthio group, an arylsulfoxy group, an arylamino group, an arylboron group, an arylsilyl group, an arylamine group is the same as the examples of the aryl group described above.

In the specification, a direct linkage may refer to a single bond. In the specification, "" 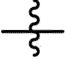 " and " 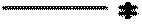 " refer to a position to be connected.

Hereinafter, embodiments of the present disclosure will be described in more detail with reference to the accompanying drawings.

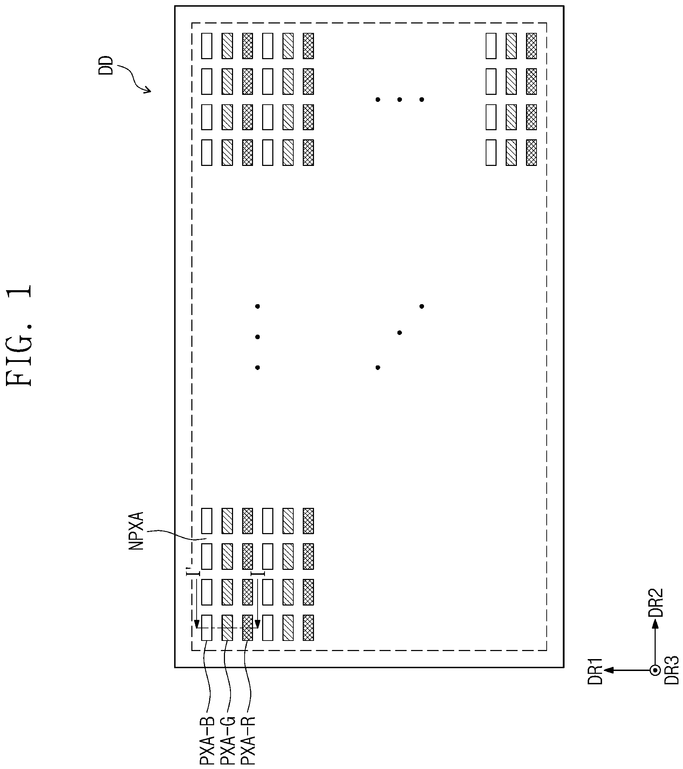

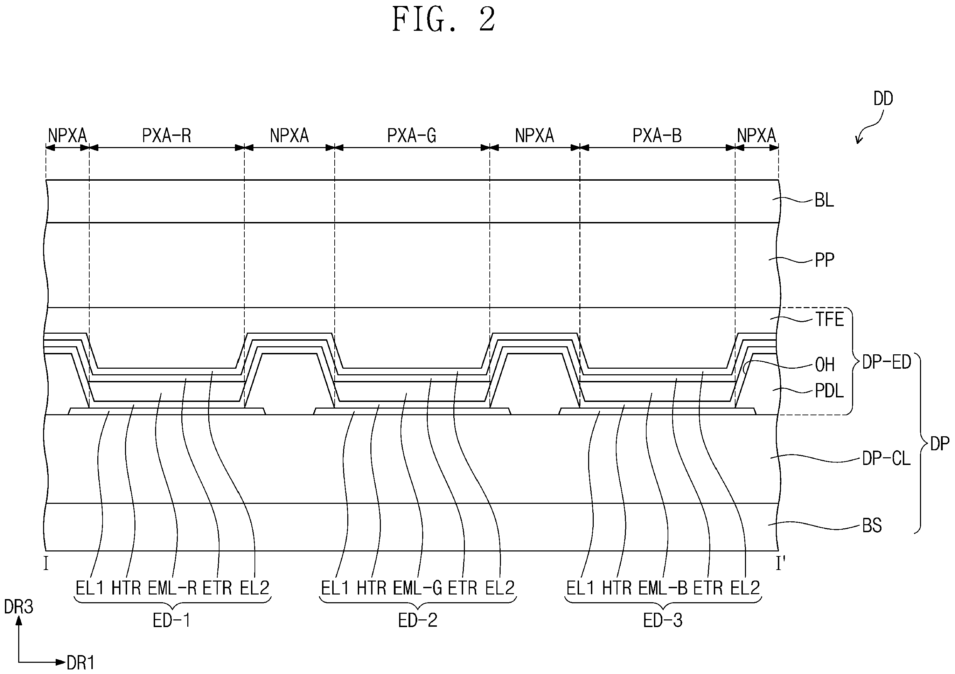

FIG. 1 is a plan view illustrating one or more embodiments of a display device DD. FIG. 2 is a cross-sectional view of the display device DD of the embodiment. FIG. 2 is a cross-sectional view illustrating a part taken along the line I-I' of FIG. 1.

The display device DD may include a display panel DP and an optical layer PP arranged on the display panel DP. The display panel DP includes light emitting elements ED-1, ED-2, and ED-3. The display device DD may include a plurality of light emitting elements ED-1, ED-2, and ED-3. The optical layer PP may be arranged on the display panel DP to control reflected light in the display panel DP due to external light. The optical layer PP may include, for example, a polarization layer or a color filter layer. In one or more embodiments, unlike the configuration illustrated in the drawing, the optical layer PP may not be provided from the display device DD of one or more embodiments.

A base substrate BL may be arranged on the optical layer PP. The base substrate BL may be a member which provides a base surface on which the optical layer PP arranged. The base substrate BL may be a glass substrate, a metal substrate, a plastic substrate, and/or the like. However, one or more embodiments of the present disclosure is not limited thereto, and the base substrate BL may be an inorganic layer, an organic layer, or a composite material layer. In addition, unlike the configuration illustrated, in one or more embodiments, the base substrate BL may not be provided.

The display device DD according to one or more embodiments may further include a filling layer. The filling layer may be arranged between a display element layer DP-ED and the base substrate BL. The filling layer may be an organic material layer. The filling layer may include at least one of an acrylic-based resin, a silicone-based resin, or an epoxy-based resin.

The display panel DP may include a base layer BS, a circuit layer DP-CL and the display element layer DP-ED provided on the base layer BS. The display element layer DP-ED may include a pixel defining film PDL, the light emitting elements ED-1, ED-2, and ED-3 arranged between portions of the pixel defining film PDL, and an encapsulation layer TFE arranged on the light emitting elements ED-1, ED-2, and ED-3.

The base layer BS may be a member which provides a base surface on which the display element layer DP-ED is arranged. The base layer BS may be a glass substrate, a metal substrate, a plastic substrate, and/or the like. However, one or more embodiments is not limited thereto, and the base layer BS may be an inorganic layer, an organic layer, or a composite material layer.

In one or more embodiments, the circuit layer DP-CL is arranged on the base layer BS, and the circuit layer DP-CL may include a plurality of transistors. Each of the transistors may include a control electrode, an input electrode, and an output electrode. For example, the circuit layer DP-CL may include a switching transistor and a driving transistor for driving the light emitting elements ED-1, ED-2, and ED-3 of the display element layer DP-ED.

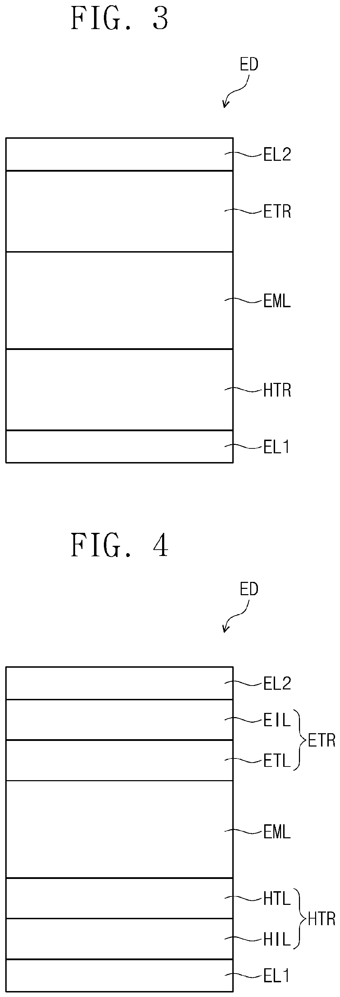

Each of the light emitting elements ED-1, ED-2, and ED-3 may have a structure of each light emitting element ED of embodiments according to FIGS. 3 to 6, which will be described in more detail later. Each of the light emitting elements ED-1, ED-2, and ED-3 may include a first electrode EL1, a hole transport region HTR, emission layers EML-R, EML-G, and EML-B, an electron transport region ETR, and a second electrode EL2.

FIG. 2 illustrates one or more embodiments in which the emission layers EML-R, EML-G, and EML-B of the light emitting elements ED-1, ED-2, and ED-3 are arranged in openings OH defined in the pixel defining film PDL, and the hole transport region HTR, the electron transport region ETR, and the second electrode EL2 are provided as a common layer in the entire light emitting elements ED-1, ED-2, and ED-3. However, one or more embodiments of the present disclosure is not limited thereto, and unlike the configuration illustrated in FIG. 2, the hole transport region HTR and the electron transport region ETR in one or more embodiments may be provided by being patterned inside the openings OH defined in the pixel defining film PDL. For example, the hole transport region HTR, the emission layers EML-R, EML-G, and EML-B, and the electron transport region ETR of the light emitting elements ED-1, ED-2, and ED-3 in one or more embodiments may be provided by being patterned in an inkjet printing method.

The encapsulation layer TFE may cover the light emitting elements ED-1, ED-2 and ED-3. The encapsulation layer TFE may seal the light emitting elements ED-1, ED-2 and ED-3. The encapsulation layer TFE may be a thin film encapsulation layer. The encapsulation layer TFE may be formed by laminating one layer or a plurality of layers. The encapsulation layer TFE includes at least one insulation layer. The encapsulation layer TFE according to one or more embodiments may include at least one inorganic film (hereinafter, an encapsulation-inorganic film). The encapsulation layer TFE according to one or more embodiments may also include at least one organic film (hereinafter, an encapsulation-organic film) and at least one encapsulation-inorganic film.

The encapsulation-inorganic film protects the light emitting elements ED-1, ED-2 and ED-3 from moisture/oxygen, and the encapsulation-organic film protects the light emitting elements ED-1, ED-2 and ED-3 from foreign substances such as dust particles. The encapsulation-inorganic film may include silicon nitride, silicon oxynitride, silicon oxide, titanium oxide, aluminum oxide, and/or the like, but one or more embodiments of the present disclosure is not particularly limited thereto. The encapsulation-organic film may include an acrylic-based compound, an epoxy-based compound, and/or the like. The encapsulation-organic film may include a photopolymerizable organic material, but one or more embodiments of the present disclosure is not particularly limited thereto.

The encapsulation layer TFE may be arranged on the second electrode EL2 and may be arranged filling the opening OH.

Referring to FIGS. 1 and 2, the display device DD may include a non-light emitting region NPXA and light emitting regions PXA-R, PXA-G, and PXA-B. The light emitting regions PXA-R, PXA-G, and PXA-B may be regions in which light generated by the respective light emitting elements ED-1, ED-2, and ED-3 is emitted. The light emitting regions PXA-R, PXA-G, and PXA-B may be spaced and/or apart (e.g., spaced apart or separated) from each other on a plane.

Each of the light emitting regions PXA-R, PXA-G, and PXA-B may be a region divided by the pixel defining film PDL. The non-light emitting areas NPXA may be areas between the adjacent light emitting areas PXA-R, PXA-G, and PXA-B, which correspond to the pixel defining film PDL. In one or more embodiments, in the specification, the light emitting regions PXA-R, PXA-G, and PXA-B may respectively correspond to pixels. The pixel defining film PDL may divide the light emitting elements ED-1, ED-2, and ED-3. The emission layers EML-R, EML-G, and EML-B of the light emitting elements ED-1, ED-2, and ED-3 may be arranged in openings OH defined in the pixel defining film PDL and separated from each other.

The light emitting regions PXA-R, PXA-G, and PXA-B may be divided into a plurality of groups according to the color of light generated from the light emitting elements ED-1, ED-2, and ED-3. In the display device DD of one or more embodiments illustrated in FIGS. 1 and 2, three light emitting regions PXA-R, PXA-G, and PXA-B, which are configured to emit red light, green light, and blue light, respectively, are illustrated as examples. For example, the display device DD of one or more embodiments may include the red light emitting region PXA-R, the green light emitting region PXA-G, and the blue light emitting region PXA-B that are separated from each other.

In the display device DD according to one or more embodiments, the plurality of light emitting elements ED-1, ED-2 and ED-3 may be configured to emit light beams having wavelengths different from each other. For example, in one or more embodiments, the display device DD may include a first light emitting element ED-1 that is configured to emit red light, a second light emitting element ED-2 that is configured to emit green light, and a third light emitting element ED-3 that is configured to emit blue light. For example, the red light emitting region PXA-R, the green light emitting region PXA-G, and the blue light emitting region PXA-B of the display device DD may correspond to the first light emitting element ED-1, the second light emitting element ED-2, and the third light emitting element ED-3, respectively.

However, one or more embodiments of the present disclosure is not limited thereto, and the first to third light emitting elements ED-1, ED-2, and ED-3 may be configured to emit light beams in substantially the same wavelength range or at least one light emitting element may be configured to emit a light beam in a wavelength range different from the others. For example, the first to third light emitting elements ED-1, ED-2, and ED-3 may all be configured to emit blue light.

The light emitting regions PXA-R, PXA-G, and PXA-B in the display device DD according to one or more embodiments may be arranged in a stripe form. Referring to FIG. 1, the plurality of red light emitting regions PXA-R may be each arranged with each other along a second directional axis DR2, the plurality of green light emitting regions PXA-G may be each arranged with each other along the second directional axis DR2, and the plurality of blue light emitting regions PXA-B may be arranged with each other arranged along the second directional axis DR2. In addition, the (e.g., a or one) red light emitting region PXA-R, the (e.g., a or one) green light emitting region PXA-G, and the (e.g., a or one) blue light emitting region PXA-B may be alternately arranged in this order along a first directional axis DR1.

FIGS. 1 and 2 illustrate that all the light emitting regions PXA-R, PXA-G, and PXA-B have similar area, but one or more embodiments of the present disclosure is not limited thereto. Thus, the light emitting regions PXA-R, PXA-G, and PXA-B may have different areas from each other according to the wavelength range of the emitted light. In this case, the areas of the light emitting regions PXA-R, PXA-G, and PXA-B may refer to areas if (e.g., when) viewed on a plane defined by the first directional axis DR1 and the second directional axis DR2.

In one or more embodiments, an arrangement form of the light emitting regions PXA-R, PXA-G, and PXA-B is not limited to the configuration illustrated in FIG. 1, and the order in which the red light emitting region PXA-R, the green light emitting region PXA-G, and the blue light emitting region PXA-B are arranged may be provided in one or more suitable combinations according to the characteristics of display quality desired or required in the display device DD. For example, the arrangement form of the light emitting regions PXA-R, PXA-G, and PXA-B may be a pentile (PENTILE^{®}) arrangement form or a diamond (Diamond Pixel^{®}) arrangement form.

In addition, the areas of the light emitting regions PXA-R, PXA-G, and PXA-B may be different from each other. For example, in one or more embodiments, the area of the green light emitting region PXA-G may be smaller than that of the blue light emitting region PXA-B, but one or more embodiments of the present disclosure is not limited thereto.

Hereinafter, FIG. 3 to FIG. 6 are cross-sectional views schematically showing light emitting elements according to one or more embodiments. The light emitting element ED of one or more embodiments may include a first electrode EL1, a hole transport region HTR, an emission layer EML, an electron transport region ETR, and a second electrode EL2 stacked in order.

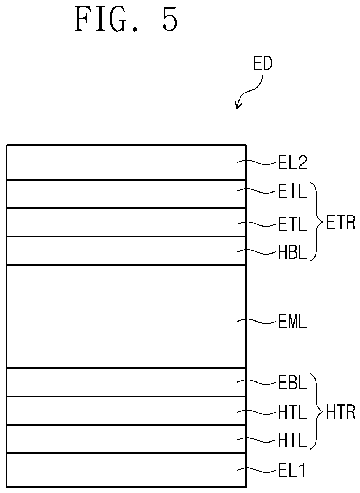

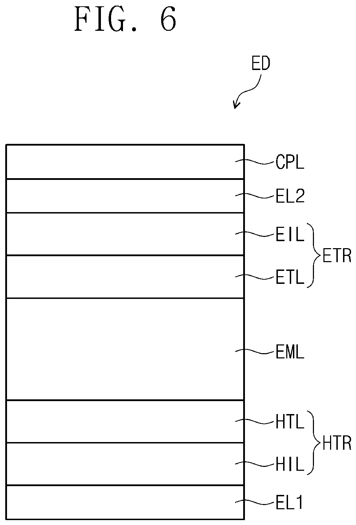

Compared with FIG. 3, FIG. 4 illustrates a cross-sectional view of a light emitting element ED of one or more embodiments, in which a hole transport region HTR includes a hole injection layer HIL and a hole transport layer HTL, and an electron transport region ETR includes an electron injection layer EIL and an electron transport layer ETL. In addition, compared with FIG. 3, FIG. 5 illustrates a cross-sectional view of a light emitting element ED of one or more embodiments, in which a hole transport region HTR includes a hole injection layer HIL, a hole transport layer HTL, and an electron blocking layer EBL, and an electron transport region ETR includes an electron injection layer EIL, an electron transport layer ETL, and a hole blocking layer HBL. Compared with FIG. 4, FIG. 6 illustrates a cross-sectional view of a light emitting element ED of one or more embodiments including a capping layer CPL arranged on a second electrode EL2.

The first electrode EL1 has conductivity (e.g., is a electron conductor). The first electrode EL1 may be formed of a metal material, a metal alloy, or a conductive compound. The first electrode EL1 may be an anode or a cathode. However, one or more embodiments of the present disclosure is not limited thereto. In addition, the first electrode EL1 may be a pixel electrode. The first electrode EL1 may be a transmissive electrode, a transflective electrode, or a reflective electrode. The first electrode EL1 may include at least one selected from among Ag, Mg, Cu, Al, Pt, Pd, Au, Ni, Nd, Ir, Cr, Li, Ca, LiF, Mo, Ti, W, In, Sn, and Zn, a compound of two or more selected from among these, a mixture of two or more selected from among these, or an oxide thereof.

If the first electrode EL1 is the transmissive electrode, the first electrode EL1 may include a transparent metal oxide such as indium tin oxide (ITO), indium zinc oxide (IZO), zinc oxide (ZnO), or indium tin zinc oxide (ITZO). If the first electrode EL1 is the transflective electrode or the reflective electrode, the first electrode EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, a compound or mixture thereof (e.g., a mixture of Ag and Mg). In one or more embodiments, the first electrode EL1 may have a multilayer structure including a reflective film or a transflective film formed of the above-described materials, and a transparent conductive film formed of ITO, IZO, ZnO, ITZO, and/or the like. For example, the first electrode EL1 may have a three-layer structure of ITO/Ag/ITO, but one or more embodiments of the present disclosure is not limited thereto. In addition, one or more embodiments of the present disclosure is not limited thereto, and the first electrode EL1 may include the above-described metal materials, combinations of at least two metal materials of the above-described metal materials, oxides of the above-described metal materials, and/or the like. The thickness of the first electrode EL1 may be from about 700 Å to about 10,000 Å. For example, the thickness of the first electrode EL1 may be from about 1,000 Å to about 3,000 Å.

The hole transport region HTR is provided on the first electrode EL1. The hole transport region HTR may include at least one of a hole injection layer HIL, a hole transport layer HTL, a buffer layer or an emission-auxiliary layer, or an electron blocking layer EBL. The thickness of the hole transport region HTR may be, for example, from about 50 Å to about 15,000 Å.

The hole transport region HTR may have a single layer formed of a single material, a single layer formed of a plurality of different materials, or a multilayer structure including a plurality of layers formed of a plurality of different materials.

For example, the hole transport region HTR may have a single layer structure of the hole injection layer HIL or the hole transport layer HTL, or may have a single layer structure formed of a hole injection material and a hole transport material. In addition, the hole transport region HTR may have a single layer structure formed of a plurality of different materials, or a structure in which a hole injection layer HIL/hole transport layer HTL, a hole injection layer HIL/hole transport layer HTL/buffer layer, a hole injection layer HIL/buffer layer, a hole transport layer HTL/buffer layer, or a hole injection layer HIL/hole transport layer HTL/electron blocking layer EBL are stacked in order from the first electrode EL1, but one or more embodiments of the present disclosure is not limited thereto.

The hole transport region HTR may be formed using one or more suitable methods such as a vacuum deposition method, a spin coating method, a cast method, a Langmuir-Blodgett (LB) method, an inkjet printing method, a laser printing method, and a laser induced thermal imaging (LITI) method.

The hole transport region HTR may include a compound represented by Formula H-1:

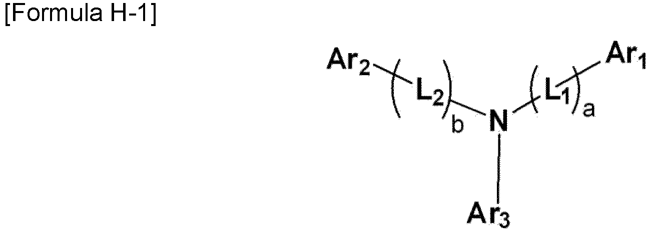

In Formula H-1, above, L₁ and L₂ may each independently be a direct linkage, a substituted or unsubstituted arylene group having 6 to 30 ring-forming carbon atoms, or a substituted or unsubstituted heteroarylene group having 2 to 30 ring-forming carbon atoms, a and b may each independently be an integer of 0 to 10. In one or more embodiments, if (e.g., when) a or b is an integer of 2 or greater, a plurality of L₁'s and L₂'s may each independently be a substituted or unsubstituted arylene group having 6 to 30 ring-forming carbon atoms, or a substituted or unsubstituted heteroarylene group having 2 to 30 ring-forming carbon atoms.

In Formula H-1, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. In addition, in Formula H-1, Ar₃ may be a substituted or unsubstituted aryl group having 6 to 30 ring-forming carbon atoms, or a substituted or unsubstituted heteroaryl group having 2 to 30 ring-forming carbon atoms.

The compound represented by Formula H-1 above may be a monoamine compound. In one or more embodiments, the compound represented by Formula H-1 above may be a diamine compound in which at least one selected from among Ar₁ to Ar₃ includes the amine group as a substituent. In addition, the compound represented by Formula H-1 above may be a carbazole-based compound including a substituted or unsubstituted carbazole group in at least one of Ar₁ or Ar₂, or a fluorene-based compound including a substituted or unsubstituted fluorene group in at least one of Ar₁ or Ar₂.

The compound represented by Formula H-1 may be represented by any one selected from among the compounds in Compound Group H. However, the compounds listed in Compound Group H are examples, and the compounds represented by Formula H-1 are not limited to those represented by Compound Group H:

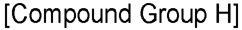

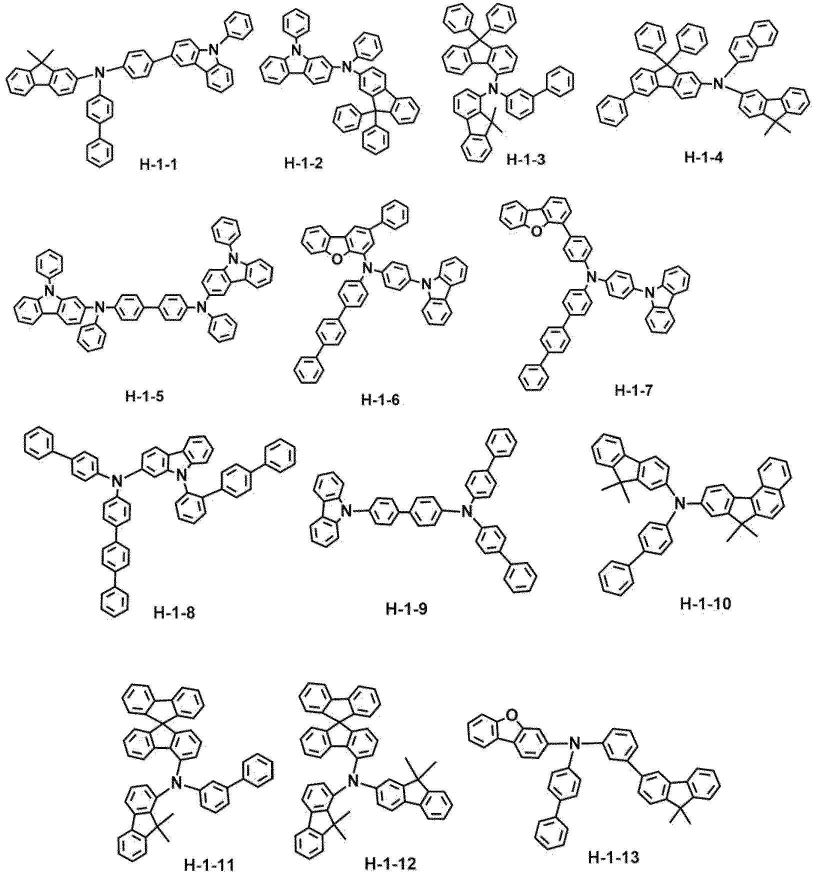

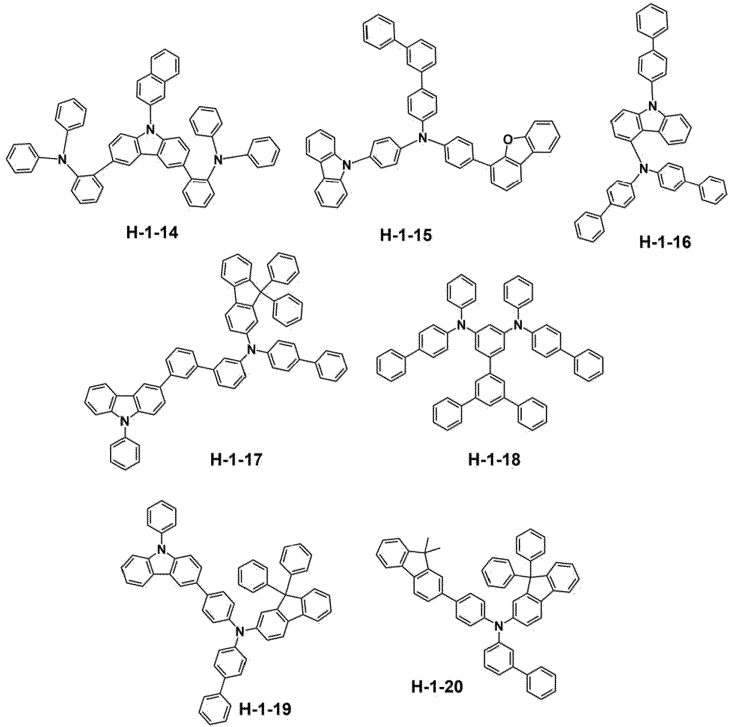

The hole transport region HTR may include a phthalocyanine compound such as copper phthalocyanine; N¹,N^{1'}-([1,1'-biphenyl]-4,4'-diyl)bis(N¹-phenyl-N⁴,N⁴-di-m-tolylbenzene-1,4-diamine) (DNTPD), 4,4',4"-[tris(3-methylphenyl)phenylamino] triphenylamine (m-MTDATA), 4,4',4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalene-1-yl)-N, N'-diphenyl-benzidine (NPB), triphenylamine-containing polyetherketone (TPAPEK), 4-isopropyl-4'-methyldiphenyliodonium [tetrakis(pentafluorophenyl)borate], dipyrazino[2,3-f: 2',3'-h]quinoxaline-2,3,6,7,10,11-hexacarbonitrile (HATCN), and/or the like.

The hole transport region HTR may include a carbazole-based derivative such as N-phenyl carbazole or polyvinyl carbazole, a fluorene-based derivative, a triphenylamine-based derivative such as N,N'-bis(3-methylphenyl)-N,N'-diphenyl-[1,1-biphenyl]-4,4'-diamine (TPD) or 4,4',4"-tris(N-carbazolyl)triphenylamine (TCTA), N,N'-di(naphthalene-1-yl)-N,N'-diphenyl-benzidine (NPB), 4,4'-cyclohexylidene bis[N,N-bis(4-methylphenyl]benzenamine] (TAPC), 4,4'-bis[N,N'-(3-tolyl)amino]-3,3'-dimethylbiphenyl (HMTPD), 1,3-bis(N-carbazolyl)benzene (mCP), and/or the like.

In addition, the hole transport region HTR may include 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), and/or the like.

The hole transport region HTR may include the above-described compounds of the hole transport region in at least one of a hole injection layer HIL, a hole transport layer HTL, or an electron blocking layer EBL.

The thickness of the hole transport region HTR may be from about 100 Å to about 10,000 Å, for example, from about 100 Å to about 5,000 Å. When the hole transport region HTR includes the hole injection layer HIL, the hole injection layer HIL may have, for example, a thickness of about 30 Å to about 1,000 Å. When the hole transport region HTR includes the hole transport layer HTL, the hole transport layer HTL may have a thickness of about 30 Å to about 1,000 Å. For example, if (e.g., when) the hole transport region HTR includes the electron blocking layer EBL, the electron blocking layer EBL may have a thickness of about 10 Å to about 1,000 Å. If the thicknesses of the hole transport region HTR, the hole injection layer HIL, the hole transport layer HTL and the electron blocking layer EBL satisfy the above-described ranges, satisfactory hole transport properties may be achieved without a substantial increase in driving voltage.

The hole transport region HTR may further include a charge generating material to increase conductivity in addition to the above-described materials. The charge generating material may be dispersed uniformly (e.g., substantially uniformly) or non-uniformly (e.g., substantially uniformly) in the hole transport region HTR. The charge generating material may be, for example, a p-dopant. The p-dopant may include at least one of a halogenated metal compound, a quinone derivative, a metal oxide, or a cyano group-containing compound, but one or more embodiments of the present disclosure is not limited thereto. For example, the p-dopant may include a metal halide compound such as Cul or RbI, a quinone derivative such as tetracyanoquinodimethane (TCNQ) or 2,3,5,6-tetrafluoro-7,7'8,8-tetracyanoquinodimethane (F4-TCNQ), a metal oxide such as tungsten oxide or molybdenum oxide, a cyano group-containing compound such as dipyrazino[2,3-f: 2',3'-h] quinoxaline-2,3,6,7,10,11-hexacarbonitrile (HATCN) or 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), and/or the like, but one or more embodiments of the present disclosure is not limited thereto.

As described above, the hole transport region HTR may further include at least one of the buffer layer or the electron blocking layer EBL in addition to the hole injection layer HIL and the hole transport layer HTL. The buffer layer may compensate for a resonance distance according to the wavelength of light emitted from the emission layer EML and may thus increase light emission efficiency. A material that may be included in the hole transport region HTR may be used as a material to be included in the buffer layer. The electron blocking layer EBL is a layer that serves to prevent or reduce the electron injection from the electron transport region ETR to the hole transport region HTR.

In one or more embodiments, the emission layer EML may include a first compound of one or more embodiments. In addition, the emission layer EML according to one or more embodiments may further include at least one selected from among the second to fourth compounds. The second compound may include a tricyclic fused ring containing a nitrogen atom as a ring-forming atom. The third compound may include a hexagonal ring group containing at least one nitrogen atom as a ring-forming atom. The fourth compound may include an organometallic complex. The second to fourth compounds will be described in more detail later.

In the present specification, the first compound may be referred to as a fused polycyclic compound of one or more embodiments. The fused polycyclic compound of one or more embodiments may include, as a central structure, a nonacyclic fused ring containing two nitrogen atoms and one boron atom as ring-forming atoms. The central structure may further include a sulfur atom and/or a silicon atom as a ring-forming atom, and may include three or more nitrogen atoms as a ring-forming atom. Two nitrogen atoms, which are ring-forming atoms, have a para position relationship with one boron atom, and a bulky substituent may be bonded to each of the two nitrogen atoms. Accordingly, the fused polycyclic compound of one or more embodiments may be configured to emit red-shifted light (e.g., green light), and Dexter energy transfer may be prevented or reduced. The light emitting element ED including the fused polycyclic compound of one or more embodiments may exhibit high efficiency and long service life characteristics.

The light emitting element ED of one or more embodiments may include a fused polycyclic compound of one or more embodiments. The fused polycyclic compound of one or more embodiments may be represented by Formula 1:

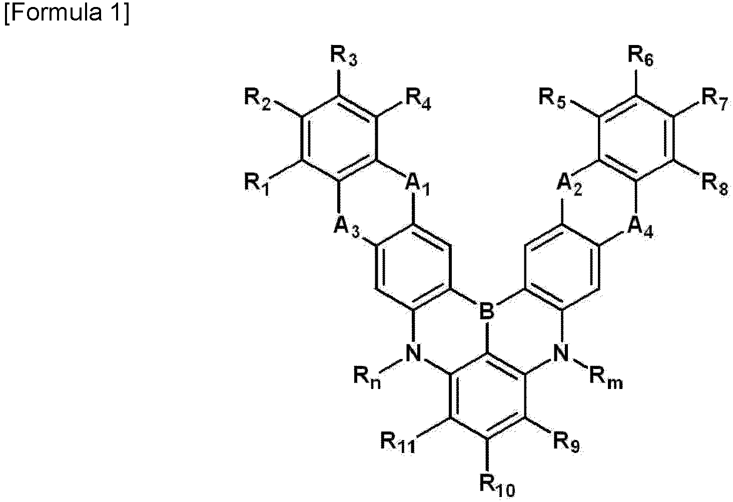

In Formula 1, A₁ and A₂ may each independently be NR_{b1}, O, S, CR_{b2}R_{b3}, or SiR_{b4}R_{b5}, and A₃ and A₄ may each independently be a direct linkage, NR_{b6}, O, S, CR_{b7}R_{b8}, or SiR_{b9}R_{b10}. When A₁ is CR_{b2}R_{b3}, A₃ may be a direct linkage, NR_{b6}, O, S, or SiR_{b9}R_{b10}. When A₁ is CR_{b2}R_{b3}, A₃ is not CR_{b7}R_{b8}. In Formula 1, the case where A₁ and A₂ are each CR_{b2}R_{b3}, A₃ and A₄ are each CR_{b7}R_{b8}, and a case in which R_{b2}, R_{b3}, R_{b7}, and R_{b8} are alkyl groups is excluded (i.e., R_{b2}, R_{b3}, R_{b7}, and R_{b8} are each not an alkyl group).

For example, in Formula 1, A₃ and A₄ may each be a direct linkage, and A₁ and A₂ may each independently be NR_{b1}. In Formula 1, A₃ and A₄ may each be a direct linkage, and A₁ and A₂ may each be O. In Formula 1, A₃ and A₄ may each be a direct linkage, and A₁ and A₂ may each be S. In Formula 1, A₃ and A₄ may each be a direct linkage, any one of A₁ and A₂ may be NR_{b1}, and the other may be O, S, CR_{b2}R_{b3}, or SiR_{b4}R_{b5}. In Formula 1, A₃ and A₄ may each be C(CH₃)₂, and A₁ and A₂ may each independently be N(Ph) or O. In this case, Ph refers to an unsubstituted phenyl group. However, this is an example, and one or more embodiments of the present disclosure is not limited thereto.

R_{b1} to R_{b10} may each independently be a substituted or unsubstituted alkyl group having 1 to 30 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. For example, R_{b1} to R_{b10} may each independently be a substituted or unsubstituted methyl group, a substituted or unsubstituted phenyl group, or a substituted or unsubstituted biphenyl group, and/or may be bonded to an adjacent group to form a ring.

In Formula 1, A₁ may be O, A₂ may be S, CR_{b2}R_{b3}, or SiR_{b4}R_{b5}, and R_{b2} to R_{b5} may each independently be a substituted or unsubstituted methyl group, or a substituted or unsubstituted phenyl group. For example, in Formula 1, A₁ may be O, and A₂ may be S, C(Ph)₂, or Si(Ph)₂. In this case, Ph refers to an unsubstituted phenyl group.

In Formula 1, to R₁₁ may each independently be a hydrogen atom, a deuterium atom, a cyano group, a substituted or unsubstituted amine group, a substituted or unsubstituted thio group, a substituted or unsubstituted oxy group, a substituted or unsubstituted silyl group, a substituted or unsubstituted alkyl group having 1 to 30 carbon atoms, a substituted or unsubstituted alkenyl group having 2 to 30 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. For example, R₁, R₄, R₅, R₈, R₉, and R₁₁ may be hydrogen atoms.

R₂, R₃, R₆, and R₇ may each independently be a hydrogen atom, a substituted or unsubstituted t-butyl group, a substituted or unsubstituted phenyl group, a substituted or unsubstituted biphenyl group, a substituted or unsubstituted naphthyl group, a substituted or unsubstituted carbazole group, or a substituted or unsubstituted dibenzofuran group. In one or more embodiments, R₂, R₃, R₆, and R₇ may each independently be a hydrogen atom or represented by any one selected from among R-1 to R-7:

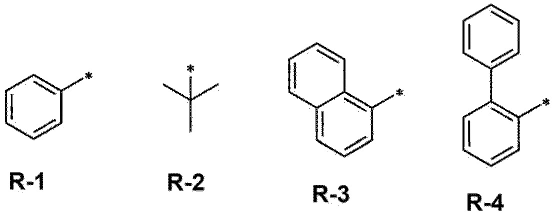

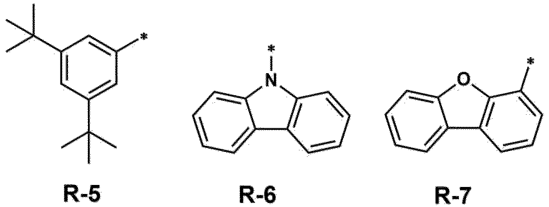

For example, R₁₀ may be a hydrogen atom, a substituted or unsubstituted methyl group, a substituted or unsubstituted isopropyl group, a substituted or unsubstituted diphenylamine group, a substituted or unsubstituted t-butyl group, a substituted or unsubstituted phenyl group, a substituted or unsubstituted naphthyl group, a substituted or unsubstituted phenanthrene group, a substituted or unsubstituted triphenylene group, a substituted or unsubstituted fluorene group, a substituted or unsubstituted carbazole group, a substituted or unsubstituted indolocarbazole group, a substituted or unsubstituted acridine group, a substituted or unsubstituted dibenzofuran group, a substituted or unsubstituted dibenzothiophene group, or a substituted or unsubstituted xanthene group. R₁₀ may be a hydrogen atom or represented by any one selected from among R10-1 to R10-32. In R10-3, R10-21 and R10-22, D is a deuterium atom.

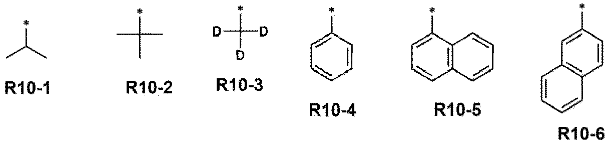

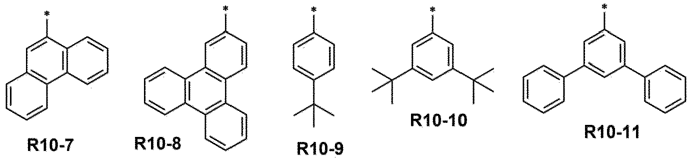

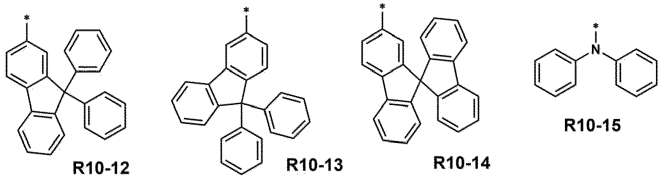

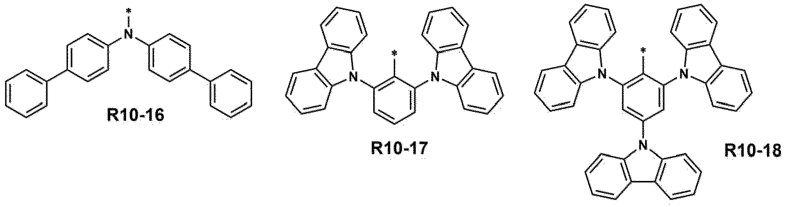

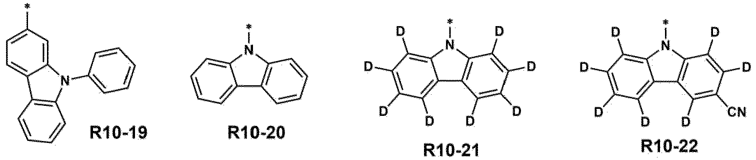

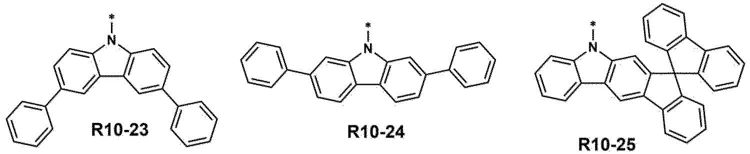

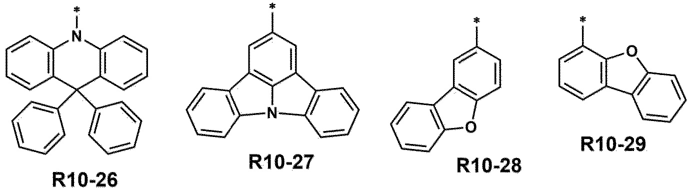

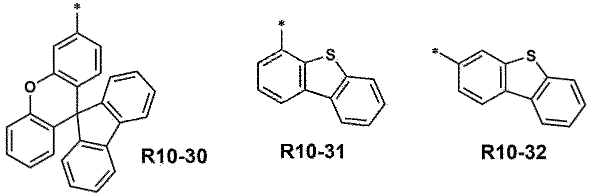

In Formula 1, Rₙ may be represented by Formula 2. Rₙ may be a substituted or unsubstituted biphenyl group. For example, Rₙ may be a substituted or unsubstituted ortho biphenyl moiety.

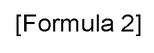

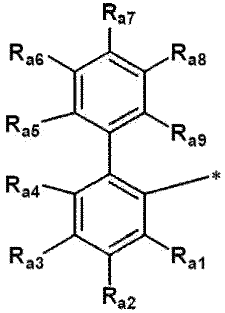

In Formula 2, Rₐ₁ to Rₐ₉ may each independently be a hydrogen atom, a deuterium atom, a cyano group, a substituted or unsubstituted amine group, a substituted or unsubstituted thio group, a substituted or unsubstituted oxy group, a substituted or unsubstituted silyl group, a substituted or unsubstituted alkyl group having 1 to 30 carbon atoms, a substituted or unsubstituted alkenyl group having 2 to 30 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. For example, Rₐ₁ to Rₐ₉ may each independently be a hydrogen atom, a substituted or unsubstituted phenyl group, and/or may be bonded to an adjacent group to form a ring. For example, two or more groups adjacent to each other among Rₐ₁ to Rₐ₉ may be bonded to each other to form a ring, and in this case, Rₙ may include a substituted or unsubstituted phenanthrene group, a substituted or unsubstituted fluorene group, a substituted or unsubstituted carbazole group, a substituted or unsubstituted dibenzofuran group, or a substituted or unsubstituted dibenzothiophene group.

In Formula 1, Rₘ may be represented by Formula 3. Rₘ may be a substituted or unsubstituted phenyl group.

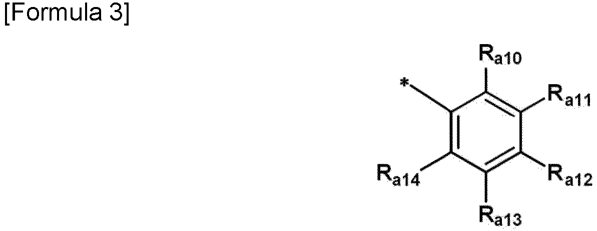

In Formula 3, Rₐ₁₀ to Rₐ₁₄ may each independently be a hydrogen atom, a deuterium atom, a cyano group, a substituted or unsubstituted amine group, a substituted or unsubstituted thio group, a substituted or unsubstituted oxy group, a substituted or unsubstituted silyl group, a substituted or unsubstituted alkyl group having 1 to 30 carbon atoms, a substituted or unsubstituted alkenyl group having 2 to 30 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. For example, Rₐ₁₀ to Rₐ₁₄ may each independently be a hydrogen atom, a substituted or unsubstituted phenyl group, and/or may be bonded to an adjacent group to form a ring. For example, two or more groups adjacent to each other among Rₐ₁₀ to Rₐ₁₄ may be bonded to each other to form a ring, and in this case, Rₘ may include a substituted or unsubstituted phenanthrene group, a substituted or unsubstituted fluorene group, a substituted or unsubstituted carbazole group, a substituted or unsubstituted dibenzofuran group, or a substituted or unsubstituted dibenzothiophene group.

Formula 2 and Formula 3 may each independently be represented by any one selected from among Formula RA-1 to RA-19:

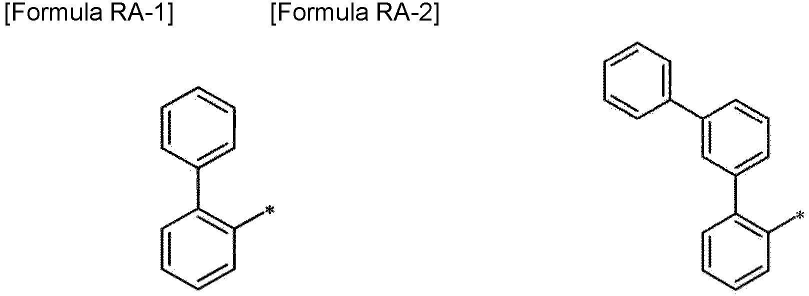

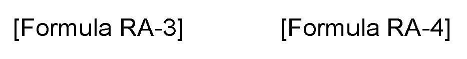

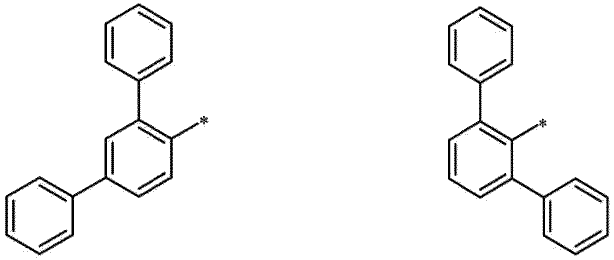

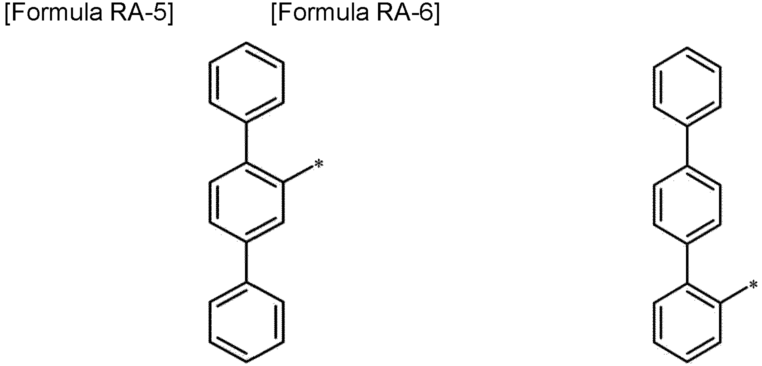

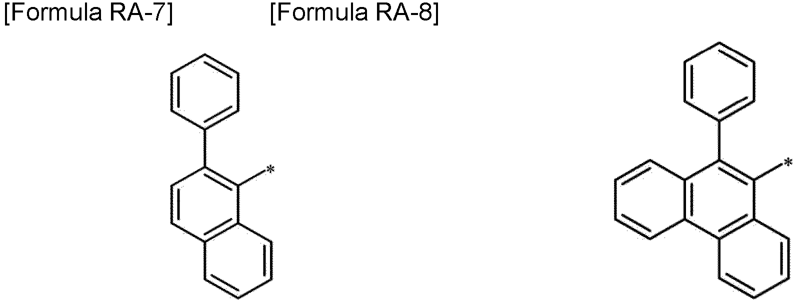

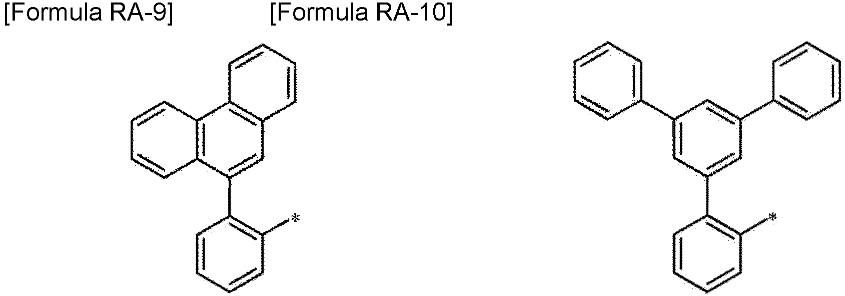

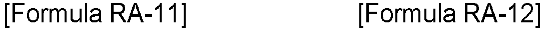

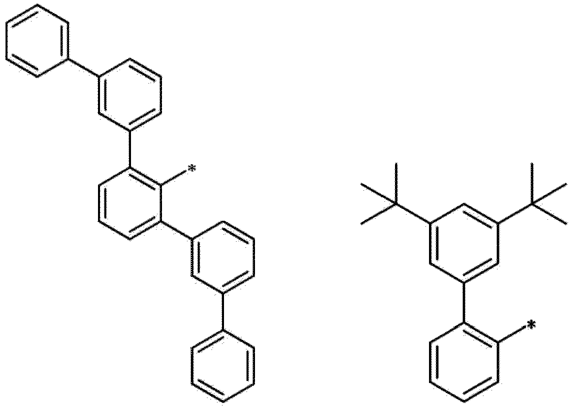

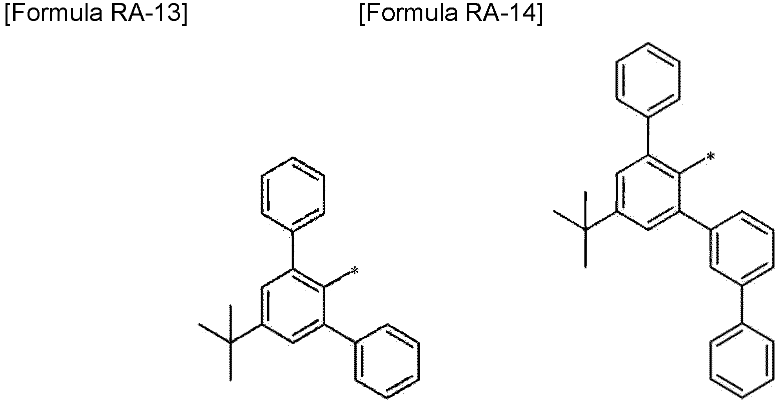

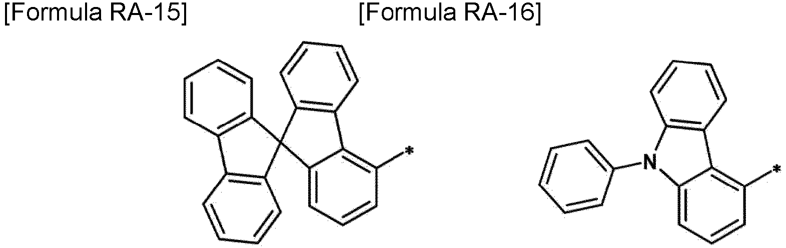

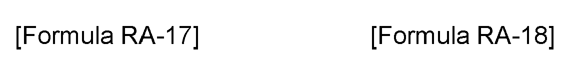

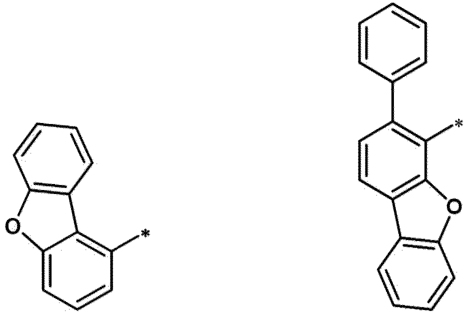

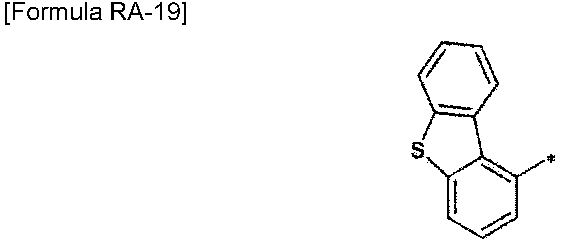

The fused polycyclic compound of one or more embodiments may include a deuterium atom. For example, the deuterium atom may be directly bonded to a nonacyclic fused ring containing two nitrogen atoms and one boron atom in Formula 1. In one or more embodiments, the deuterium atom may be included as a substituent in A₁ to A₄, R₁ to R₁₁, Rₙ, and/or Rₘ of Formula 1 and may be indirectly bonded to a nonacyclic fused ring.

Formula 1 may be represented by Formula 1-1 or Formula 1-2. Formula 1-1 may represent the case where A₃ and A₄ are direct linkages in Formula 1. Formula 1-2 may represent the case where A₃ and A₄ are not direct linkages in Formula 1.

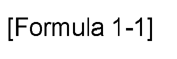

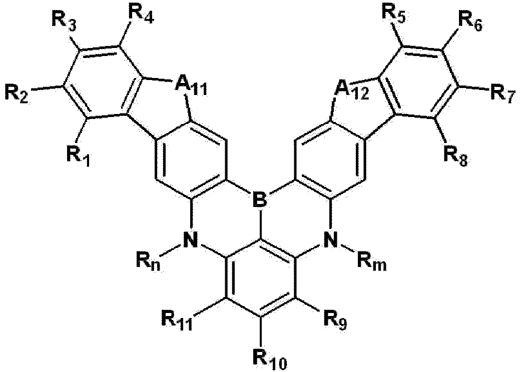

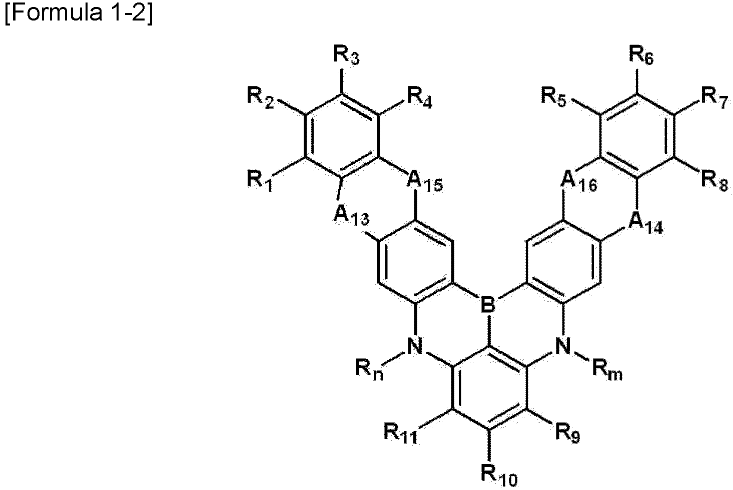

In Formula 1-1, A₁₁ and A₁₂ may correspond to A₁ and A₂ in Formula 1, respectively. In Formula 1-2, A₁₅ and A₁₆ may correspond to A₁ and A₂ in Formula 1, respectively.

In Formula 1-1, A₁₁ and A₁₂ may each independently be NR_{b1}, O, S, CR_{b2}R_{b3}, or SiR_{b4}R_{b5}. In Formula 1-2, A₁₃ to A₁₆ may each independently be NR_{b6}, O, S, CR_{b7}R_{b8}, or SiR_{b9}R_{b10}. When A₁₅ is CR_{b7}R_{b8}, A₁₃ may be NR_{b6}, O, S, or SiR_{b9}R_{b10}. When A₁₅ is CR_{b7}R_{b8}, A₁₃ is not CR_{b7}R_{b8}. In Formula 1-2, the case where A₁₃ to A₁₆ are each independently CR_{b7}R_{b8} and a case in which R_{b7} and R_{b8} are alkyl groups is excluded (i.e., R_{b7} and R_{b8} are each not an alkyl group). In Formula 1-1 and Formula 1-2, the same as described in Formula 1 may be applied to R₁ to R₁₁, R_{b1} to R_{b10}, Rₙ, and Rₘ.

Formula 1-1 may be represented by any one selected from among Formula 1-1A to Formula 1-1D. Formula 1-1A may represent the case where A₁₁ and A₁₂ in Formula 1-1 are each independently NR_{b1}. Formula 1-1B may represent the case where A₁₁ and A₁₂ in Formula 1-1 are each O. Formula 1-1C may represent the case where A₁₁ and A₁₂ in Formula 1-1 are each S. Formula 1-1D may represent the case where any one of A₁₁ and A₁₂ in Formula 1-1 is NR_{b1}, and the other is O, S, or CR_{b2}R_{b3}.

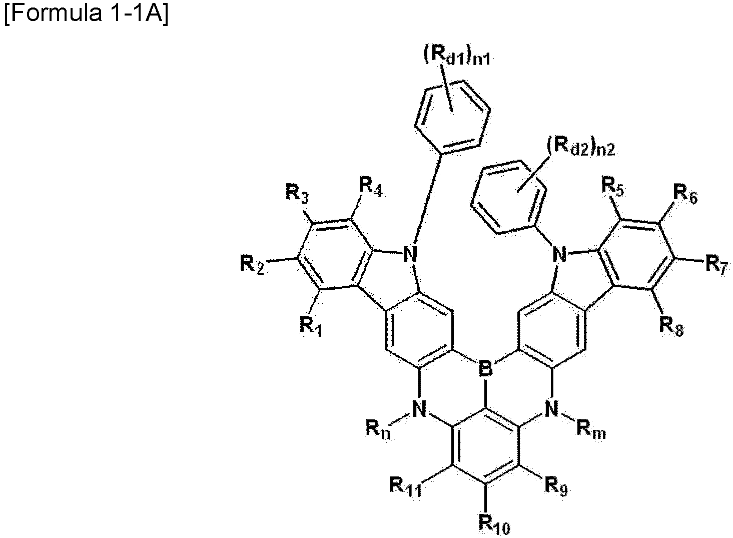

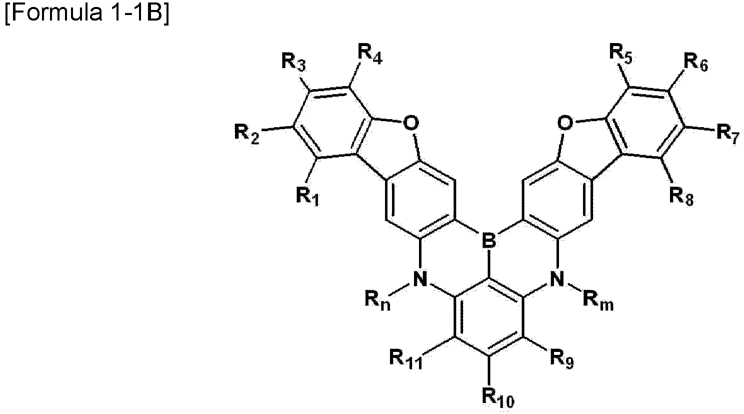

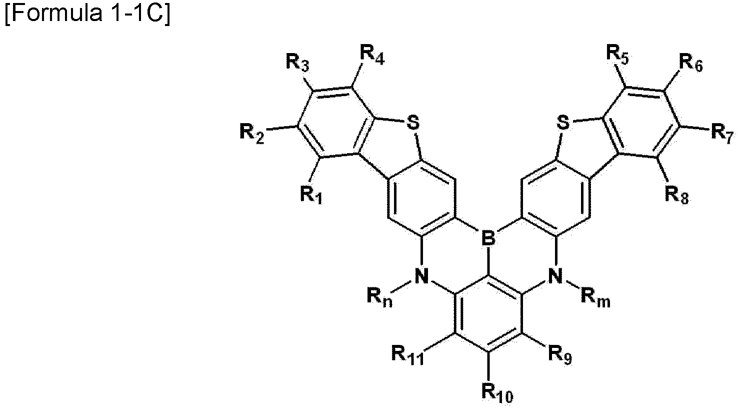

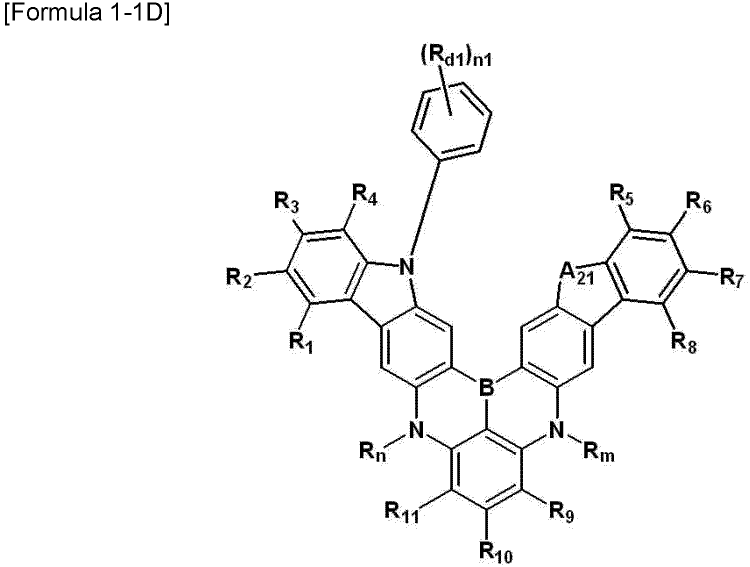

In Formula 1-1A and Formula 1-1D, n1 and n2 may each independently be an integer of 0 to 5. R_{d1} and R_{d2} may each independently be a hydrogen atom, a deuterium atom, or a substituted or unsubstituted aryl group having 6 to 30 ring-forming carbon atoms. When n1 is an integer of 2 or greater, a plurality of R_{d1}'s may be the same as each other or at least one may be different from the others. The case where n1 is 0 may be the same as the case where n1 is 5 and five R_{d1}'s are hydrogen atoms. When n2 is an integer of 2 or greater, a plurality of R_{d2}'s may be the same as each other or at least one may be different from the others. The case where n2 is 0 may be the same as the case where n2 is 5 and five R_{d2}'s are hydrogen atoms.

In Formula 1-1D, A₂₁ may be O, S, or CR_{b2}R_{b3}. For example, A₂₁ may be CR_{b2}R_{b3}, and R_{b2} and R_{b3} may each independently be a substituted or unsubstituted methyl group, or a substituted or unsubstituted phenyl group.

In Formula 1-1A to Formula 1-1D, the same as described in Formula 1-1 may be applied to R₁ to R₁₁, R_{b2}, R_{b3}, Rₙ, and Rₘ.

Formula 1-1 may be represented by Formula 1-1E. Formula 1-1E may represent the case where R₂ and R₃ are bonded to form a ring and R₆ and R₇ are bonded to form a ring in Formula 1-1.

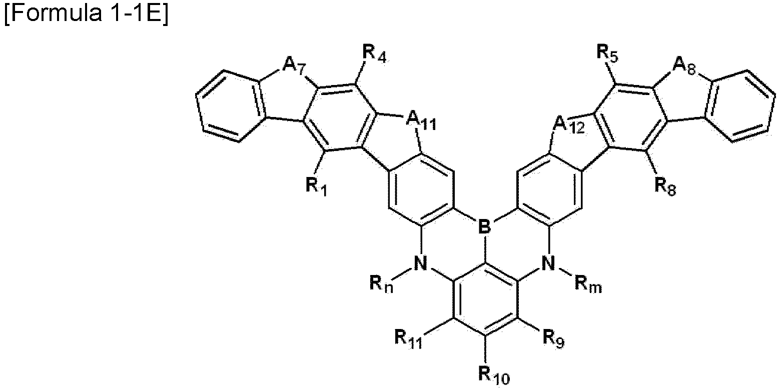

In Formula 1-1E, the same as described in Formula 1-1 may be applied to A₁₁, A₁₂, R₁, R₄, R₅, R₈ to R₁₁, Rₙ, and Rₘ. In Formula 1-1E, A₇ and A₈ may each independently be NR_{b11}, O, or S. R_{b11} may be a substituted or unsubstituted aryl group having 6 to 30 ring-forming carbon atoms.

Formula 1 may be represented by any one selected from among Formula 1-X1 to Formula 1-X4. Formula 1-X1 to Formula 1-X4 may represent the cases where two or more groups in R₉ to R₁₁ are bonded to each other to form a ring in Formula 1.

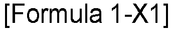

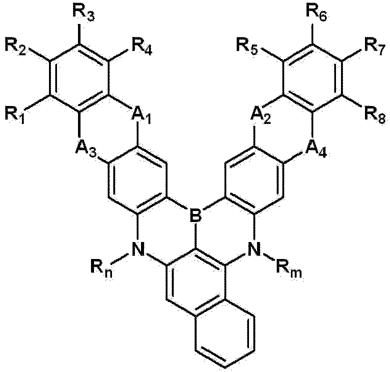

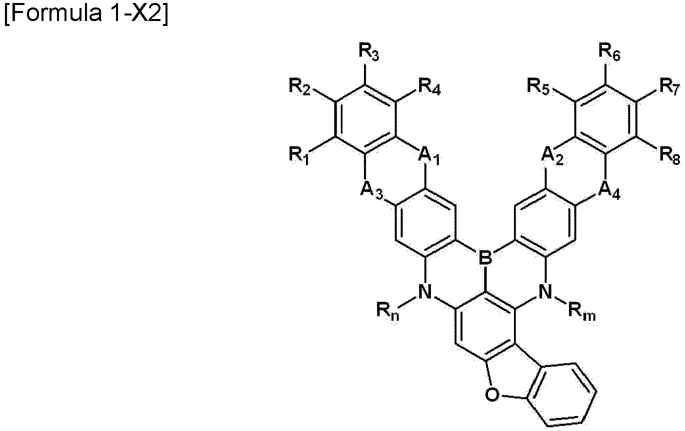

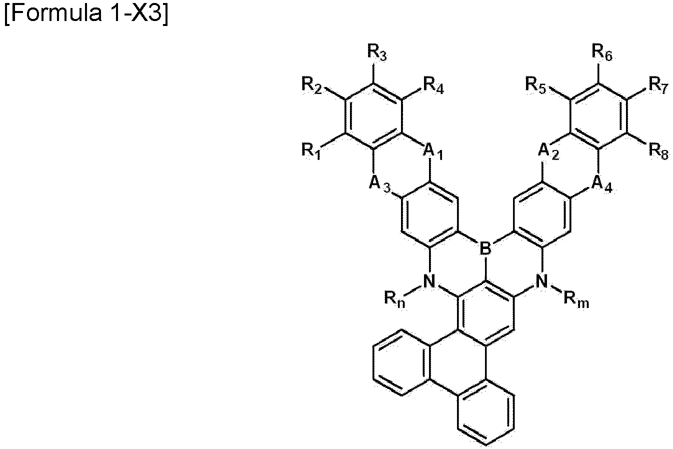

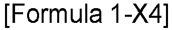

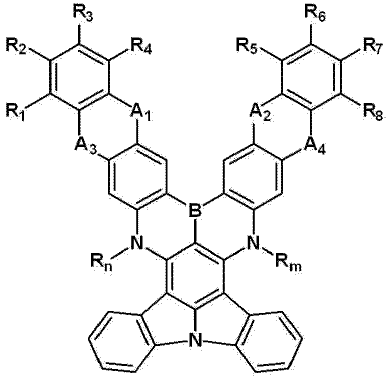

In Formula 1-X1 to Formula 1-X4, the same as described in Formula 1 may be applied to A₁ to A₄, R₁ to R₈, Rₙ, and Rₘ.

Formula 1 may be any one selected from among the compounds of Compound Group 1. The fused polycyclic compound of one or more embodiments may be represented by any one selected from among compounds in Compound Group 1. The light emitting element ED of one or more embodiments may include at least one selected from among the compounds of Compound Group 1. In Compound Group 1, D is a deuterium atom.

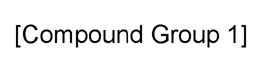

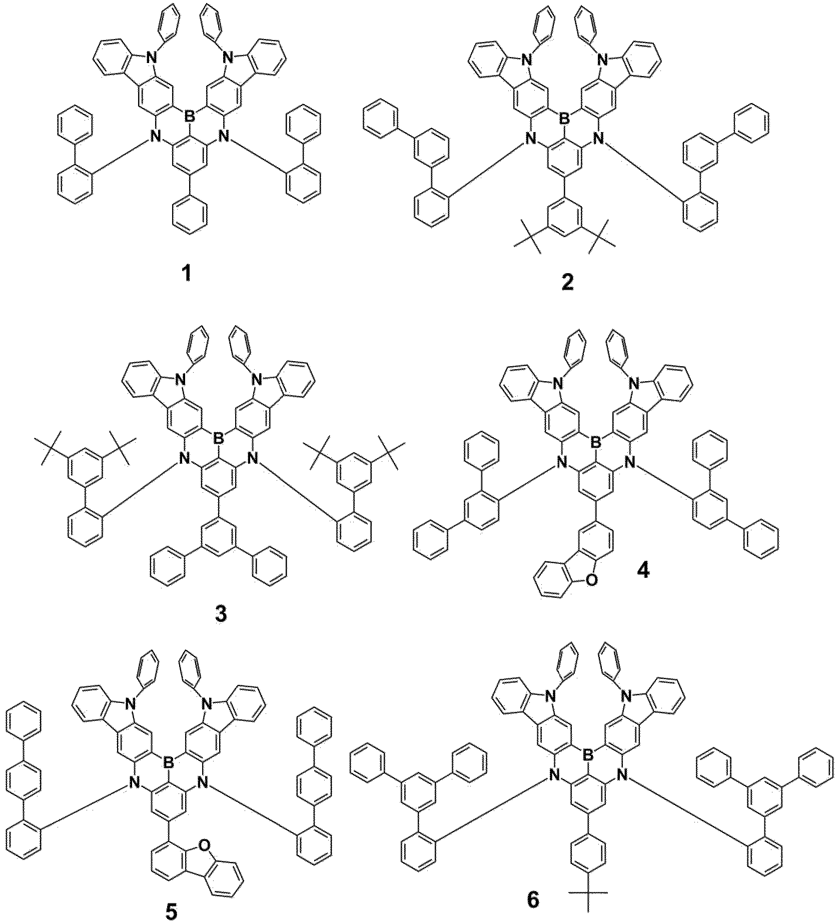

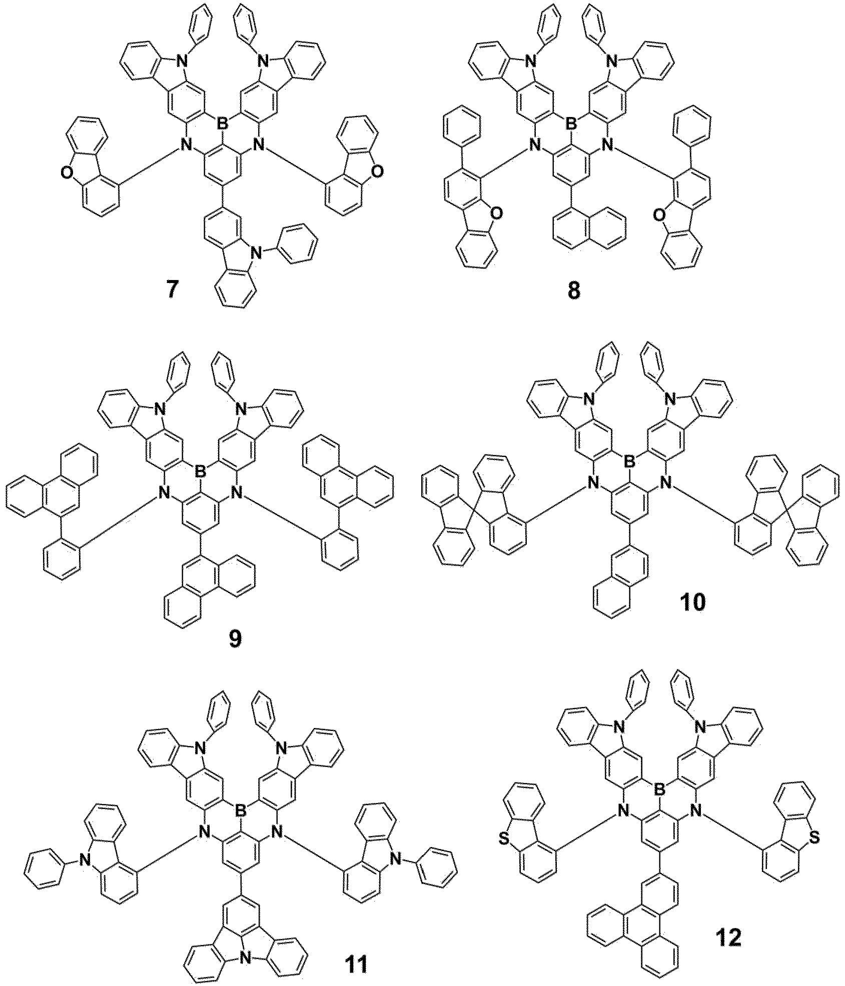

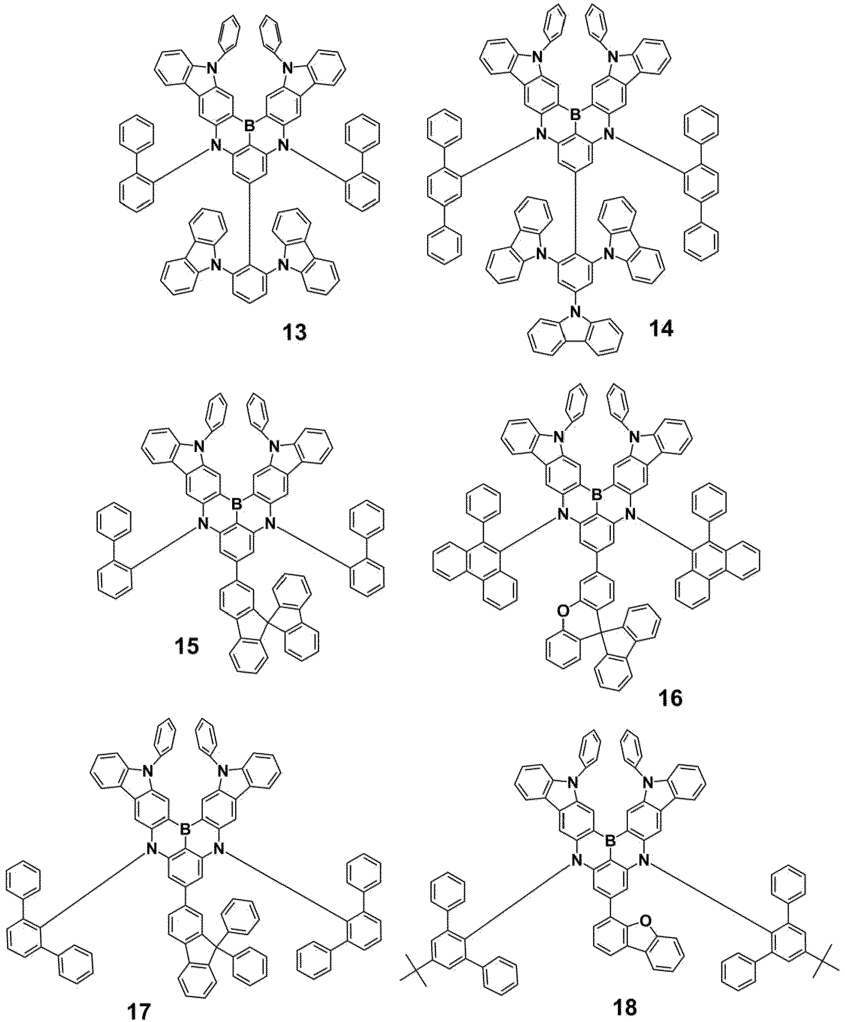

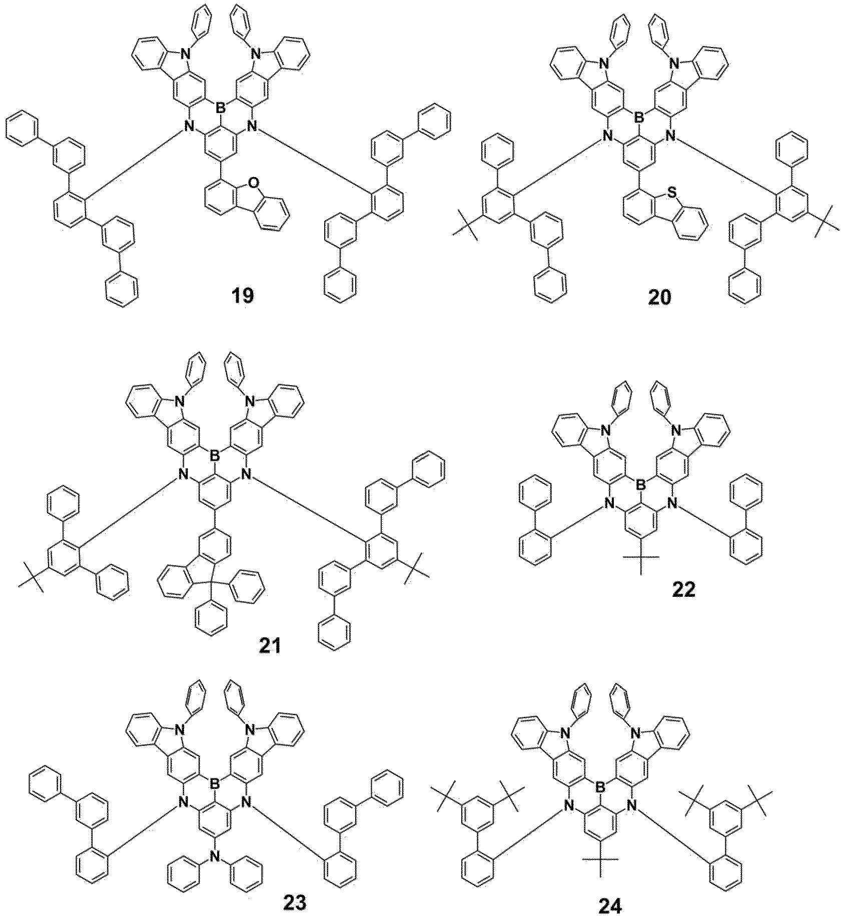

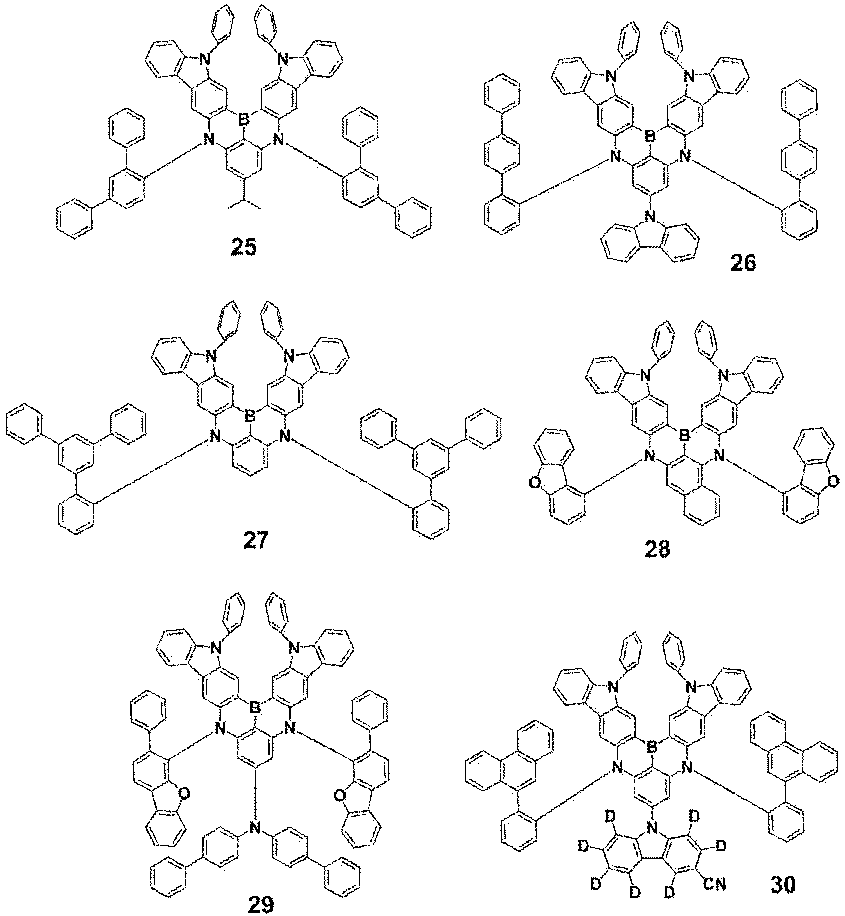

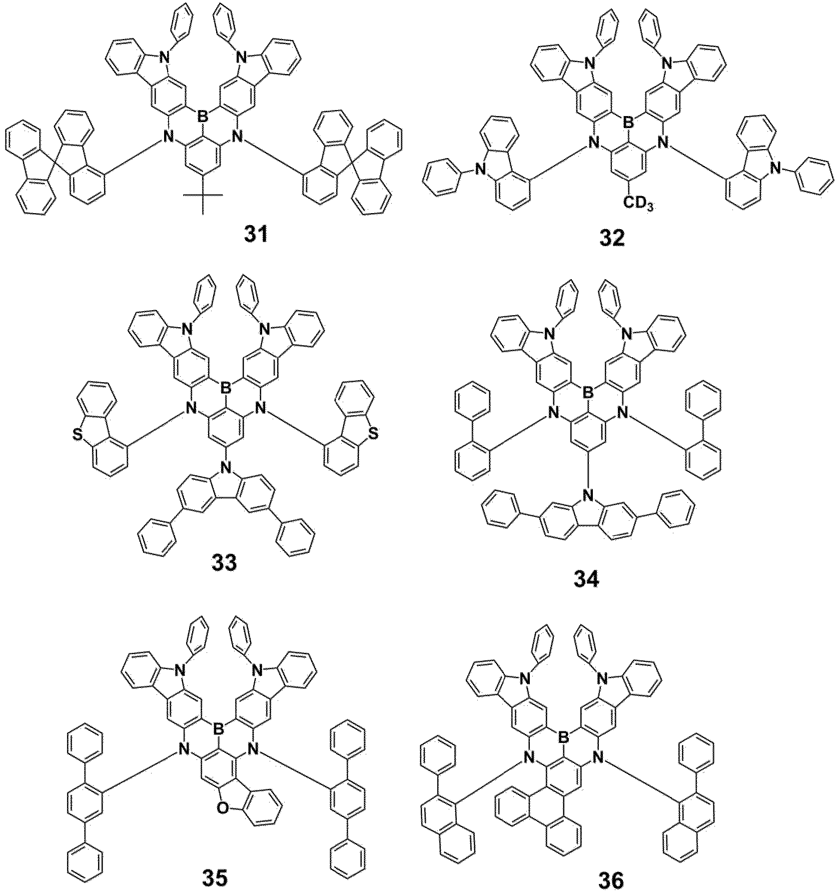

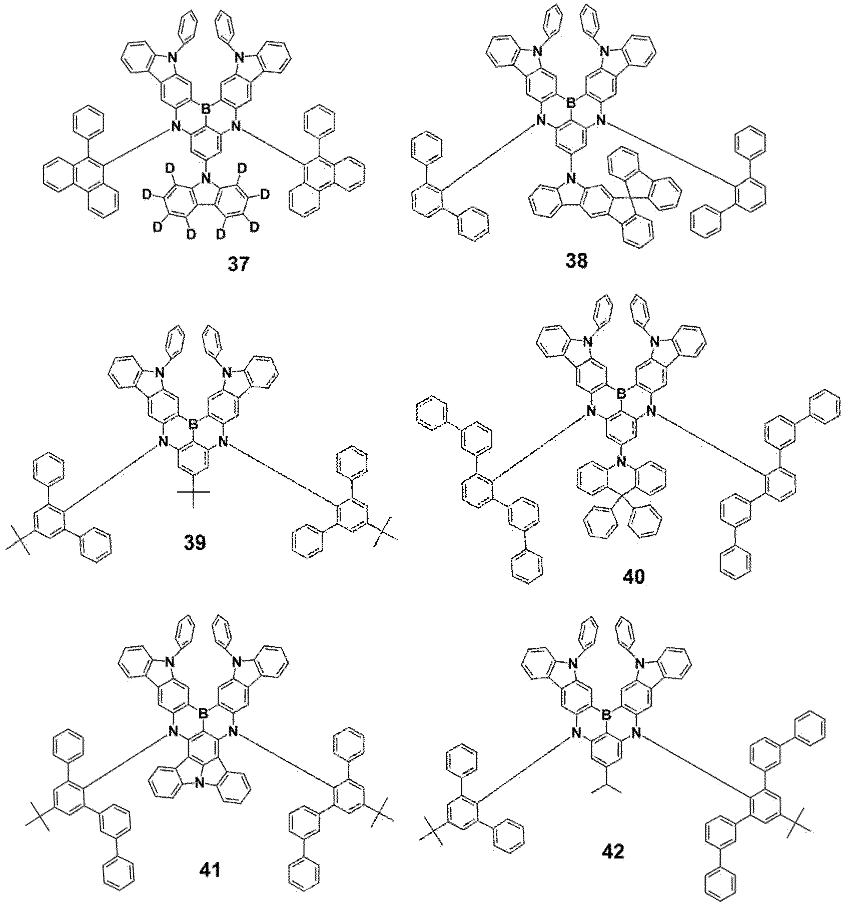

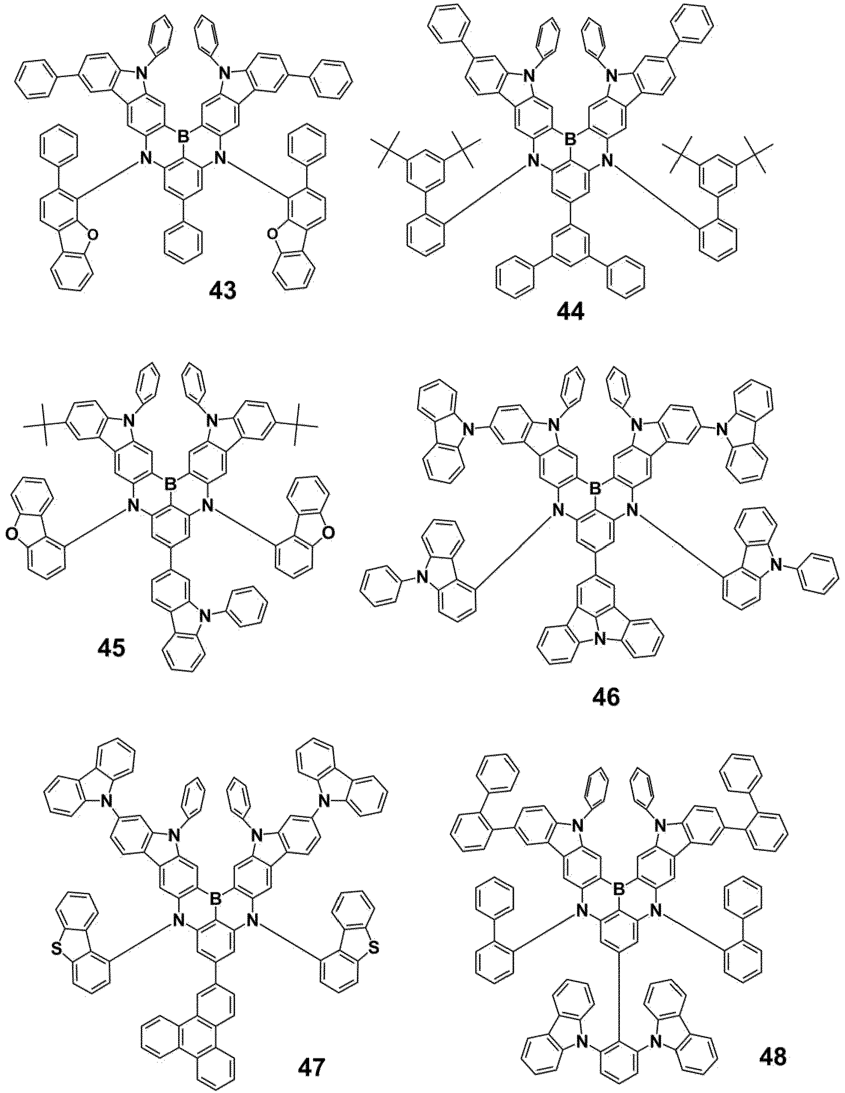

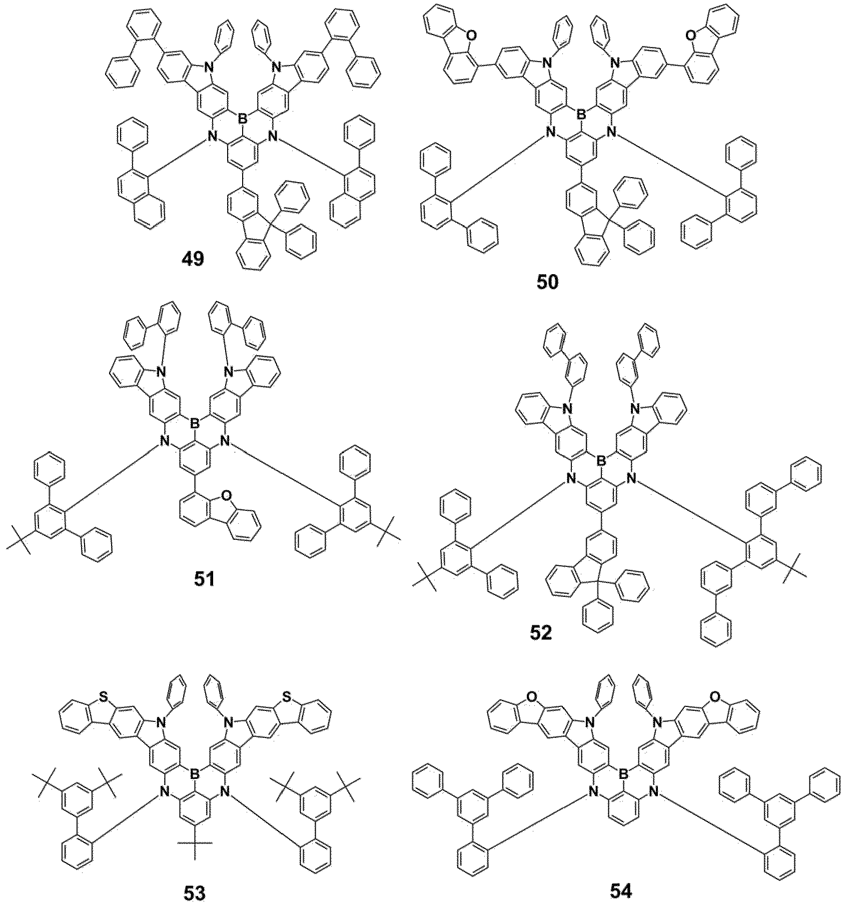

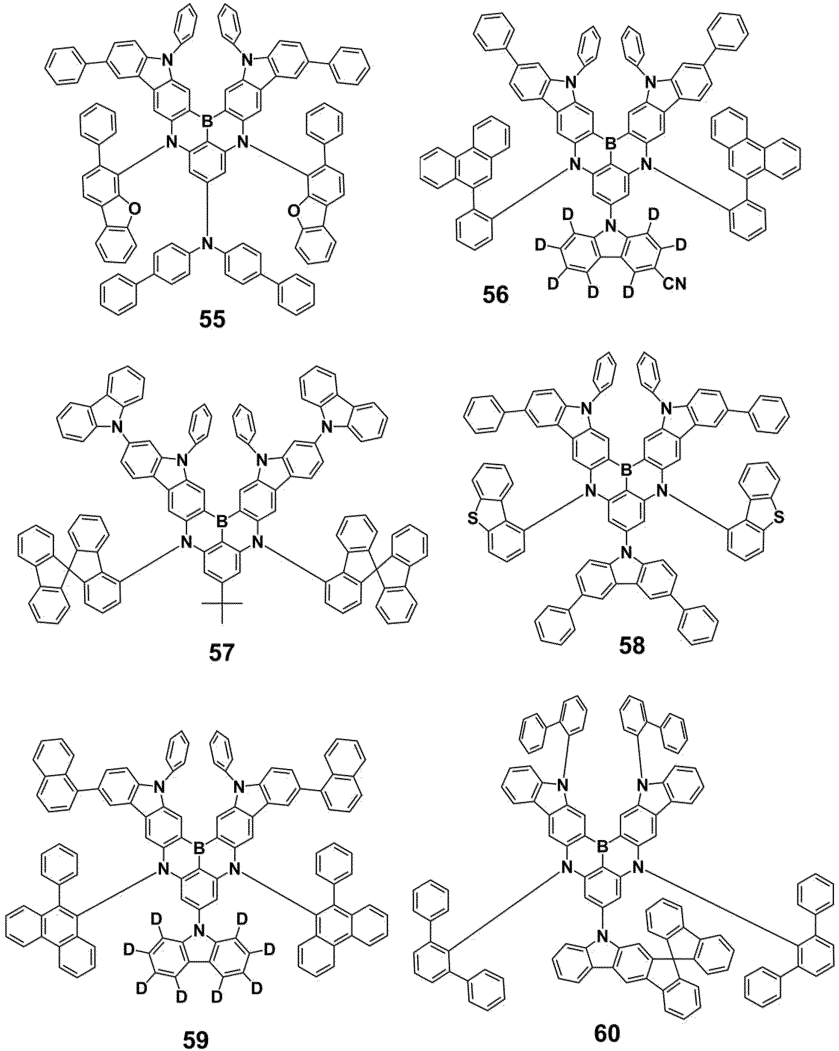

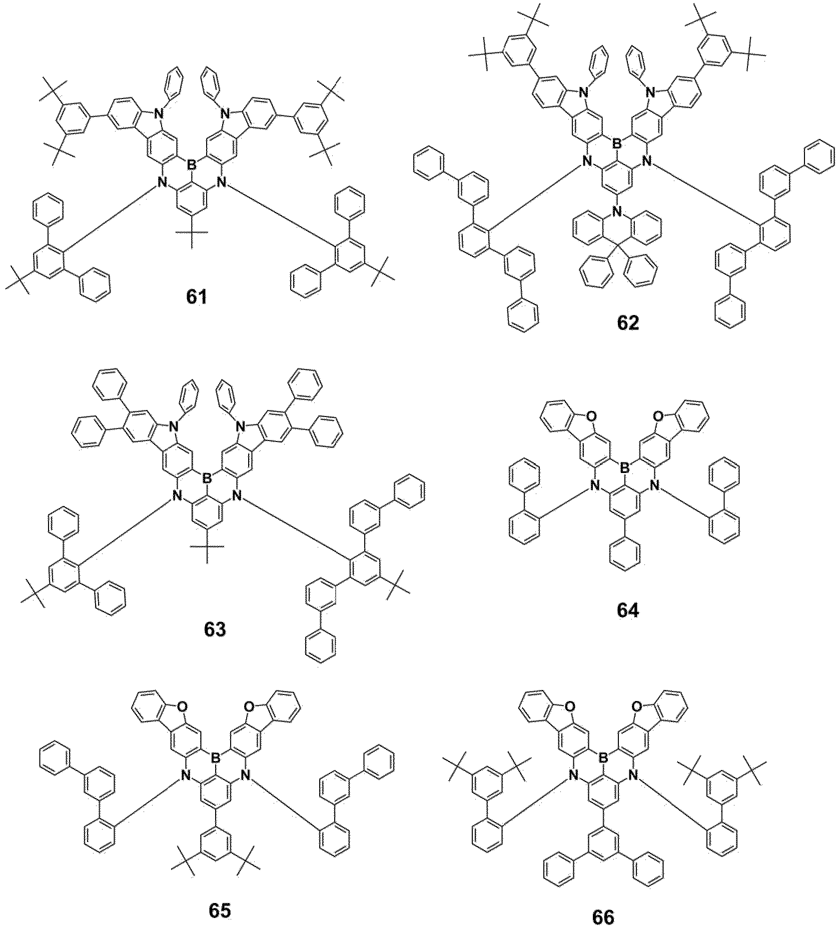

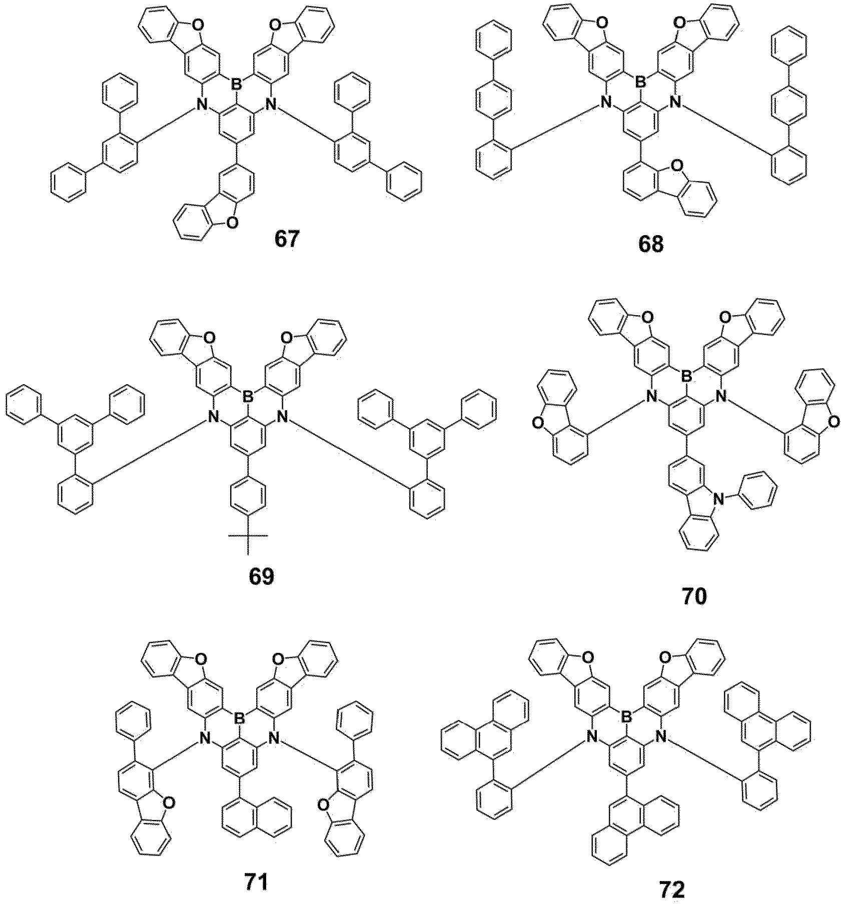

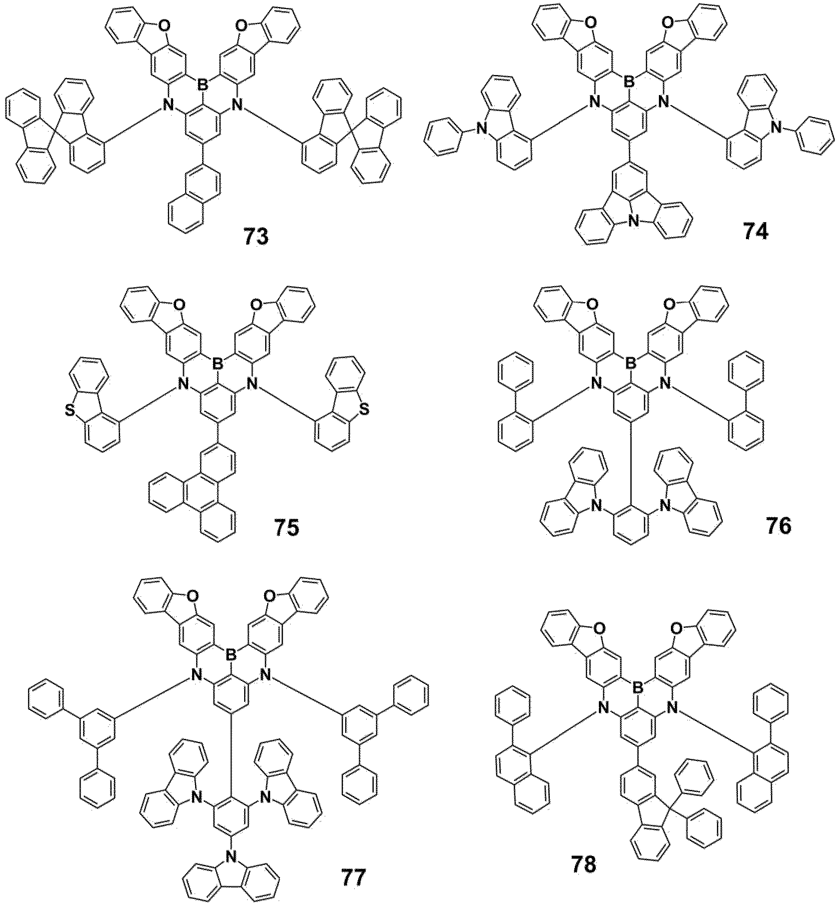

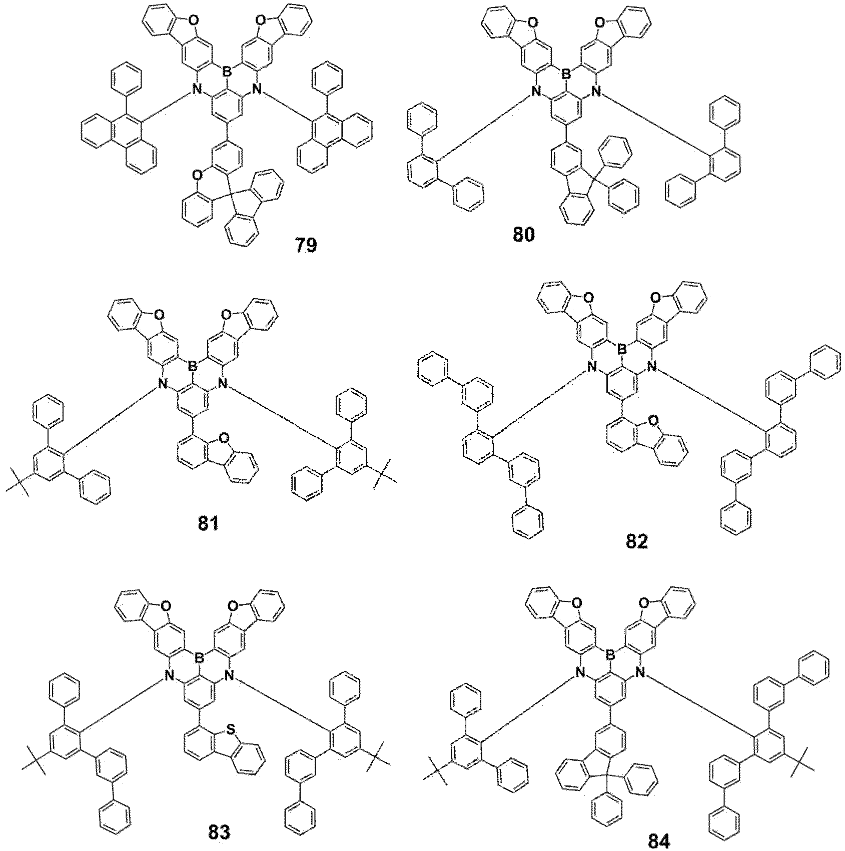

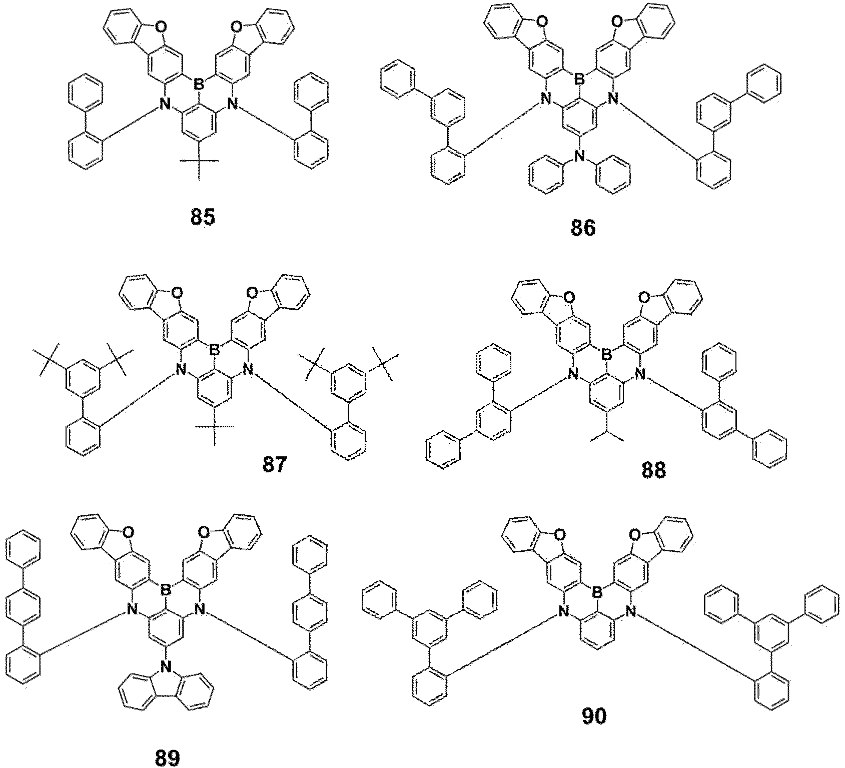

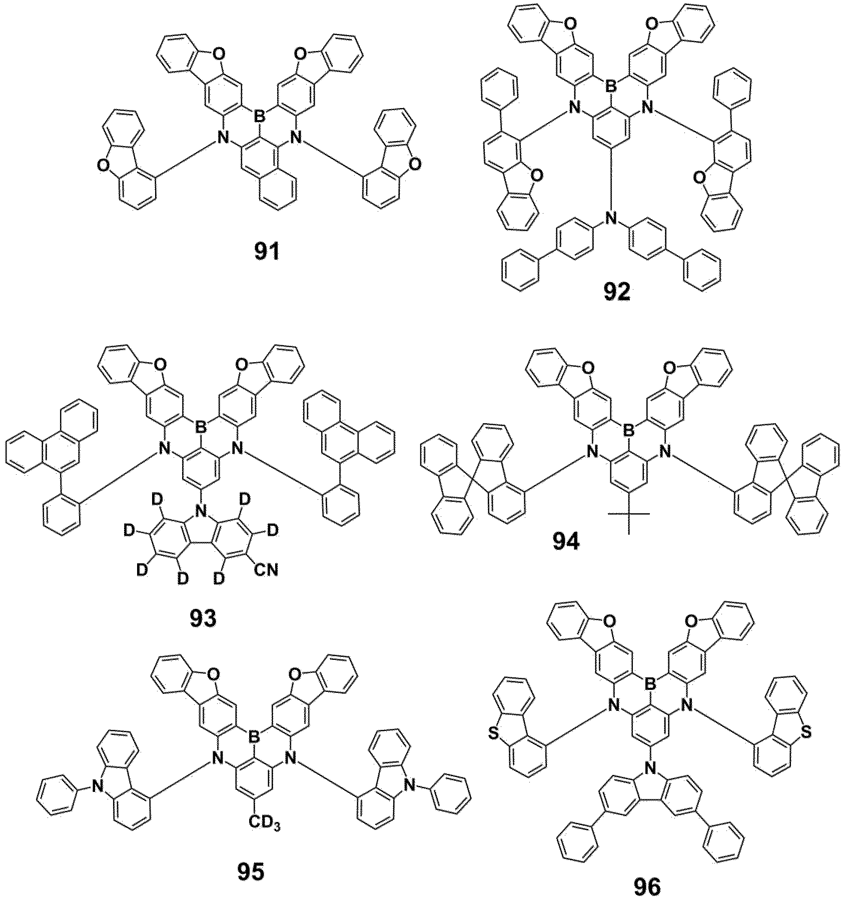

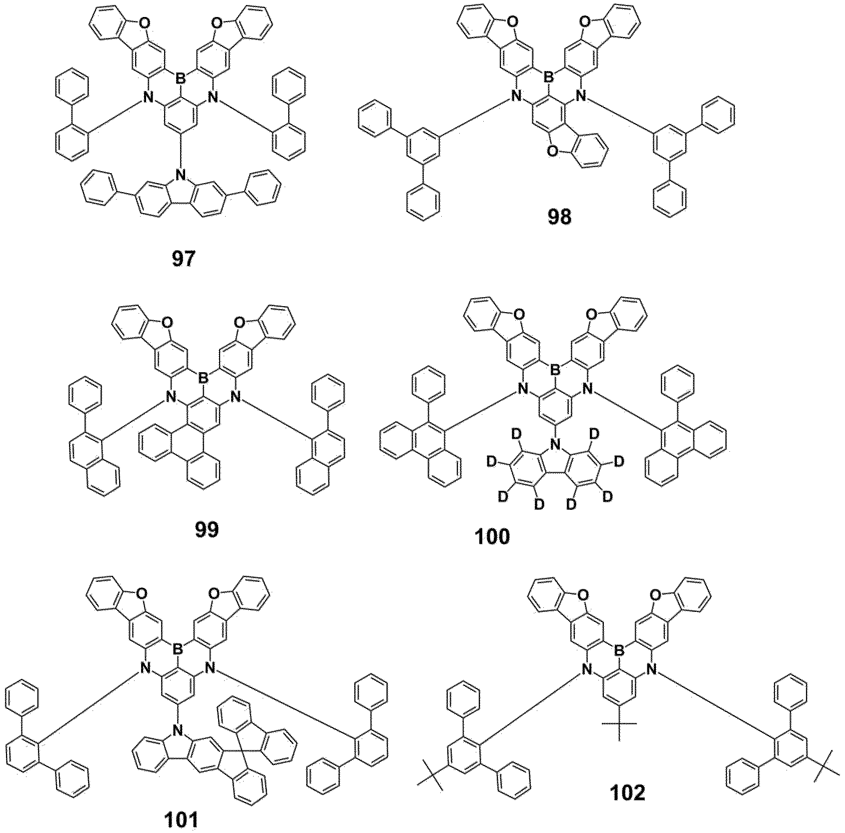

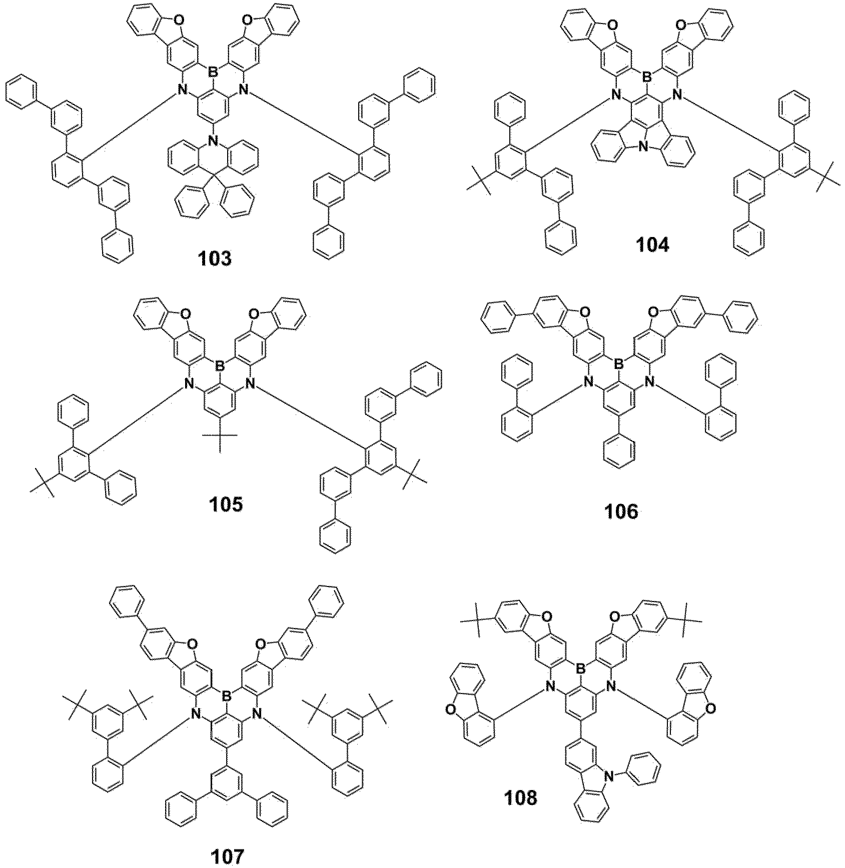

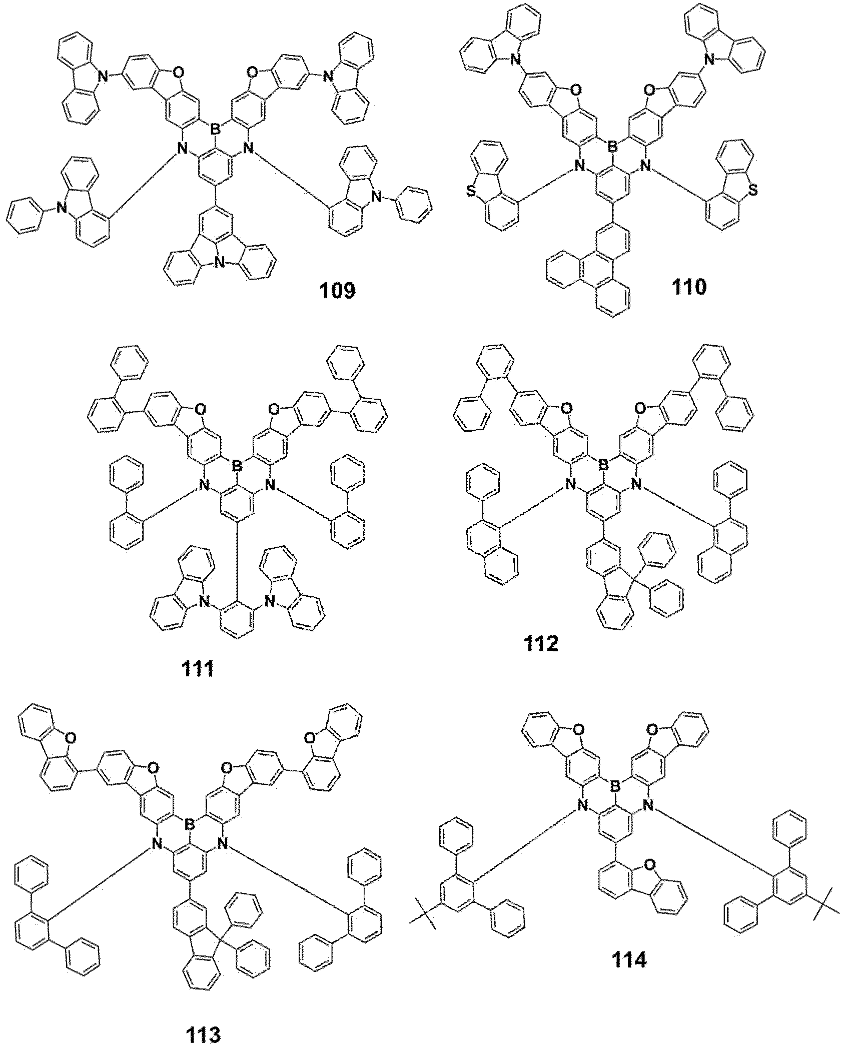

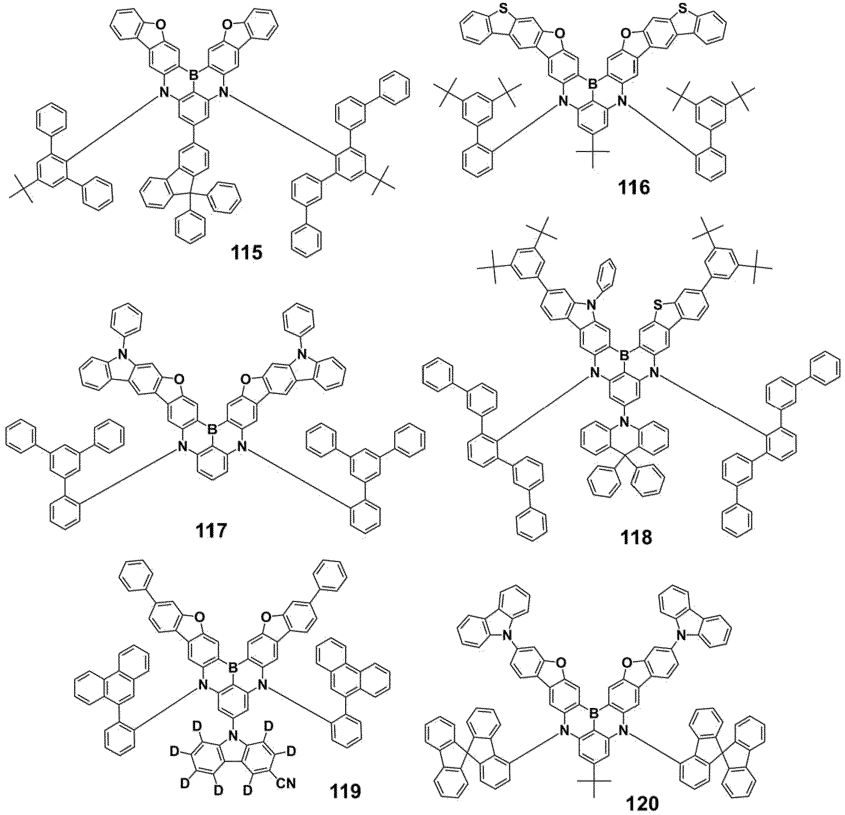

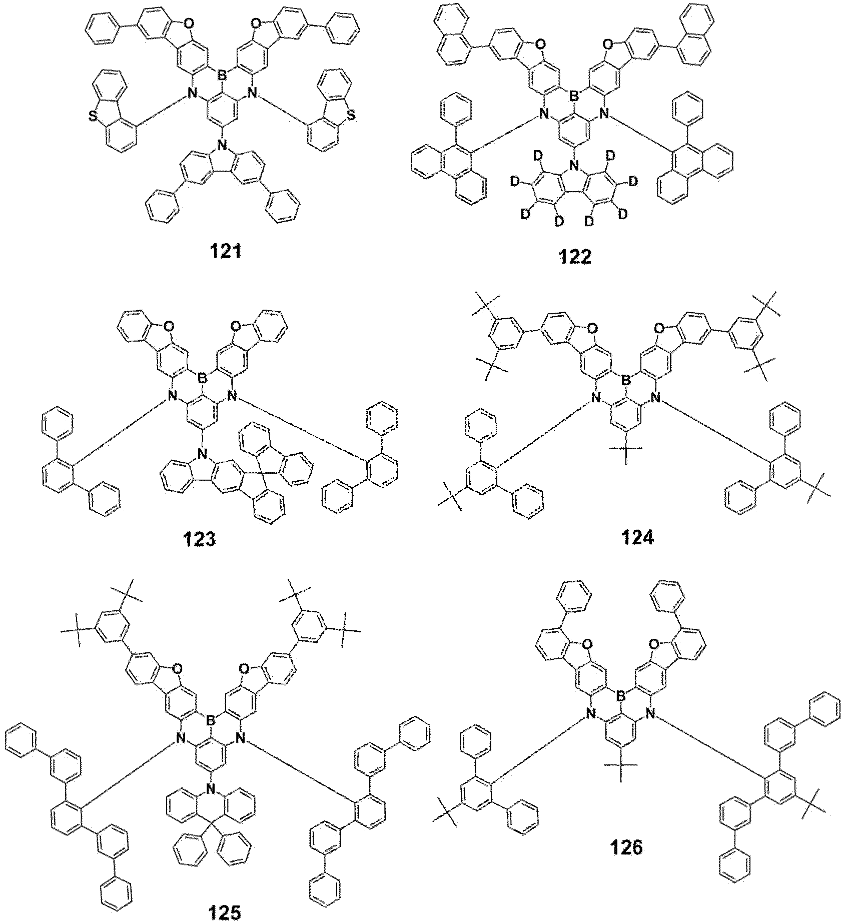

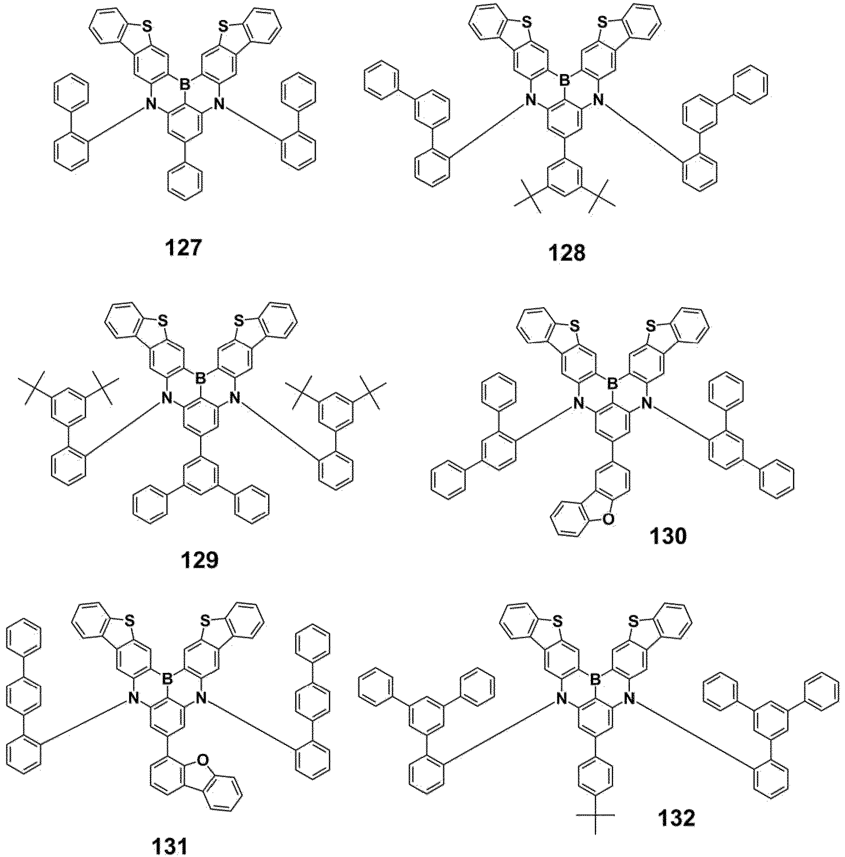

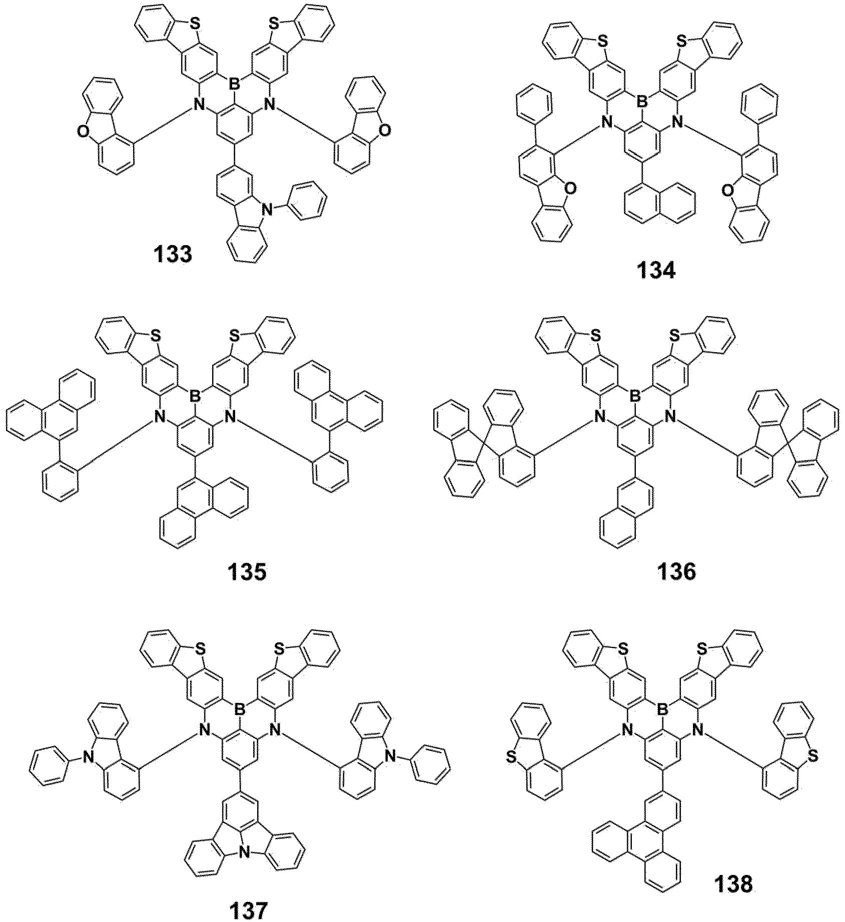

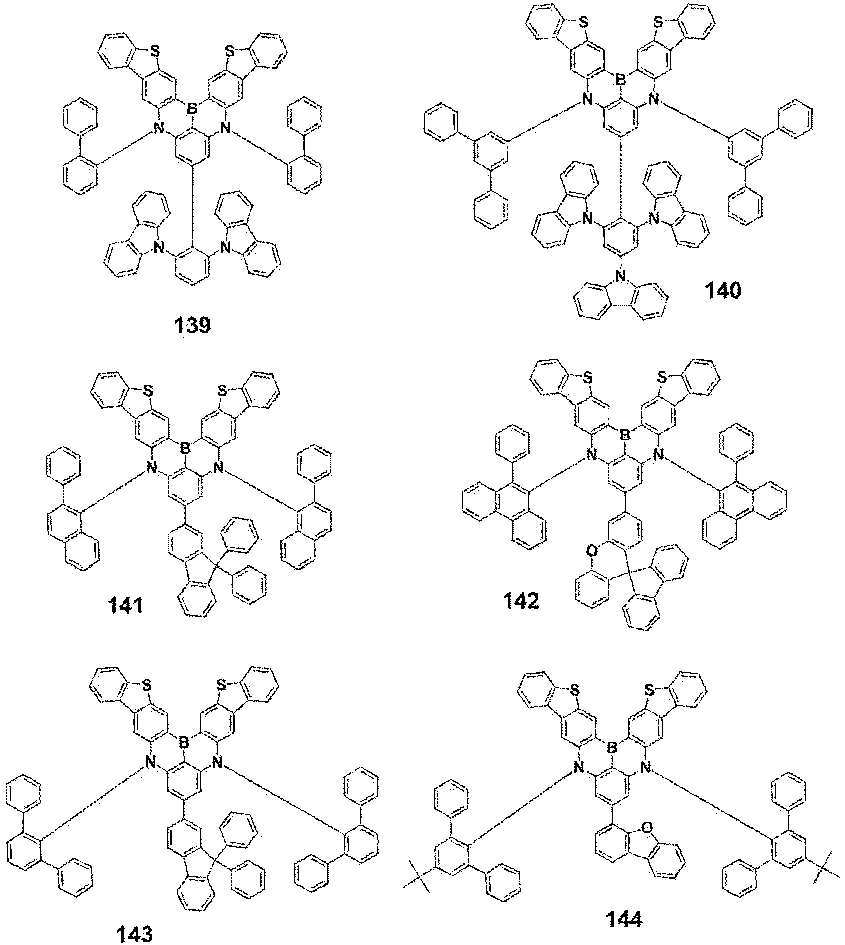

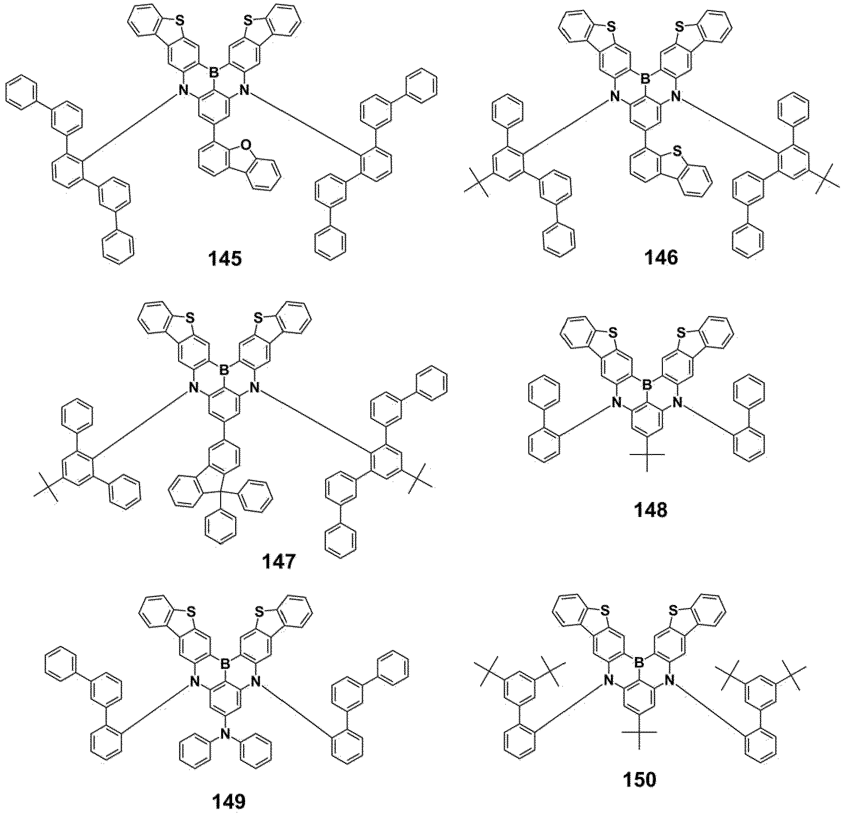

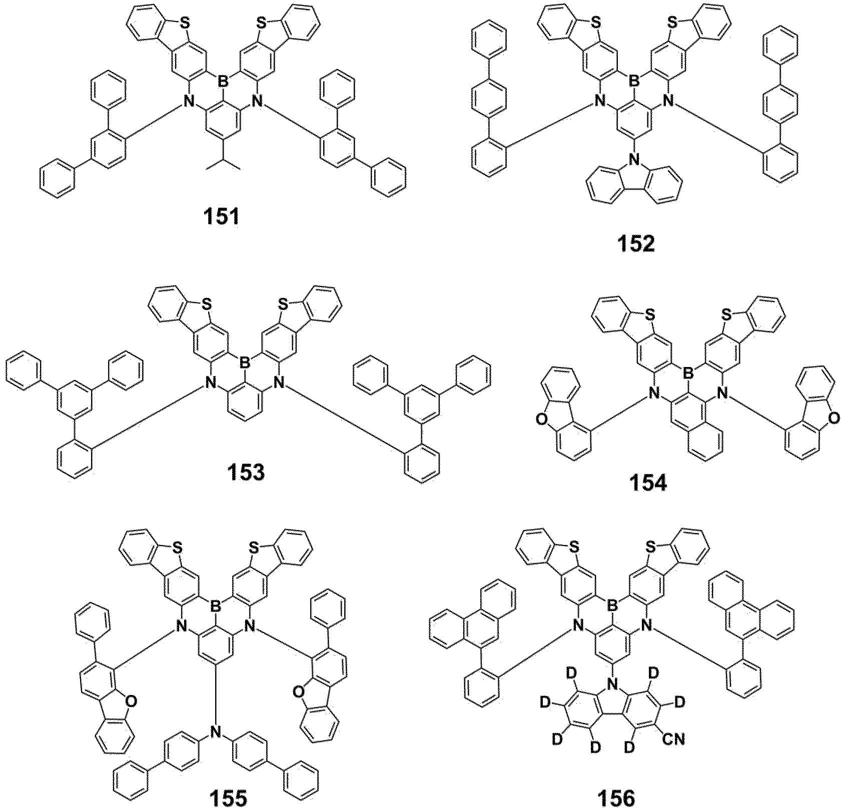

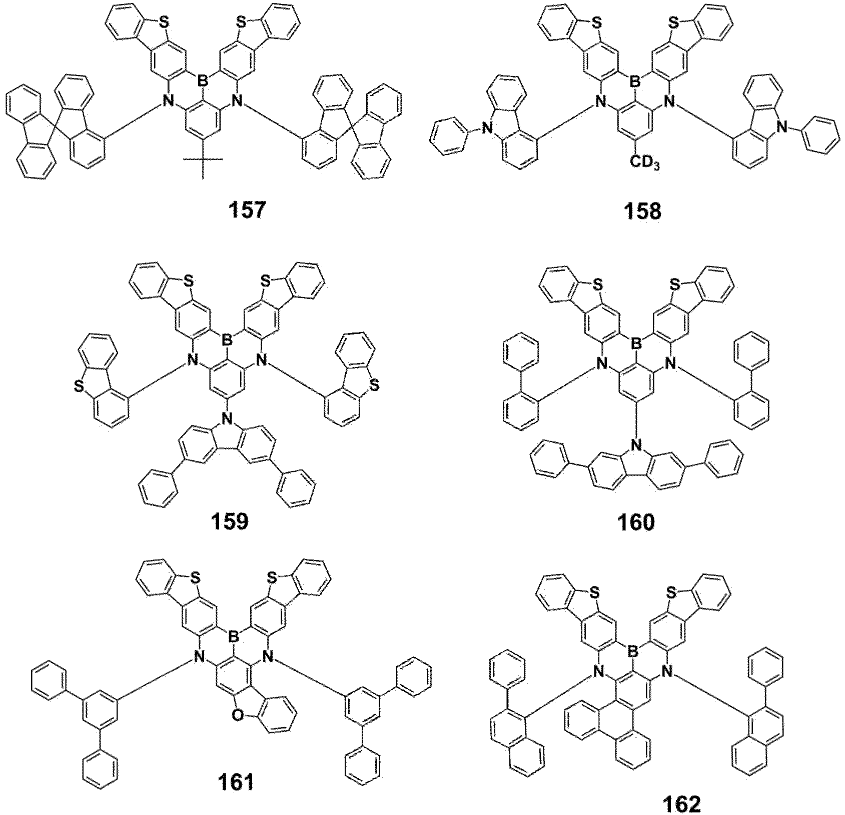

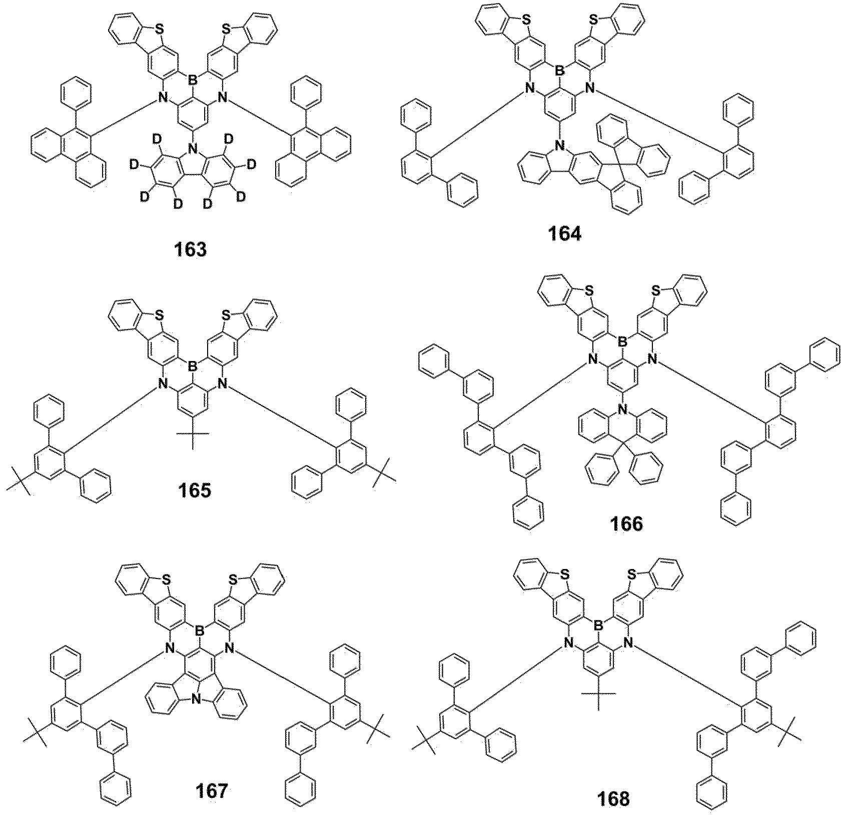

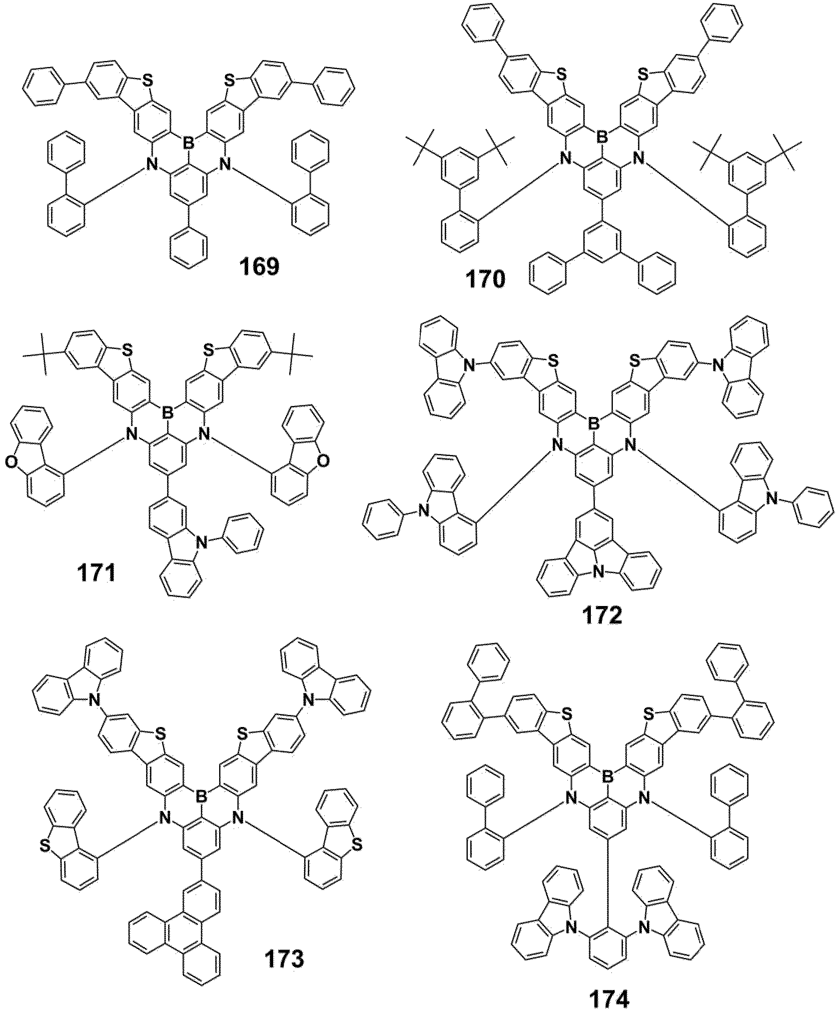

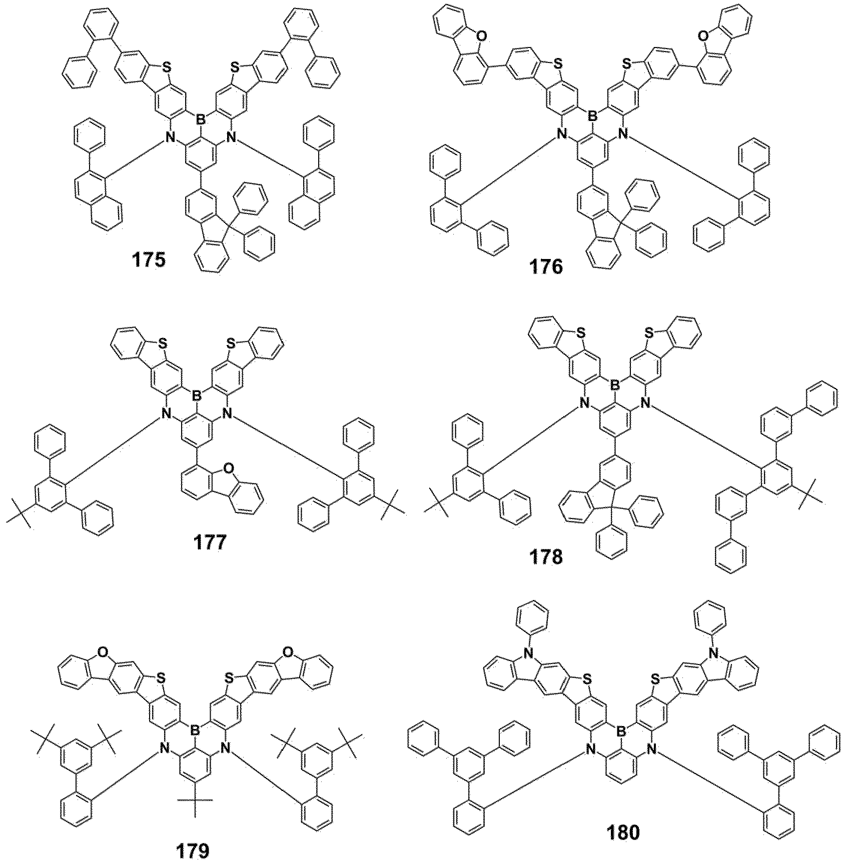

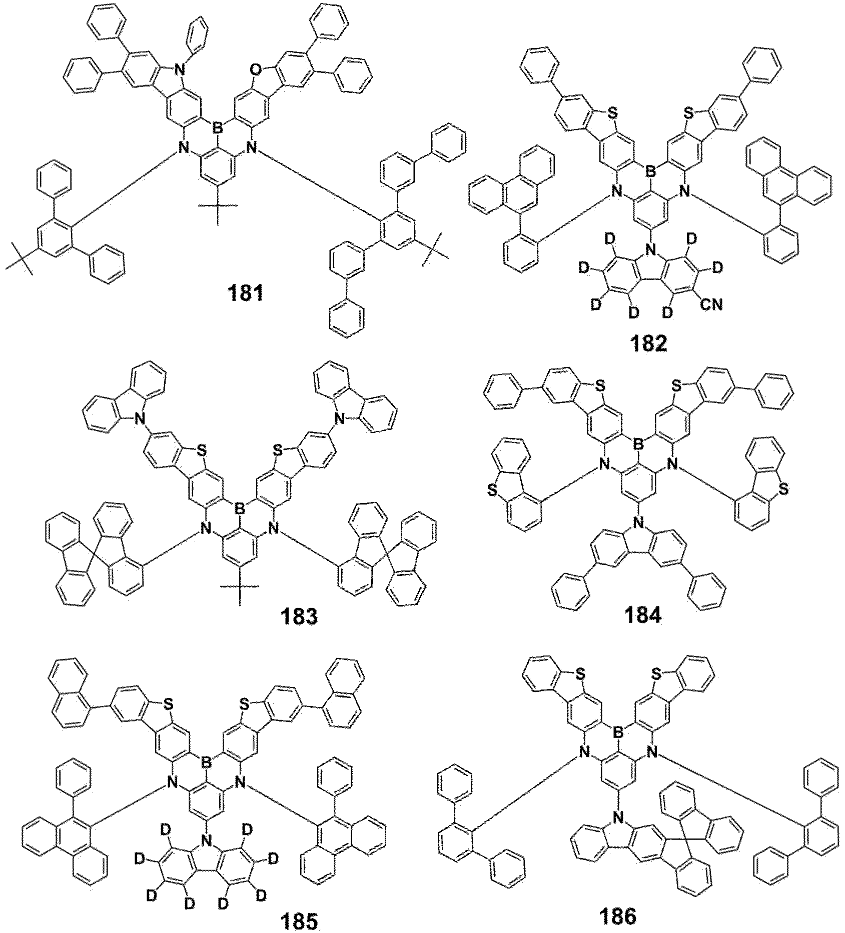

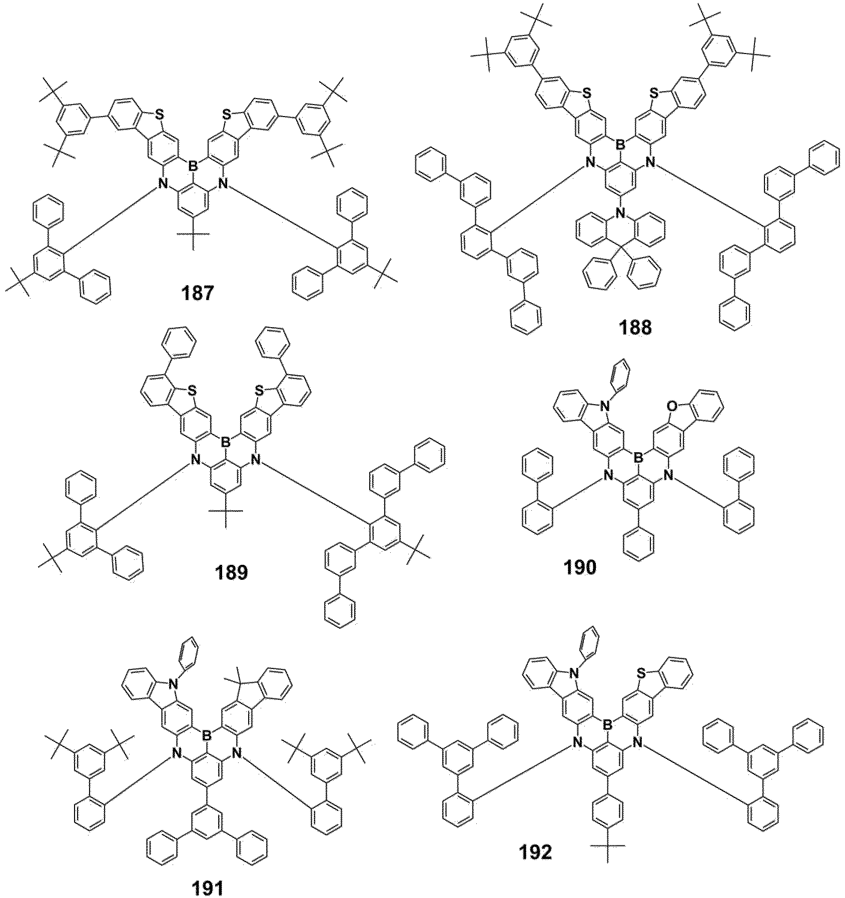

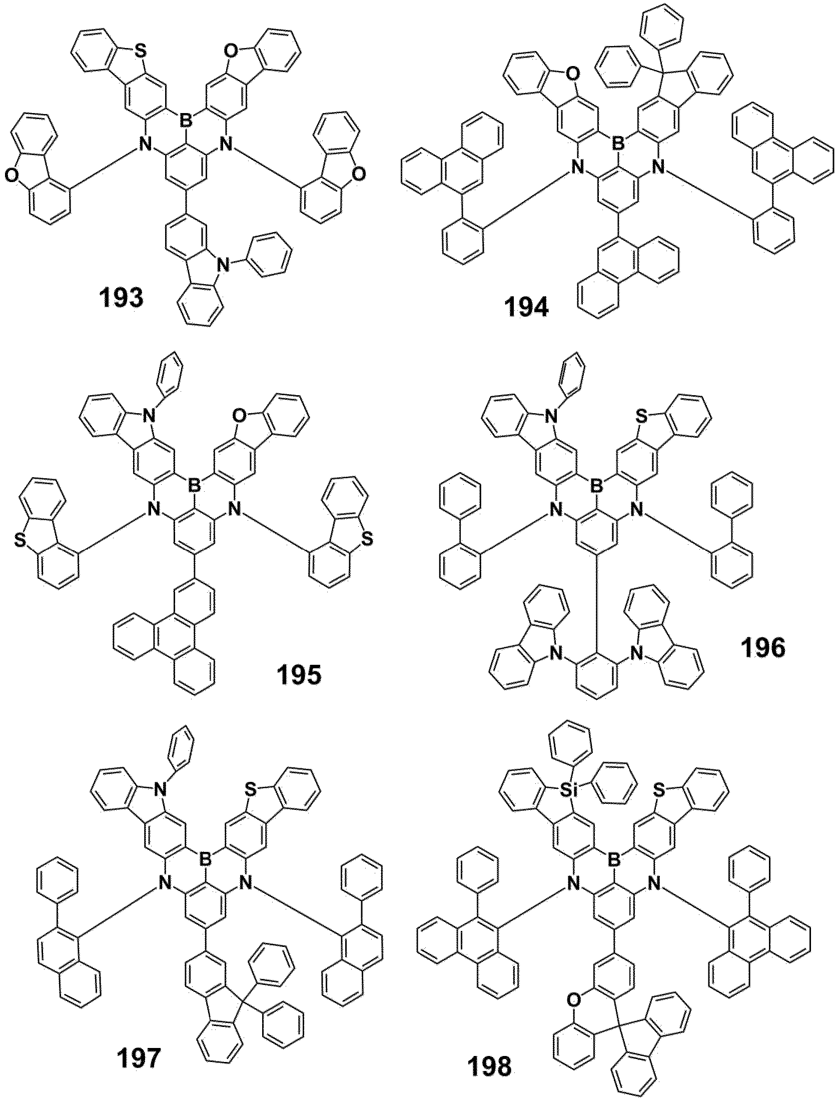

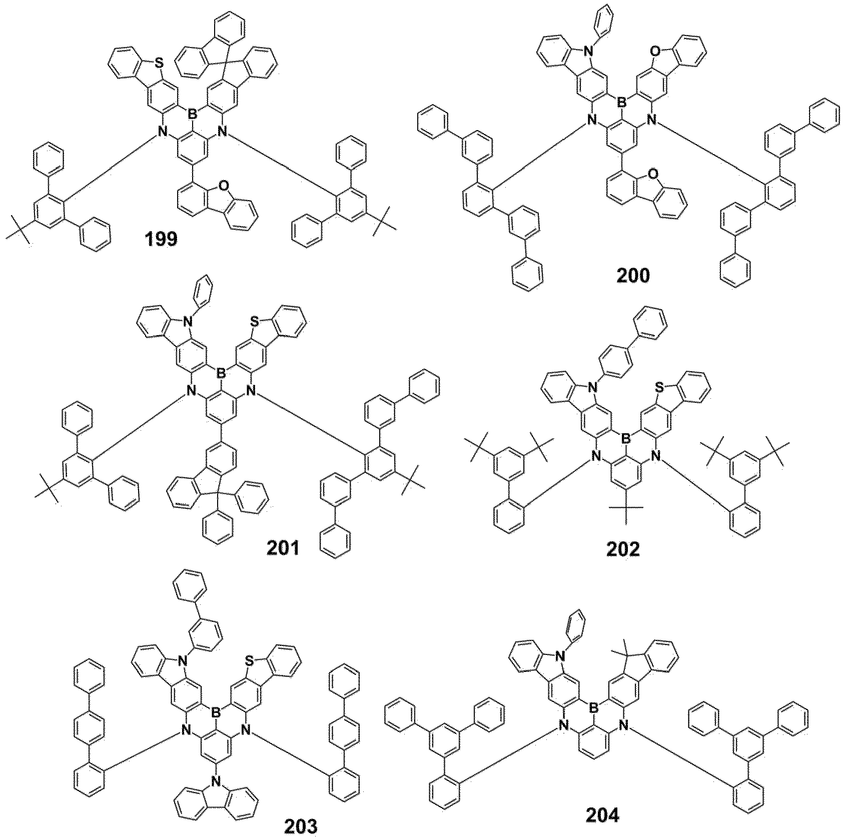

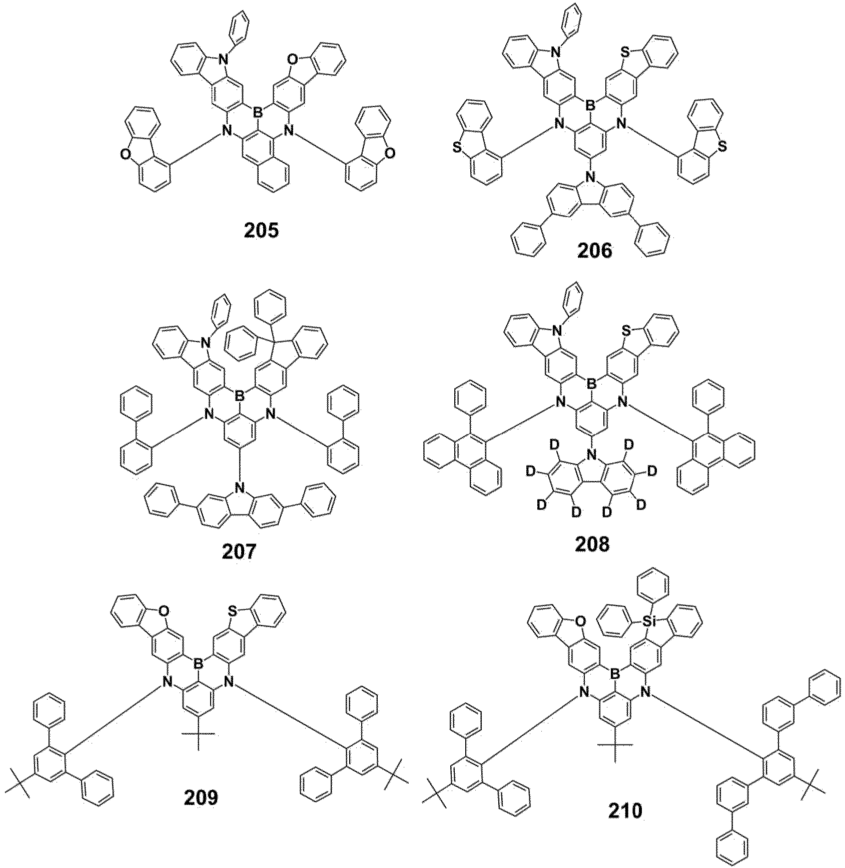

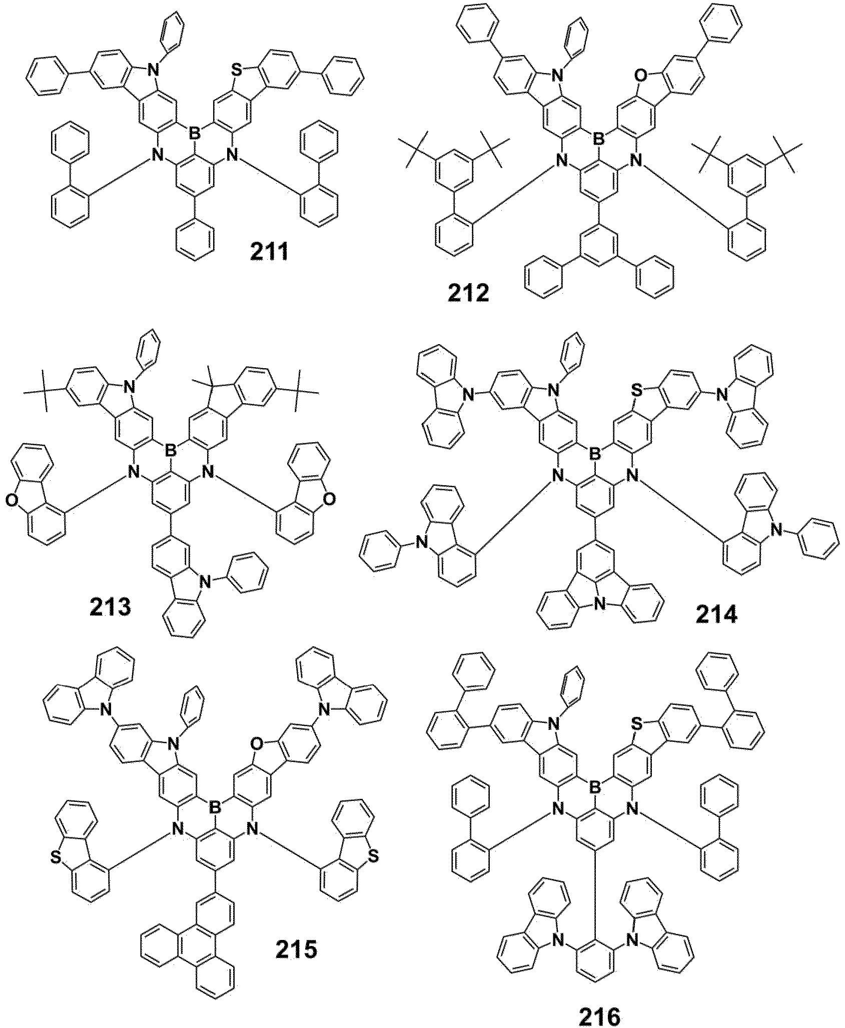

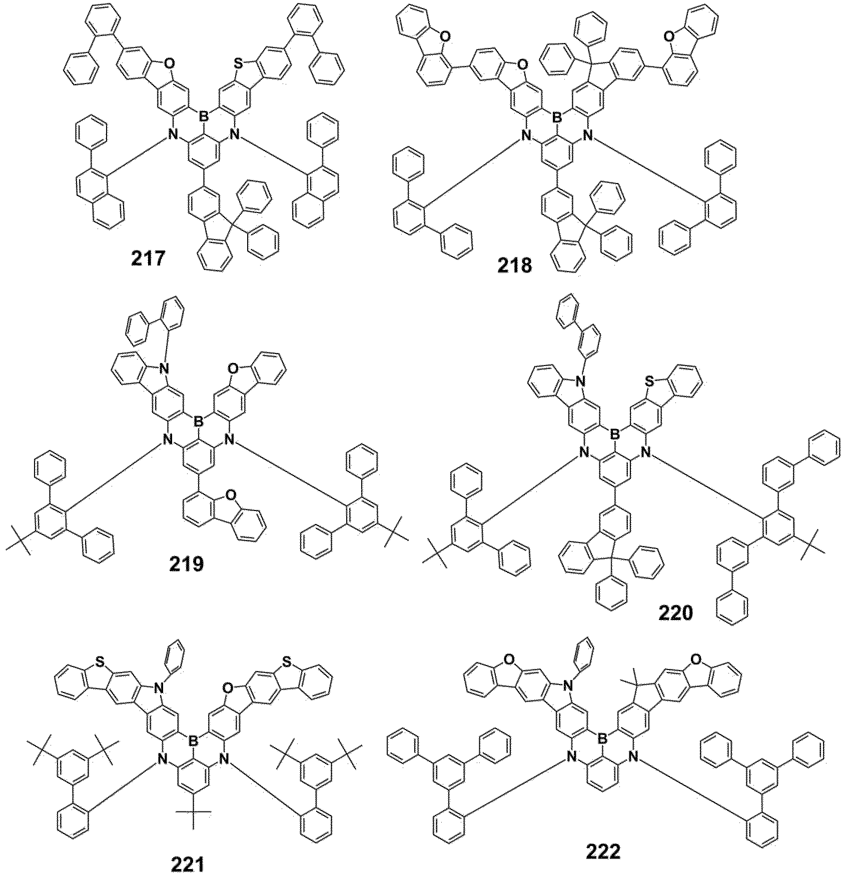

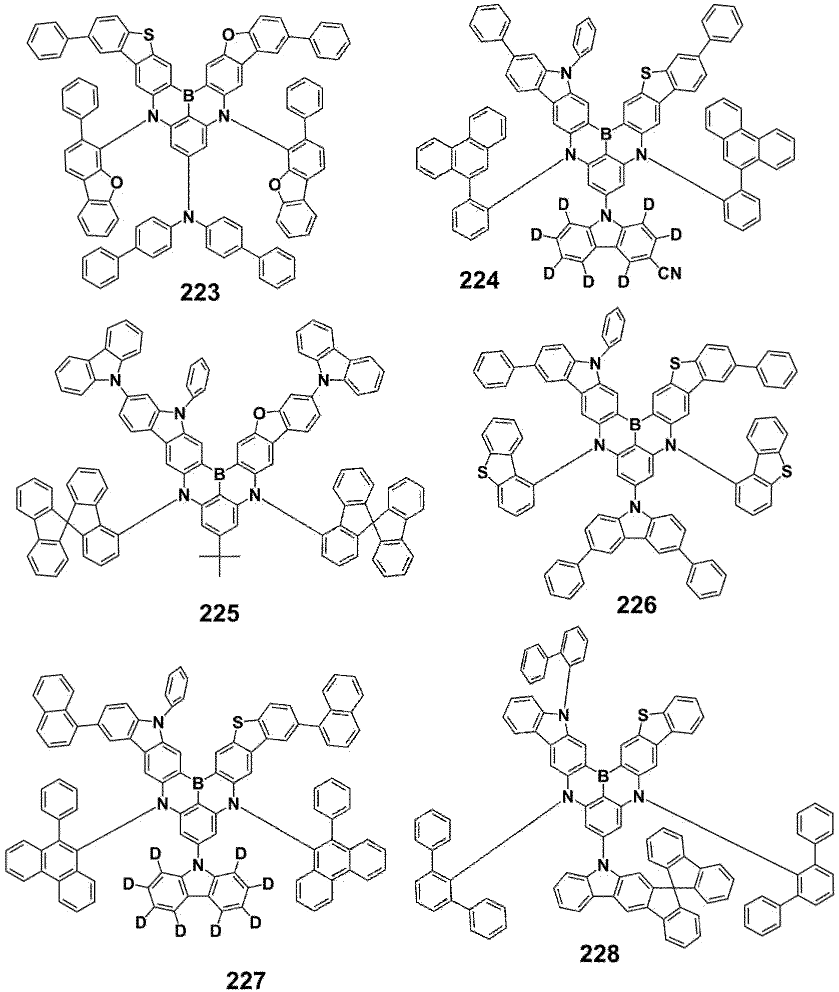

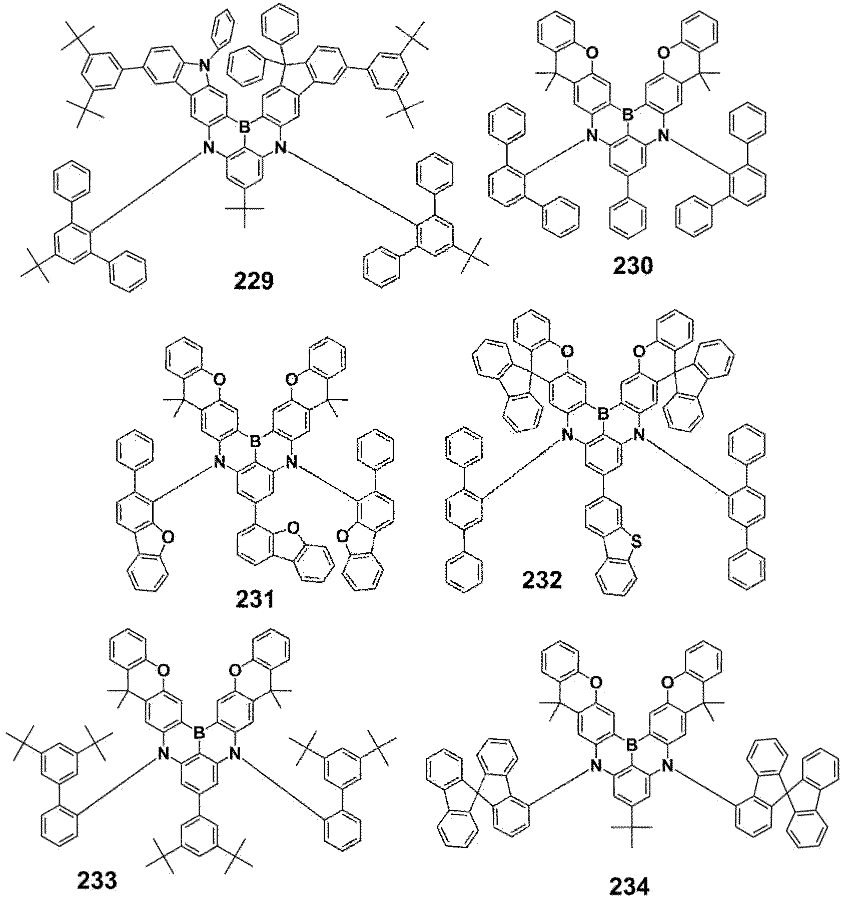

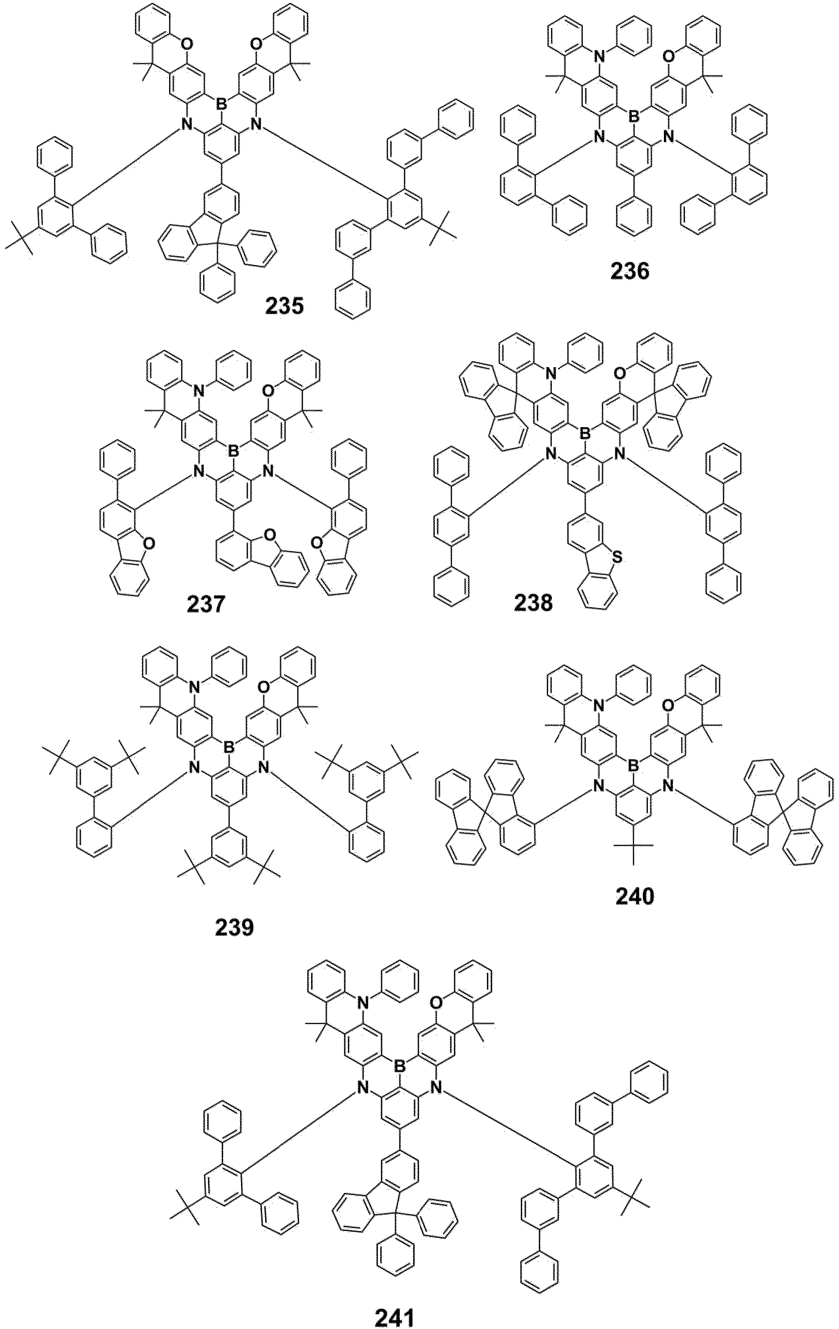

The fused polycyclic compound of one or more embodiments may be configured to emit green light. For example, the fused polycyclic compound of one or more embodiments may be a luminescent material having a luminescence center wavelength in a wavelength region of about 495 nm to about 570 nm. The light emitting element ED including the fused polycyclic compound of one or more embodiments may be configured to emit green light.

The emission layer EML may include the fused polycyclic compound of one or more embodiments as a dopant. The fused polycyclic compound of one or more embodiments may be configured to emit thermally activated delayed fluorescence (TADF). The fused polycyclic compound of one or more embodiments may be configured to emit light by converting triplet excitons into singlet excitons by reverse inter system crossing (RISC) mechanism.

The fused polycyclic compound of one or more embodiments includes a nonacyclic fused ring as a central structure, and an ortho biphenyl moiety may be bonded to the nonacyclic fused ring. The ortho biphenyl moiety may correspond to Rₙ and/or Rₘ of Formula 1 as described above.

In the fused polycyclic compound of one or more embodiments, the nonacyclic fused ring may include two nitrogen atoms and one boron atom as ring-forming atoms. In addition, the nonacyclic fused ring may further include a sulfur atom and/or a silicon atom as ring-forming atoms, and may include three or more nitrogen atoms as ring-forming atom. Two nitrogen atoms, which are ring-forming atoms, have a para position relationship with one boron atom, and a bulky substituent may be bonded to each of the two nitrogen atoms. The ortho biphenyl moiety may correspond to a bulky substituent.

Compound 1 corresponds to Compound 1 of Compound Group 1 as described above. In Comparative Example Compound CX2, A₁ and A₂ in Formula 1 as described above are direct linkages, which is different from the fused polycyclic compound according to one or more embodiments. In Compound 1 and Comparative Compound CX2, C^{a}, C^{b}, and N^{a} to N^{f} are indicated by alphabet letters a to f in carbon atoms and nitrogen atoms for the convenience of explanation.

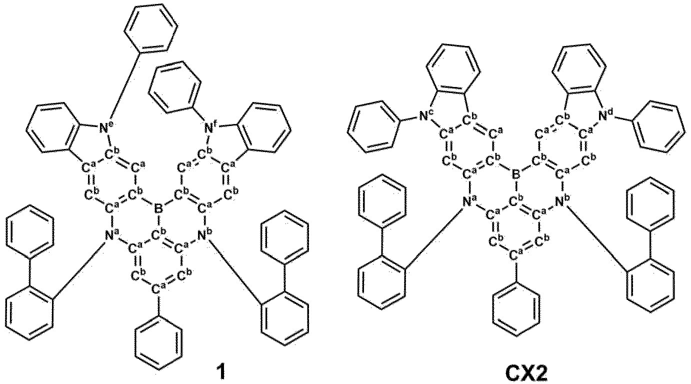

In Compound 1 and Comparative Compound CX2, a lowest unoccupied molecular orbital (LUMO) is present in a boron atom which is a ring-forming atom, and a highest occupied molecular orbital (HOMO) is present in each of the first nitrogen atom N^{a} and the second nitrogen atom N^{b}. In Compound 1 and Comparative Compound CX2, the LUMO is present in the first carbon atom C^{a}, and the HOMO is present in the second carbon atom C^{b}. The pentacyclic fused ring in which the LUMO and the HOMO are alternately present forms multiple resonances. The pentacyclic fused ring refers to a structure including a boron atom, the first nitrogen atom N^{a}, the second nitrogen atom N^{b}, the first carbon atom C^{a}, and the second carbon atom C^{b} as ring-forming atoms.

In Comparative Example Compound CX2, the HOMO is present in each of the third nitrogen atom N^{c} and the fourth nitrogen atom N^{d}, and in addition to the pentacyclic fused ring, up to the third nitrogen atom N^{c} and the fourth nitrogen atom N^{d} form multiple resonances. Accordingly, Comparative Example Compound CX2 emits blue light. In contrast, in Compound 1, the LUMO is present in each of the fifth nitrogen atom N^{e} and the sixth nitrogen atom N^{f}, and the fifth nitrogen atom N^{e} and the sixth nitrogen atom N^{f} do not form multiple resonances. The fifth nitrogen atom N^{e} and the sixth nitrogen atom N^{f} induce the red shift of emission wavelength, and Compound 1 is configured to emit green light.

The ortho biphenyl moiety protects the empty p orbital of boron, which is a ring-forming atom, and increases the intermolecular distance, thereby preventing or reducing the Dexter energy transfer.

A boron atom, which is a ring-forming atom, is a trivalent group, and a compound containing a trivalent boron atom is a Lewis acid, and is easily bonded to a nucleophile (Lewis Base) or a deterioration product (e.g., radical) in a light emitting element. In this case, the ring containing the boron atom is deformed into a tetrahedral structure, and the deterioration of the light emitting element occurs. In addition, the compound in which the central structure exhibits multiple resonance characteristics has a planar structure, and an intermolecular interaction causes a decrease in the efficiency and service life of the light emitting element.

In contrast, in the fused polycyclic compound of one or more embodiments, the ortho biphenyl moiety, which is a bulky substituent, protects the boron atom, which is a ring-forming atom, and increases the intermolecular distance to prevent or reduce Dexter energy transfer, thereby contributing to the improvement of the efficiency and service life of the light emitting element ED. The light emitting element ED including the fused polycyclic compound of one or more embodiments may exhibit high efficiency and long service life characteristics.

In one or more embodiments, the emission layer EML may include the fused polycyclic compound of one or more embodiments and may further include at least one selected from among the second to fourth compounds. In one or more embodiments, the emission layer EML may include the second compound represented by Formula HT-1. For example, the second compound may be used as a hole transporting host material of the emission layer EML.

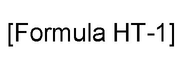

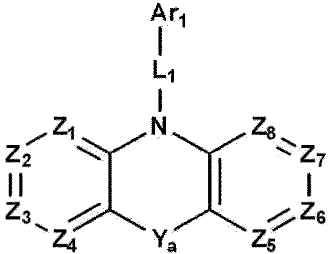

In Formula HT-1, Z₁ to Z₈ may each independently be N or CR₅₁. For example, all of Z₁ to Z₈ may be CR₅₁. In one or more embodiments, any one selected from among Z₁ to Z₈ may be N, and the rest may be CR₅₁.

In Formula HT-1, L₁ may be a direct linkage, a substituted or unsubstituted arylene group having 6 to 30 ring-forming carbon atoms, or a substituted or unsubstituted heteroarylene group having 2 to 30 ring-forming carbon atoms. For example, L₁ may be a direct linkage, a substituted or unsubstituted phenylene group, a substituted or unsubstituted divalent biphenyl group, a substituted or unsubstituted divalent carbazole group, and/or the like, but one or more embodiments of the present disclosure is not limited thereto.

In Formula HT-1, Yₐ may be a direct linkage, CR₅₂R₅₃, or SiR₅₄R₅₅. For example, it may refer to that the two benzene rings linked to the nitrogen atom in Formula HT-1 are linked via a direct linkage, 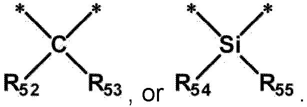 In Formula HT-1, if (e.g., when) Yₐ is a direct linkage, the second compound represented by Formula HT-1 may include a carbazole moiety.

In Formula HT-1, Ar₁ may be a substituted or unsubstituted aryl group having 6 to 30 ring-forming carbon atoms, or a substituted or unsubstituted heteroaryl group having 2 to 30 ring-forming carbon atoms. For example, Ar₁ may be a substituted or unsubstituted carbazole group, a substituted or unsubstituted dibenzofuran group, a substituted or unsubstituted dibenzothiophene group, a substituted or unsubstituted biphenyl group, and/or the like, but one or more embodiments of the present disclosure is not limited thereto.

In Formula HT-1, R₅₁ to R₅₅ may each independently be a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms. In one or more embodiments, each of R₅₁ to R₅₅ may be bonded to an adjacent group to form a ring. For example, R₅₁ to R₅₅ may each independently be a hydrogen atom or a deuterium atom. R₅₁ to R₅₅ may each independently be an unsubstituted methyl group or an unsubstituted phenyl group.

In one or more embodiments, the second compound represented by Formula HT-1 may be represented by any one selected from among the compounds represented by Compound Group 2. The emission layer EML may include at least one selected from among the compounds represented by Compound Group 2 as a hole transporting host material.

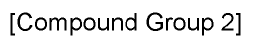

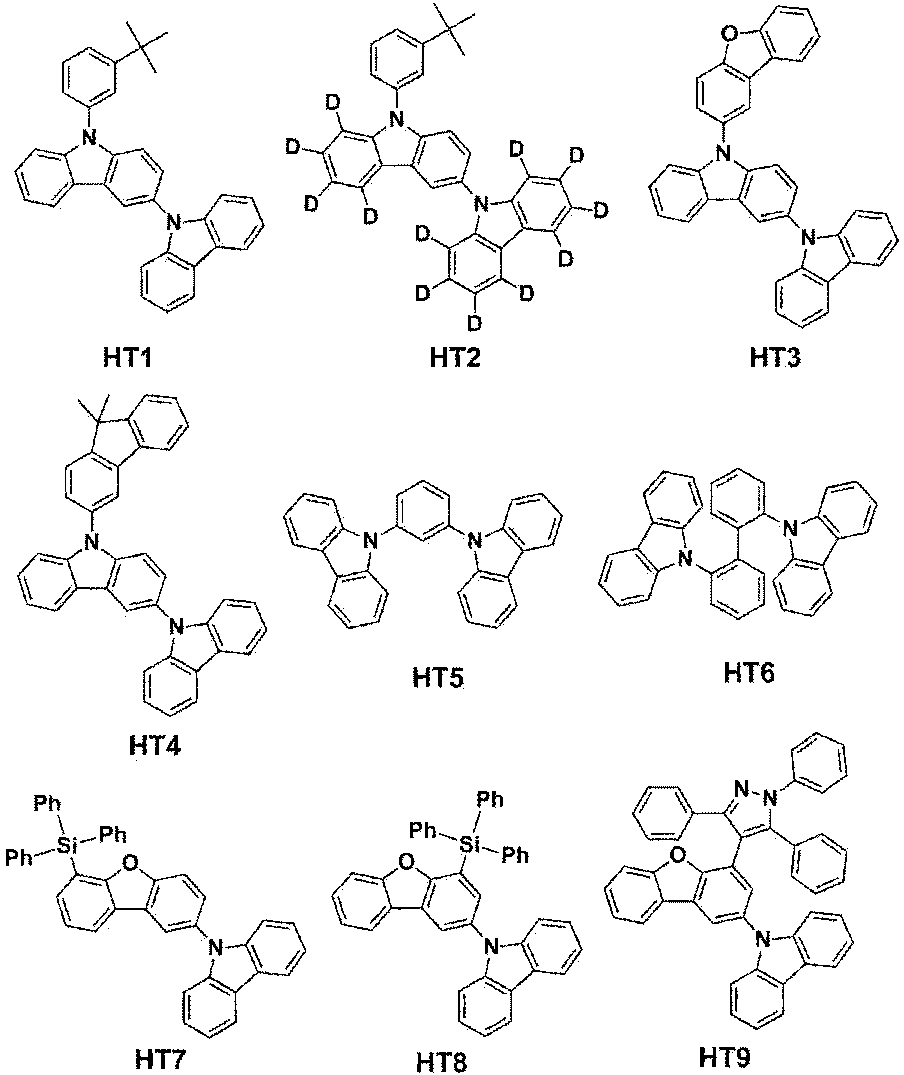

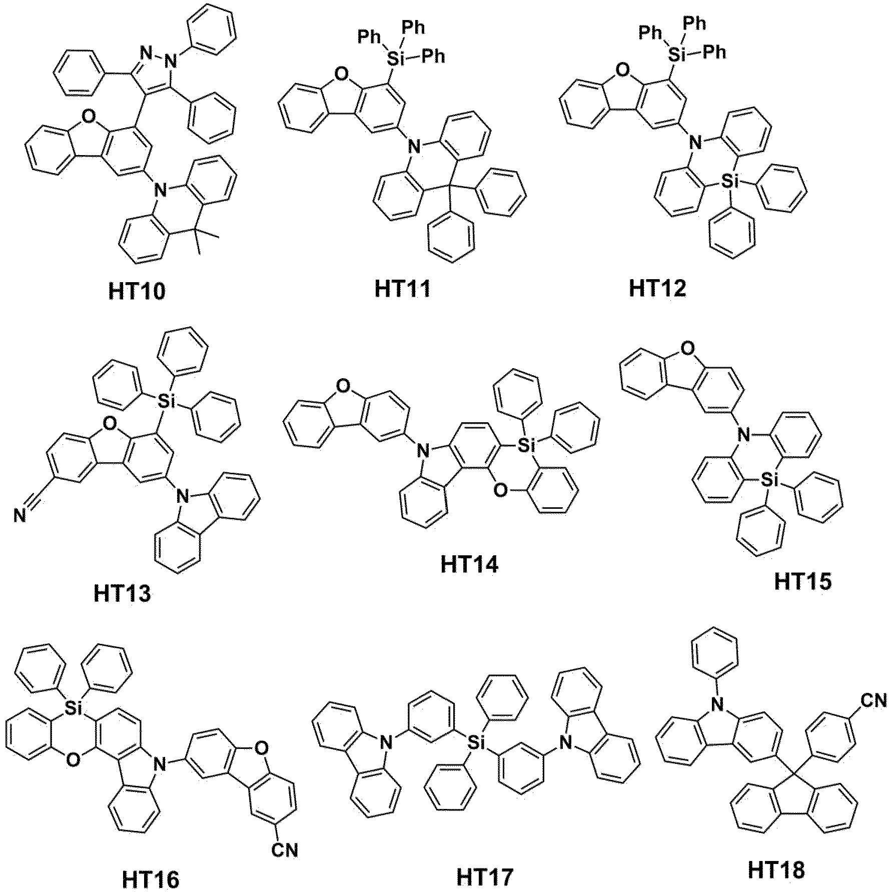

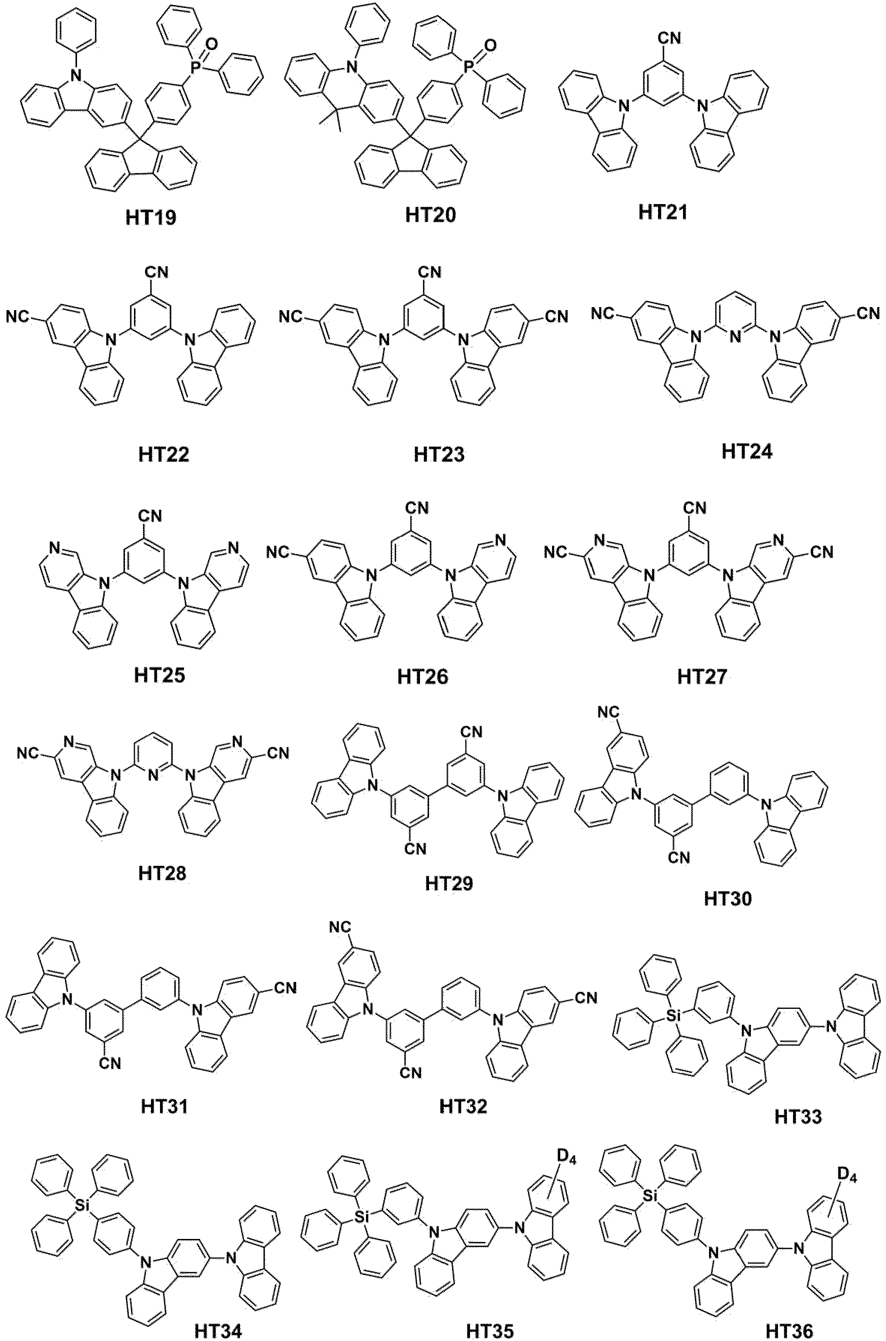

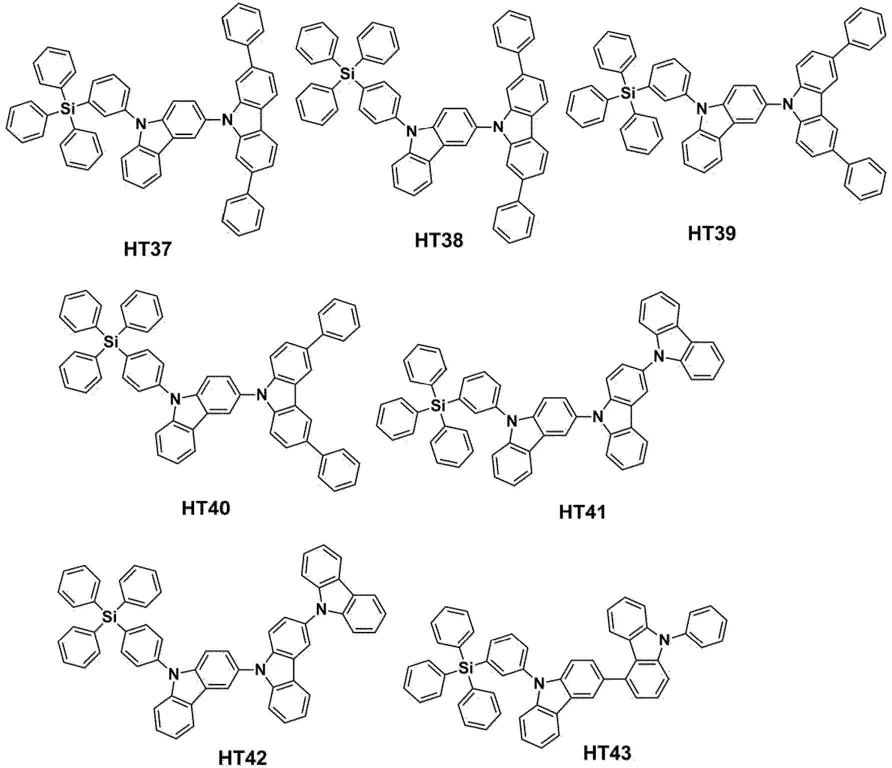

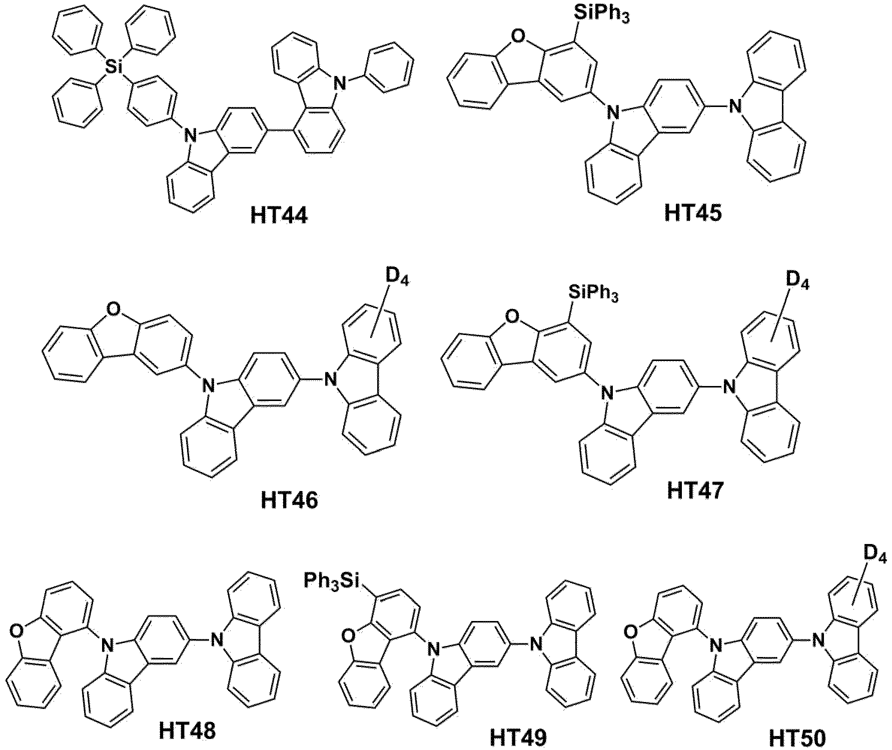

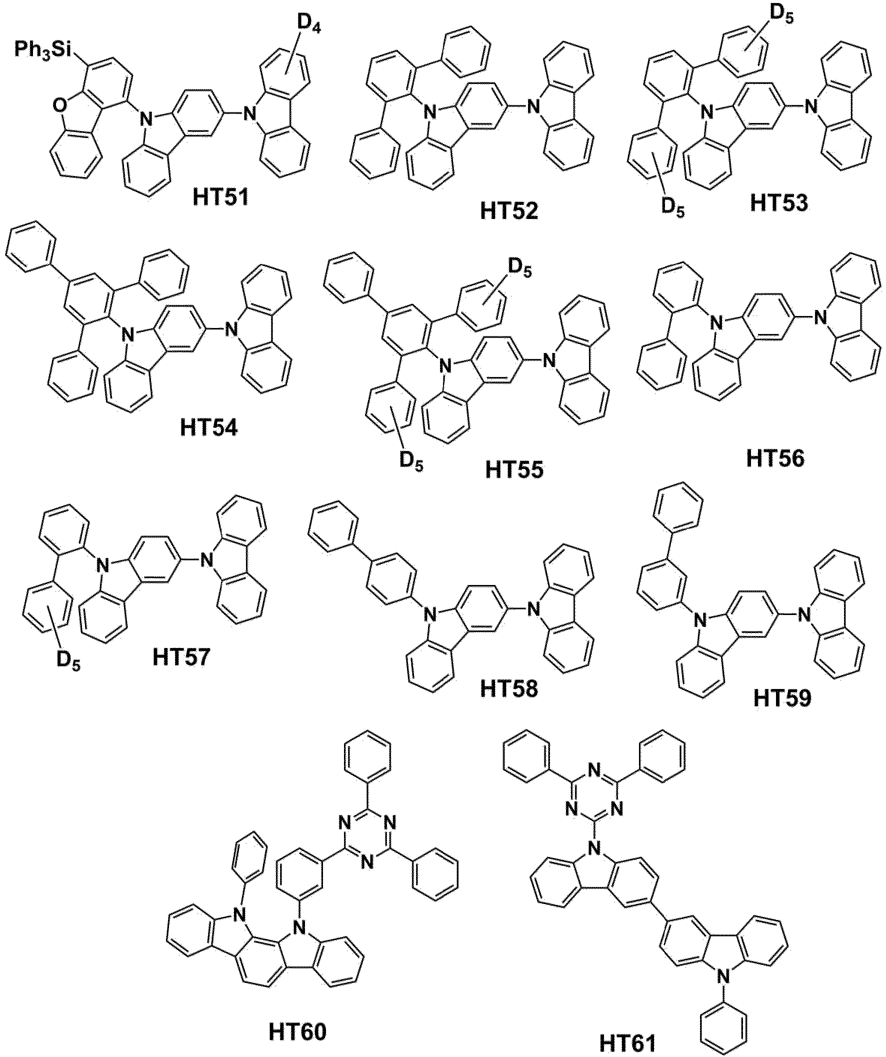

In embodiment compounds presented in Compound Group 2, "D" may refer to a deuterium atom, and "Ph" may refer to a substituted or unsubstituted phenyl group. For example, in embodiment compounds presented in Compound Group 2, "Ph" may refer to an unsubstituted phenyl group.

In one or more embodiments, the emission layer EML may include the third compound represented by Formula ET-1. For example, the third compound may be used as an electron transport host material for the emission layer EML.

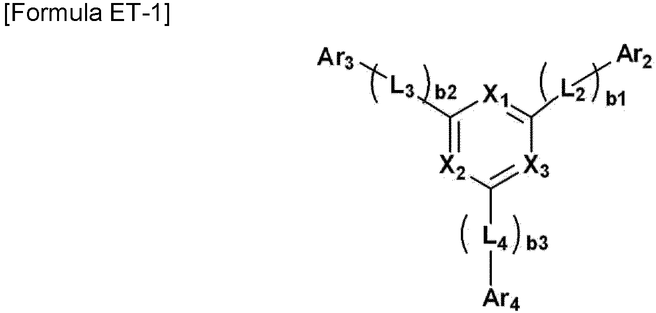

In Formula ET-1, at least one selected from among X₁ to X₃ is N, and the rest are CR₅₆. For example, any one selected from among X₁ to X₃ may be N, and the rest may each independently be CR₅₆. In this case, the third compound represented by Formula ET-1 may include a pyridine moiety. In one or more embodiments, two among X₁ to X₃ may be N, and the rest may be CR₅₆. In this case, the third compound represented by Formula ET-1 may include a pyrimidine moiety. In one or more embodiments, X₁ to X₃ may all be N. In this case, the third compound represented by Formula ET-1 may include a triazine moiety.

In Formula ET-1, R₅₆ may be a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms.

In Formula ET-1, b1 to b3 may each independently be an integer of 0 to 10.

In Formula ET-1, Ar₂ to Ar₄ may each independently be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, Ar₂ to Ar₄ may each independently be a substituted or unsubstituted phenyl group, or a substituted or unsubstituted carbazole group.

In Formula ET-1, L₂ to L₄ may each independently be a direct linkage, a substituted or unsubstituted arylene group having 6 to 30 ring-forming carbon atoms, or a substituted or unsubstituted heteroarylene group having 2 to 30 ring-forming carbon atoms. In one or more embodiments, if (e.g., when) b1 to b3 are integers of 2 or greater, L₂ to L₄ may each independently be a substituted or unsubstituted arylene group having 6 to 30 ring-forming carbon atoms, or a substituted or unsubstituted heteroarylene group having 2 to 30 ring-forming carbon atoms.

In one or more embodiments, the third compound may be represented by any one among compounds in Compound Group 3. The light emitting element ED of one or more embodiments may include at least one selected from among the compounds in Compound Group 3.

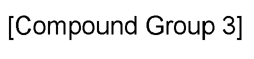

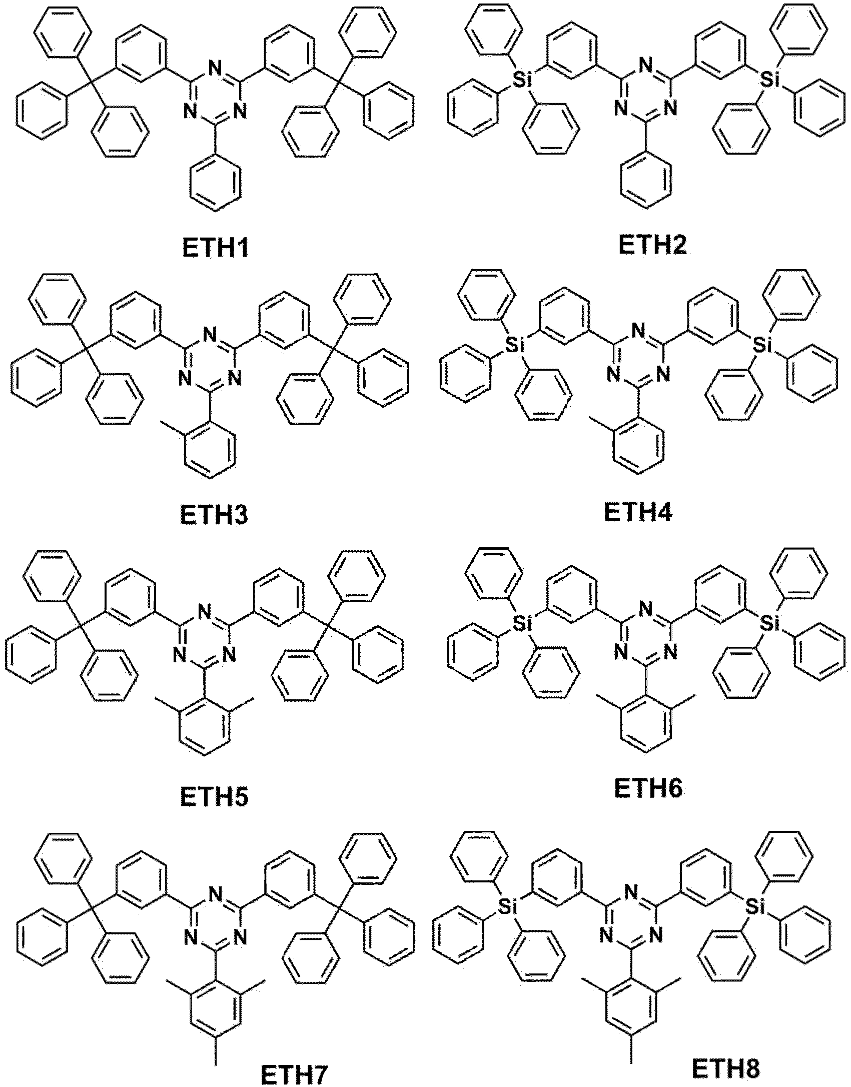

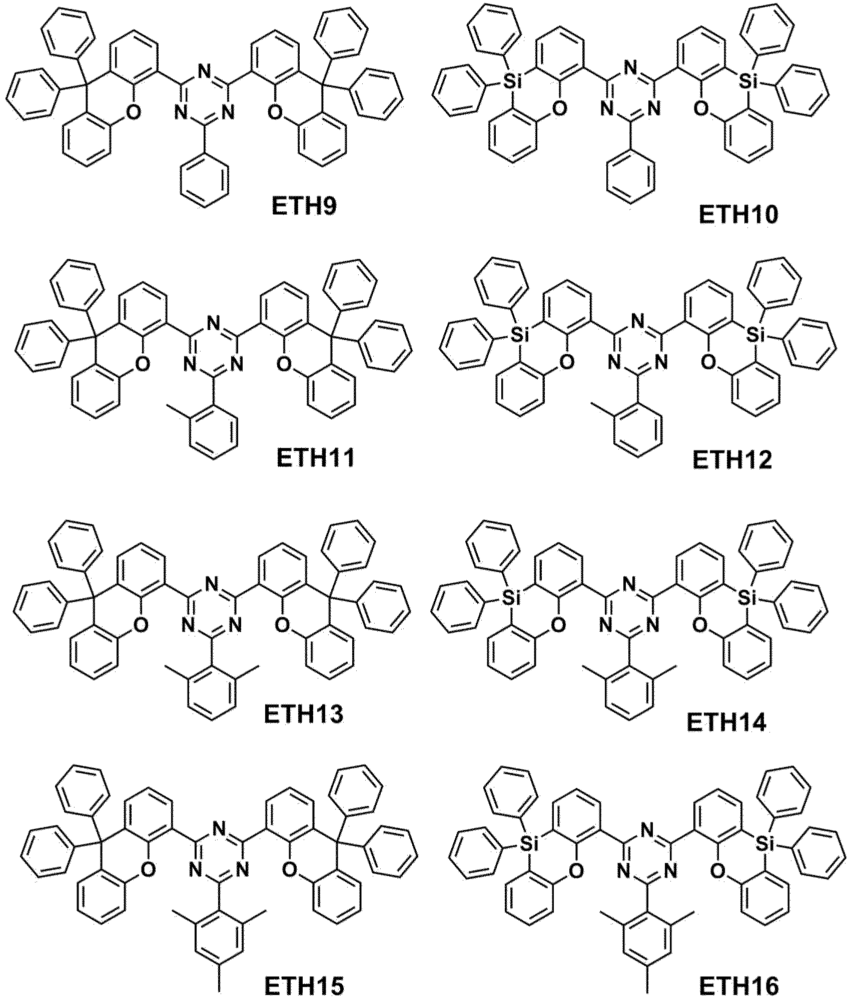

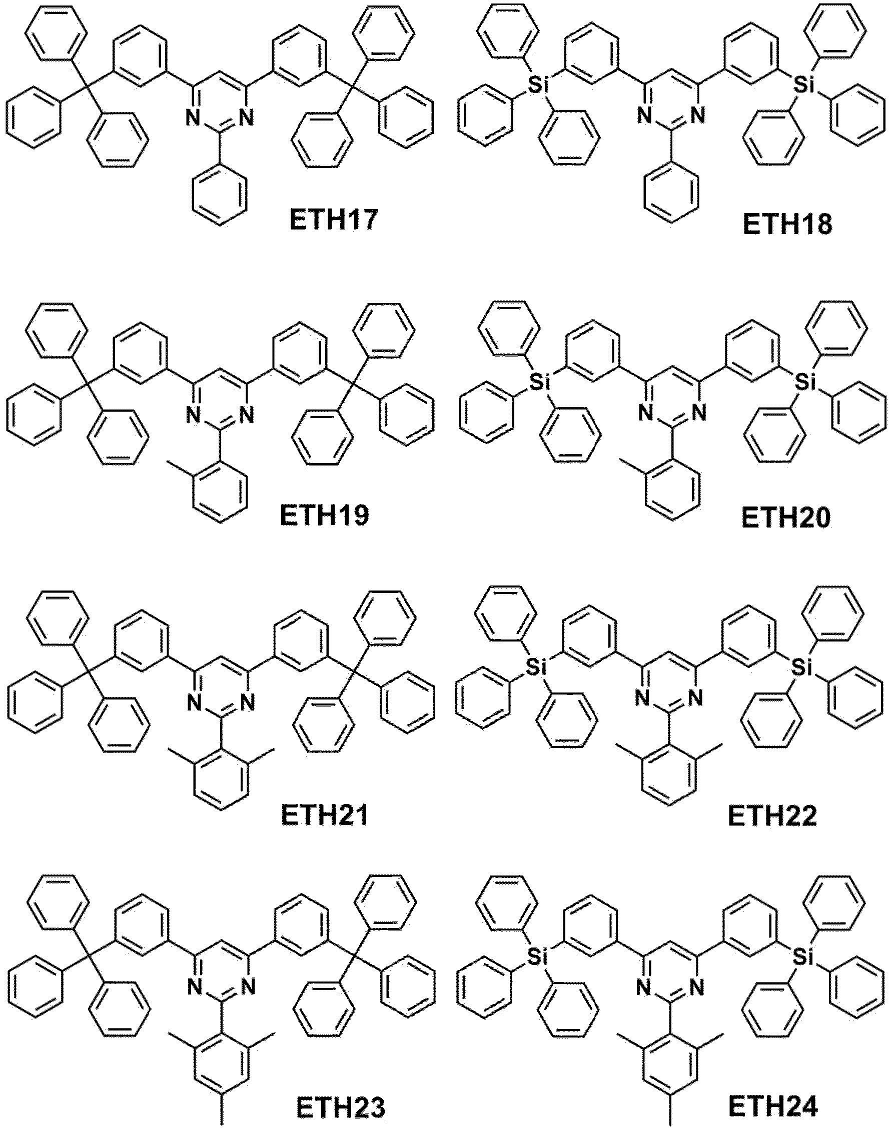

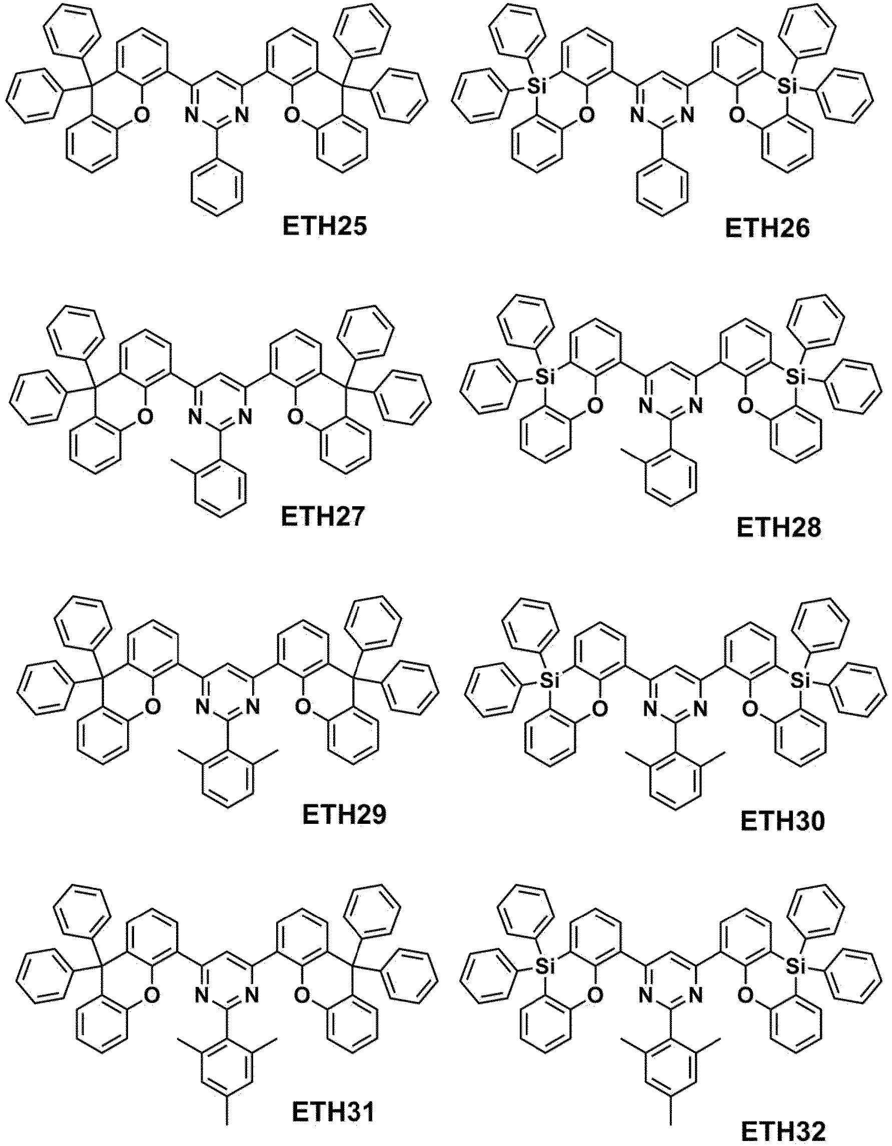

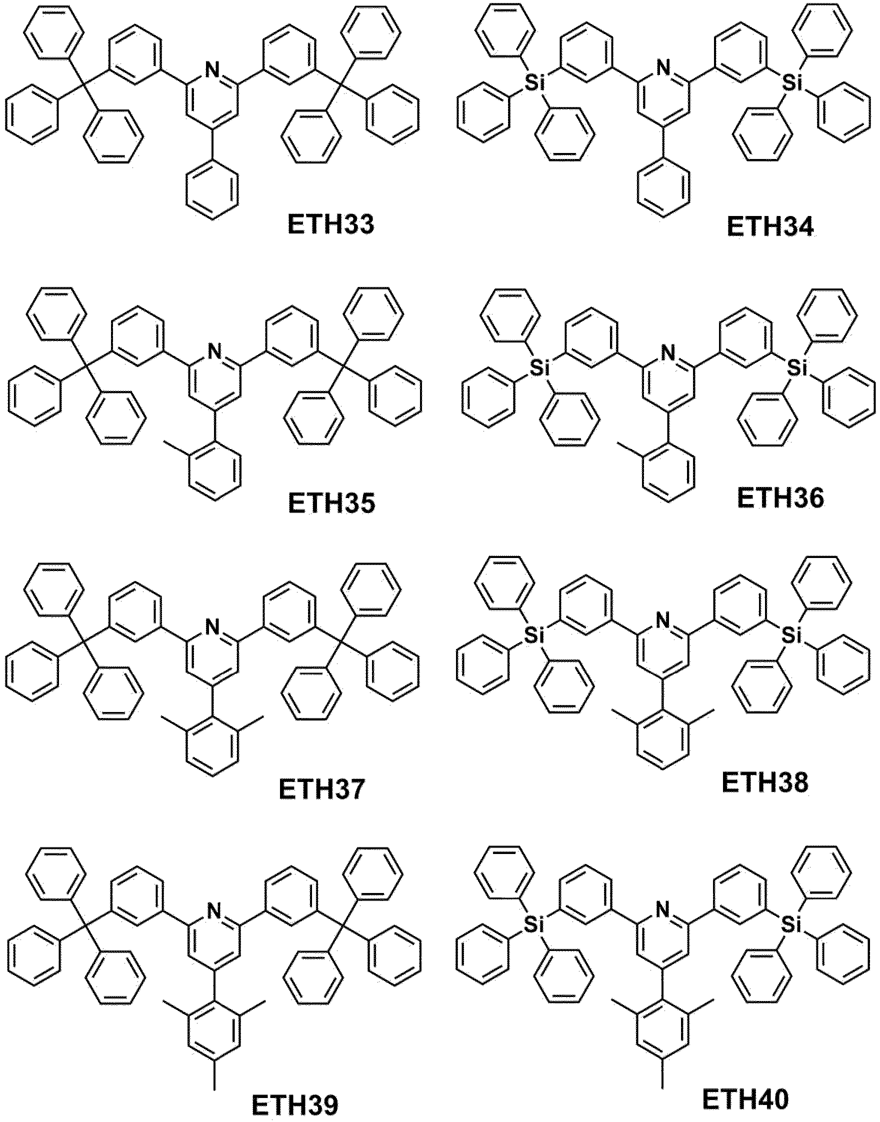

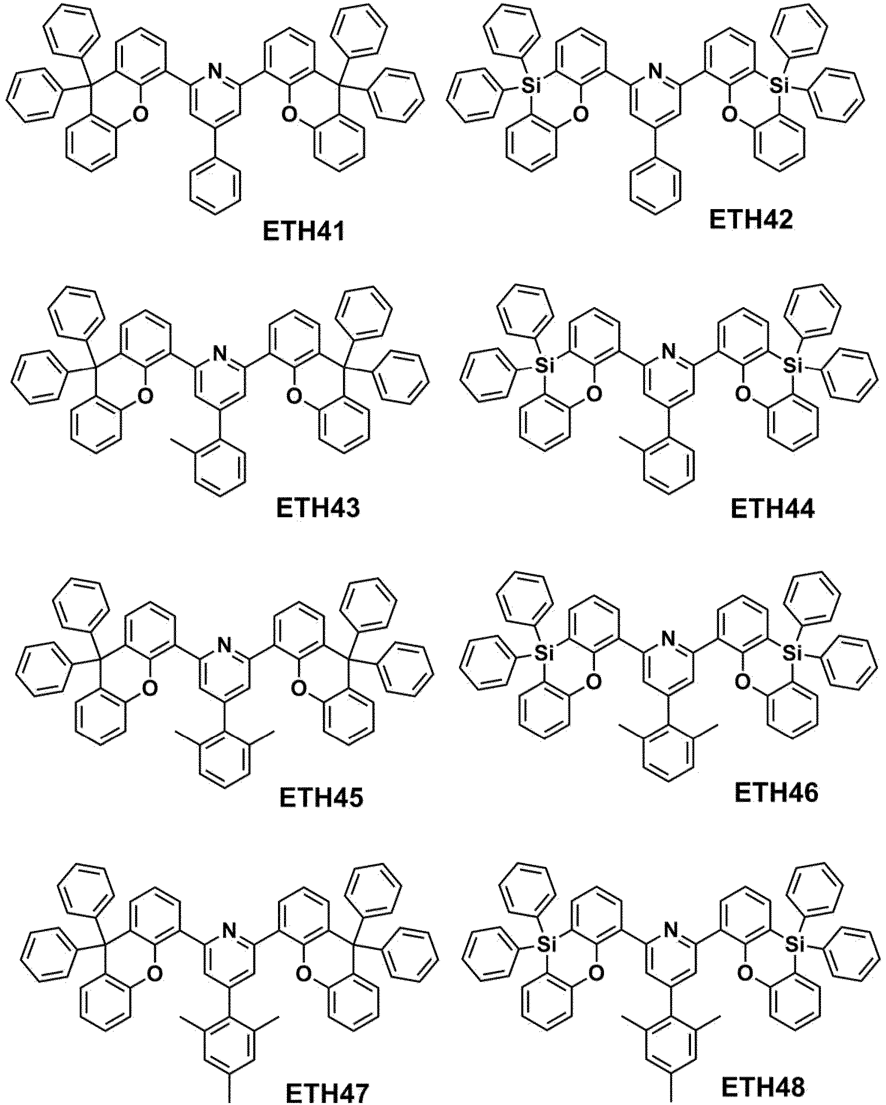

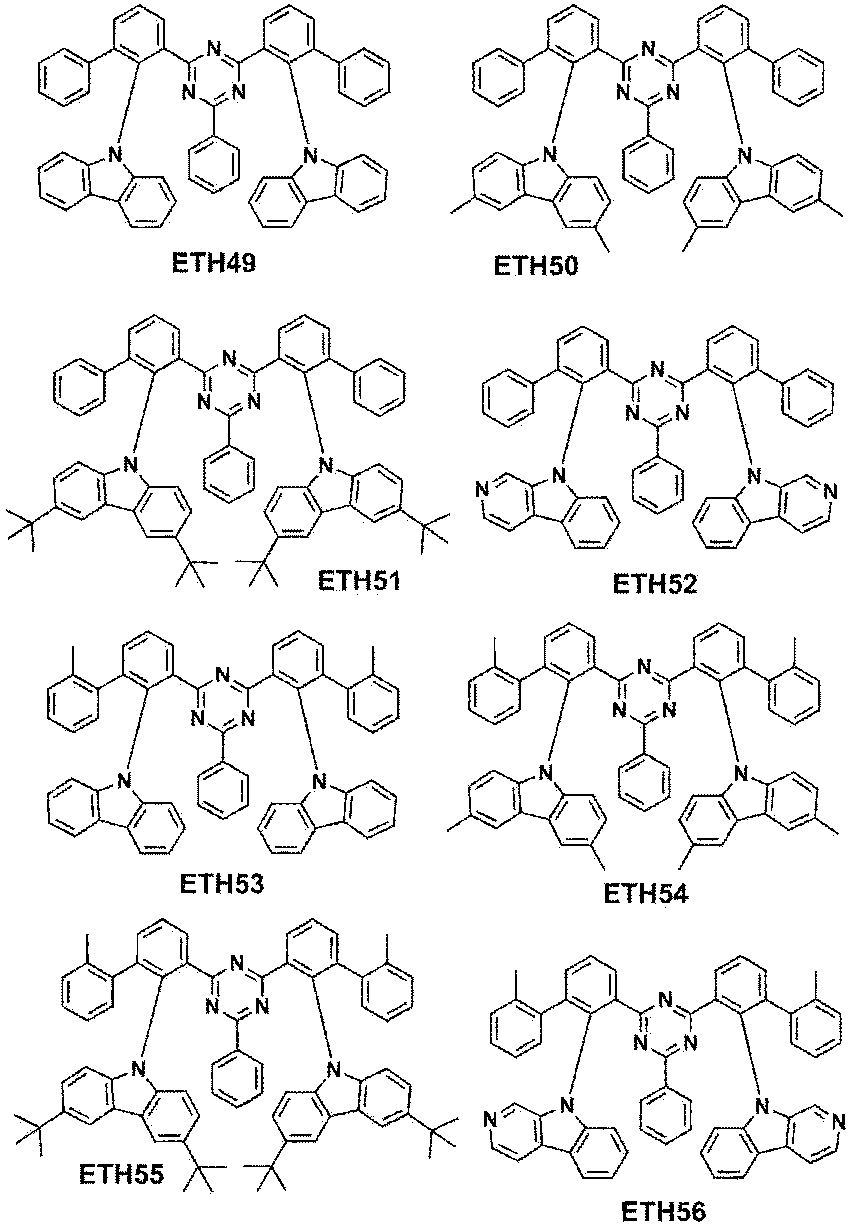

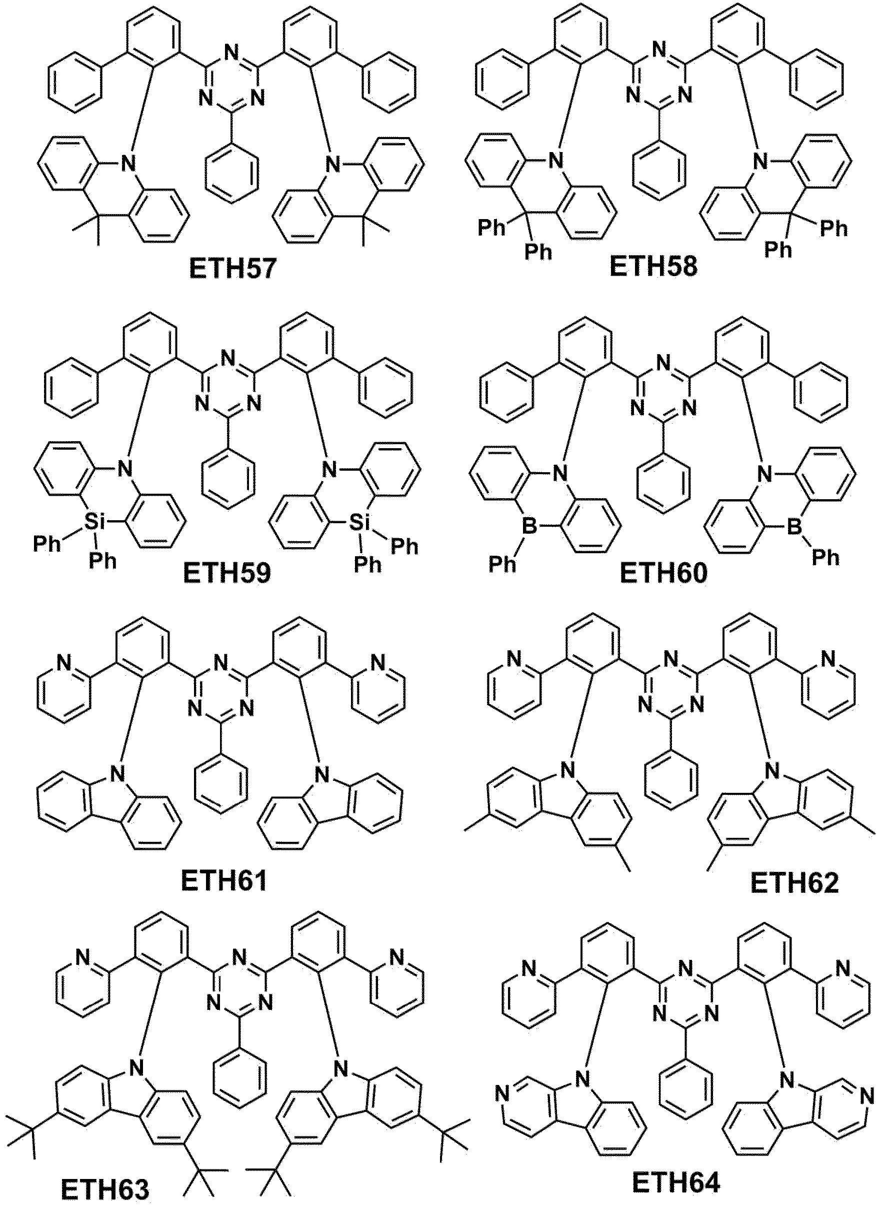

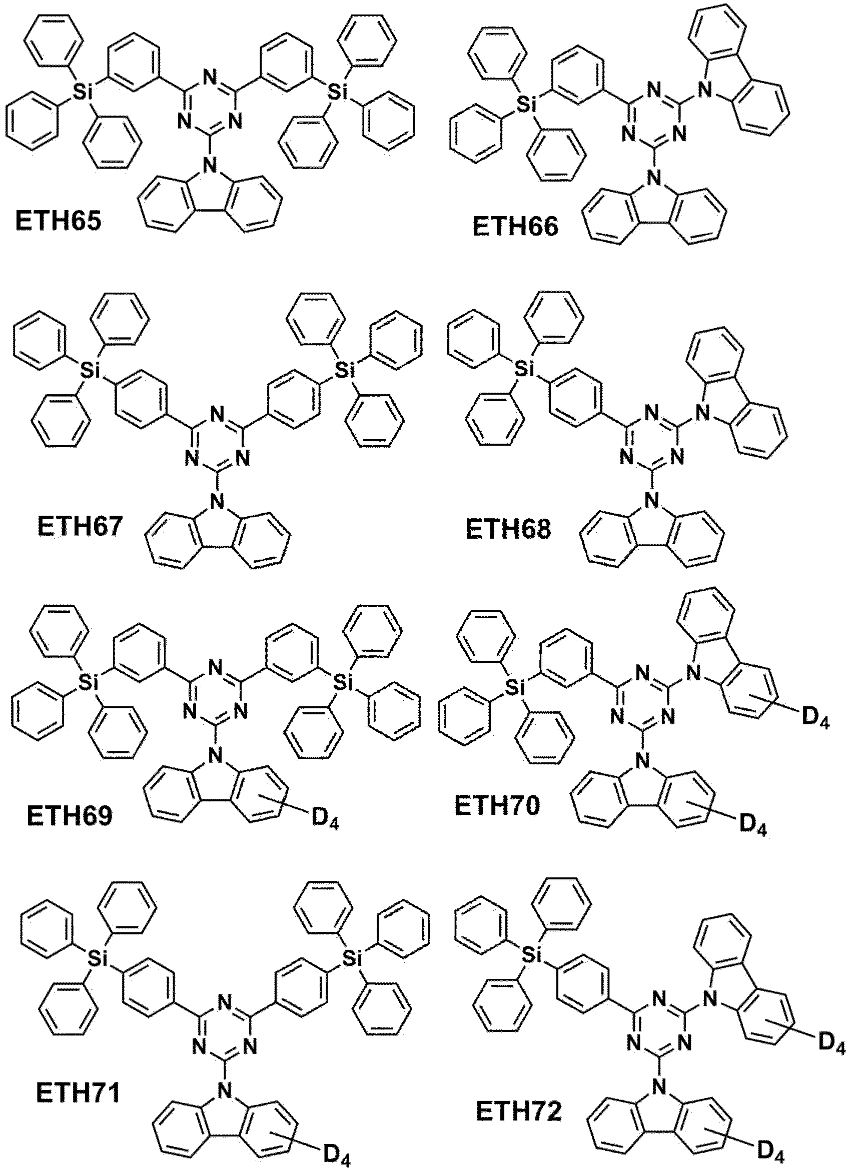

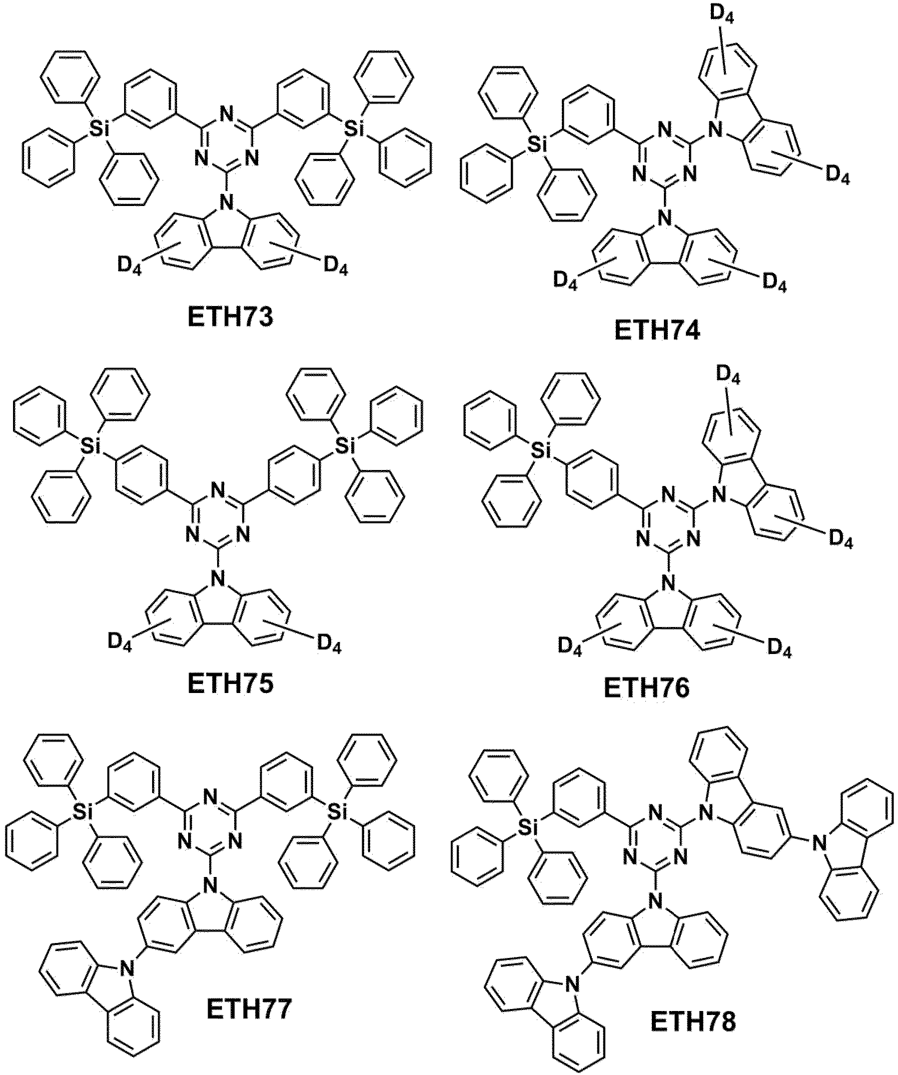

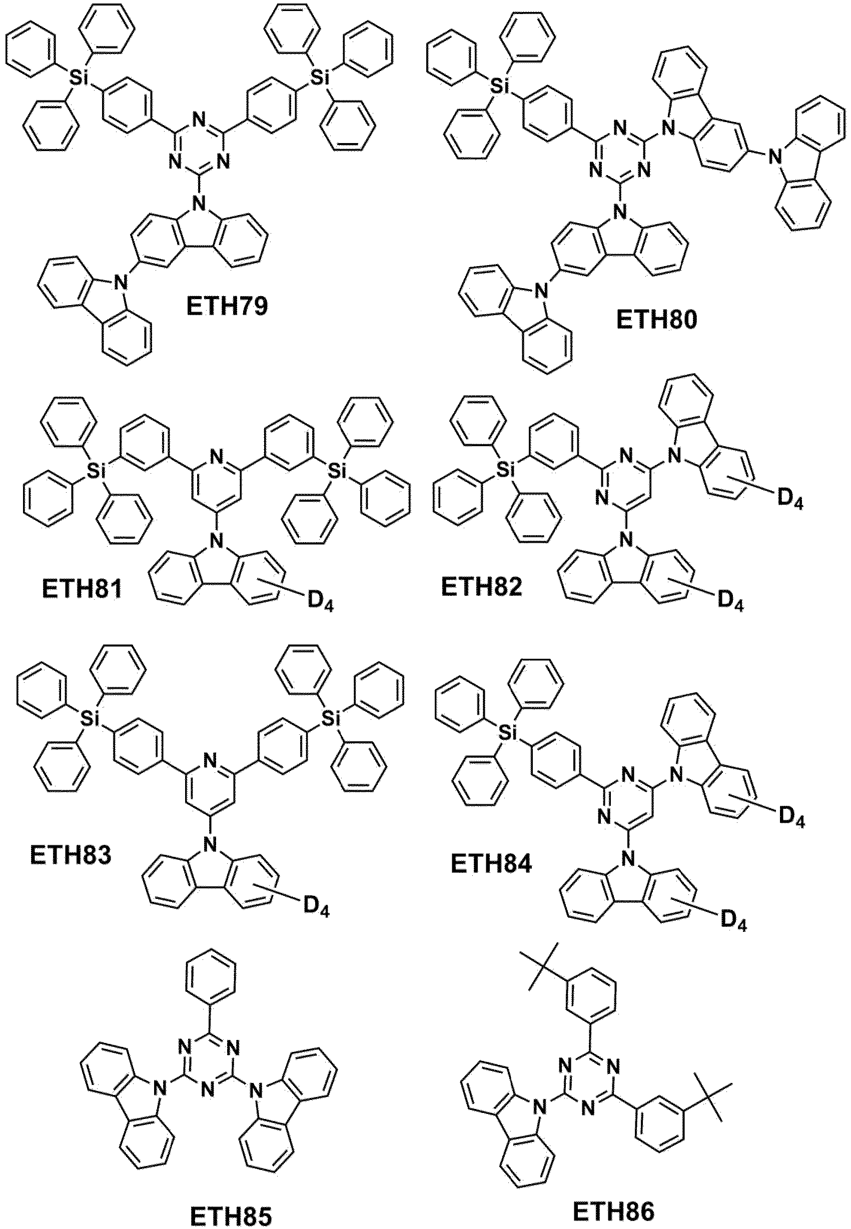

In the compounds presented in Compound Group 3, "D" refers to a deuterium atom and "Ph" refers to an unsubstituted phenyl group.

The emission layer EML may include the second compound and the third compound, and the second compound and the third compound may form an exciplex. In the emission layer EML, an exciplex may be formed by the hole transport host and the electron transport host. In this case, a triplet energy of the exciplex formed by the hole transporting host and the electron transporting host may correspond to the difference between a lowest unoccupied molecular orbital (LUMO) energy level of the electron transporting host and a highest occupied molecular orbital (HOMO) energy level of the hole transporting host.

For example, the absolute value of the triplet energy (T1) of the exciplex formed by the hole transporting host and the electron transporting host may be about 2.4 eV to about 3.0 eV. In addition, the triplet energy of the exciplex may be a value smaller than an energy gap of each host material. The exciplex may have a triplet energy of about 3.0 eV or less that is an energy gap between the hole transporting host and the electron transporting host.

In one or more embodiments, the emission layer EML may include a fourth compound in addition to the first compound to the third compound as described above. The fourth compound may be used as a phosphorescent sensitizer of the emission layer EML. The energy may be transferred from the fourth compound to the first compound, thereby emitting light.

For example, the emission layer EML may include, as the fourth compound, an organometallic complex containing platinum (Pt) as a central metal atom and ligands linked to the central metal atom. The emission layer EML in the light emitting element ED of one or more embodiments may include, as the fourth compound, a compound represented by Formula D-1:

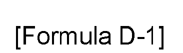

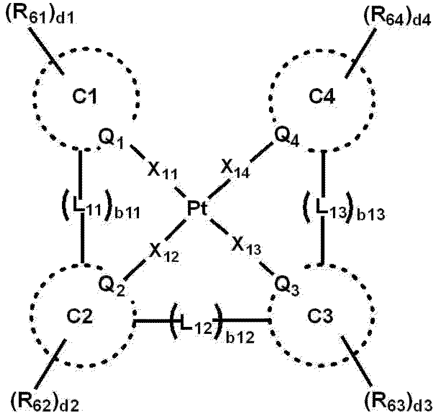

In Formula D-1, Q₁ to Q₄ may each independently be C or N. In Formula D-1, C1 to C4 may each independently be a substituted or unsubstituted hydrocarbon ring having 5 to 30 ring-forming carbon atoms, a substituted or unsubstituted aryl group having 6 to 30 ring-forming carbon atoms, or a substituted or unsubstituted heterocycle having 2 to 30 ring-forming carbon atoms,

X₁₁ to X₁₄ may each independently be a direct linkage, or *-O-*. For example, any one of X₁₁ to X₁₄ may be *-O-* , and the remainder may be the direct linkage.

In Formula D-1, L₁₁ to L₁₃ may each independently be a direct linkage, *-O-* *-S-*, > > 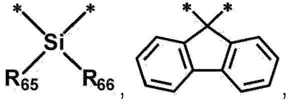 a substituted or unsubstituted alkylene group having 1 to 20 carbon atoms, a substituted or unsubstituted arylene group having 6 to 30 ring-forming carbon atoms, or a substituted or unsubstituted heteroarylene group having 2 to 30 ring-forming carbon atoms. In L₁₁ to L₁₃, " * " refers to a part linked to C1 to C4.

In Formula D-1, b11 to b13 may each independently be 0 or 1. If b11 is 0, C1 and C2 may not be linked to each other. If b12 is 0, C2 and C3 may not be linked to each other. If b13 is 0, C3 and C4 may not be linked to each other.

In Formula D-1, R₆₁ to R₆₆ may each independently be a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms. In one or more embodiments, each of R₆₁ to R₆₆ may be bonded to an adjacent group to form a ring. R₆₁ to R₆₆ may each independently be a substituted or unsubstituted methyl group, or a substituted or unsubstituted t-butyl group.

In Formula D-1, d1 to d4 may each independently be an integer of 0 to 4. In Formula D-1, if each of d1 to d4 is 0, the fourth compound may not be substituted with each of R₆₁ to R₆₄. The case where each of d1 to d4 is 4 and R₆₁'s to R₆₄' are each hydrogen atoms may be the same as the case where each of d1 to d4 is 0. When each of d1 to d4 is an integer of 2 or more, a plurality of R₆₁'s to Rsa's may each be the same or at least one selected from among the plurality of R₆₁'s to R₆₄'s may be different from the others.

In Formula D-1, C1 to C4 may each independently be a substituted or unsubstituted hydrocarbon ring or be a substituted or unsubstituted heterocycle represented by any one selected from among C-1 to C-4 below:

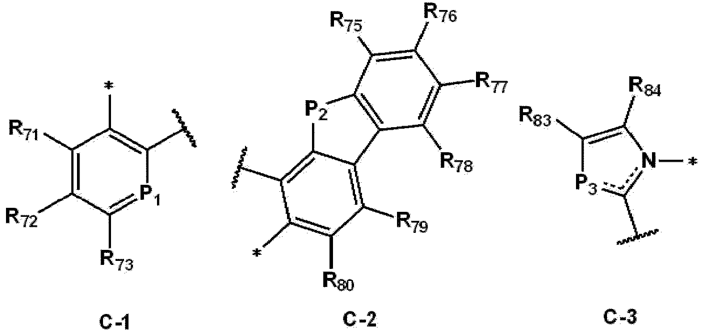

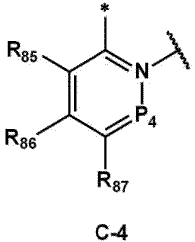

In C-1 to C-4, P₁ may be c-* or CR₇₄, P₂ may be N-* or NR₈₁, P₃ may be N-* or NR₈₂, and P₄ may be c-* or CR₈₈. R₇₁ to R₈₈ may each independently be a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring.

In addition, in C-1 to C-4, " 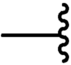 " corresponds to a part linked to Pt that is a central metal atom, and "-*" corresponds to a part linked to a neighboring cyclic group C1 to C4 or a linker (L₁₁ to L₁₃).

The emission layer EML of one or more embodiments may include the first compound, which is a fused polycyclic compound, and at least one of the second to fourth compounds. For example, the emission layer EML may include the first compound, the second compound, and the third compound. In the emission layer EML, the second compound and the third compound may form an exciplex, and the energy may be transferred from the exciplex to the first compound, thereby emitting light.

In addition, the emission layer EML may include the first compound, the second compound, the third compound, and the fourth compound. In the emission layer EML, the second compound and the third compound may form an exciplex, and the energy may be transferred from the exciplex to the fourth compound and the first compound, thereby emitting light. In one or more embodiments, the fourth compound may be a sensitizer. The fourth compound included in the emission layer EML in the light emitting element ED of one or more embodiments may serve as a sensitizer to deliver energy from the host to the first compound that is a light emitting dopant. For example, the fourth compound serving as an auxiliary dopant accelerates energy delivery to the first compound that is a light emitting dopant, thereby increasing the emission ratio of the first compound. Therefore, the emission layer EML of one or more embodiments may improve luminous efficiency. In addition, if (e.g., when) the energy delivery to the first compound is increased, an exciton formed in the emission layer EML is not accumulated inside the emission layer EML and emits light rapidly, and thus deterioration of the device may be reduced. Therefore, the service life of the light emitting element ED of one or more embodiments may increase.

The light emitting element ED of one or more embodiments may include all of the first compound, the second compound, the third compound, and the fourth compound, and the emission layer EML may include the combination of two host materials and two dopant materials. In the light emitting element ED of one or more embodiments, the emission layer EML may concurrently (e.g., simultaneously) include the second compound and the third compound, which are two different hosts, the first compound that is configured to emit a delayed fluorescence, and the fourth compound including an organometallic complex, thereby exhibiting excellent or suitable luminous efficiency characteristics.

In one or more embodiments, the fourth compound represented by Formula D-1 may be represented by at least one selected from among the compounds represented by Compound Group 4. The emission layer EML may include at least one selected from among the compounds represented by Compound Group 4 as a sensitizer material.

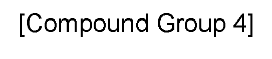

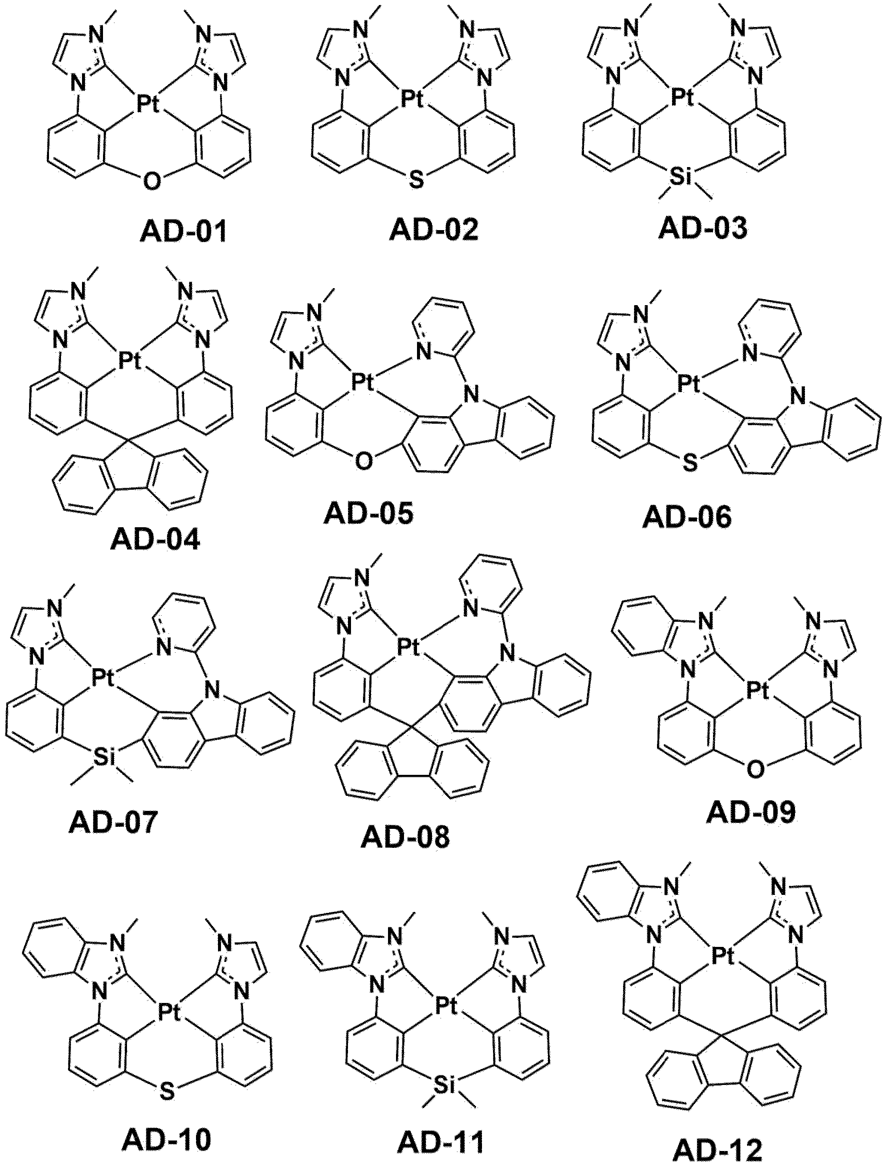

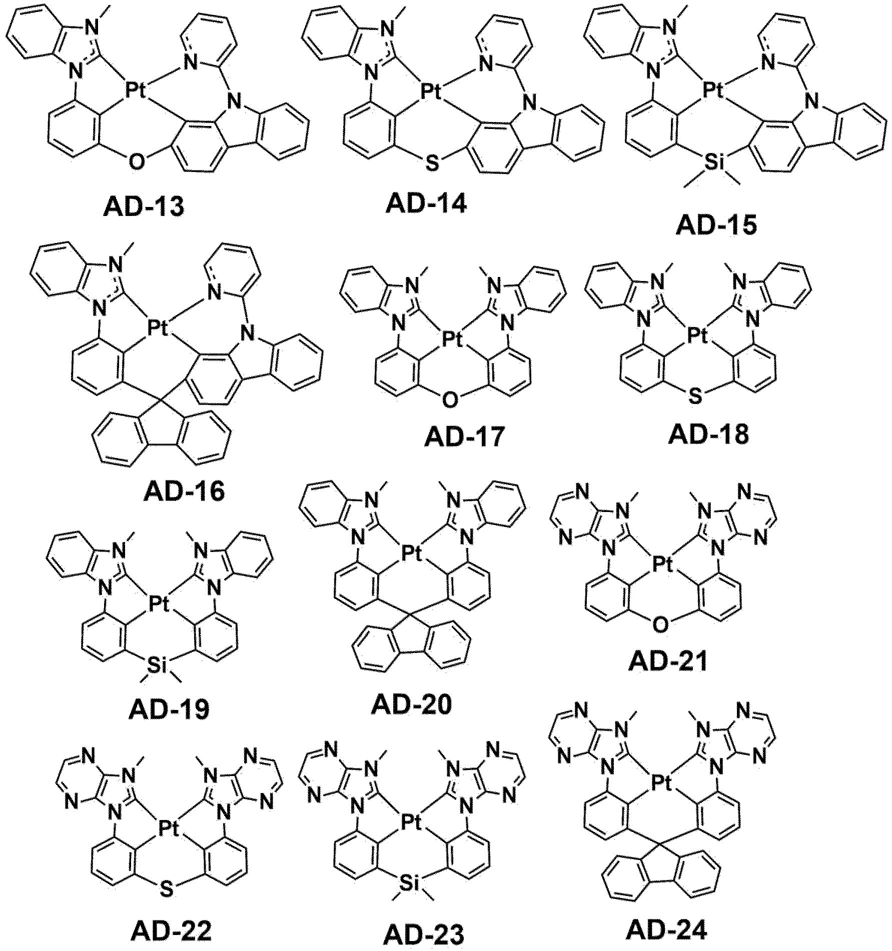

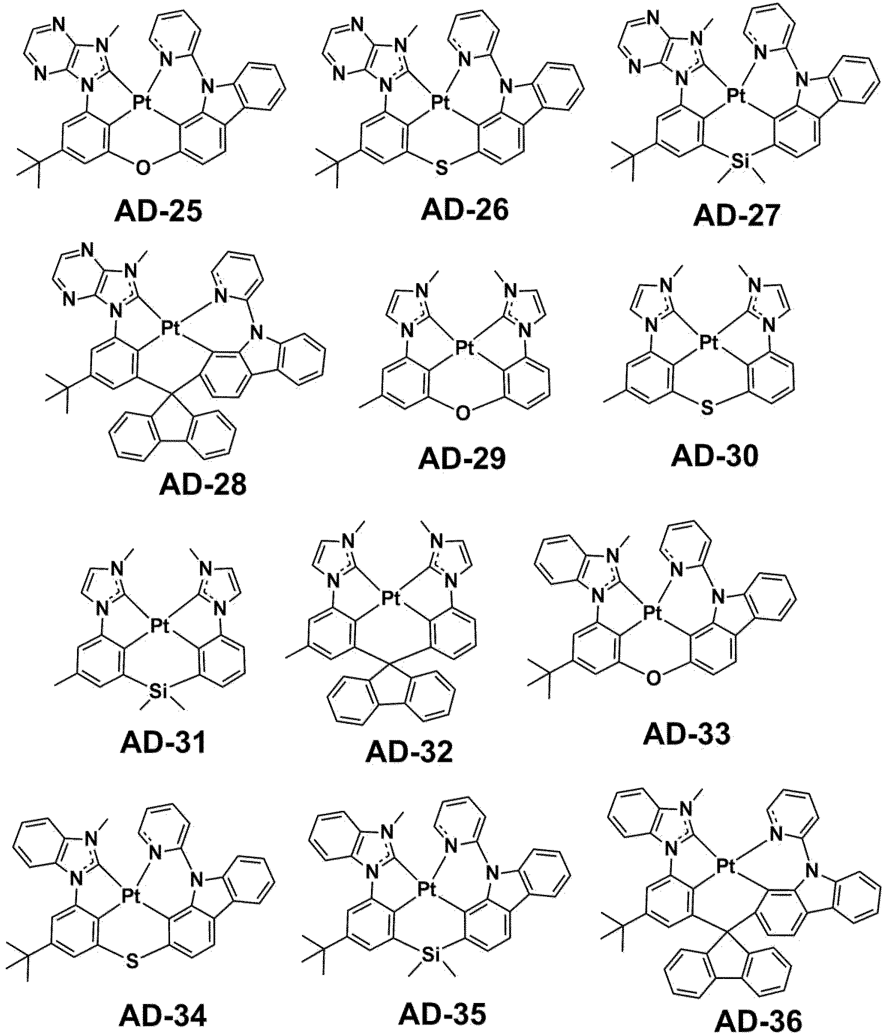

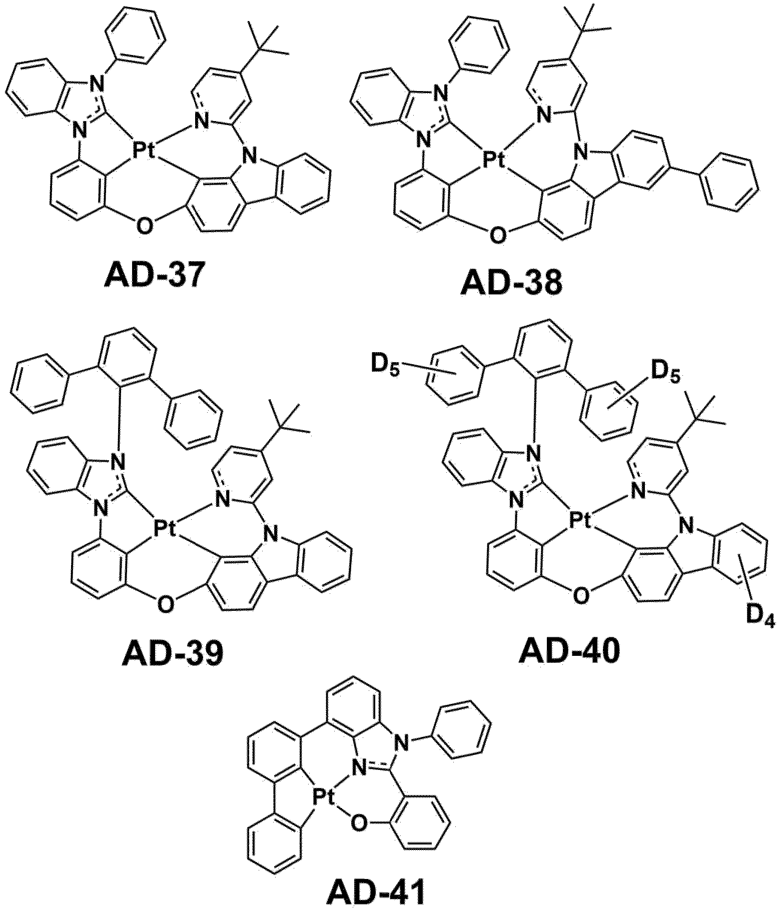

In the compounds presented in Compound Group 4, "D" refers to a deuterium atom.

When the emission layer EML in the light emitting element ED of one or more embodiments includes all of the first compound, the second compound, and the third compound, with respect to the total weight of the first compound, the second compound, and the third compound, the content (e.g., amount) of the first compound may be about 0.1 wt% to about 5 wt%. However, one or more embodiments of the present disclosure is not limited thereto. When the content (e.g., amount) of the first compound satisfies the above-described proportion, the energy transfer from the second compound and the third compound to the first compound may increase, and thus the luminous efficiency and element service life may increase.

The contents of the second compound and the third compound in the emission layer EML may be the rest excluding the weight of the first compound. For example, the contents of the second compound and the third compound in the emission layer EML may be about 65 wt% to about 95 wt% with respect to the total weight of the first compound, the second compound, and the third compound.

In the total weight of the second compound and the third compound, the weight ratio of the second compound and the third compound may be about 3:7 to about 7:3.

When the contents of the second compound and the third compound satisfy the above-described ratio, a charge balance characteristic in the emission layer EML are improved, and thus the luminous efficiency and device service life may increase. When the contents of the second compound and the third compound deviate from the above-described ratio range, a charge balance in the emission layer EML is broken, and thus the luminous efficiency may be reduced and the device may be easily deteriorated.

When the emission layer EML includes the fourth compound, the content (e.g., amount) of the fourth compound in the emission layer EML may be about 10 wt% to about 30 wt% with respect to the total weight of (100 wt% of) the first compound, the second compound, the third compound, and the fourth compound. However, one or more embodiments of the present disclosure is not limited thereto. When the content (e.g., amount) of the fourth compound satisfies the above-described content (e.g., amount), the energy delivery from the host to the first compound which is a light emitting dopant may be increased, thereby a luminous ratio may be improved, and thus the luminous efficiency of the emission layer EML may be improved. When the first compound, the second compound, the third compound, and the fourth compound included in the emission layer EML satisfy the above-described content (e.g., amount) ratio range, excellent or suitable luminous efficiency and long service life may be achieved.

The emission layer EML is provided on the hole transport region HTR. The emission layer EML may have a thickness of, for example, about 100 Å to about 1,000 Å or about 100 Å to about 300 Å. The emission layer EML may have a single layer formed of a single material, a single layer formed of a plurality of different materials, or a multilayer structure having a plurality of layers formed of a plurality of different materials.

In the light emitting element ED of one or more embodiments, the emission layer EML may include an anthracene derivative, a pyrene derivative, a fluoranthene derivative, a chrysene derivative, a dihydrobenzanthracene derivative, or a triphenylene derivative. For example, the emission layer EML may include the anthracene derivative or the pyrene derivative.

In each light emitting element ED of embodiments illustrated in FIGS. 3 to 6, the emission layer EML may further include a suitable host and dopant besides the above-described host and dopant, and for example the emission layer EML may include a compound represented by Formula E-1. The compound represented by Formula E-1 may be used as a fluorescent host material.

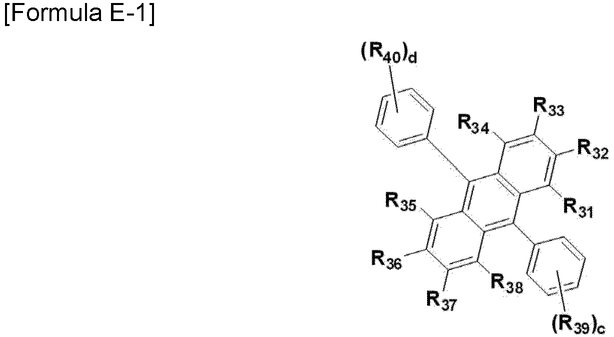

In Formula E-1, R₃₁ to R₄₀ may each independently be a hydrogen atom, a deuterium atom, a halogen atom, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In one or more embodiments, R₃₁ to R₄₀ may be bonded to an adjacent group to form a saturated hydrocarbon ring or an unsaturated hydrocarbon ring, a saturated heterocycle, or an unsaturated heterocycle.

In Formula E-1, c and d may each independently be an integer of 0 to 5.

Formula E-1 may be represented by any one selected from among Compound E1 to Compound E19:

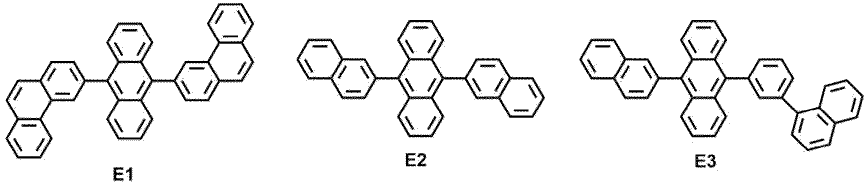

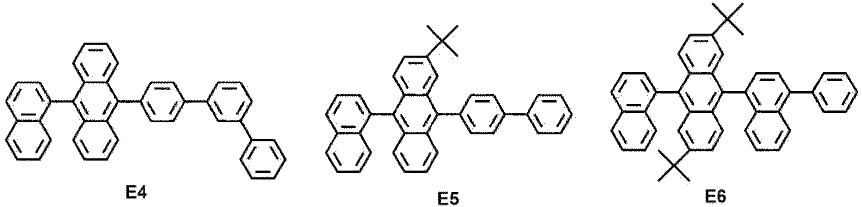

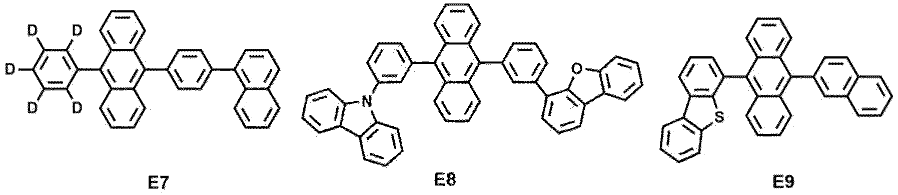

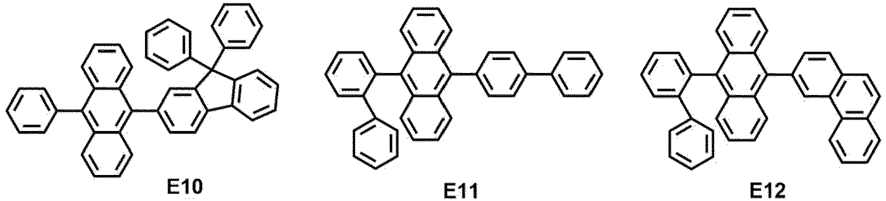

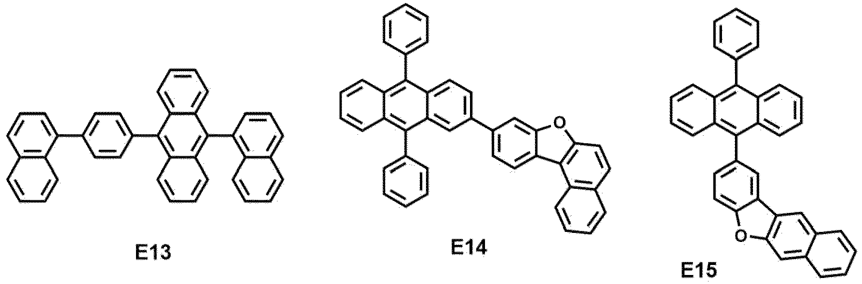

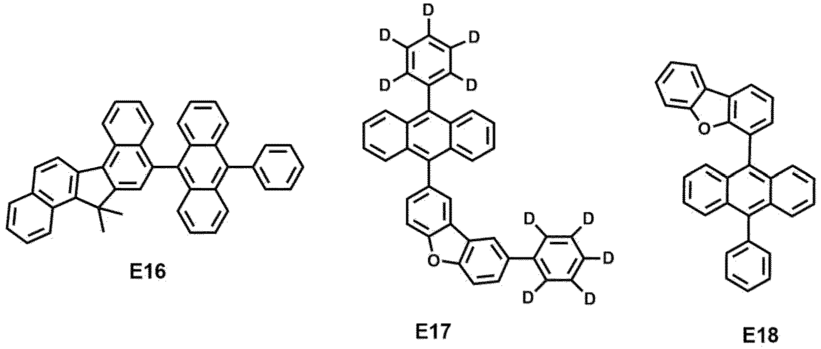

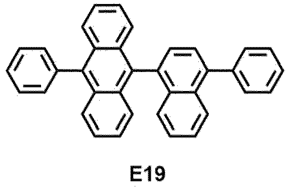

In one or more embodiments, the emission layer EML may include a compound represented by Formula E-2a or Formula E-2b. The compound represented by Formula E-2a or Formula E-2b may be used as a host material for a phosphorescent element.

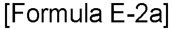

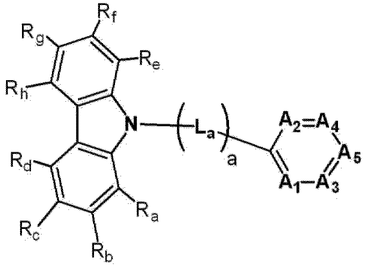

In Formula E-2a, a may be an integer of 0 to 10, and Lₐ may be a direct linkage, a substituted or unsubstituted arylene group having 6 to 30 ring-forming carbon atoms, or a substituted or unsubstituted heteroarylene group having 2 to 30 ring-forming carbon atoms. In one or more embodiments, if (e.g., when) a is an integer of 2 or greater, a plurality of Lₐ's may each independently be a substituted or unsubstituted arylene group having 6 to 30 ring-forming carbon atoms, or a substituted or unsubstituted heteroarylene group having 2 to 30 ring-forming carbon atoms.

In addition, in Formula E-2a, A₁ to A₅ may each independently be N or CRᵢ. Rₐ to Rᵢ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. Rₐ to Rᵢ may be bonded to an adjacent group to form a hydrocarbon ring or a heterocycle containing N, O, S, and/or the like, as a ring-forming atom.

In one or more embodiments, in Formula E-2a, two or three selected from among A₁ to A₅ may be N, and the rest may be CRᵢ.

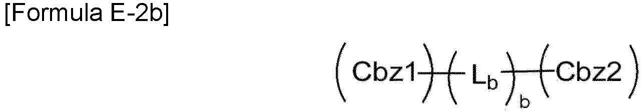

In Formula E-2b, Cbz1 and Cbz2 may each independently be an unsubstituted carbazole group, or a carbazole group substituted with an aryl group having 6 to 30 ring-forming carbon atoms. L_{b} is a direct linkage, a substituted or unsubstituted arylene group having 6 to 30 ring-forming carbon atoms, or a substituted or unsubstituted heteroarylene group having 2 to 30 ring-forming carbon atoms. In one or more embodiments, b is an integer of 0 to 10, and if (e.g., when) b is an integer of 2 or more, a plurality of L_{b}'s may each independently be a substituted or unsubstituted arylene group having 6 to 30 ring-forming carbon atoms, or a substituted or unsubstituted heteroarylene group having 2 to 30 ring-forming carbon atoms.

The compound represented by Formula E-2a or Formula E-2b may be represented by any one selected from among the compounds of Compound Group E-2. However, the compounds listed in Compound Group E-2 are examples, and the compound represented by Formula E-2a or Formula E-2b is not limited to those represented in Compound Group E-2.

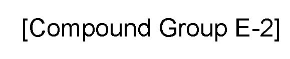

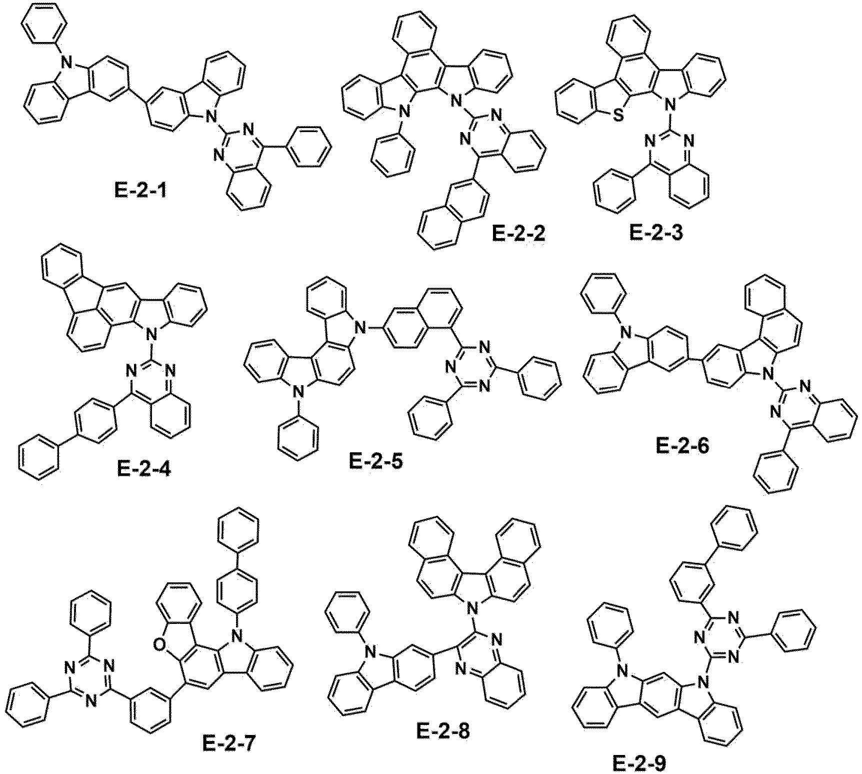

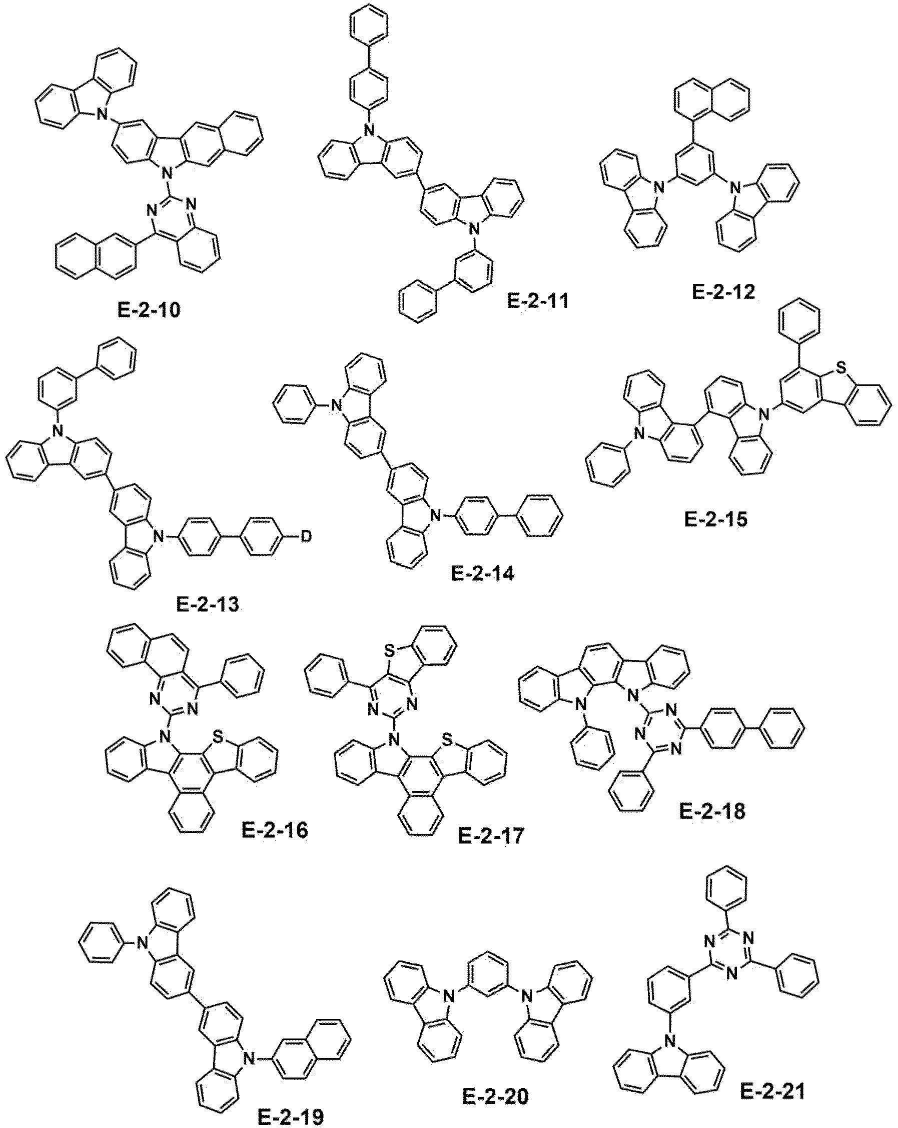

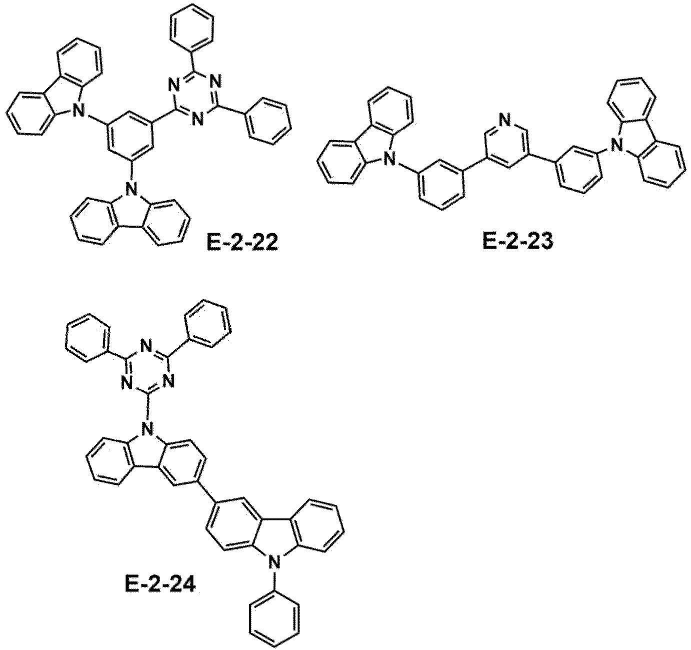

The emission layer EML may further include a general material suitable in the art as a host material. For example, the emission layer EML may include, as a host material, at least one of bis(4-(9H-carbazol-9-yl)phenyl)diphenylsilane (BCPDS), (4-(1-(4-(diphenylamino)phenyl)cyclohexyl)phenyl)diphenyl-phosphine oxide (POPCPA), bis[2-(diphenylphosphino)phenyl]ether oxide (DPEPO), 4,4'-bis(N-carbazolyl)-1,1'-biphenyl (CBP), 1,3-bis(carbazol-9-yl)benzene (mCP), 2,8-bis(diphenylphosphoryl)dibenzo[b,d]furan (PPF), 4,4',4"-tris(carbazol-9-yl)-triphenylamine (TCTA), or 1,3,5-tris(1-phenyl-1H-benzo[d]imidazole-2-yl)benzene (TPBi). However, one or more embodiments of the present disclosure is not limited thereto, for example, tris(8-hydroxyquinolino)aluminum (Alqs), 9,10-di(naphthalen-2-yl)anthracene (ADN), 2-tert-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiOs), octaphenylcyclotetrasiloxane (DPSiO₄), and/or the like may be used as a host material.

The emission layer EML may include the compound represented by Formula M-a. The compound represented by Formula M-a may be used as a phosphorescent dopant material.

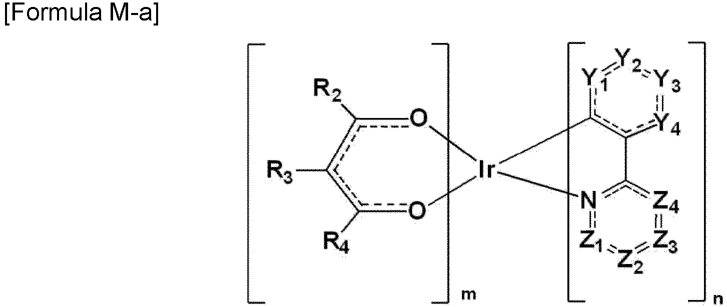

In Formula M-a above, Y₁ to Y₄ and Z₁ to Z₄ may each independently be CR₁ or N, R₁ to R₄ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In Formula M-a, m is 0 or 1, and n is 2 or 3. In Formula M-a, if (e.g., when) m is 0, n is 3, and if (e.g., when) m is 1, n is 2.

The compound represented by Formula M-a may be used as a phosphorescent dopant.

The compound represented by Formula M-a may be represented by any one selected from among Compound M-a1 to Compound M-a25. However, Compounds M-a1 to M-a25 are examples, and the compound represented by Formula M-a is not limited to those represented by Compounds M-a1 to M-a25.

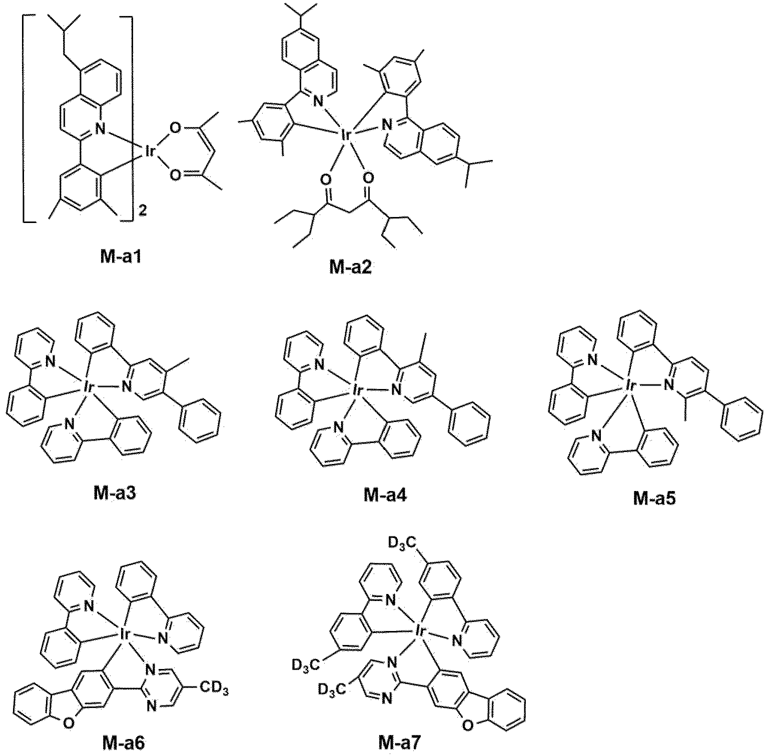

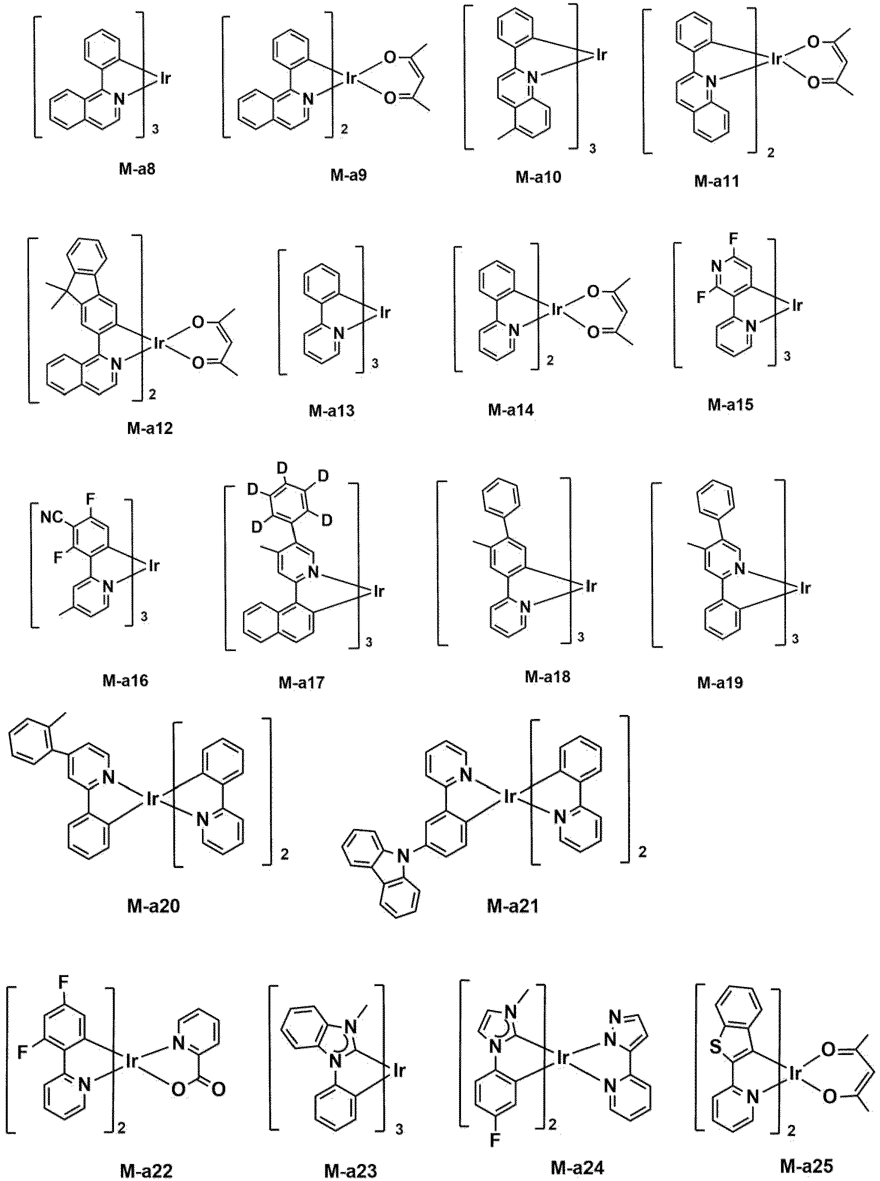

The emission layer EML may include a compound represented by any one selected from among Formula F-a to Formula F-c. The compound represented by Formula F-a to Formula F-c may be used as a fluorescence dopant material.

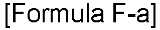

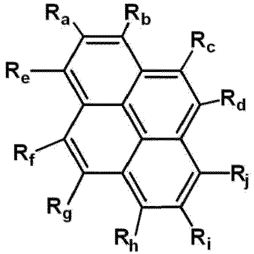

In Formula F-a above, two selected from among Rₐ to Rⱼ may each independently be substituted with *-NAr₁Ar₂. The others, which are not substituted with *-NAr₁Ar₂, among Rₐ to Rⱼ may each independently be a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In *-NAr₁Ar₂, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. For example, at least one of Ar₁ or Ar₂ may be a heteroaryl group containing O or S as a ring-forming atom.

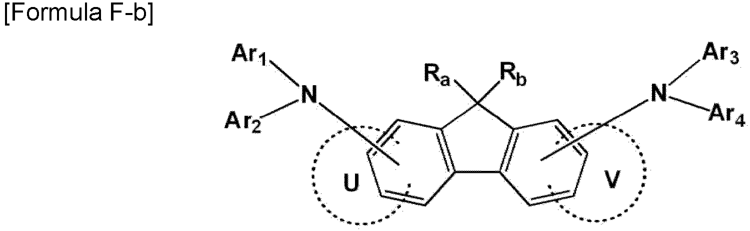

In Formula F-b above, Rₐ and R_{b} may each independently be a hydrogen atom, a deuterium atom, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. Ar₁ to Ar₄ may each independently be a substituted or unsubstituted aryl group having 6 to 30 ring-forming carbon atoms, or a substituted or unsubstituted heteroaryl group having 2 to 30 ring-forming carbon atoms.

In Formula F-b, U and V may each independently be a substituted or unsubstituted hydrocarbon ring having 5 to 30 ring-forming carbon atoms, or a substituted or unsubstituted heterocycle having 2 to 30 ring-forming carbon atoms. At least one selected from among Ar₁ to Ar₄ may be a heteroaryl group containing O or S as a ring-forming atom.

In Formula F-b, the number of rings represented by U and V may each independently be 0 or 1. For example, in Formula F-b, it refers to that if (e.g., when) the number of U or V is 1, one ring constitutes a fused ring at a portion indicated by U or V, and if (e.g., when) the number of U or V is 0, a ring indicated by U or V does not exist. For example, if (e.g., when) the number of U is 0 and the number of V is 1, or if (e.g., when) the number of U is 1 and the number of V is 0, the fused ring having a fluorene core in Formula F-b may be a cyclic compound having four rings. In addition, if (e.g., when) each number of U and V is 0, the fused ring having a fluorene core in Formula F-b may be a cyclic compound having three rings. In addition, if (e.g., when) each number of U and V is 1, the fused ring having a fluorene core in Formula F-b may be a cyclic compound having five rings.

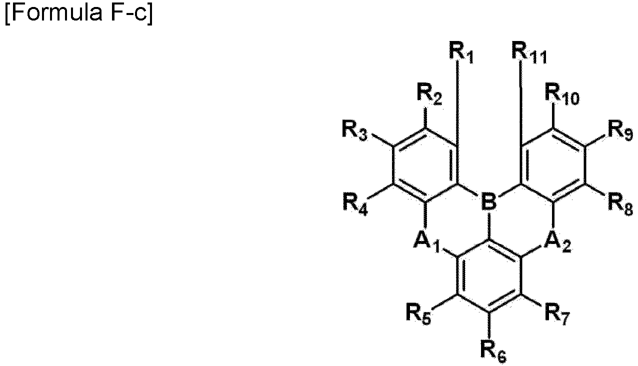

In Formula F-c, A₁ and A₂ may each independently be O, S, Se, or NRₘ, and Rₘ may be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. R₁ to R₁₁ may each independently be a hydrogen atom, a deuterium atom, a halogen atom, a cyano group, a substituted or unsubstituted amine group, a substituted or unsubstituted boryl group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and/or are bonded to an adjacent group to form a ring.

In Formula F-c, A₁ and A₂ may each independently be bonded to substituents of an adjacent ring to form a fused ring. For example, if (e.g., when) A₁ and A₂ may each independently be NRₘ, A₁ may be bonded to R₄ or R₅ to form a ring. In addition, A₂ may be bonded to R₇ or R₈ to form a ring.

In one or more embodiments, the emission layer EML may further include, as a suitable dopant material, a styryl derivative (*e*.*g*., 1,4-bis[2-(3-N-ethylcarbazolyl)vinyl]benzene (BCzVB), 4-(di-p-tolylamino)-4'-[(di-p-tolylamino)styryl]stilbene (DPAVB), and N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi), perylene and a derivative thereof (*e.g.,* 2,5,8,11-tetra-t-butylperylene (TBP)), pyrene and a derivative thereof (*e.g.,* 1,1-dipyrene, 1,4-dipyrenylbenzene, 1,4-bis(N,N-diphenylamino)pyrene), and/or the like.

The emission layer EML may further include a suitable phosphorescence dopant material. For example, a metal complex containing iridium (Ir), platinum (Pt), osmium (Os), aurum (Au), titanium (Ti), zirconium (Zr), hafnium (Hf), europium (Eu), terbium (Tb), or thulium (Tm) may be used as a phosphorescent dopant. For example, iridium(III) bis(4,6-difluorophenylpyridinato-N, C2')picolinate) (FIrpic), bis(2,4-difluorophenylpyridinato)-tetrakis(1-pyrazolyl)borate iridium(III) (Fir6), or platinum octaethyl porphyrin (PtOEP) may be used as a phosphorescent dopant. However, one or more embodiments of the present disclosure is not limited thereto.

The emission layer EML may include a quantum dot material. The core of the quantum dot may be selected from among a Group II-VI compound, a Group I-II-VI compound, a Group II-IV-VI compound, a Group I-II-IV-VI compound, a Group II-IV-V compound. III-VI compound, a Group I-III-VI compound, a Group III-V compound, a Group III-II-V compound, a Group IV-VI compound, a Group IV element, a Group IV compound, and/or a (e.g., any suitable) combination thereof.

The Group II-VI compound may be selected from among the group consisting of a binary compound selected from among the group consisting of CdSe, CdTe, CdS, ZnS, ZnSe, ZnTe, ZnO, HgS, HgSe, HgTe, MgSe, MgS, and/or a (e.g., any suitable) mixture thereof, a ternary compound selected from among the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and/or a (e.g., any suitable) mixture thereof, and a quaternary compound selected from among the group consisting of HgZnTeS, CdZnSeS, CdZnSeTe, CdZnSTe, CdHgSeS, CdHgSeTe, CdHgSTe, HgZnSeS, HgZnSeTe, and/or a (e.g., any suitable) mixture thereof.

In one or more embodiments, the Group II-VI compound may further include a Group I metal and/or a Group IV element. The Group I-II-VI compound may be selected from among CuSnS or CuZnS, and ZnSnS, and/or the like may be selected as the Group II-IV-VI compound. The Group I-II-IV-VI compound may be selected from among a quaternary compound selected from among the group consisting of Cu₂ZnSnS₂, Cu₂ZnSnS₄, Cu₂ZnSnSe₄, Ag₂ZnSnS₂, and/or a (e.g., any suitable) mixture thereof.

The Group II-IV-V compound may be a ternary compound selected from among the group consisting of ZnSnP, ZnSnP₂, ZnSnAs₂, ZnGeP₂, ZnGeAs₂, CdSnP₂, CdGeP₂, and/or a (e.g., any suitable) mixture thereof.

The Group III-VI compound may include a binary compound such as GaS, Ga₂S₃, GaSe, Ga₂Se₃, GaTe, InTe, InS, InSe, In₂S₃, or In₂Se₃, a ternary compound such as InGaS₃ or InGaSes, or any combination thereof.

The Group I-III-VI compound may be selected from among a ternary compound selected from among the group consisting of AgInS, AgInS₂, CuInS, CuInS₂, AgGaS₂, CuGaS₂ CuGaO₂, AgGaO₂, AgAlO₂, and/or a (e.g., any suitable) mixture thereof, or a quaternary compound such as AgInGaS₂ or CuInGaS₂.

The Group III-V compound may be selected from among the group consisting of a binary compound selected from among the group consisting of GaN, GaP, GaAs, GaSb, AlN, AlP, AlAs, AlSb, InN, InP, InAs, InSb, and/or a (e.g., any suitable) mixture thereof, a ternary compound selected from among the group consisting of GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and/or a (e.g., any suitable) mixture thereof, and a quaternary compound selected from among the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and/or a (e.g., any suitable) mixture thereof. In one or more embodiments, the Group III-V compound may further include a Group II metal. For example, InZnP, and/or the like may be selected as a Group III-II-V compound.

The Group IV-VI compound may be selected from among the group consisting of a binary compound selected from among the group consisting of SnS, SnSe, SnTe, PbS, PbSe, PbTe, and/or a (e.g., any suitable) mixture thereof, a ternary compound selected from among the group consisting of SnSeS, SnSeTe, SnSTe, PbSeS, PbSeTe, PbSTe, SnPbS, SnPbSe, SnPbTe, and/or a (e.g., any suitable) mixture thereof, and a quaternary compound selected from among the group consisting of SnPbSSe, SnPbSeTe, SnPbSTe, and/or a (e.g., any suitable) mixture thereof. The Group IV element may be selected from among the group consisting of Si, Ge, and/or a (e.g., any suitable) mixture thereof. The Group IV compound may be a binary compound selected from among the group consisting of SiC, SiGe, and/or a (e.g., any suitable) mixture thereof.

Each element included in a polynary compound such as the binary compound, the ternary compound, or the quaternary compound may be present in a particle with a substantially uniform or substantially non-uniform concentration distribution. For example, the formulae refer to the types (kinds) of elements included in the compounds, and the elemental ratio in the compound may be different. For example, AgInGaS₂ may refer to AgInₓGa₁₋ₓS₂ (where x is a real number of 0 to 1).

In one or more embodiments, the quantum dot may have a single structure or a double structure of core-shell in which the concentration of each element included in the quantum dot is substantially uniform. For example, the material included in the core may be different from the material included in the shell.

The shell of the quantum dot may serve as a protection layer to prevent or reduce the chemical deformation of the core to maintain semiconductor properties, and/or a charging layer to impart electrophoresis properties to the quantum dot. The shell may be a single layer or a multilayer. An interface between the core and the shell may have a concentration gradient in which the concentration of an element present in the shell becomes lower towards the center.

In one or more embodiments, the quantum dot may have the above-described core-shell structure including a core containing nanocrystals and a shell around (e.g., surrounding) the core. An example of the shell of the quantum dots may include a metal or non-metal oxide, a semiconductor compound, and/or a (e.g., any suitable) combination thereof.

For example, the metal or non-metal oxide may be a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO, or a ternary compound such as MgAl₂O₄, CoFe₂O₄, NiFe₂O₄, or CoMn₂O₄, but one or more embodiments of the present disclosure is not limited thereto.

Also, examples of the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, and/or the like, but one or more embodiments of the present disclosure is not limited thereto.

Each element included in a polynary compound such as the binary compound, or the ternary compound may be present in a particle with a substantially uniform or substantially non-uniform concentration distribution. For example, the formulae refer to the types (kinds) of elements included in the compounds, and the elemental ratio in the compound may be different.

The quantum dot may have a full width of half maximum (FWHM) of an emission wavelength spectrum of about 45 nm or less, about 40 nm or less, and more about 30 nm or less, and color purity or color reproducibility may be improved in the above range. In addition, because the light emitted through the quantum dot is emitted in all directions, a wide viewing angle may be improved.

In addition, although the form of the quantum dot is not particularly limited as long as it is a form commonly used in the art, more specifically, the quantum dot in the form of spherical, pyramidal, multi-arm, or cubic nanoparticles, nanotubes, nanowires, nanofibers, nanoplate particles, and/or the like may be used.

As the size of the quantum dot is adjusted or the elemental ratio in the quantum dot compound is adjusted, it is possible to control the energy band gap, and thus light in one or more suitable wavelength ranges may be obtained in the quantum dot emission layer. Therefore, the quantum dot as above (using different sizes of quantum dots or different elemental ratios in the quantum dot compound) is used, and thus the light emitting element, which emits light in one or more suitable wavelengths, may be implemented. For example, the adjustment of the size of the quantum dot or the elemental ratio in the quantum dot compound may be selected to emit red, green, and/or blue light. In addition, the quantum dots may be configured to emit white light by combining one or more suitable colors of light.

In each of the light emitting elements ED of embodiments illustrated in FIGS. 3 to 6, the electron transport region ETR is provided on the emission layer EML. The electron transport region ETR may include at least one of the hole blocking layer HBL, the electron transport layer ETL, or the electron injection layer EIL, but one or more embodiments of the present disclosure is not limited thereto.

The electron transport region ETR may have a single layer formed of a single material, a single layer formed of a plurality of different materials, or a multilayer structure including a plurality of layers formed of a plurality of different materials.

For example, the electron transport region ETR may have a single layer structure of the electron injection layer EIL or the electron transport layer ETL, and may have a single layer structure formed of an electron injection material and an electron transport material. In addition, the electron transport region ETR may have a single layer structure formed of a plurality of different materials, or may have a structure in which an electron transport layer ETL/electron injection layer EIL, a hole blocking layer HBL/electron transport layer ETL/electron injection layer EIL are stacked in order from the emission layer EML, but one or more embodiments of the present disclosure is not limited thereto. The electron transport region ETR may have a thickness, for example, from about 1,000 Å to about 1,500 Å.

The electron transport region ETR may be formed using one or more suitable methods such as a vacuum deposition method, a spin coating method, a cast method, a Langmuir-Blodgett (LB) method, an inkjet printing method, a laser printing method, and a laser induced thermal imaging (LITI) method.

The electron transport region ETR may include a compound represented by Formula ET-2:

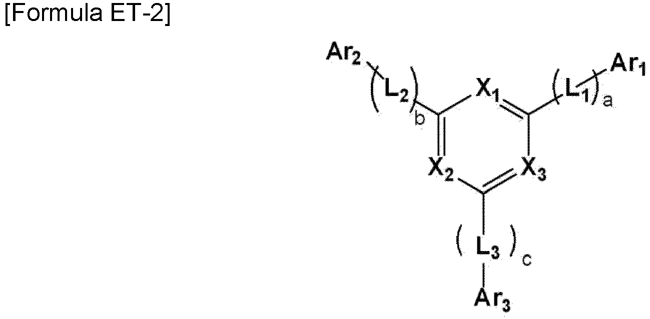

In Formula ET-2, at least one selected from among X₁ to X₃ is N, and the rest are CRₐ. Rₐ may be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. Ar₁ to Ar₃ may each independently be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In Formula ET-2, a to c may each independently be an integer of 0 to 10. In Formula ET-2, L₁ to L₃ may each independently be a direct linkage, a substituted or unsubstituted arylene group having 6 to 30 ring-forming carbon atoms, or a substituted or unsubstituted heteroarylene group having 2 to 30 ring-forming carbon atoms. In one or more embodiments, if (e.g., when) a to c may each independently be an integer of 2 or more, L₁ to L₃ may each independently be a substituted or unsubstituted arylene group having 6 to 30 ring-forming carbon atoms, or a substituted or unsubstituted heteroarylene group having 2 to 30 ring-forming carbon atoms.

The electron transport region ETR may include an anthracene-based compound. However, one or more embodiments of the present disclosure is not limited thereto, and the electron transport region ETR may include, for example, tris(8-hydroxyquinolinato)aluminum (Alqs), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1 - yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenylyl)-5-(4-tert-butylphenyl)-1,3,4-oxadiazole (tBu-PBD), bis(2-methyl-8-quinolinolato-N1,O8)-(1,1'-biphenyl-4-olato)aluminum (BAlq), beryllium bis(benzoquinolin-10-olate) (Bebq₂), 9,10-di(naphthalen-2-yl)anthracene (ADN), 1,3-bis[3,5-di(pyridin-3-yl)phenyl]benzene (BmPyPhB), and/or a (e.g., any suitable) mixture thereof.

The electron transport region ETR may include at least one selected from among Compound ET1 to Compound ET36:

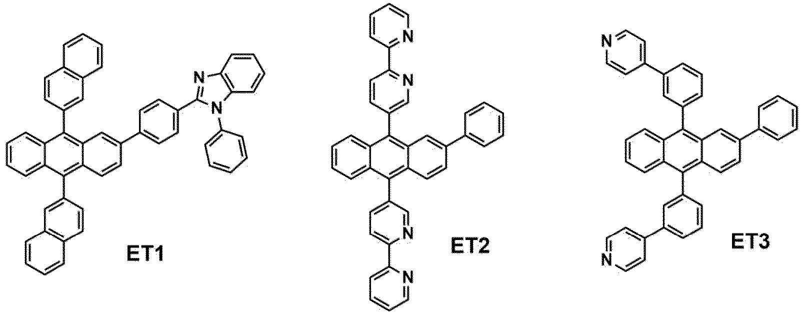

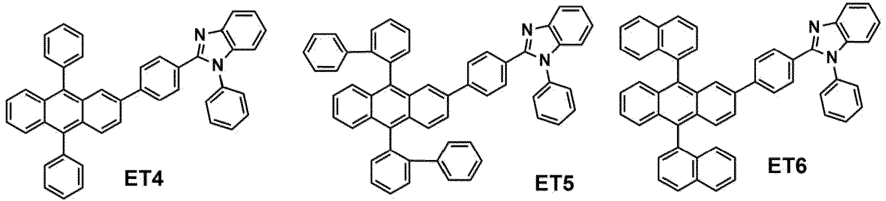

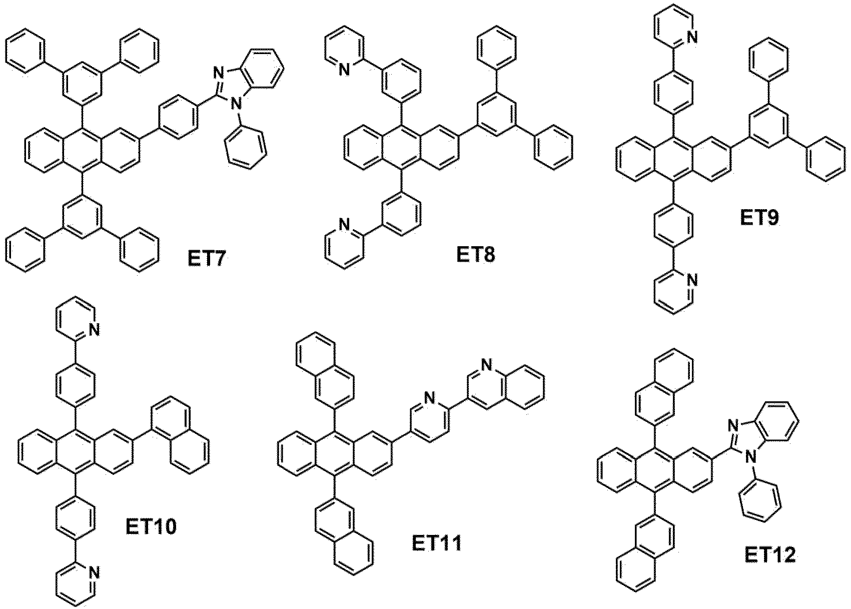

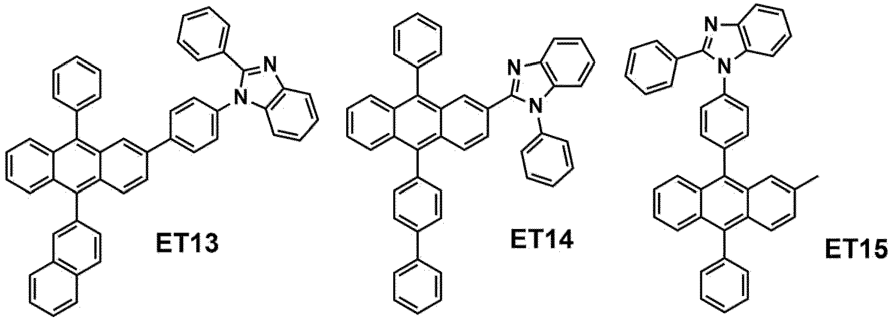

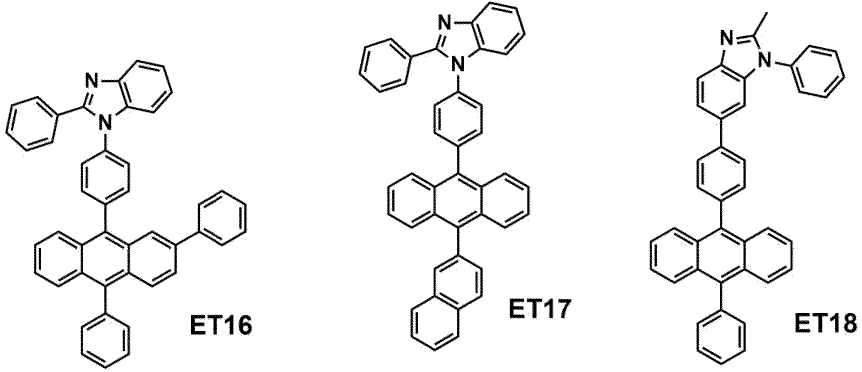

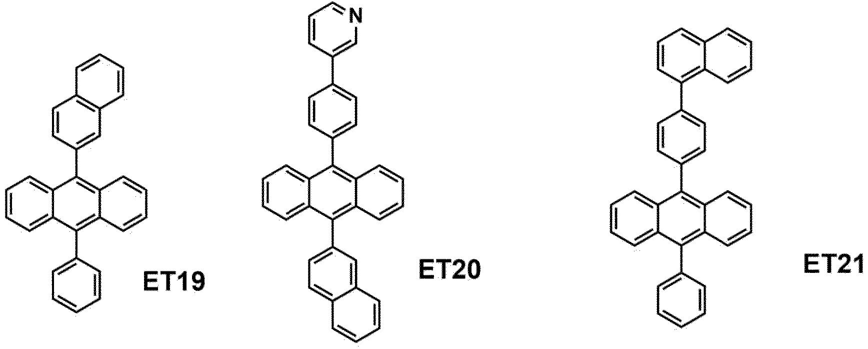

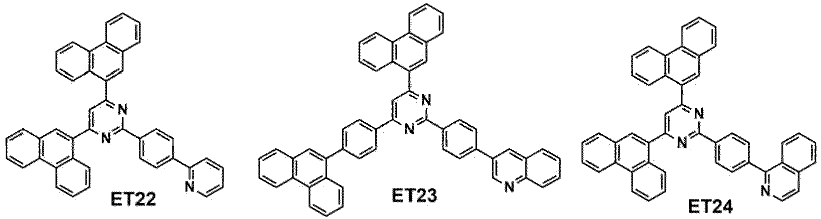

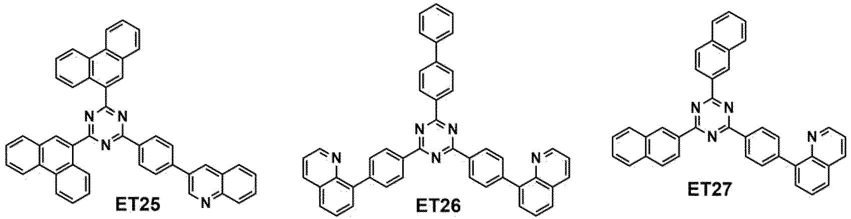

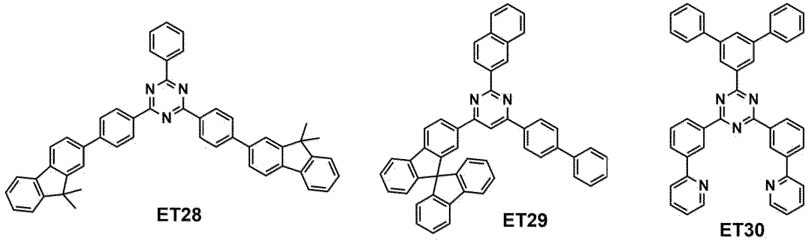

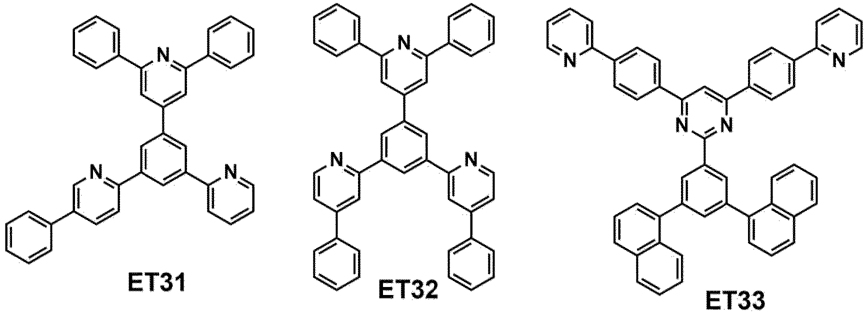

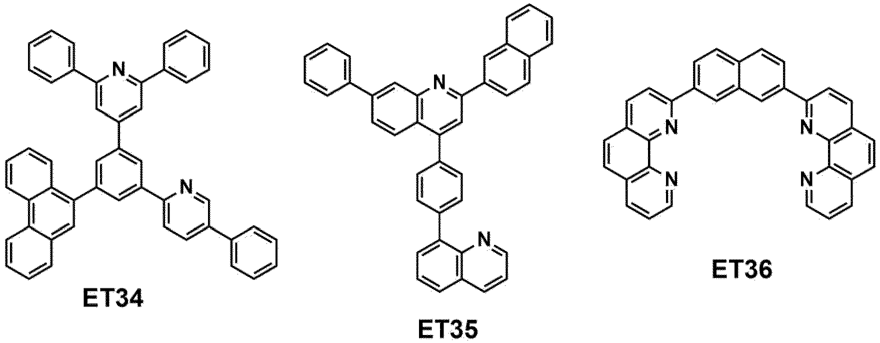

In addition, the electron transport region ETR may include a metal halide such as LiF, NaCl, CsF, RbCl, Rbl, Cui, and KI, a lanthanide metal such as Yb, and a co-deposited material of the metal halide and the lanthanide metal. For example, the electron transport region ETR may include KI:Yb, RbI:Yb, LiF:Yb, and/or the like, as a co-deposited material. In one or more embodiments, the electron transport region ETR may be formed using a metal oxide such as Li₂O or BaO, or 8-hydroxyl-lithium quinolate (Liq), and/or the like, but one or more embodiments of the present disclosure is not limited thereto. The electron transport region ETR may also be formed of a mixture material of an electron transport material and an insulating organometallic salt. The organometallic salt may be a material having an energy band gap of about 4 eV or more. For example, the organometallic salt may include, for example, a metal acetate, a metal benzoate, a metal acetoacetate, a metal acetylacetonate, or a metal stearate.

The electron transport region ETR may further include at least one of 2,9-dimethyl-4,7-diphenyl-1,10-phenanthroline (BCP), diphenyl(4-(triphenylsilyl)phenyl)phosphine oxide (TSPO1), or 4,7-diphenyl-1,10-phenanthroline (Bphen) in addition to the above-described materials, but one or more embodiments of the present disclosure is not limited thereto.

The electron transport region ETR may include the above-described compounds of the electron transport region in at least one of the electron injection layer EIL, the electron transport layer ETL, or the hole blocking layer HBL.

When the electron transport region ETR includes the electron transport layer ETL, the electron transport layer ETL may have a thickness of about 100 Å to about 1,000 Å, for example, about 150 Å to about 500 Å. If the thickness of the electron transport layer ETL satisfies the aforementioned range, satisfactory electron transport characteristics may be obtained without a substantial increase in driving voltage. When the electron transport region ETR includes the electron injection layer EIL, the electron injection layer EIL may have a thickness of about 1 Å to about 100 Å, for example, about 3 Å to about 90 Å. If the thickness of the electron injection layer EIL satisfies the above-described range, satisfactory electron injection characteristics may be obtained without a substantial increase in driving voltage.

The second electrode EL2 is provided on the electron transport region ETR. The second electrode EL2 may be a common electrode. The second electrode EL2 may be a cathode or an anode, but one or more embodiments of the present disclosure is not limited thereto. For example, if (e.g., when) the first electrode EL1 is an anode, the second electrode EL2 may be a cathode, and if (e.g., when) the first electrode EL1 is a cathode, the second electrode EL2 may be an anode.

The second electrode EL2 may be a transmissive electrode, a transflective electrode, or a reflective electrode. When the second electrode EL2 is the transmissive electrode, the second electrode EL2 may be formed of a transparent metal oxide, for example, indium tin oxide (ITO), indium zinc oxide (IZO), zinc oxide (ZnO), indium tin zinc oxide (ITZO), and/or the like.

When the second electrode EL2 is the transflective electrode or the reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, or a compound or mixture thereof (e.g., AgMg, AgYb, or MgYb). In one or more embodiments, the second electrode EL2 may have a multilayer structure including a reflective film or a transflective film formed of the above-described materials, and a transparent conductive film formed of ITO, IZO, ZnO, ITZO, and/or the like. For example, the second electrode EL2 may include the above-described metal materials, combinations of at least two metal materials of the above-described metal materials, oxides of the above-described metal materials, and/or the like.

In one or more embodiments, the second electrode EL2 may be connected with an auxiliary electrode. If the second electrode EL2 is connected with the auxiliary electrode, the resistance of the second electrode EL2 may be decreased.

In one or more embodiments, a capping layer CPL may further be arranged on the second electrode EL2 of the light emitting element ED of one or more embodiments. The capping layer CPL may include a multilayer or a single layer.

In one or more embodiments, the capping layer CPL may be an organic layer or an inorganic layer. For example, if (e.g., when) the capping layer CPL contains an inorganic material, the inorganic material may include an alkaline metal compound (e.g., LiF), an alkaline earth metal compound (e.g., MgF₂), SiON, SiNₓ, SiO_{y}, and/or the like.

For example, if (e.g., when) the capping layer CPL includes an organic material, the organic material may include α-NPD, NPB, TPD, m-MTDATA, Alq₃, CuPc, N4,N4,N4',N4'-tetra(biphenyl-4-yl)biphenyl-4,4'-diamine (TPD15), 4,4',4"-tris(carbazol-9-yl)triphenylamine (TCTA), and/or the like, or an epoxy resin, or acrylate such as methacrylate. However, one or more embodiments of the present disclosure is not limited thereto, and the capping layer CPL may include at least one selected from among Compounds P1 to P5:

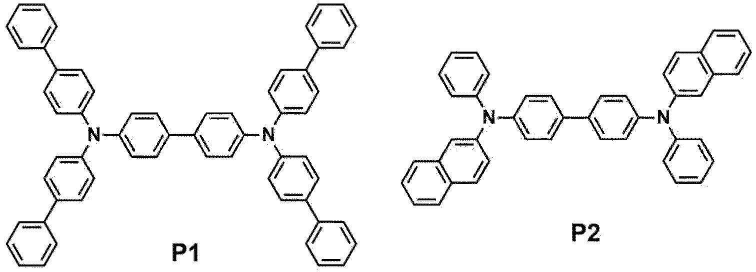

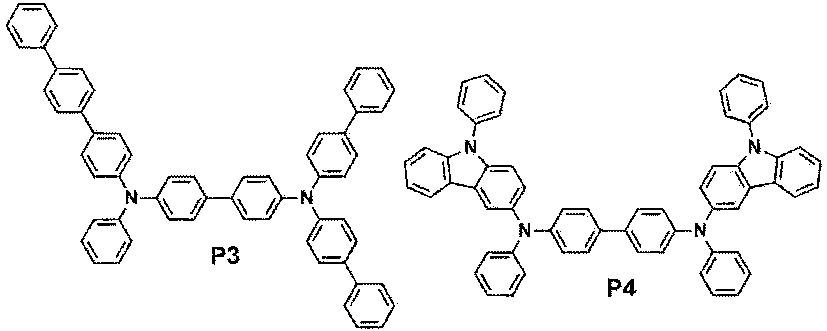

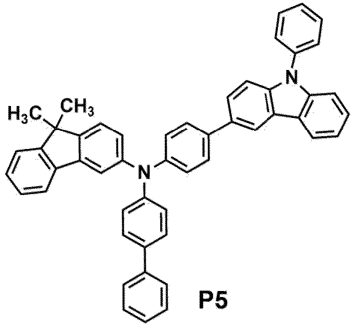

In one or more embodiments, the refractive index of the capping layer CPL may be about 1.6 or more. For example, the refractive index of the capping layer CPL may be about 1.6 or more with respect to light in a wavelength range of about 550 nm to about 660 nm.

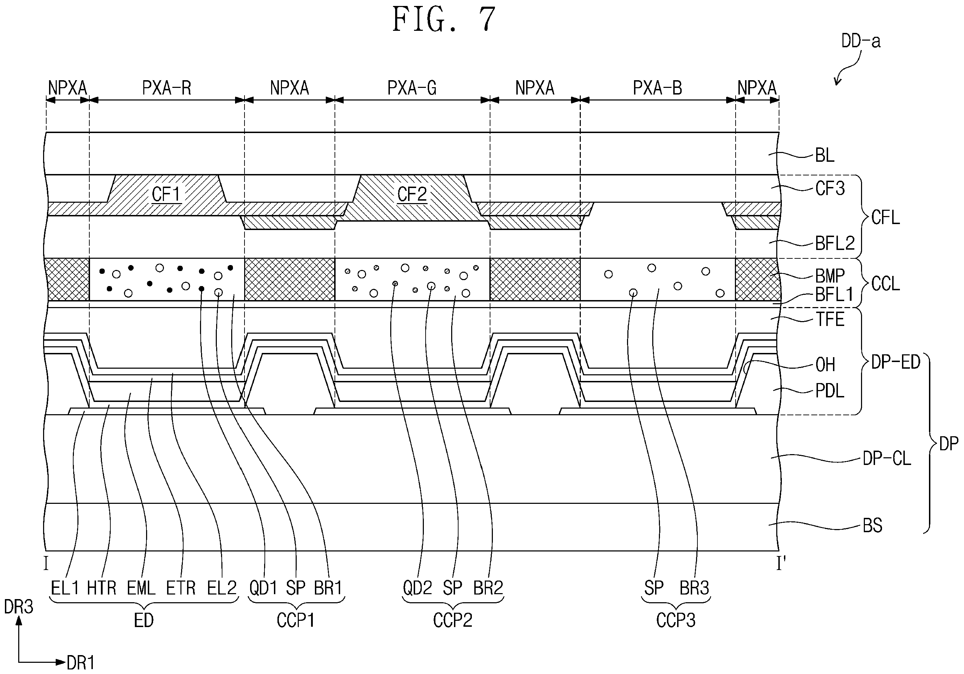

Each of FIGS. 7 to 10 is a cross-sectional view of a display device according to one or more embodiments of the present disclosure. Hereinafter, in describing the display devices of embodiments with reference to FIGS. 7 to 10, the duplicated features which have been described in FIGS. 1 to 6 are not described again, but their differences will be mainly described.

Referring to FIG. 7, the display device DD-a according to one or more embodiments may include a display panel DP including a display element layer DP-ED, a light control layer CCL arranged on the display panel DP, and a color filter layer CFL. In one or more embodiments illustrated in FIG. 7, the display panel DP may include a base layer BS, a circuit layer DP-CL, and the display element layer DP-ED provided on the base layer BS, and the display element layer DP-ED may include a light emitting element ED.

The light emitting element ED may include a first electrode EL1, a hole transport region HTR arranged on the first electrode EL1, an emission layer EML arranged on the hole transport region HTR, an electron transport region ETR arranged on the emission layer EML, and a second electrode EL2 arranged on the electron transport region ETR. The light emitting element ED of one or more embodiments illustrated in FIG. 7 may include the fused polycyclic compound of one or more embodiments. The light emitting element ED including the fused polycyclic compound of one or more embodiments may exhibit high efficiency and long service life characteristics. In one or more embodiments, the structures of the light emitting elements of FIGS. 3 to 6 as described above may be equally applied to the structure of the light emitting element ED illustrated in FIG. 7.

Referring to FIG. 7, the emission layer EML may be arranged in an opening OH defined in a pixel defining film PDL. For example, the emission layer EML which is divided by the pixel defining film PDL and provided corresponding to each light emitting regions PXA-R, PXA-G, and PXA-B may be configured to emit light in substantially the same wavelength range. In the display device DD-a of one or more embodiments, the emission layer EML may be configured to emit blue light. In one or more embodiments, unlike the configuration illustrated, in one or more embodiments, the emission layer EML may be provided as a common layer in the entire light emitting regions PXA-R, PXA-G, and PXA-B.

The light control layer CCL may be arranged on the display panel DP. The light control layer CCL may include a light conversion body. The light conversion body may be a quantum dot, a phosphor, and/or the like. The light conversion body may be configured to emit provided light by converting the wavelength thereof. For example, the light control layer CCL may be a layer containing the quantum dot or a layer containing the phosphor.

The light control layer CCL may include a plurality of light control parts CCP1, CCP2 and CCP3. The light control parts CCP1, CCP2, and CCP3 may be spaced and/or apart (e.g., spaced apart or separated) from each other.

Referring to FIG. 7, divided patterns BMP may be arranged between the light control parts CCP1, CCP2 and CCP3 which are spaced and/or apart (e.g., spaced apart or separated) from each other, but one or more embodiments of the present disclosure is not limited thereto. FIG. 7 illustrates that the divided patterns BMP do not overlap the light control parts CCP1, CCP2 and CCP3, but at least a portion of the edges of the light control parts CCP1, CCP2 and CCP3 may overlap the divided patterns BMP.

The light control layer CCL may include a first light control part CCP1 containing a first quantum dot QD1 which converts first color light provided from the light emitting element ED into second color light, a second light control part CCP2 containing a second quantum dot QD2 which converts the first color light into third color light, and a third light control part CCP3 which transmits the first color light.

In one or more embodiments, the first light control part CCP1 may provide red light that is the second color light, and the second light control part CCP2 may provide green light that is the third color light. The third light control part CCP3 may provide blue light by transmitting the blue light that is the first color light provided from the light emitting element ED. For example, the first quantum dot QD1 may be a red quantum dot, and the second quantum dot QD2 may be a green quantum dot. The same as described above may be applied with respect to the quantum dots QD1 and QD2.

In addition, the light control layer CCL may further include a scatterer SP. The first light control part CCP1 may include the first quantum dot QD1 and the scatterer SP, the second light control part CCP2 may include the second quantum dot QD2 and the scatterer SP, and the third light control part CCP3 may not include (e.g., may exclude) any quantum dot but include the scatterer SP.

The scatterer SP may be inorganic particles. For example, the scatterer SP may include at least one of TiO₂, ZnO, Al₂O₃, SiO₂, or hollow sphere silica. The scatterer SP may include any one among TiO₂, ZnO, Al₂O₃, SiO₂, and hollow sphere silica, or may be a mixture of at least two materials selected from among TiO₂, ZnO, Al₂O₃, SiO₂, and hollow sphere silica.

The first light control part CCP1, the second light control part CCP2, and the third light control part CCP3 each may include base resins BR1, BR2, and BR3 in which the quantum dots QD1 and QD2 and the scatterer SP are dispersed. In one or more embodiments, the first light control part CCP1 may include the first quantum dot QD1 and the scatterer SP dispersed in a first base resin BR1, the second light control part CCP2 may include the second quantum dot QD2 and the scatterer SP dispersed in a second base resin BR2, and the third light control part CCP3 may include the scatterer SP dispersed in a third base resin BR3.

The base resins BR1, BR2, and BR3 are media in which the quantum dots QD1 and QD2 and the scatterer SP are dispersed, and may be formed of one or more suitable resin compositions, which may be generally referred to as a binder. For example, the base resins BR1, BR2, and BR3 may be acrylic-based resins, urethane-based resins, silicone-based resins, epoxy-based resins, and/or the like. The base resins BR1, BR2, and BR3 may be transparent resins. In one or more embodiments, the first base resin BR1, the second base resin BR2, and the third base resin BR3 may be the same as or different from each other.

The light control layer CCL may include a barrier layer BFL1. The barrier layer BFL1 may serve to prevent or reduce the penetration of moisture and/or oxygen (hereinafter, referred to as 'moisture/oxygen'). The barrier layer BFL1 may block the light control parts CCP1, CCP2 and CCP3 from being exposed to moisture/oxygen. In one or more embodiments, the barrier layer BFL1 may cover the light control parts CCP1, CCP2, and CCP3. In addition, the barrier layer BFL2 may be provided between the light control parts CCP1, CCP2, and CCP3 and the color filter layer CFL.

The barrier layers BFL1 and BFL2 may include at least one inorganic layer. For example, the barrier layers BFL1 and BFL2 may include an inorganic material. For example, the barrier layers BFL1 and BFL2 may include a silicon nitride, an aluminum nitride, a zirconium nitride, a titanium nitride, a hafnium nitride, a tantalum nitride, a silicon oxide, an aluminum oxide, a titanium oxide, a tin oxide, a cerium oxide, a silicon oxynitride, a metal thin film which secures a transmittance, and/or the like. In one or more embodiments, the barrier layers BFL1 and BFL2 may further include an organic film. The barrier layers BFL1 and BFL2 may be formed of a single layer or a plurality of layers.

In the display device DD-a of one or more embodiments, the color filter layer CFL may be arranged on the light control layer CCL. For example, the color filter layer CFL may be directly arranged on the light control layer CCL. In this case, the barrier layer BFL2 may not be provided.

The color filter layer CFL may include filters CF1, CF2, and CF3. The color filter layer CFL may include a first filter CF1 configured to transmit the second color light, a second filter CF2 configured to transmit the third color light, and a third filter CF3 configured to transmit the first color light. For example, the first filter CF1 may be a red filter, the second filter CF2 may be a green filter, and the third filter CF3 may be a blue filter. The filters CF1, CF2, and CF3 each may include a polymeric photosensitive resin and a pigment or dye. The first filter CF1 may include a red pigment or dye, the second filter CF2 may include a green pigment or dye, and the third filter CF3 may include a blue pigment or dye.

In one or more embodiments, one or more embodiments of the present disclosure is not limited thereto, and the third filter CF3 may not include a (e.g., may exclude any) pigment or dye. The third filter CF3 may include a polymeric photosensitive resin and may not include a (e.g., may exclude any) pigment or dye. The third filter CF3 may be transparent. The third filter CF3 may be formed of a transparent photosensitive resin.

Furthermore, in one or more embodiments, the first filter CF1 and the second filter CF2 may be a yellow filter. The first filter CF1 and the second filter CF2 may not be separated but be provided as one filter.

In one or more embodiments, the color filter layer CFL may further include a light shielding part. The light shielding part may be a black matrix. The light shielding part may include an organic light shielding material or an inorganic light shielding material containing a black pigment or dye. The light shielding part may prevent or reduce light leakage, and may separate boundaries between the adjacent filters CF1, CF2, and CF3.

The first to third filters CF1, CF2, and CF3 may be arranged corresponding to the red light emitting region PXA-R, the green light emitting region PXA-G, and the blue light emitting region PXA-B, respectively.

A base substrate BL may be arranged on the color filter layer CFL. The base substrate BL may be a member which provides a base surface in which the color filter layer CFL, the light control layer CCL, and/or the like are arranged. The base substrate BL may be a glass substrate, a metal substrate, a plastic substrate, and/or the like. However, one or more embodiments of the present disclosure is not limited thereto, and the base substrate BL may be an inorganic layer, an organic layer, or a composite material layer. In addition, unlike the configuration illustrated, in one or more embodiments, the base substrate BL may not be provided.

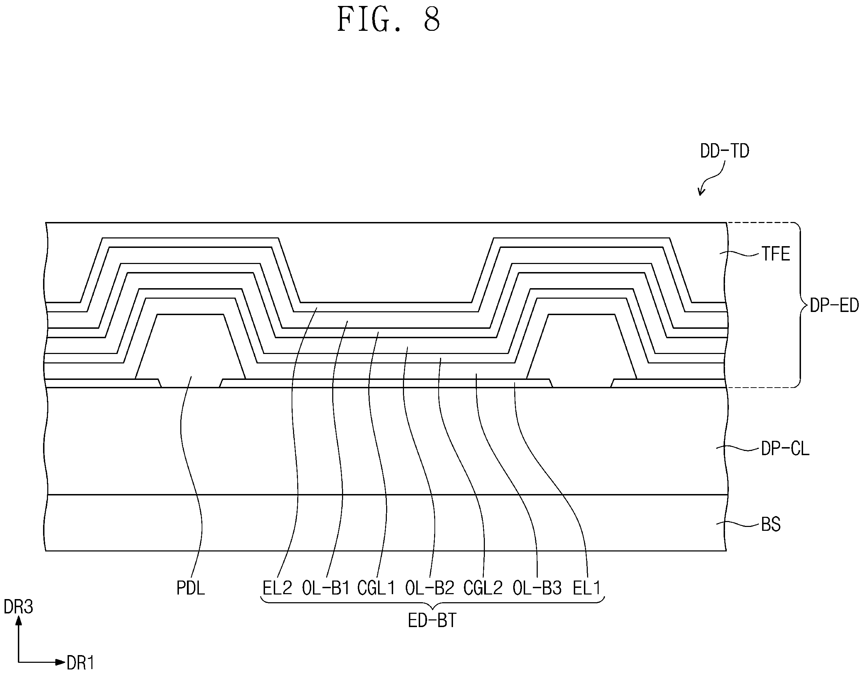

FIG. 8 is a cross-sectional view illustrating a portion of a display device according to one or more embodiments. In the display device DD-TD of one or more embodiments, the light emitting element ED-BT may include a plurality of light emitting structures OL-B1, OL-B2, and OL-B3. The light emitting element ED-BT may include a first electrode EL1 and a second electrode EL2 which face each other, and the plurality of light emitting structures OL-B1, OL-B2, and OL-B3 sequentially stacked in the thickness direction between the first electrode EL1 and the second electrode EL2. The light emitting structures OL-B1, OL-B2, and OL-B3 each may include an emission layer EML (FIG. 7) and a hole transport region HTR and an electron transport region ETR arranged with the emission layer EML (FIG. 7) located therebetween. For example, the light emitting element ED-BT included in the display device DD-TD of one or more embodiments may be a light emitting element having a tandem structure and including a plurality of emission layers. The light emitting element ED-BT of one or more embodiments illustrated in FIG. 8 may include the fused polycyclic compound of one or more embodiments. The light emitting element ED-BT including the fused polycyclic compound of one or more embodiments may exhibit high efficiency and long service life characteristics.

In one or more embodiments illustrated in FIG. 8, all light beams respectively emitted from the light emitting structures OL-B1, OL-B2, and OL-B3 may be blue light. However, one or more embodiments of the present disclosure is not limited thereto, and the light beams respectively emitted from the light emitting structures OL-B1, OL-B2, and OL-B3 may have wavelength ranges different from each other. For example, the light emitting element ED-BT including the plurality of light emitting structures OL-B1, OL-B2, and OL-B3 which emit light beams having wavelength ranges different from each other may be configured to emit white light.

Charge generation layers CGL1 and CGL2 may be respectively arranged between two of the neighboring light emitting structures OL-B1, OL-B2, and OL-B3. The charge generation layers CGL1 and CGL2 may include a p-type or kind charge generation layer and/or an n-type or kind charge generation layer.

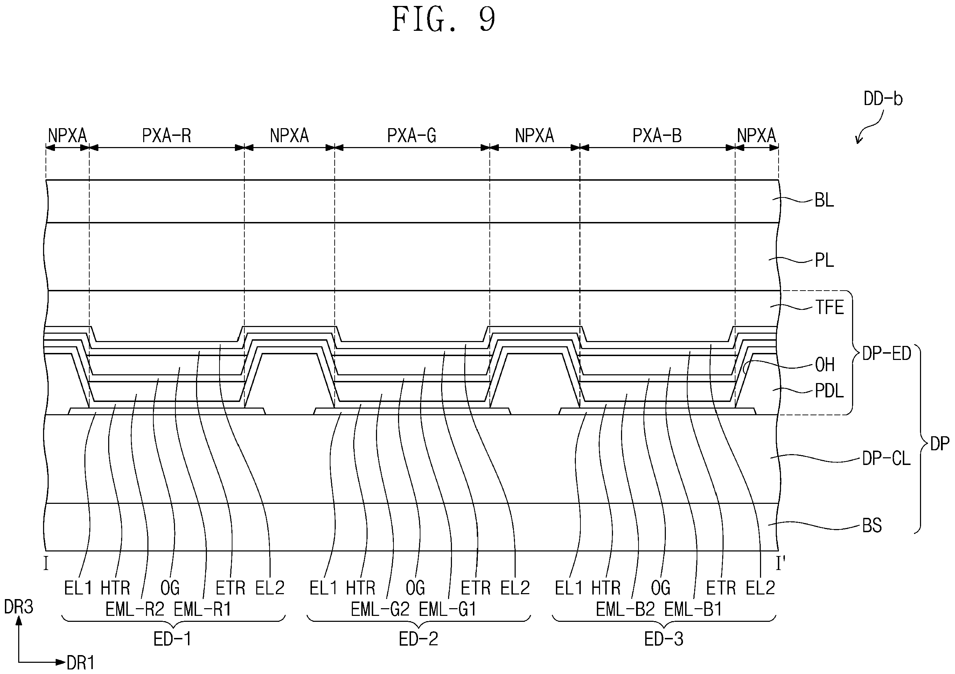

Referring to FIG. 9, the display device DD-b according to one or more embodiments may include light emitting elements ED-1, ED-2, and ED-3 in which two emission layers are stacked. Compared with the display device DD of one or more embodiments illustrated in FIG. 2, one or more embodiments illustrated in FIG. 9 has a difference in that the first to third light emitting elements ED-1, ED-2, and ED-3 each include two emission layers stacked in the thickness direction. In each of the first to third light emitting elements ED-1, ED-2, and ED-3, the two emission layers may be configured to emit light in substantially the same wavelength region. At least one among the first to third light emitting elements ED-1, ED-2, and ED-3 may include the fused polycyclic compound of one or more embodiments. The light emitting elements ED-1, ED-2, and ED-3 each including the fused polycyclic compound of one or more embodiments may exhibit high efficiency and long service life characteristics.

The first light emitting element ED-1 may include a first red emission layer EML-R1 and a second red emission layer EML-R2. The second light emitting element ED-2 may include a first green emission layer EML-G1 and a second green emission layer EML-G2. In addition, the third light emitting element ED-3 may include a first blue emission layer EML-B1 and a second blue emission layer EML-B2. An emission auxiliary part OG may be arranged between the first red emission layer EML-R1 and the second red emission layer EML-R2, between the first green emission layer EML-G1 and the second green emission layer EML-G2, and between the first blue emission layer EML-B1 and the second blue emission layer EML-B2.

The emission auxiliary part OG may include a single layer or a multilayer. The emission auxiliary part OG may include a charge generation layer. More specifically, the emission auxiliary part OG may include an electron transport region, a charge generation layer, and a hole transport region that are sequentially stacked. The emission auxiliary part OG may be provided as a common layer in the whole of the first to third light emitting elements ED-1, ED-2, and ED-3. However, one or more embodiments of the present disclosure is not limited thereto, and the emission auxiliary part OG may be provided by being patterned within the openings OH defined in the pixel defining film PDL.

The first red emission layer EML-R1, the first green emission layer EML-G1, and the first blue emission layer EML-B1 may be arranged between the emission auxiliary part OG and the electron transport region ETR. The second red emission layer EML-R2, the second green emission layer EML-G2, and the second blue emission layer EML-B2 may be arranged between the hole transport region HTR and the emission auxiliary part OG.

For example, the first light emitting element ED-1 may include the first electrode EL1, the hole transport region HTR, the second red emission layer EML-R2, the emission auxiliary part OG, the first red emission layer EML-R1, the electron transport region ETR, and the second electrode EL2 that are sequentially stacked. The second light emitting element ED-2 may include the first electrode EL1, the hole transport region HTR, the second green emission layer EML-G2, the emission auxiliary part OG, the first green emission layer EML-G1, the electron transport region ETR, and the second electrode EL2 that are sequentially stacked. The third light emitting element ED-3 may include the first electrode EL1, the hole transport region HTR, the second blue emission layer EML-B2, the emission auxiliary part OG, the first blue emission layer EML-B1, the electron transport region ETR, and the second electrode EL2 that are sequentially stacked.

In one or more embodiments, an optical auxiliary layer PL may be arranged on the display element layer DP-ED. The optical auxiliary layer PL may include a polarizing layer. The optical auxiliary layer PL may be arranged on the display panel DP and control reflected light in the display panel DP due to external light. Unlike the configuration illustrated, the optical auxiliary layer PL in the display device according to one or more embodiments may not be provided.

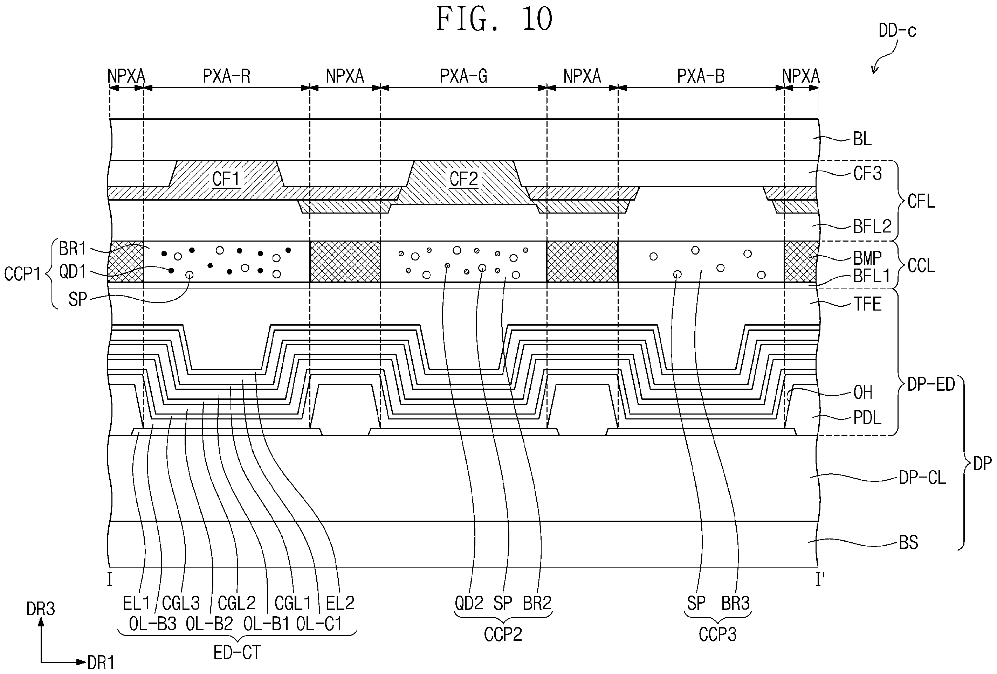

Unlike FIGS. 8 and 9, FIG. 10 illustrates that a display device DD-c includes four light emitting structures OL-B1, OL-B2, OL-B3, and OL-C1. A light emitting element ED-CT may include a first electrode EL1 and a second electrode EL2 which face each other, and first to fourth light emitting structures OL-C1, OL-B1, OL-B2, and OL-B3 that are sequentially stacked in the thickness direction between the first electrode EL1 and the second electrode EL2. The light emitting element ED-CT of one or more embodiments illustrated in FIG. 10 may include the fused polycyclic compound of one or more embodiments. The light emitting element ED-CT including the fused polycyclic compound of one or more embodiments may exhibit high efficiency and long service life characteristics.

Charge generation layers CGL1, CGL2, and CGL3 may be arranged between the first to fourth light emitting structures OL-C1, OL-B1, OL-B2, and OL-B3. Among the four light emitting structures, the second to fourth light emitting structures OL-B1, OL-B2, and OL-B3 may be configured to emit blue light, and the first light emitting structure OL-C1 may be configured to emit green light. However, one or more embodiments of the present disclosure is not limited thereto, and the first to fourth light emitting structures OL-C1, OL-B1, OL-B2, and OL-B3 may be configured to emit light beams in different wavelength regions.

The charge generation layers CGL1, CGL2, and CGL3 arranged between adjacent light emitting structures OL-B1, OL-B2, OL-B3, and OL-C1 may include a p-type or kind (e.g., P) charge generation layer and/or an n-type or kind (e.g., N) charge generation layer.

In one or more embodiments, the electronic apparatus may include a display device including a plurality of light emitting elements, and a control part which controls the display device. The electronic apparatus of one or more embodiments may be a device that is activated according to an electrical signal. The electronic apparatus may include display devices of one or more suitable embodiments. For example, the electronic apparatus may include not only large-sized electronic apparatus such as a television set, a monitor, or an outdoor billboard but also include small- and medium-sized electronic apparatus such as a personal computer, a laptop computer, a personal digital terminal, a display device for a vehicle, a game console, a portable electronic apparatus, or a camera.

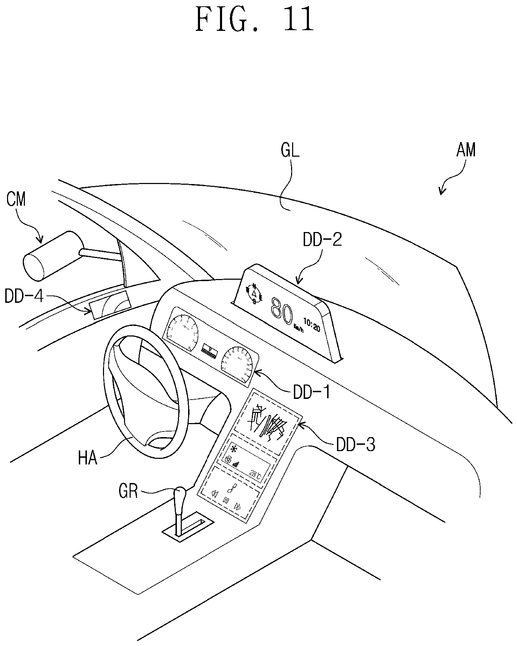

FIG. 11 is a view illustrating a vehicle AM in which first to fourth display devices DD-1, DD-2, DD-3, and DD-4 are arranged. At least one among the first to fourth display devices DD-1, DD-2, DD-3, and DD-4 may include the same configuration as the display devices DD, DD-TD, DD-a, DD-b, and DD-c as described with reference to FIGS. 1, and 2, and 7 to 10.

FIG. 11 illustrates a vehicle AM, but this is an example, and the first to fourth display devices DD-1, DD-2, DD-3, and DD-4 may be arranged in another transportation refers to such as bicycles, motorcycles, trains, ships, and airplanes. In addition, at least one selected from among the first to fourth display devices DD-1, DD-2, DD-3, and DD-4 including the same configuration as the display devices DD, DD-TD, DD-a, DD-b, and DD-c of one or more embodiments may be employed in a personal computer, a laptop computer, a personal digital terminal, a game console, a portable electronic device, a television, a monitor, an outdoor billboard, and/or the like. In addition, these are merely provided as embodiments, and thus may be employed in other electronic apparatuses unless departing from the present disclosure.

At least one selected from among the first to fourth display devices DD-1, DD-2, DD-3, and DD-4 may include the light emitting element ED as described with reference to FIGS. 3 to 6. At least one selected from among the first to fourth display devices DD-1, DD-2, DD-3, and DD-4 may include the fused polycyclic compound of one or more embodiments. The display device (the first to fourth display devices DD-1, DD-2, DD-3, and DD-4) including the fused polycyclic compound of one or more embodiments may exhibit excellent or suitable display efficiency and display service life.

Referring to FIG. 11, the vehicle AM may include a steering wheel HA and a gear GR for driving the vehicle AM. In addition, the vehicle AM may include a front window GL arranged so as to face the driver.

The first display device DD-1 may be arranged in a first region overlapping the steering wheel HA. For example, the first display device DD-1 may be a digital cluster which displays first information of the vehicle AM. The first information may include a first scale which indicates a driving speed of the vehicle AM, a second scale which indicates an engine speed (that is, revolutions per minute (RPM)), an image which indicates a fuel state, and/or the like. A first scale and a second scale may be indicated as a digital image.

The second display device DD-2 may be arranged in a second region opposite to (e.g., facing) the driver's seat and overlapping the front window GL. The driver's seat may be a seat in which the steering wheel HA is arranged. For example, the second display device DD-2 may be a head up display (HUD) which displays second information of the vehicle AM. The second display device DD-2 may be optically transparent. The second information may include digital numbers which indicate a driving speed, and may further include information such as the current time. Unlike the configuration illustrated, the second information of the second display device DD-2 may be projected to the front window GL to be displayed.

The third display device DD-3 may be arranged in a third region adjacent to the gear GR. For example, the third display device DD-3 may be arranged between the driver's seat and the passenger seat and may be a center information display (CID) for a vehicle for displaying third information. The passenger seat may be a seat spaced and/or apart (e.g., spaced apart or separated) from the driver's seat with the gear GR arranged therebetween. The third information may include information about traffic (e.g., navigation information), playing music or radio or a video (or an image), temperatures inside the vehicle AM, and/or the like.

The fourth display device DD-4 may be spaced and/or apart (e.g., spaced apart or separated) from the steering wheel HA and the gear GR, and may be arranged in a fourth region adjacent to the side of the vehicle AM. For example, the fourth display device DD-4 may be a digital side-view mirror which displays fourth information. The fourth display device DD-4 may display an image outside the vehicle AM taken by a camera module CM arranged outside the vehicle AM. The fourth information may include an image outside the vehicle AM.

The above-described first to fourth information may be examples, and the first to fourth display devices DD-1, DD-2, DD-3, and DD-4 may further display information about the inside and outside of the vehicle AM. The first to fourth information may include different information. However, one or more embodiments of the present disclosure is not limited thereto, and a part of the first to fourth information may include the same information as one another.

Hereinafter, with reference to Examples and Comparative Examples, a fused polycyclic compound according to one or more embodiments of the present disclosure and a light emitting element of one or more embodiments of the present disclosure will be described in more detail. In addition, Examples described in more detail are only illustrations to assist the understanding of the present disclosure, and the scope of the present disclosure is not limited thereto.

### [Example]

### 1. Synthesis of Fused Polycyclic Compounds of Examples

A synthetic method of a fused polycyclic compound according to the current embodiment will be described in more detail by illustrating synthetic methods of Fused Polycyclic Compounds 15, 43, 51, 109, 130, 216, and 233. In addition, in the following descriptions, the synthetic method of the fused polycyclic compound is provided as an example, but the synthetic method of the compound according to one or more embodiments of the present disclosure is not limited to Examples.

### (1) Synthesis of Fused Polycyclic Compound 15

Fused Polycyclic Compound 15 according to an example may be synthesized by, for example, the steps (e.g., acts or tasks) shown in Reaction Scheme 1:

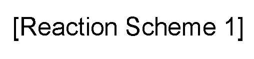

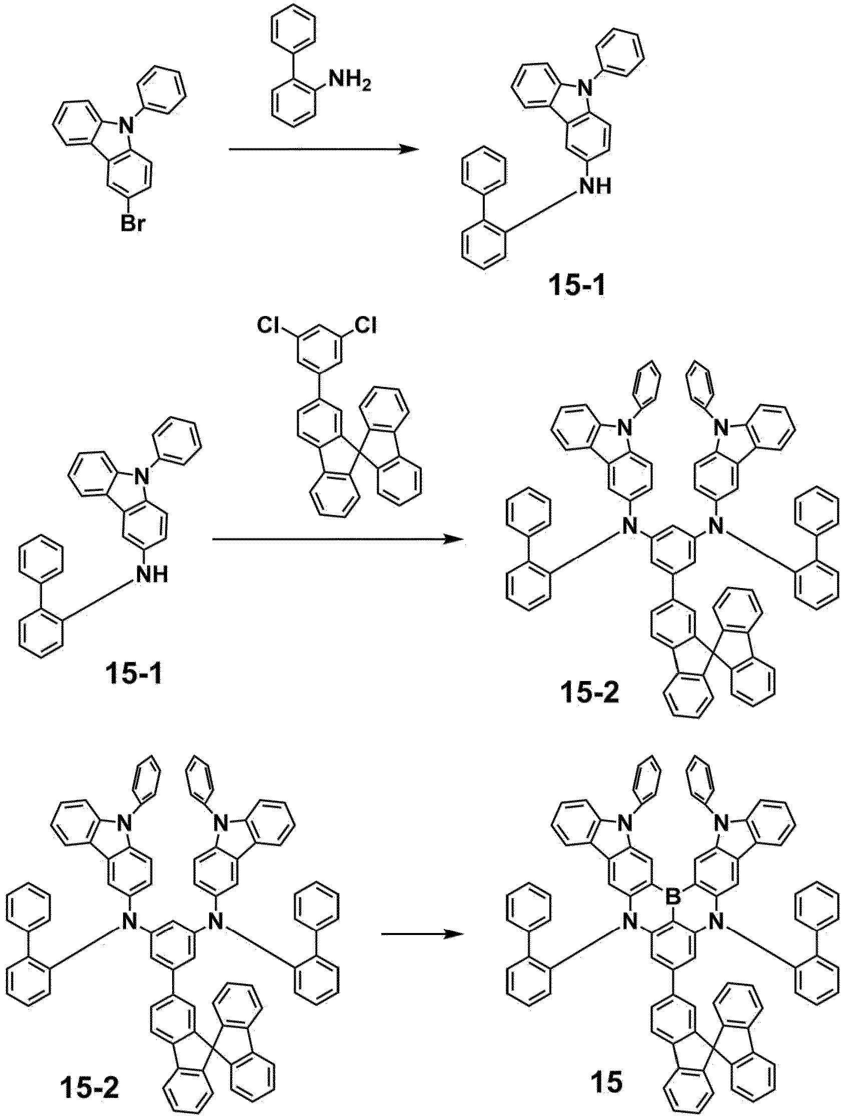

### Synthesis of Intermediate 15-1

3-bromo-9-phenyl-9*H*-carbazole (1 eq), [1,1'-biphenyl]-2-amine (1.3 eq), tris(dibenzylideneacetone)dipalladium(0) (0.05 eq), tri-*tert*-butylphosphine (0.1 eq), and sodium *tert*-butoxide (3 eq) were dissolved in toluene, and then the resultant mixture was stirred at about 90 °C for about 4 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC (dichloromethane) and n-hexane to obtain Intermediate 15-1. (yield: 82%)

### Synthesis of Intermediate 15-2

2-(3,5-dichlorophenyl)-9,9'-spirobi[fluorene] (1 eq), Intermediate 15-1 (2.05 eq), tris(dibenzylideneacetone)dipalladium(0) (0.1 eq), tri-tert-butylphosphine (0.2 eq), and sodium tert-butoxide (5 eq) were dissolved in toluene, and then the resultant mixture was stirred at about 110 °C for about 12 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC and n-hexane to obtain Intermediate 15-2. (yield: 68%)

### Synthesis of Compound 15

Intermediate 15-2 (1 eq) was dissolved in ortho dichlorobenezene, the mixture was then cooled to about 0 °C, and then BBr₃ (4 eq) was slowly injected thereto in a nitrogen atmosphere. After dropping was completed, the temperature was elevated to about 180 °C, and the mixture was stirred for about 48 hours. After the reactant was cooled, the reaction was terminated by dropping triethylamine slowly in the flask containing the reactant, and then ethyl alcohol was added to the reactant to extract. The extracted product was filtered to obtain solids. The obtained solids were purified by column chromatography using MC and n-hexane, and were then subjected to recrystallization using toluene and acetone to obtain Compound 15. (yield: 6%)

### (2) Synthesis of Fused Polycyclic Compound 43

Fused Polycyclic Compound 43 according to an example may be synthesized by, for example, the steps (e.g., acts or tasks) shown in Reaction Scheme 2:

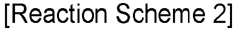

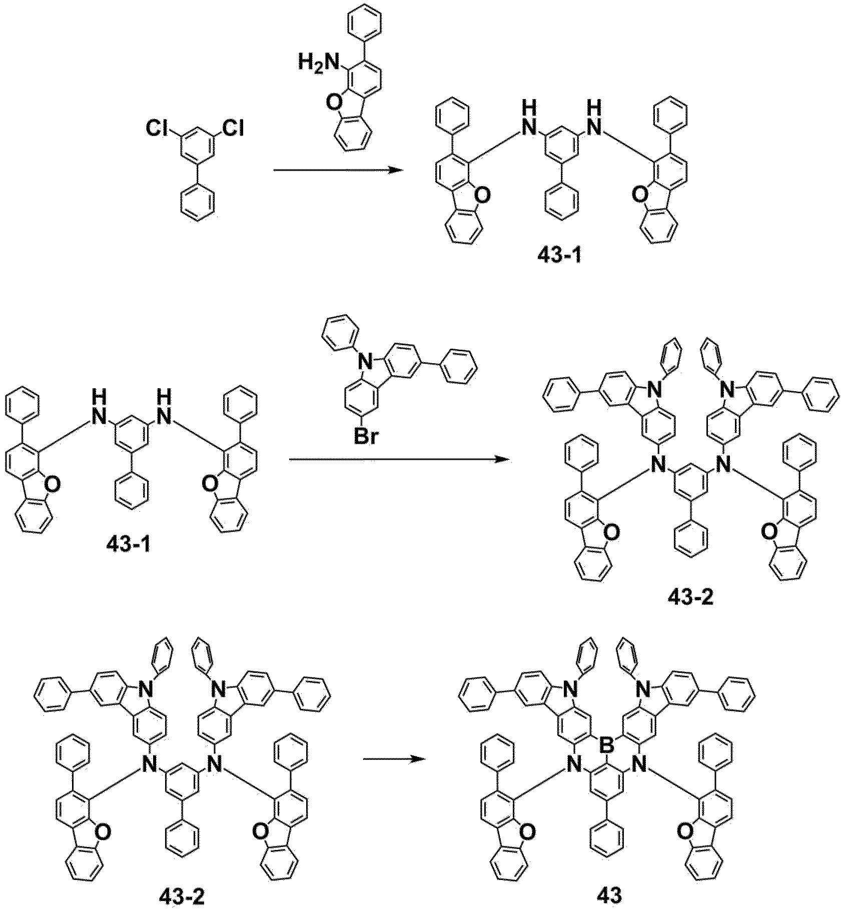

### Synthesis of Intermediate 43-1

3,5-dichloro-1,1'-biphenyl (1 eq), 3-phenyldibenzo[*b*,*d*]furan-4-amine (2.05 eq), tris(dibenzylideneacetone)dipalladium(0) (0.1 eq), tri-*tert*-butylphosphine (0.2 eq), and sodium *tert*-butoxide (5 eq) were dissolved in toluene, and then the resultant mixture was stirred at about 110 °C for about 12 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC and n-hexane to obtain Intermediate 43-1. (yield: 74%)

### Synthesis of Intermediate 43-2

Intermediate 43-1 (1 eq), 3-bromo-6,9-diphenyl-9*H*-carbazole (2.2 eq), tris(dibenzylideneacetone)dipalladium(0) (0.1 eq), tri-*tert*-butylphosphine (0.2 eq), and sodium *tert*-butoxide (5 eq) were dissolved in toluene, and then the resultant mixture was stirred at about 110 °C for about 12 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC and n-hexane to obtain Intermediate 43-2. (yield: 71%)

### Synthesis of Compound 43

Intermediate 43-2 (1 eq) was dissolved in ortho dichlorobenezene, the mixture was then cooled to about 0 °C, and then BBr₃ (4 eq) was slowly injected thereto in a nitrogen atmosphere. After dropping was completed, the temperature was elevated to about 180 °C, and the mixture was stirred for about 48 hours. After the reactant was cooled, the reaction was terminated by dropping triethylamine slowly in the flask containing the reactant, and then ethyl alcohol was added to the reactant to extract. The extracted product was filtered to obtain solids. The obtained solids were purified by column chromatography using MC and n-hexane, and were then subjected to recrystallization using toluene and acetone to obtain Compound 43. (yield: 17%)

### (3) Synthesis of Fused Polycyclic Compound 51

Fused Polycyclic Compound 51 according to an example may be synthesized by, for example, the steps (e.g., acts or tasks) shown in Reaction Scheme 3:

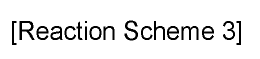

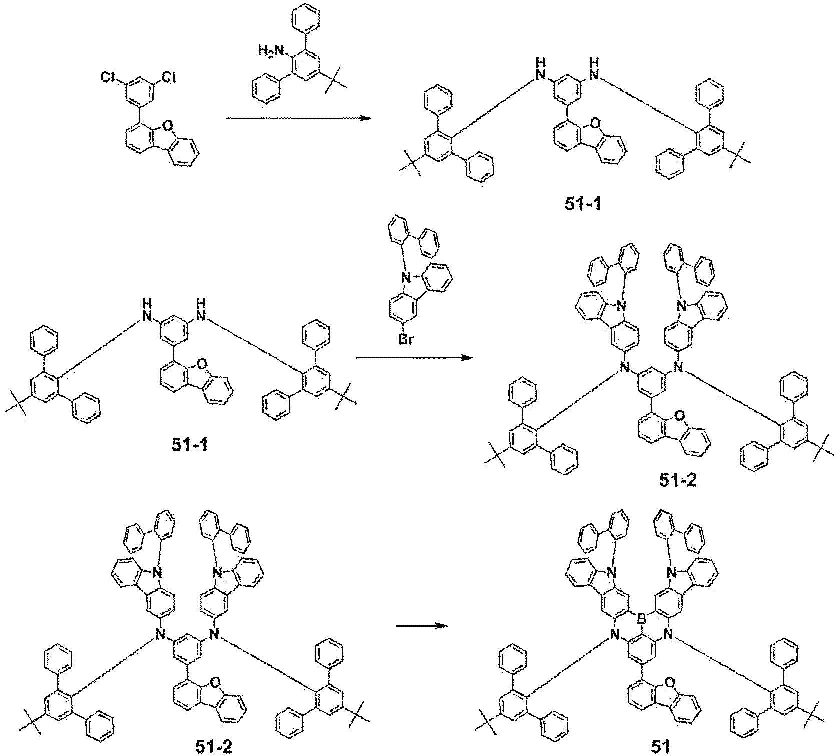

### Synthesis of Intermediate 51-1

4-(3,5-dichlorophenyl)dibenzo[b,d]furan (1 eq), 5'-(*tert*-butyl)-[1,1':3',1"-terphenyl]-2'-amine (2.05 eq), tris(dibenzylideneacetone)dipalladium(0) (0.1 eq), tri-*tert-*butylphosphine (0.2 eq), and sodium tert-butoxide (5 eq) were dissolved in toluene, and then the resultant mixture was stirred at about 110 °C for about 12 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC and n-hexane to obtain Intermediate 51-1. (yield: 68%)

### Synthesis of Intermediate 51-2

Intermediate 51-1 (1 eq), (*S*)-9-([1,1'-biphenyl]-2-yl)-3-bromo-9*H*-carbazole (4 eq), tris(dibenzylideneacetone)dipalladium(0) (0.2 eq), tri-*tert*-butylphosphine (0.4 eq), and sodium tert-butoxide (5 eq) were dissolved in o-xylene, and then the resultant mixture was stirred at about 150 °C for about 60 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC and n-hexane to obtain Intermediate 51-2. (yield: 31%)

### Synthesis of Compound 51

Intermediate 51-2 (1 eq) was dissolved in ortho dichlorobenezene, the mixture was then cooled to about 0 °C, and then BBr₃ (4 eq) was slowly injected thereto in a nitrogen atmosphere. After dropping was completed, the temperature was elevated to about 180 °C, and the mixture was stirred for about 48 hours. After the reactant was cooled, the reaction was terminated by dropping triethylamine slowly in the flask containing the reactant, and then ethyl alcohol was added to the reactant to extract. The extracted product was filtered to obtain solids. The obtained solids were purified by column chromatography using MC and n-hexane, and were then subjected to recrystallization using toluene and acetone to obtain Compound 51. (yield: 12%)

### (4) Synthesis of Fused Polycyclic Compound 109

Fused Polycyclic Compound 109 according to an example may be synthesized by, for example, the steps (e.g., acts or tasks) shown in Reaction Scheme 4:

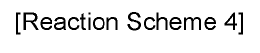

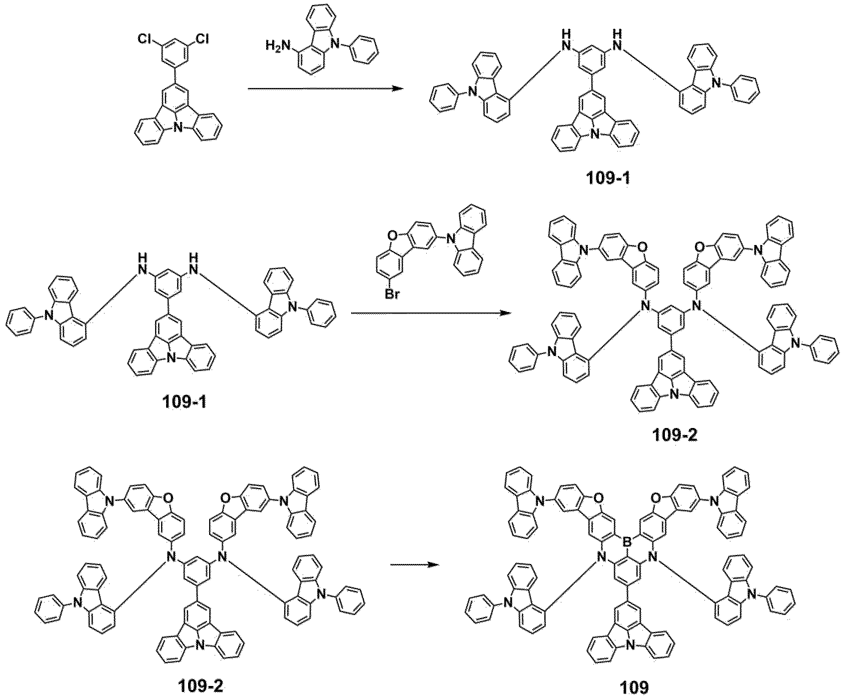

### Synthesis of Intermediate 109-1

2-(3,5-dichlorophenyl)indolo[3,2,1-jk]carbazole (1 eq), 9-phenyl-9*H*-carbazol-4-amine (2.05 eq), tris(dibenzylideneacetone)dipalladium(0) (0.1 eq), tri-*tert-*butylphosphine (0.2 eq), and sodium *tert*-butoxide (3 eq) were dissolved in toluene, and then the resultant mixture was stirred at about 110 °C for about 12 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC and n-hexane to obtain Intermediate 109-1. (yield: 82%)

### Synthesis of Intermediate 109-2

Intermediate 109-1 (1 eq), 9-(8-bromodibenzo[*b*,*d*]furan-2-yl)-9*H*-carbazole (2.2 eq), tris(dibenzylideneacetone)dipalladium(0) (0.1 eq), tri-*tert*-butylphosphine (0.2 eq), and sodium *tert*-butoxide (3 eq) were dissolved in toluene, and then the resultant mixture was stirred at about 110 °C for about 12 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC and n-hexane to obtain Intermediate 109-2. (yield: 59%)

### Synthesis of Compound 109

Intermediate 109-2 (1 eq) was dissolved in ortho dichlorobenezene, the mixture was then cooled to about 0 °C, and then BBr₃ (4 eq) was slowly injected thereto in a nitrogen atmosphere. After dropping was completed, the temperature was elevated to about 180 °C, and the mixture was stirred for about 48 hours. After the reactant was cooled, the reaction was terminated by dropping triethylamine slowly in the flask containing the reactant, and then ethyl alcohol was added to the reactant to extract. The extracted product was filtered to obtain solids. The obtained solids were purified by column chromatography using MC and n-hexane, and were then subjected to recrystallization using toluene and acetone to obtain Compound 109. (yield: 14%)

### (5) Synthesis of Fused Polycyclic Compound 130

Fused Polycyclic Compound 130 according to an example may be synthesized by, for example, the steps (e.g., acts or tasks) shown in Reaction Scheme 5:

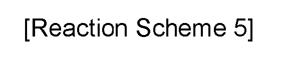

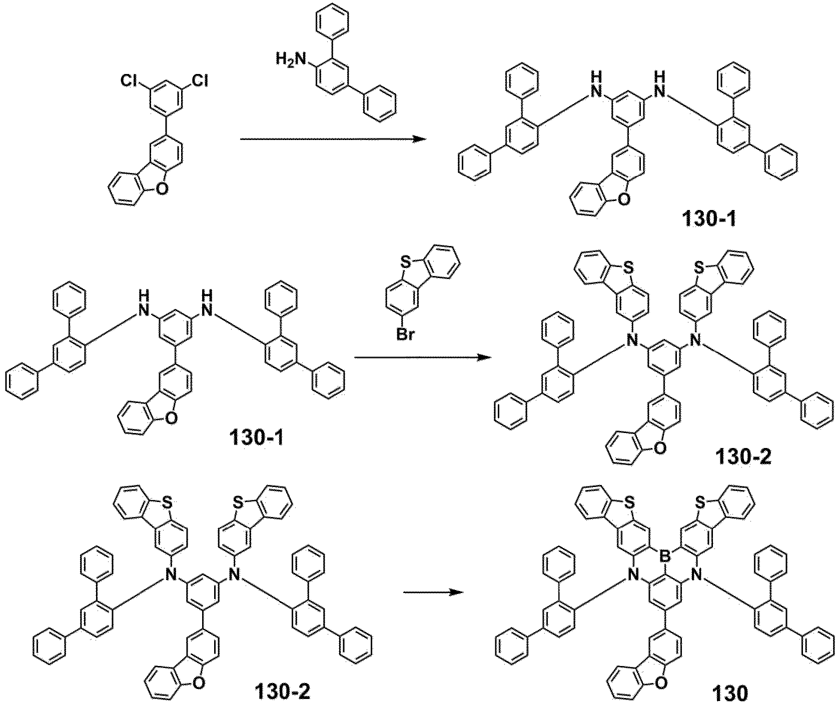

### Synthesis of Intermediate 130-1

2-(3,5-dichlorophenyl)dibenzo[b,d]furan (1 eq), [1,1':3',1"-terphenyl]-4'-amine (2.05 eq), tris(dibenzylideneacetone)dipalladium(0) (0.1 eq), tri-*tert*-butylphosphine (0.2 eq), and sodium *tert*-butoxide (3 eq) were dissolved in toluene, and then the resultant mixture was stirred at about 110 °C for about 12 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC and n-hexane to obtain Intermediate 130-1. (yield: 68%)

### Synthesis of Intermediate 130-2

Intermediate 130-1 (1 eq), 2-bromodibenzo[*b*,*d*]thiophene (2.2 eq), tris(dibenzylideneacetone)dipalladium(0) (0.1 eq), tri-*tert*-butylphosphine (0.2 eq), and sodium *tert*-butoxide (3 eq) were dissolved in toluene, and then the resultant mixture was stirred at about 110 °C for about 12 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC and n-hexane to obtain Intermediate 130-2. (yield: 63%)

### Synthesis of Compound 130

Intermediate 130-2 (1 eq) was dissolved in ortho dichlorobenezene, the mixture was then cooled to about 0 °C, and then BBr₃ (4 eq) was slowly injected thereto in a nitrogen atmosphere. After dropping was completed, the temperature was elevated to about 180 °C, and the mixture was stirred for about 48 hours. After the reactant was cooled, the reaction was terminated by dropping triethylamine slowly in the flask containing the reactant, and then ethyl alcohol was added to the reactant to extract. The extracted product was filtered to obtain solids. The obtained solids were purified by column chromatography using MC and n-hexane, and were then subjected to recrystallization using toluene and acetone to obtain Compound 130. (yield: 16%)

### (6) Synthesis of Fused Polycyclic Compound 216

Fused Polycyclic Compound 216 according to an example may be synthesized by, for example, the steps (e.g., acts or tasks) shown in Reaction Scheme 6:

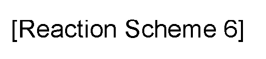

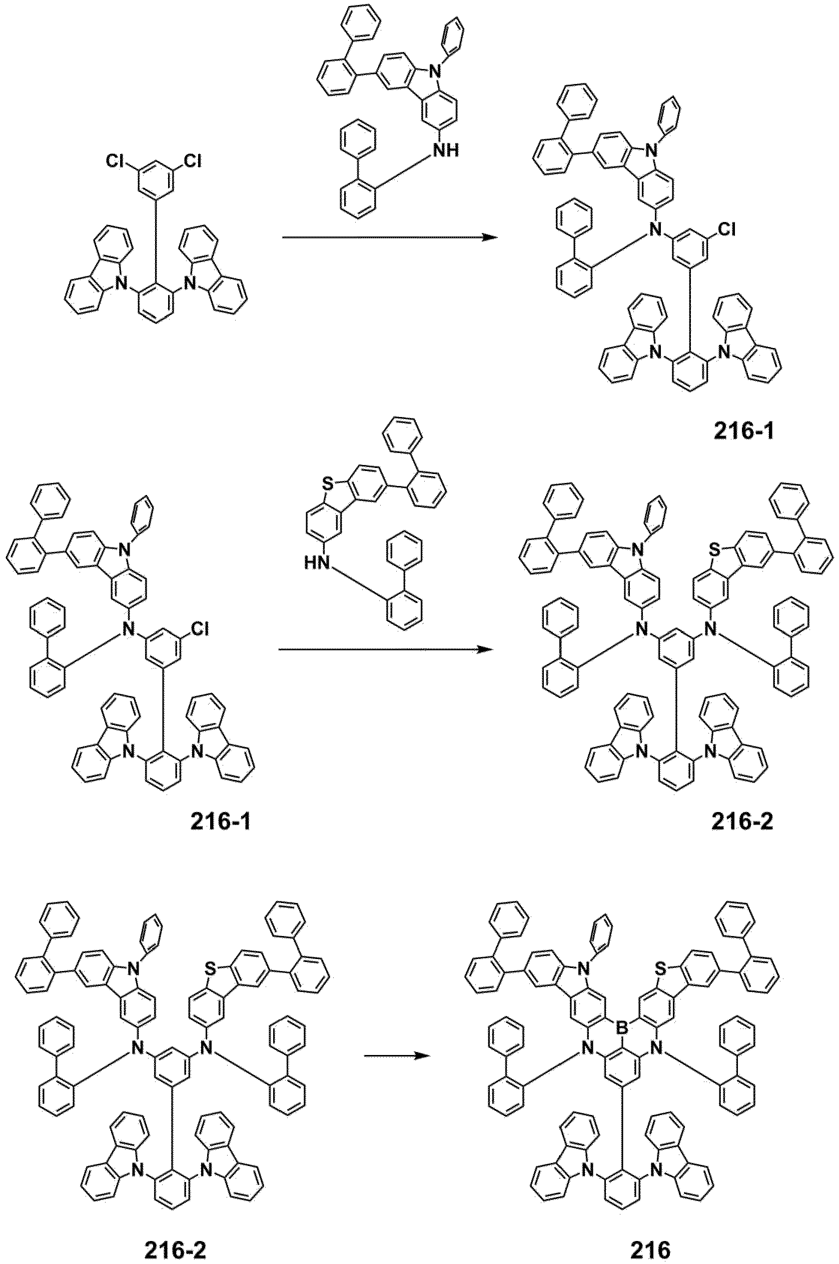

### Synthesis of Intermediate 216-1

9,9'-(3',5'-dichloro-[1,1'-biphenyl]-2,6-diyl)bis(9*H*-carbazole) (1 eq), *N*,6-di([1,1'-biphenyl]-2-yl)-9-phenyl-9*H*-carbazol-3-amine (1 eq), tris(dibenzylideneacetone)dipalladium(0) (0.1 eq), BINAP (0.2 eq), and sodium *tert-*butoxide (3 eq) were dissolved in toluene, and then the resultant mixture was stirred at about 100 °C for about 12 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC and n-hexane to obtain Intermediate 216-1. (yield: 49%)

### Synthesis of Intermediate 216-2

Intermediate 216-1 (1 eq), N,8-di([1,1'-biphenyl]-2-yl)dibenzo[b,d]thiophen-2-amine (1.05 eq), tris(dibenzylideneacetone)dipalladium(0) (0.1 eq), tri-*tert-*butylphosphine (0.2 eq), and sodium tert-butoxide (3 eq) were dissolved in toluene, and then the resultant mixture was stirred at about 110 °C for about 12 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC and n-hexane to obtain Intermediate 216-2. (yield: 80%)

### Synthesis of Compound 216

Intermediate 216-2 (1 eq) was dissolved in ortho dichlorobenezene, the mixture was then cooled to about 0 °C, and then BBr₃ (4 eq) was slowly injected thereto in a nitrogen atmosphere. After dropping was completed, the temperature was elevated to about 180 °C, and the mixture was stirred for about 48 hours. After the reactant was cooled, the reaction was terminated by dropping triethylamine slowly in the flask containing the reactant, and then ethyl alcohol was added to the reactant to extract. The extracted product was filtered to obtain solids. The obtained solids were purified by column chromatography using MC and n-hexane, and were then subjected to recrystallization using toluene and acetone to obtain Compound 216. (yield: 8%)

### (7) Synthesis of Fused Polycyclic Compound 233

Fused Polycyclic Compound 233 according to an example may be synthesized by, for example, the steps (e.g., acts or tasks) shown in Reaction Scheme 7:

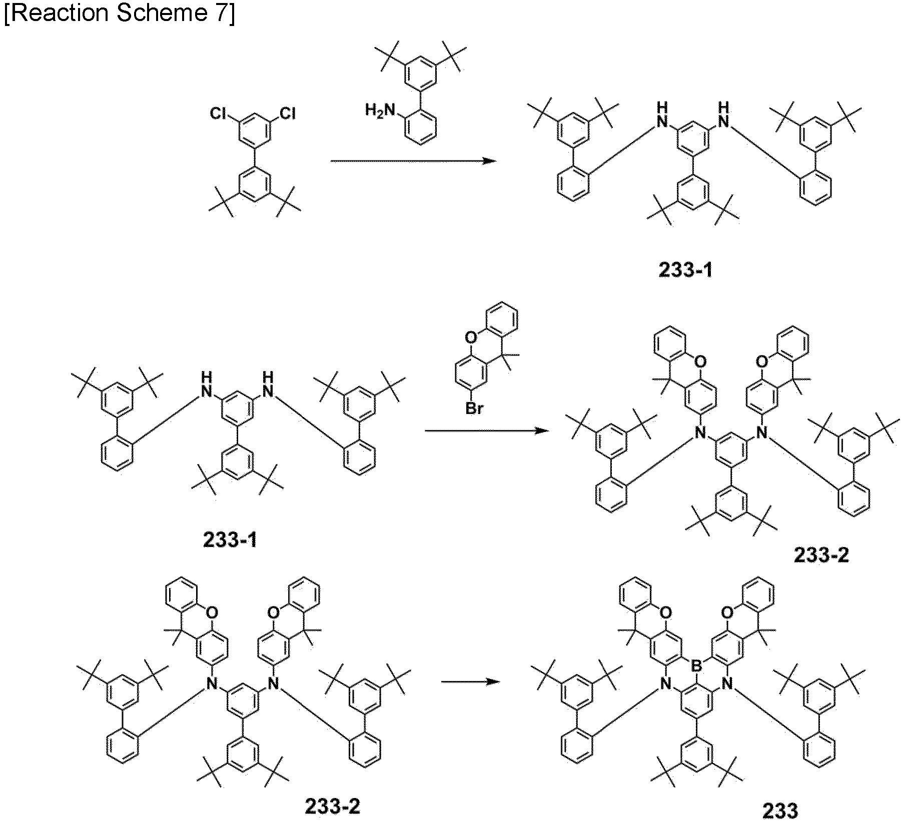

### Synthesis of Intermediate 233-1

3,5-di-tert-butyl-3',5'-dichloro-1,1'-biphenyl (1 eq), 3',5'-di-tert-butyl-[1,1'-biphenyl]-2-amine (2.05 eq), tris(dibenzylideneacetone)dipalladium(0) (0.1 eq), tri-tert-butylphosphine (0.2 eq), and sodium tert-butoxide (3 eq) were dissolved in toluene, and then the resultant mixture was stirred at about 110 °C for about 12 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC and n-hexane to obtain Intermediate 233-1. (yield: 75%)

### Synthesis of Intermediate 233-2

Intermediate 233-1 (1 eq), 2-bromo-9,9-dimethyl-9*H*-xanthene (2.05 eq), tris(dibenzylideneacetone)dipalladium(0) (0.1 eq), tri-*tert*-butylphosphine (0.2 eq), and sodium *tert*-butoxide (3 eq) were dissolved in toluene, and then the resultant mixture was stirred at about 110 °C for about 12 hours. The reactant was cooled, then washed three times with ethyl acetate and water, and then subjected to liquid separation to obtain an organic layer. The obtained organic layer was dried over MgSO₄ and then dried under reduced pressure. The resulting product was purified by column chromatography using MC and n-hexane to obtain Intermediate 233-2. (yield: 71%)

### Synthesis of Compound 233

Intermediate 233-2 (1 eq) was dissolved in ortho dichlorobenezene, the mixture was then cooled to about 0 °C, and then BBr₃ (4 eq) was slowly injected thereto in a nitrogen atmosphere. After dropping was completed, the temperature was elevated to about 180 °C, and the mixture was stirred for about 48 hours. After the reactant was cooled, the reaction was terminated by dropping triethylamine slowly in the flask containing the reactant, and then ethyl alcohol was added to the reactant to extract. The extracted product was filtered to obtain solids. The obtained solids were purified by column chromatography using MC and n-hexane, and were then subjected to recrystallization using toluene and acetone to obtain Compound 233. (yield: 12%)

### 2. Manufacture and Evaluation of Light Emitting Elements

### (1) Manufacture of Light Emitting Elements

Light emitting elements (each including the fused polycyclic compound of an example or Comparative Example Compound in the emission layer) were manufactured as follows. Compounds 15, 43, 51, 109, 130, 216, and 233 which are fused polycyclic compounds of examples were respectively used as a dopant material for the emission layer to manufacture the light emitting elements of Examples 1 to 7. Comparative Example Compounds CX1 to CX9 were respectively used as a dopant material for the emission layer to manufacture the light emitting elements of Comparative Examples 1 to 9.

For a first electrode, an ITO glass substrate of about 15 Ω/cm² (about 1,200 Å) made by Corning Co. was cut to a size of 50 mm x 50 mm x 0.7 mm, cleansed by ultrasonic waves using isopropyl alcohol and pure water for about 5 minutes each, and then irradiated with ultraviolet rays for about 30 minutes and exposed to ozone and cleansed. The glass substrate was installed on a vacuum deposition apparatus.

Compound H-1-1 was deposited in vacuum on the glass substrate to form a 600-Á thick hole transport layer. Compound H-1-20 was deposited in vacuum on the hole transport layer to form a 300-Å thick electron blocking layer.

On the hole transport layer, a host, a sensitizer, and a dopant were codeposited at a weight ratio of about 85:13.5:1.5 to form a 300 Å-thick emission layer. When forming the emission layer, the host and the sensitizer were made of the same materials as those shown in Table 1.

ET46 was deposited in vacuum on the emission layer to form a 50-Å thick hole blocking layer, and ET47:LiQ (weight ratio of 5:5) was formed on the hole blocking layer to form a 300-Å thick electron transport layer. Yb was deposited in vacuum on the electron transport layer to form a 10-Å thick electron injection layer. Al was deposited in vacuum on the electron injection layer to form a 3,000-Å thick second electrode, thereby manufacture a light emitting element.

### (Materials Used to Manufacture Light Emitting Elements)

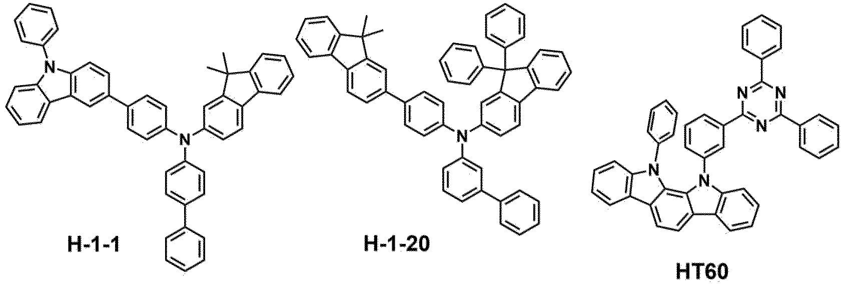

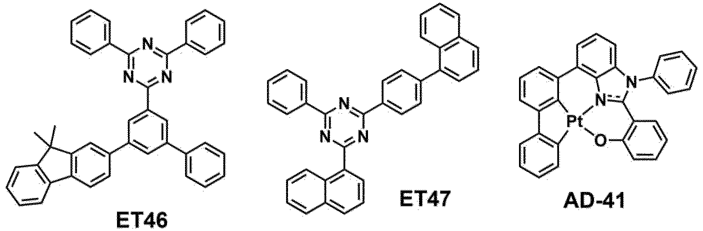

### Example Compounds

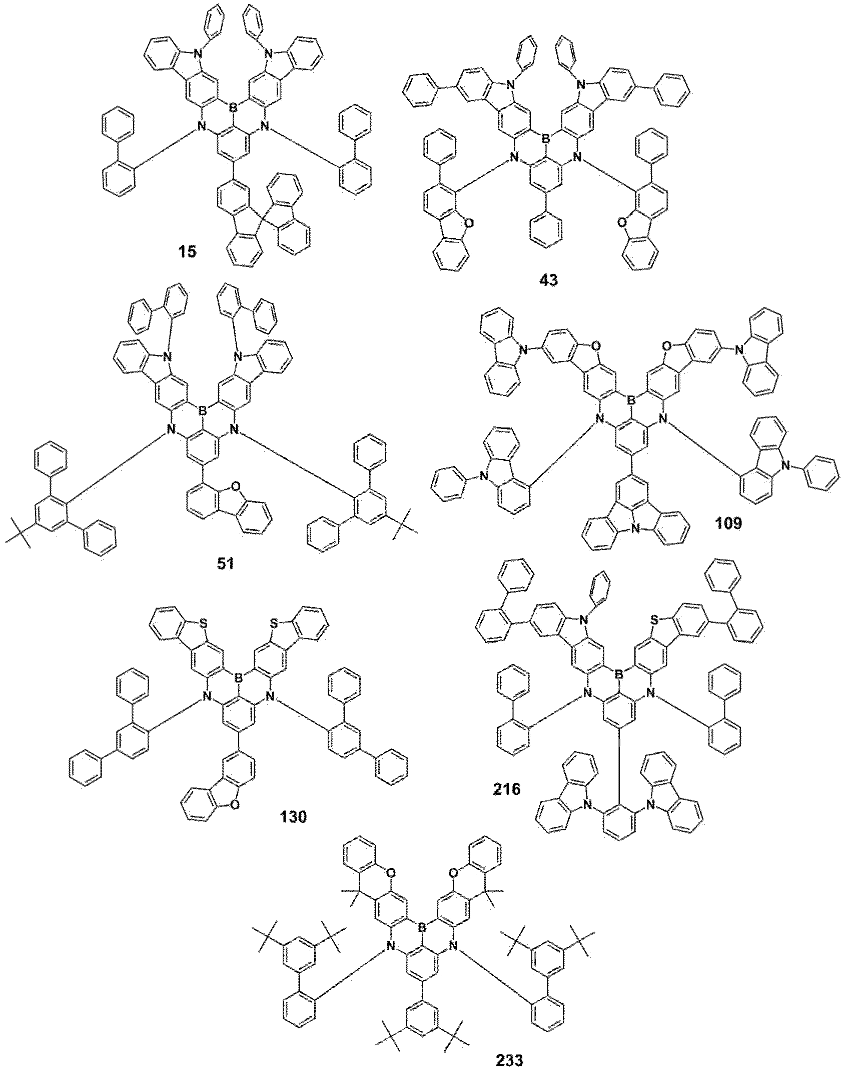

### Comparative Example Compounds

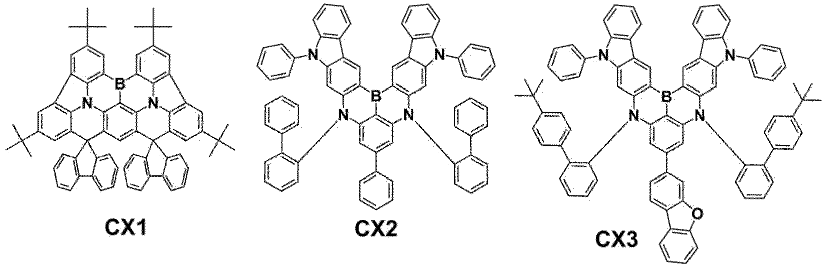

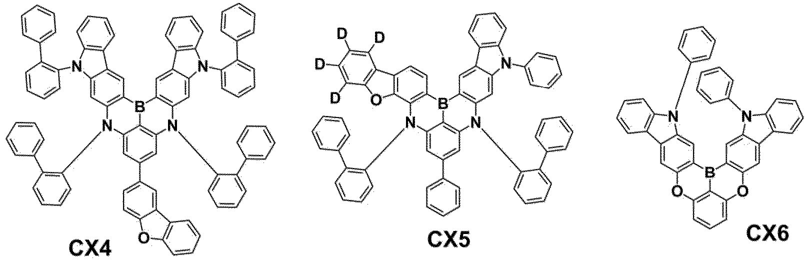

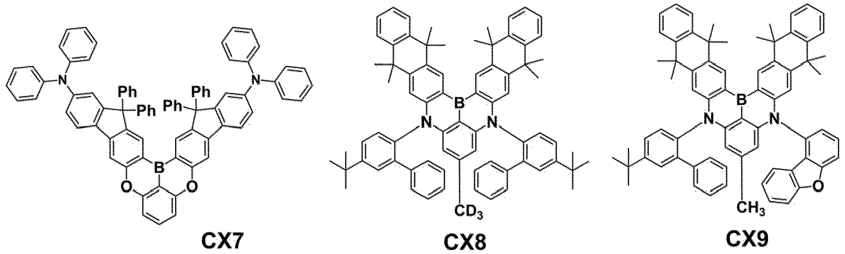

### (2) Evaluation of Light Emitting Elements

The light emitting elements of Comparative Examples and Examples were evaluated and the results are shown in Table 1. The driving voltage, luminous efficiency, luminous wavelength, and service life at a current density of 10 mA/cm² were measured using Keithley MU 236 and a luminance meter PR650. For the service life (T₉₅), the time taken to be reduced from the initial brightness to 95% brightness was measured, and a relative service life was calculated on the basis of Comparative Example 1, and the results are shown in Table 1.

**[Table 1]**

| | Host | Sensitiz er | Dopant | Drivin 9 voltag e (V) | Efficienc y (cd/A) | Luminescen ce wavelength (nm) | Servic e life (T95) |
|---|---|---|---|---|---|---|---|
| Example 1 | HT6 0 | AD-41 | Compound 15 | 97% | 129 | 532 | 161% |
| Example 2 | HT6 0 | AD-41 | Compound 43 | 99% | 135 | 526 | 183% |
| Example 3 | HT6 0 | AD-41 | Compound 51 | 98% | 133 | 536 | 196% |
| Example 4 | HT6 0 | AD-41 | Compound 109 | 102% | 119 | 528 | 157% |
| Example 5 | HT6 0 | AD-41 | Compound 130 | 101% | 137 | 522 | 148% |
| Example 6 | HT6 0 | AD-41 | Compound 216 | 95% | 131 | 532 | 202% |
| Example 7 | HT6 0 | AD-41 | Compound 233 | 97% | 111 | 518 | 120% |
| Com parati ve Example 1 | HT6 0 | AD-41 | Comparati ve Example Compound CX1 | 100% | 102 | 534 | 100% |
| Com parati ve Example 2 | HT6 0 | AD-41 | Comparati ve Example Compound CX2 | 126% | 28.2 | 528 | 21% |
| Com parati ve Example 3 | HT6 0 | AD-41 | Comparati ve Example Compound CX3 | 142% | 32.4 | 526 | 16% |
| Com parati ve Example 4 | HT6 0 | AD-41 | Comparati ve Example Compound CX4 | 138% | 15.8 | 527 | 24% |
| Com parati ve Example 5 | HT6 0 | AD-41 | Comparati ve Example Compound CX5 | 155% | 33.5 | 528 | 21% |
| Com parati ve Example 6 | HT6 0 | AD-41 | Comparati ve Example Compound CX6 | 155% | 24.2 | 531 | 29% |
| Com parati ve Example 7 | HT6 0 | AD-41 | Comparati ve Example Compound CX7 | 166% | 31.1 | 530 | 33% |
| Com parati ve Example 8 | HT6 0 | AD-41 | Comparati ve Example Compound CX8 | 134% | 13.8 | 527 | 14% |
| Com parati ve Example 9 | HT6 0 | AD-41 | Comparati ve Example Compound CX9 | 127% | 29.2 | 526 | 25% |

Referring to Table 1, it may be seen that the light emitting elements of Comparative Examples 1 to 9 and Examples 1 to 7 emit light in a wavelength region of about 495 nm to about 570 nm. It may be seen that the light emitting elements of Examples 1 to 7 each exhibit high efficiency and long service life compared to those of Comparative Examples 1 to 9. The light emitting elements of Examples 1 to 7 include Compounds 15, 43, 51, 109, 130, 216, and 233, respectively, and Compounds 15, 43, 51, 109, 130, 216, and 233 are fused polycyclic compounds of examples. Compounds 15, 43, 51, 109, 130, 216, and 233 each include a nonacyclic fused ring as a central structure, and an ortho biphenyl moiety is bonded to the nitrogen atom at the para position with respect to the boron atom in the nonacyclic fused ring. Accordingly, it may be seen that the light emitting element including the fused polycyclic compound of an example will exhibit high efficiency and long service life characteristics. It may be seen that the light emitting element including the fused polycyclic compound of an example will emit green light.

The light emitting element of Comparative Example 1 includes Comparative Example Compound CX1, and Comparative Example Compound CX1 is different from the fused polycyclic compound of an example in that an undecacyclic fused ring is included as a central structure. The undecacyclic fused ring contains two nitrogen atoms and one boron atom as ring-forming atoms. Accordingly, the light emitting element of Comparative Example 1 exhibits low efficiency and a short service life.

The light emitting element of Comparative Example 2 includes Comparative Example Compound CX2, the light emitting element of Comparative Example 3 includes Comparative Example Compound CX3, and the light emitting element of Comparative Example 4 includes Comparative Example Compound CX4. Comparative Example Compounds CX2 to CX4 are directly bonded to A₁ and A₂ in Formula 1 as described above, and are different from the fused polycyclic compound of an example. Accordingly, the light emitting elements of Comparative Examples 2 to 4 each exhibit low efficiency and a short service life.

The light emitting element of Comparative Example 5 includes Comparative Example Compound CX5, and Comparative Example Compound CX5 includes a nonacyclic fused ring. However, Comparative Example Compound CX5 is different from the fused polycyclic compound of an example in terms of the fused position of dibenzofuran. Accordingly, the light emitting element of Comparative Example 5 exhibits low efficiency and a short service life.

The light emitting element of Comparative Example 6 includes Comparative Example Compound CX6, and the light emitting element of Comparative Example 7 includes Comparative Example Compound CX7. Comparative Example Compounds CX6 and CX7 each include a nonacyclic fused ring. However, Comparative Example Compounds CX6 and CX7 each include the oxygen atom at the para position with the boron atom in the nonacyclic fused ring, and are different from the fused polycyclic compound of an example. Accordingly, the light emitting elements of Comparative Examples 6 and 7 each exhibit low efficiency and a short service life.

The light emitting element of Comparative Example 8 includes Comparative Example Compound CX8, and the light emitting element of Comparative Example 9 includes Comparative Example Compound CX9. Comparative Example Compounds CX8 and CX9 are different from the fused polycyclic compound of an example in that A₁ is C(CH₃)₂ and A₃ is C(CH₃)₂ in Formula 1 as described above. Accordingly, the light emitting elements of Comparative Examples 8 and 9 each exhibit low efficiency and a short service life.

Comparative Example Compounds CX2 to CX6, CX8, and CX9 are blue light emitting dopants having a luminescence center wavelength in a wavelength region of about 460 nm to about 470 nm if (e.g., when) used as dopants without a sensitizer. Comparative Example Compound CX7 is a material having a luminescence center wavelength in a wavelength region of about 460 nm or less, and is a compound developed as a host material.

When Comparative Example Compounds CX2 to CX6, CX8, and CX9 are each provided together with a sensitizer (*i*.*e*., Compound AD-41) as a material for forming an emission layer, the sensitizer (*i*.*e*., Compound AD-41) becomes an emitter, and Comparative Example Compounds CX2 to CX6, CX8, and CX9 each serve as a sensitizer. When Compound AD-41 is a material that emits green phosphorescence and forms an emission layer with each of Comparative Example Compounds CX2 to CX6, CX8, and CX9, which are blue light emitting dopants, cascading does not match energetically, and thus the light emitting element exhibits low efficiency and a short service life. Comparative Example Compounds CX2 to CX6, CX8, and CX9, which are blue light emitting dopants, each have a long triplet lifetime, and are not suitable for the function of the sensitizer, triplet excitons are accumulated, and the light emitting elements of Comparative Examples 2 to 6, 8, and 9 including Comparative Example Compounds CX2 to CX6, CX8, and CX9 each exhibit low efficiency and a short service life.

The display device of one or more embodiments may include the light emitting element of one or more embodiments. The light emitting element of one or more embodiments may include the fused polycyclic compound of an example. The fused polycyclic compound of one or more embodiments includes, as a central structure, a nonacyclic fused ring including two nitrogen atoms and one boron atom as ring-forming atom, and an ortho biphenyl moiety may be bonded to the two nitrogen atoms. Accordingly, the fused polycyclic compound of one or more embodiments may be configured to emit red-shifted light, and the Dexter energy transfer may be prevented or reduced. The light emitting element including the fused polycyclic compound of an example may exhibit high efficiency and long service life characteristics.

The light emitting element of one or more embodiments and a display device including the same may include the fused polycyclic compound of one or more embodiments, thereby exhibiting high efficiency and long service life characteristics.

The fused polycyclic compound of one or more embodiments may contribute to high efficiency and long service life of the light emitting element.

The light-emitting device, the display device, the electronic apparatus, the electronic equipment, or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

A person of ordinary skill in the art would appreciate, in view of the present disclosure in its entirety, would appreciate that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Although the present disclosure has been described with reference to a one or more embodiments of the present disclosure, it will be understood that the present disclosure should not be limited to these embodiments but one or more suitable changes and modifications can be made by those skilled in the art without departing from the spirit and scope of the present disclosure.

Accordingly, the technical scope of the present disclosure is not intended to be limited to the contents set forth in the detailed description of the specification, but is intended to be defined by the appended claims.

## Claims

1. A fused polycyclic compound represented by Formula 1: 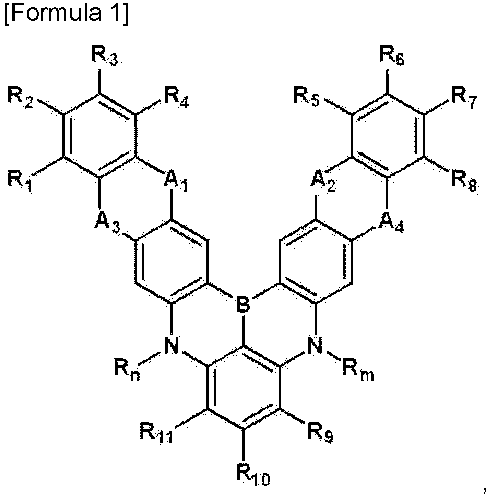 wherein, in Formula 1,
A₁ and A₂ are each independently NR_{b1}, O, S, CR_{b2}R_{b3}, or SiR_{b4}R_{b5},
A₃ and A₄ are each independently a direct linkage, NR_{b6}, O, S, CR_{b7}R_{b8}, or SiR_{b9}R_{b10}, when A₁ is CR_{b2}R_{b3}, then A₃ is a direct linkage, NR_{b6}, O, S, or SiR_{b9}R_{b10},
R_{b1} to R_{b10} are each independently a substituted or unsubstituted alkyl group having 1 to 30 carbon atoms, a substituted or unsubstituted aryl group having 6 to 30 ring-forming carbon atoms, or a substituted or unsubstituted heteroaryl group having 2 to 30 ring-forming carbon atoms, and/or are bonded to an adjacent group to form a ring,
R₁ to R₁₁ are each independently a hydrogen atom, a deuterium atom, a cyano group,
a substituted or unsubstituted amine group, a substituted or unsubstituted thio group, a substituted or unsubstituted oxy group, a substituted or unsubstituted silyl group, a substituted or unsubstituted alkyl group having 1 to 30 carbon atoms, a substituted or
unsubstituted alkenyl group having 2 to 30 carbon atoms, a substituted or
unsubstituted aryl group having 6 to 30 ring-forming carbon atoms, or a substituted or
unsubstituted heteroaryl group having 2 to 30 ring-forming carbon atoms, and/or are bonded to an adjacent group to form a ring, and
Rₙ is represented by Formula 2, and Rₘ is represented by Formula 3: 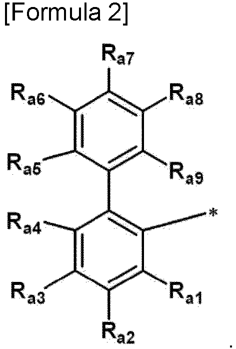
wherein, in Formula 2,
Rₐ₁ to Rₐ₉ are each independently a hydrogen atom, a deuterium atom, a cyano group, a substituted or unsubstituted amine group, a substituted or unsubstituted thio group, a substituted or unsubstituted oxy group, a substituted or unsubstituted silyl group, a substituted or unsubstituted alkyl group having 1 to 30 carbon atoms, a substituted or unsubstituted alkenyl group having 2 to 30 carbon atoms, a substituted or
unsubstituted aryl group having 6 to 30 ring-forming carbon atoms, or a substituted or
unsubstituted heteroaryl group having 2 to 30 ring-forming carbon atoms, and/or are bonded to an adjacent group to form a ring, and 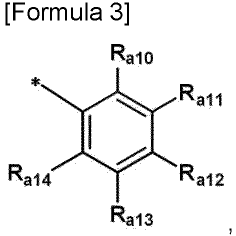
wherein, in Formula 3,
Rₐ₁₀ to Rₐ₁₄ are each independently a hydrogen atom, a deuterium atom, a cyano group, a substituted or unsubstituted amine group, a substituted or unsubstituted thio group, a substituted or unsubstituted oxy group, a substituted or unsubstituted silyl group, a substituted or unsubstituted alkyl group having 1 to 30 carbon atoms, a substituted or unsubstituted alkenyl group having 2 to 30 carbon atoms, a substituted or unsubstituted aryl group having 6 to 30 ring-forming carbon atoms, or a substituted or unsubstituted heteroaryl group having 2 to 30 ring-forming carbon atoms, and/or are bonded to an adjacent group to form a ring.

2. The fused polycyclic compound of claim 1, wherein Formula 1 is represented by Formula 1-1 or Formula 1-2: 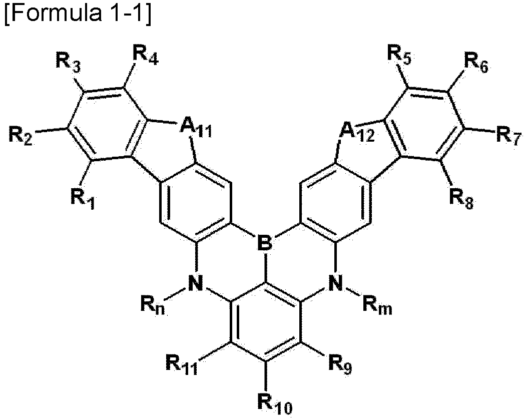 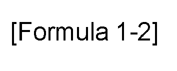 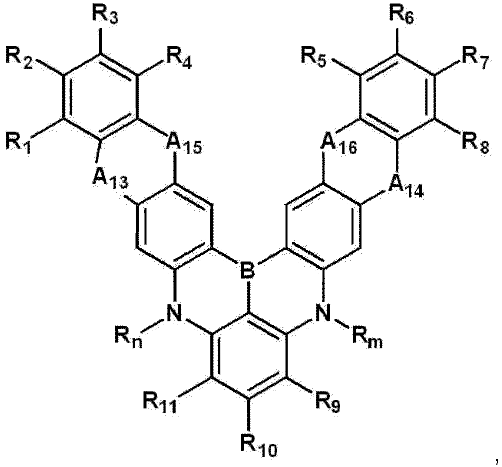 wherein, in Formula 1-1,
A₁₁ and A₁₂ are each independently NR_{b1}, O, S, CR_{b2}R_{b3}, or SiR_{b4}R_{b5},
wherein, in Formula 1-2,
A₁₃ to A₁₆ are each independently NR_{b6}, O, S, CR_{b7}R_{b8}, or SiR_{b9}R_{b10},
when A₁₅ is CR_{b7}R_{b8}, then A₁₃ is NR_{b6}, O, S, or SiR_{b9}R_{b10}, and
wherein, in Formula 1-1 and Formula 1-2,
R₁ to R₁₁, R_{b1} to R_{b10}, Rₙ, and Rₘ are the same as defined in Formula 1.

3. The fused polycyclic compound of claim 2, wherein Formula 1-1 is represented by any one selected from among Formula 1-1A to Formula 1-1D: 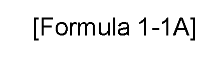 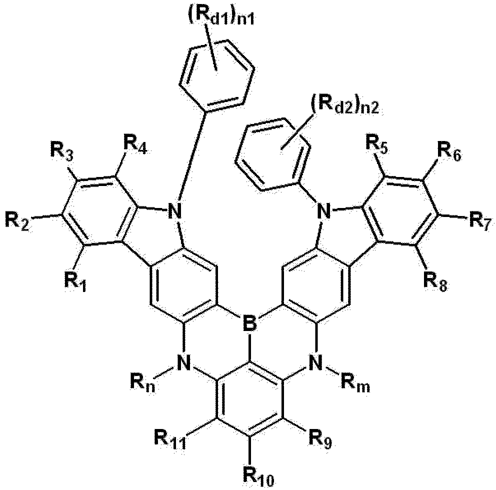 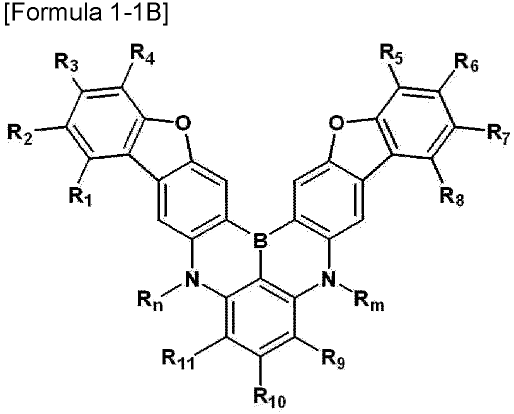 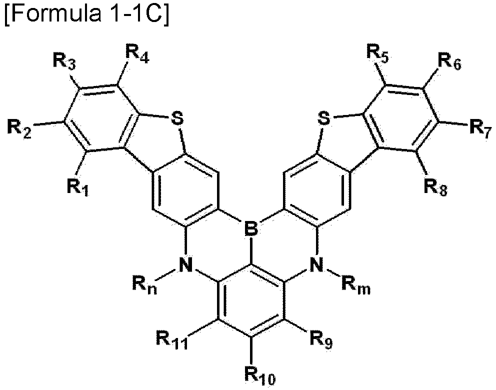 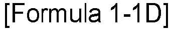 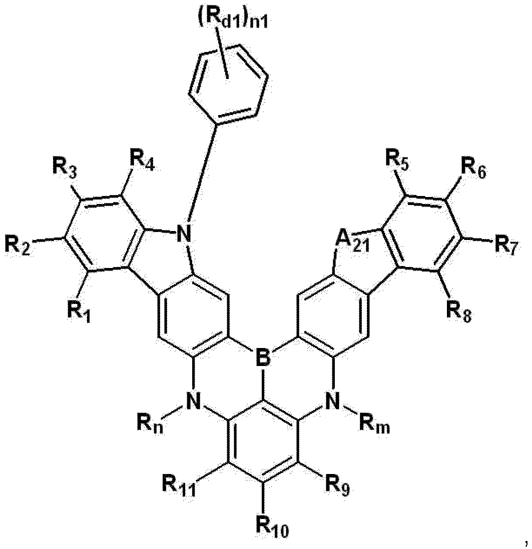 wherein, in Formula 1-1A and Formula 1-1D,
n1 and n2 are each independently an integer of 0 to 5, and
R_{d1} and R_{d2} are each independently a hydrogen atom, a deuterium atom, or a substituted or unsubstituted aryl group having 6 to 30 ring-forming carbon atoms, and
in Formula 1-1D,
A₂₁ is O, S, or CR_{b2}R_{b3}, and
wherein, in Formula 1 -1A to Formula 1-1D,
R₁ to R₁₁, R_{b2}, R_{b3}, Rₙ, and Rₘ are the same as defined in Formula 1-1.

4. The fused polycyclic compound of claim 3, wherein in Formula 1-1D, A₂₁ is CR_{b2}R_{b3}, and R_{b2} and R_{b3} are each independently a substituted or unsubstituted methyl group, or a substituted or unsubstituted phenyl group.

5. The fused polycyclic compound of claim 1, wherein in Formula 1, A₁ is O, A₂ is S, CR_{b2}R_{b3}, or SiR_{b4}R_{b5}, and R_{b2} to R_{b5} are each independently a substituted or unsubstituted methyl group, or a substituted or unsubstituted phenyl group.

6. The fused polycyclic compound of claim 1, wherein Formula 2 and Formula 3 are each independently represented by any one selected from among Formula RA-1 to Formula RA-19:

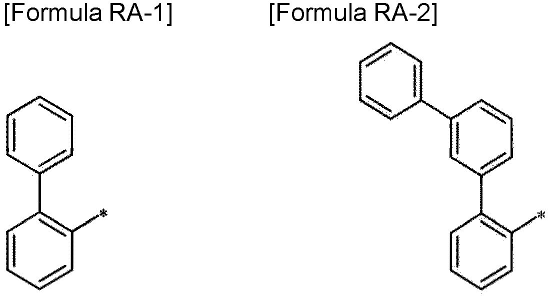

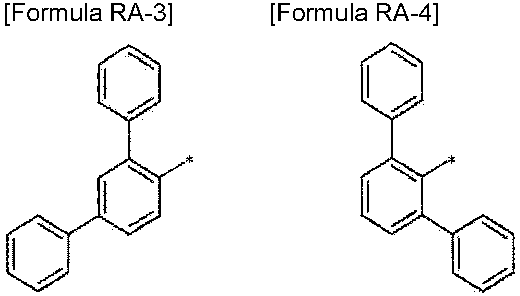

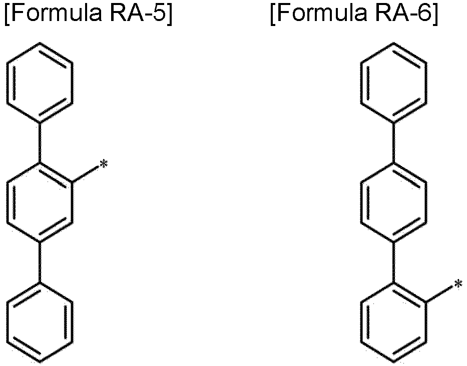

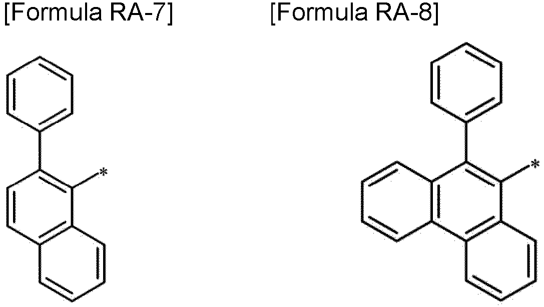

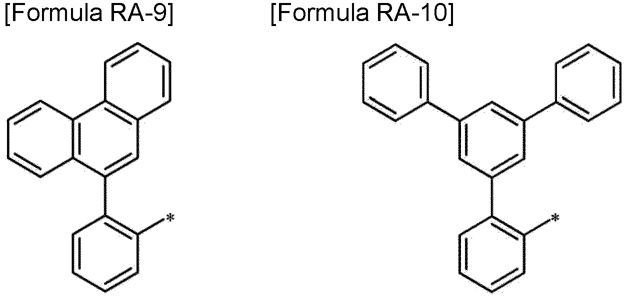

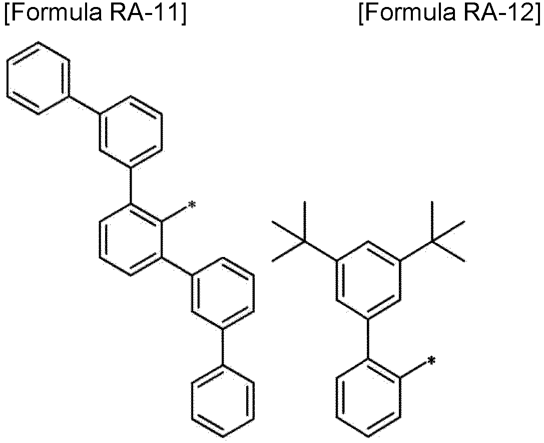

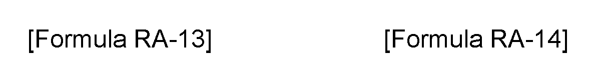

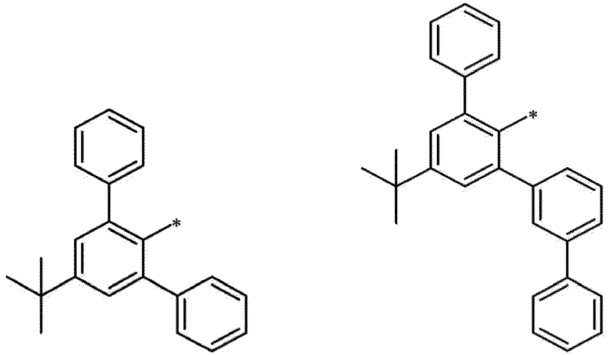

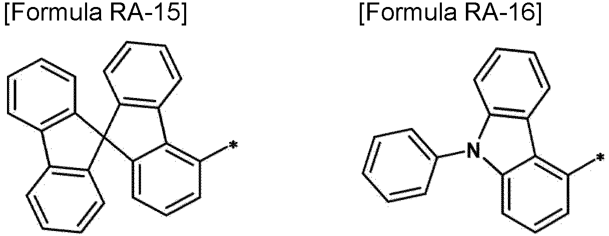

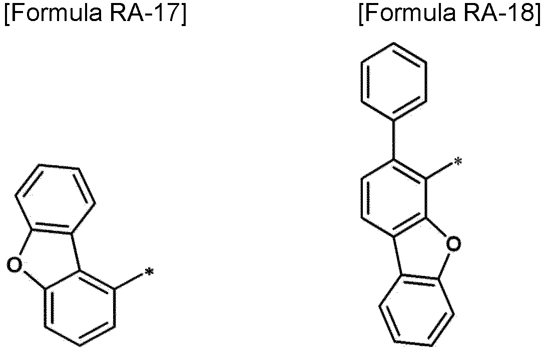

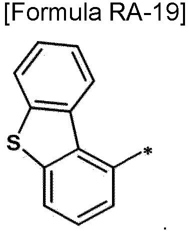

7. The fused polycyclic compound of claim 1, wherein in Formula 1, R₂, R₃, R₆, and R₇ are each independently a hydrogen atom or represented by any one selected from among R-1 to R-7:

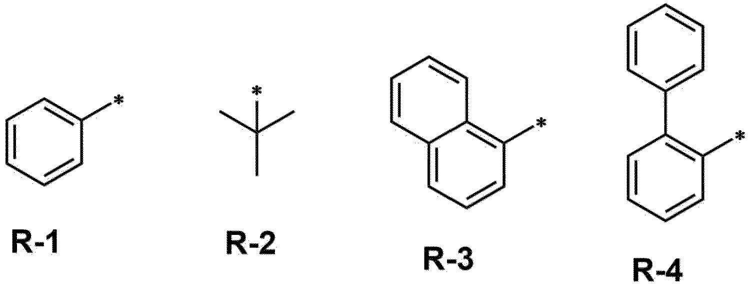

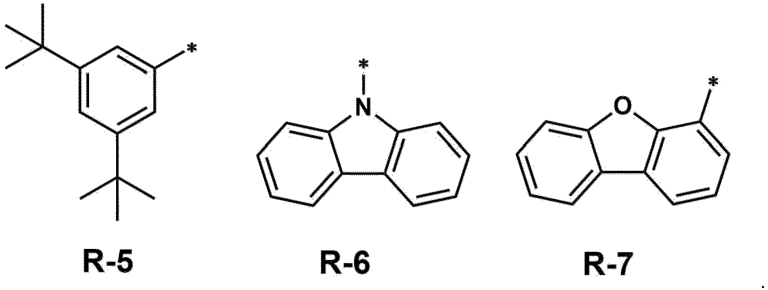

8. The fused polycyclic compound of claim 1, wherein in Formula 1, R₁₀ is a hydrogen atom or represented by any one selected from among R10-1 to R10-32: 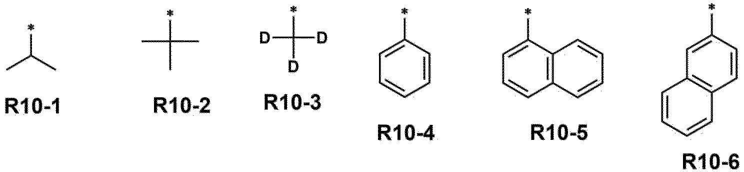 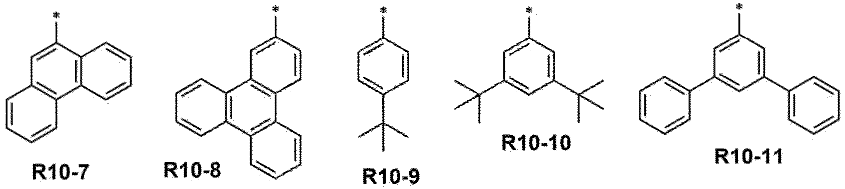 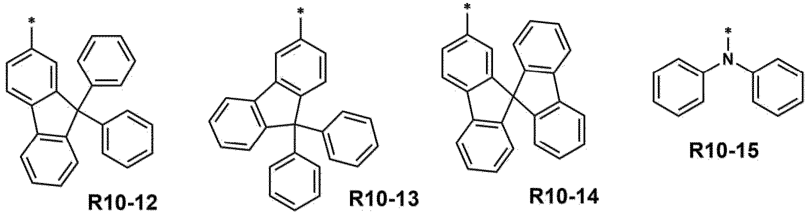 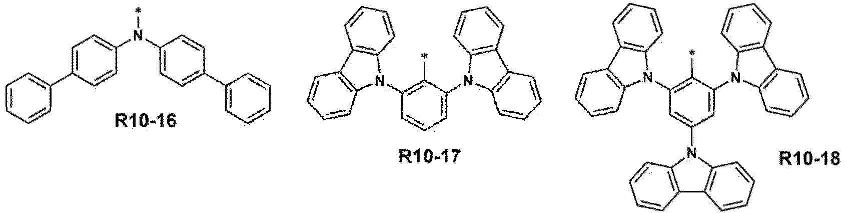 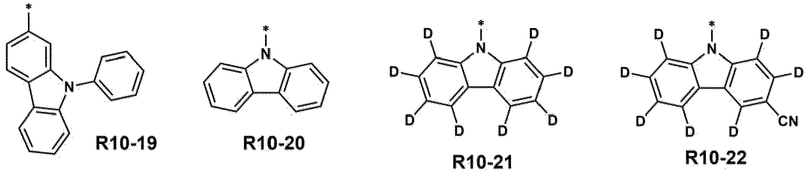 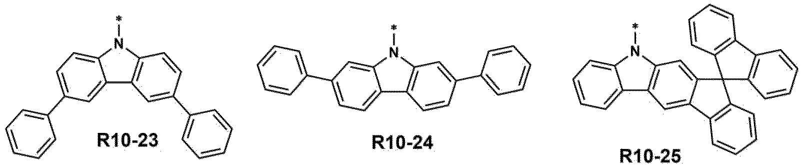 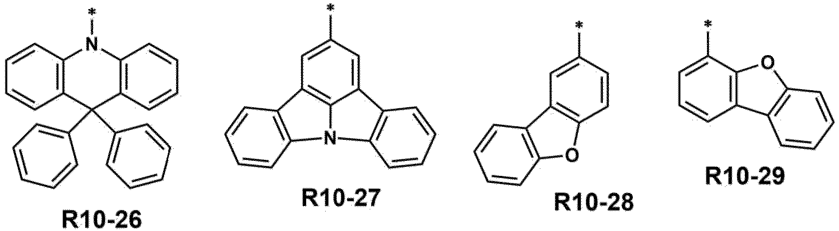 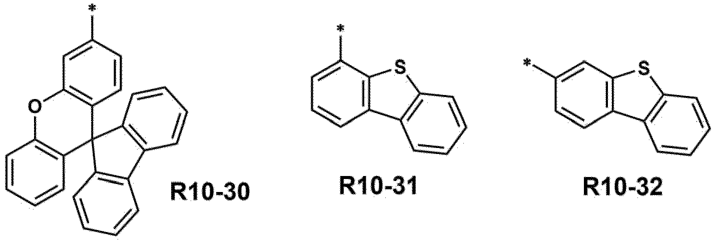 wherein, in R10-3, R10-21 and R10-22, D is a deuterium atom.

9. The fused polycyclic compound of claim 1, wherein Formula 1 is represented by any one selected from among compounds of Compound Group 1: 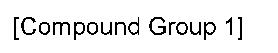 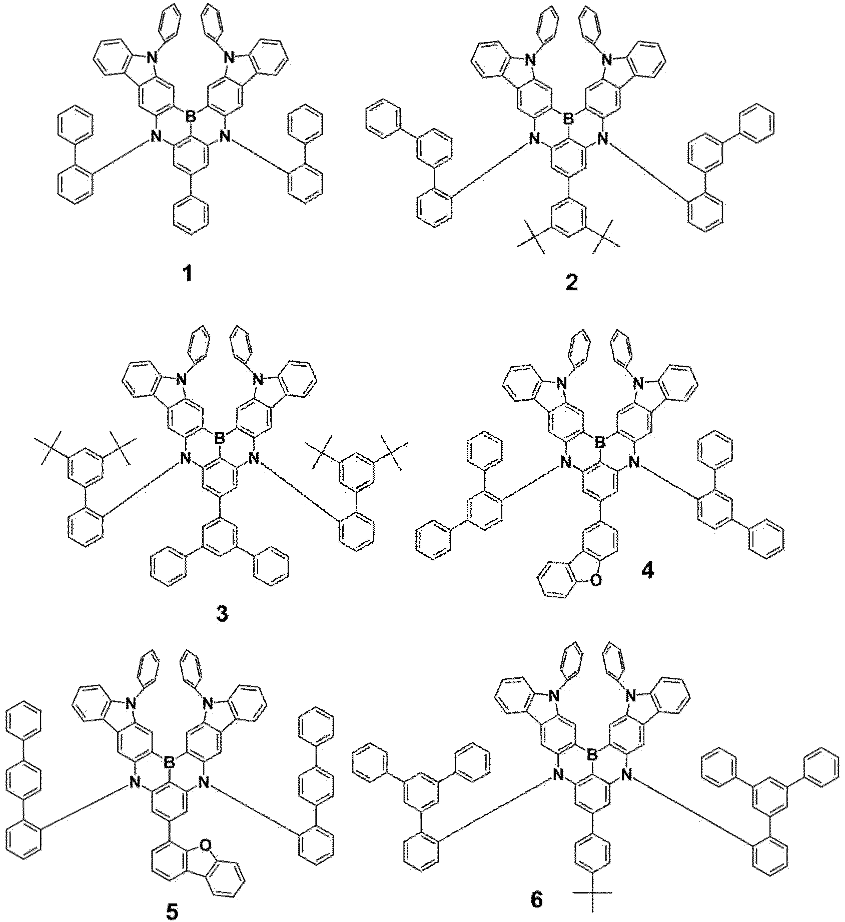 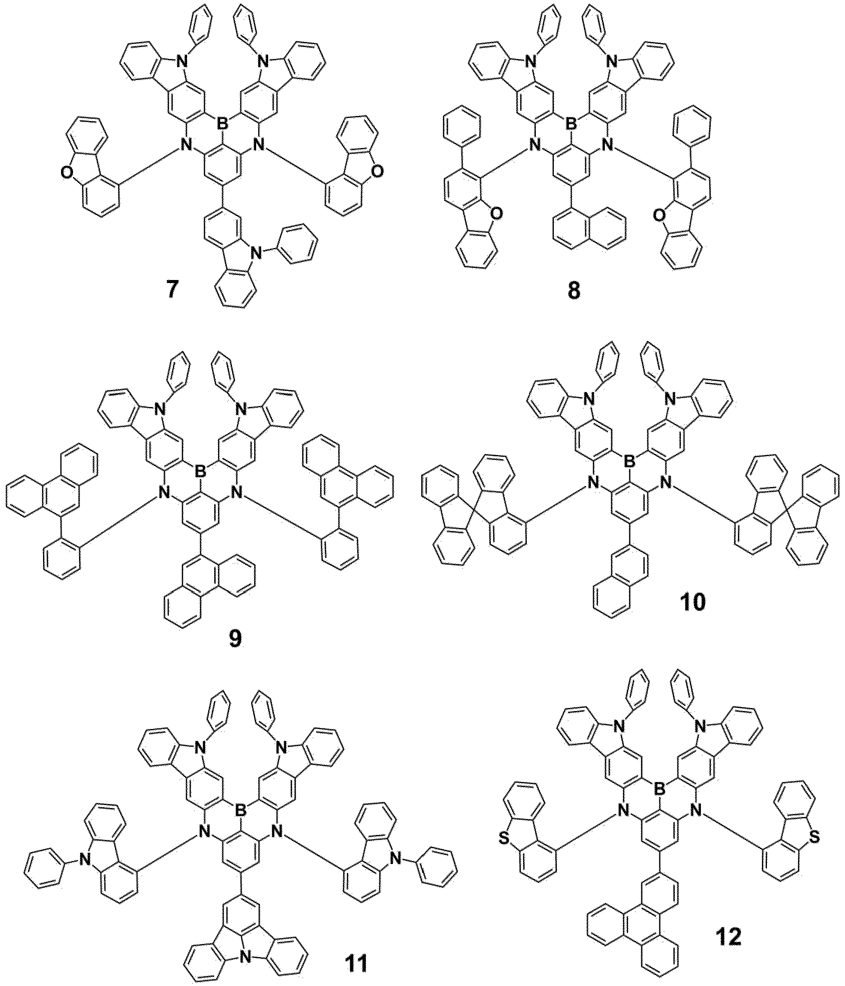 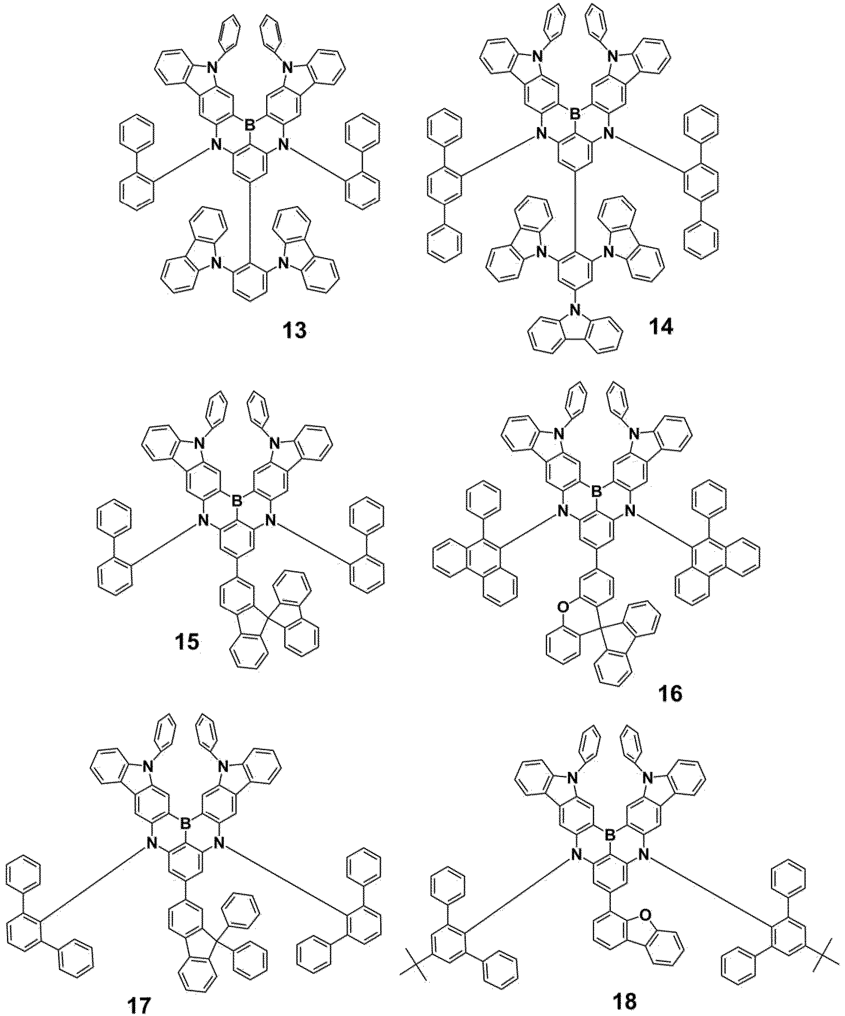 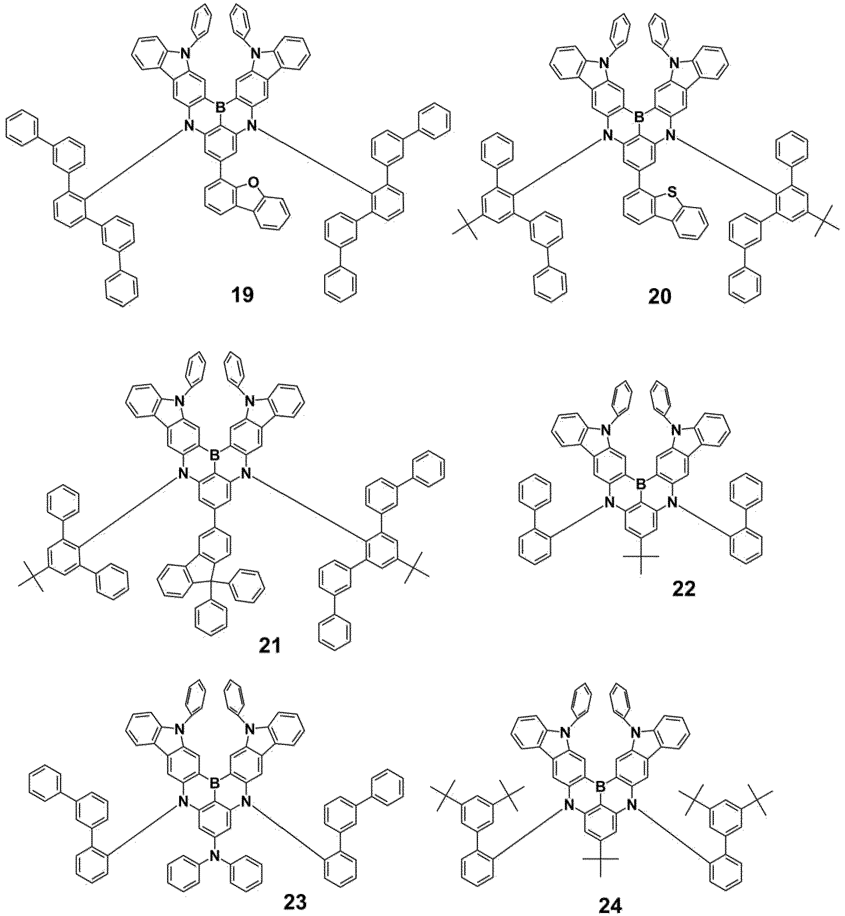 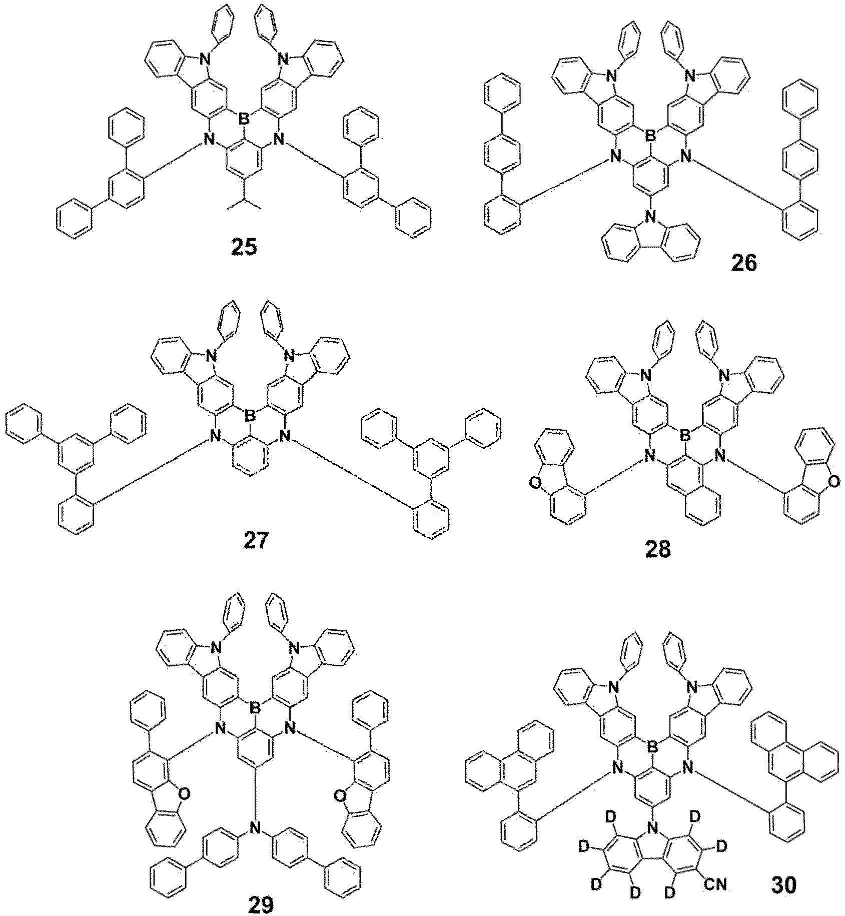 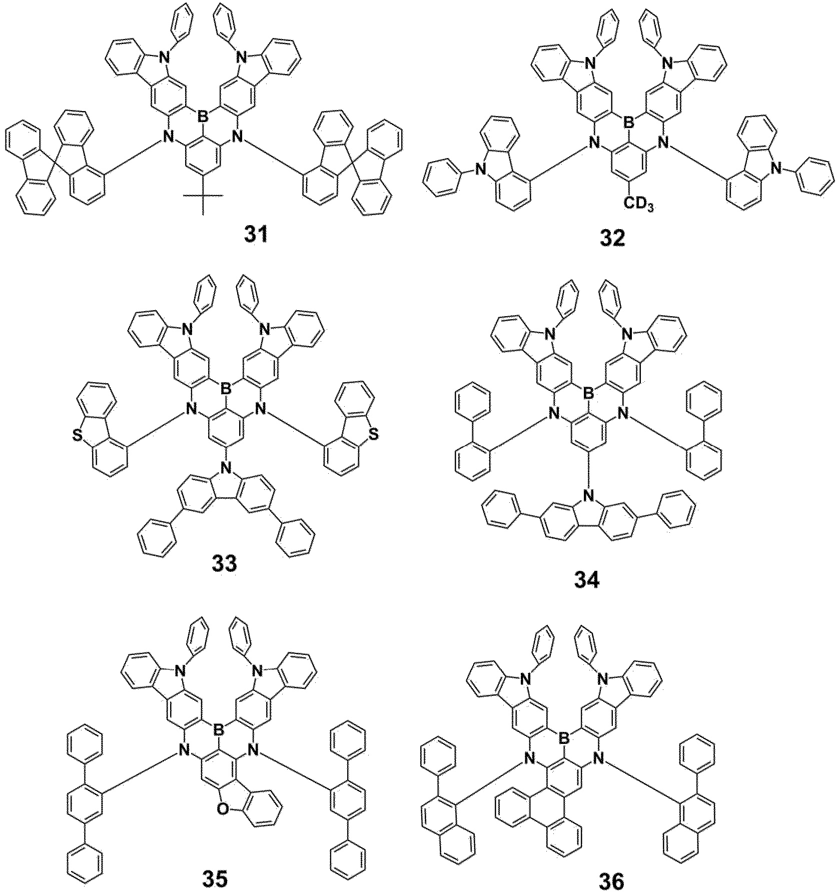 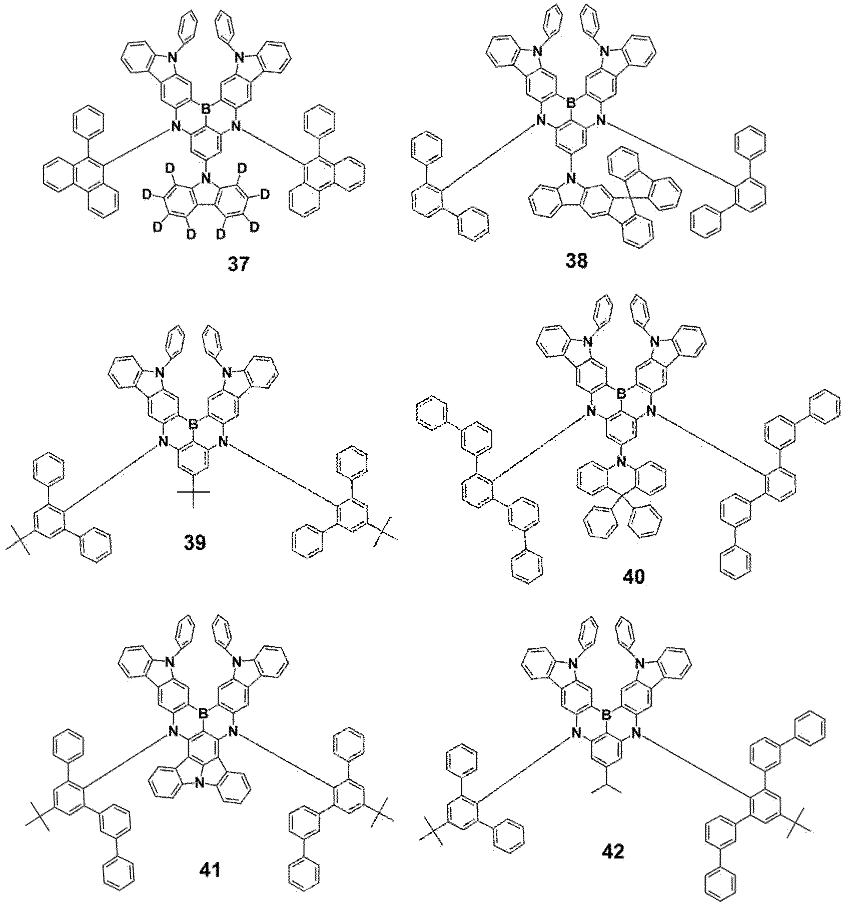 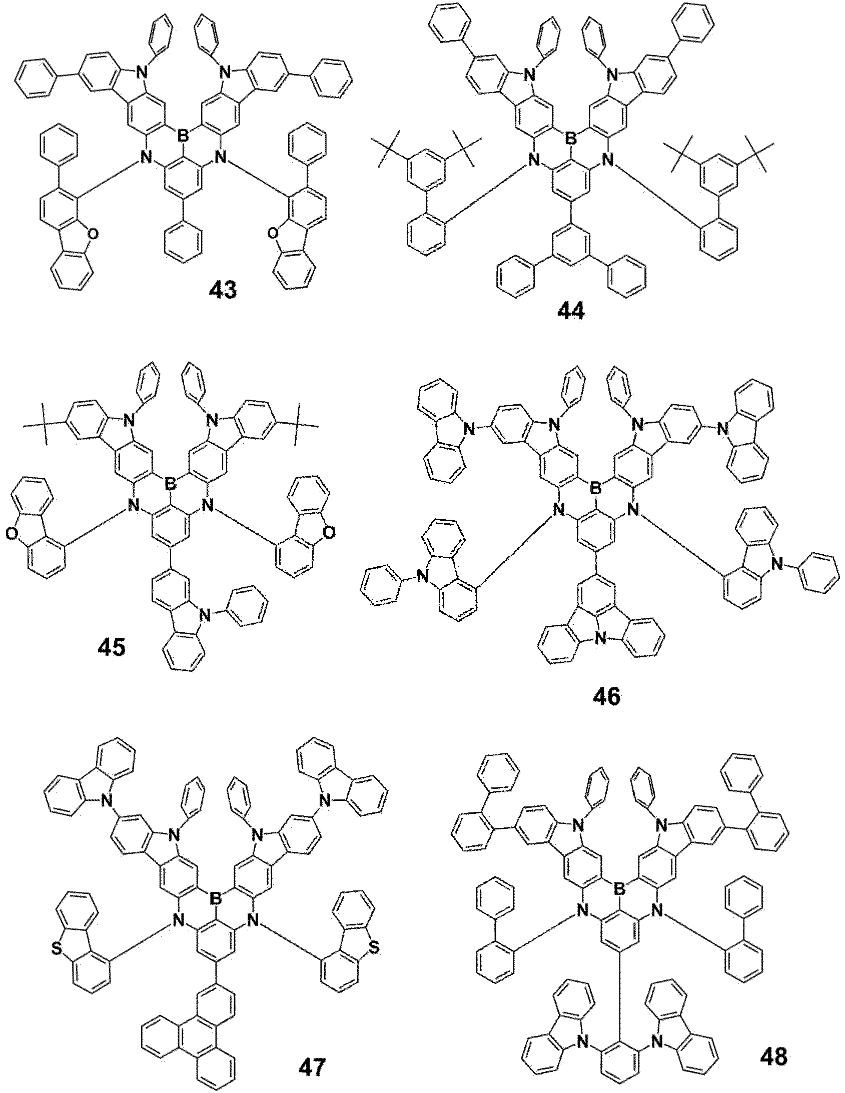 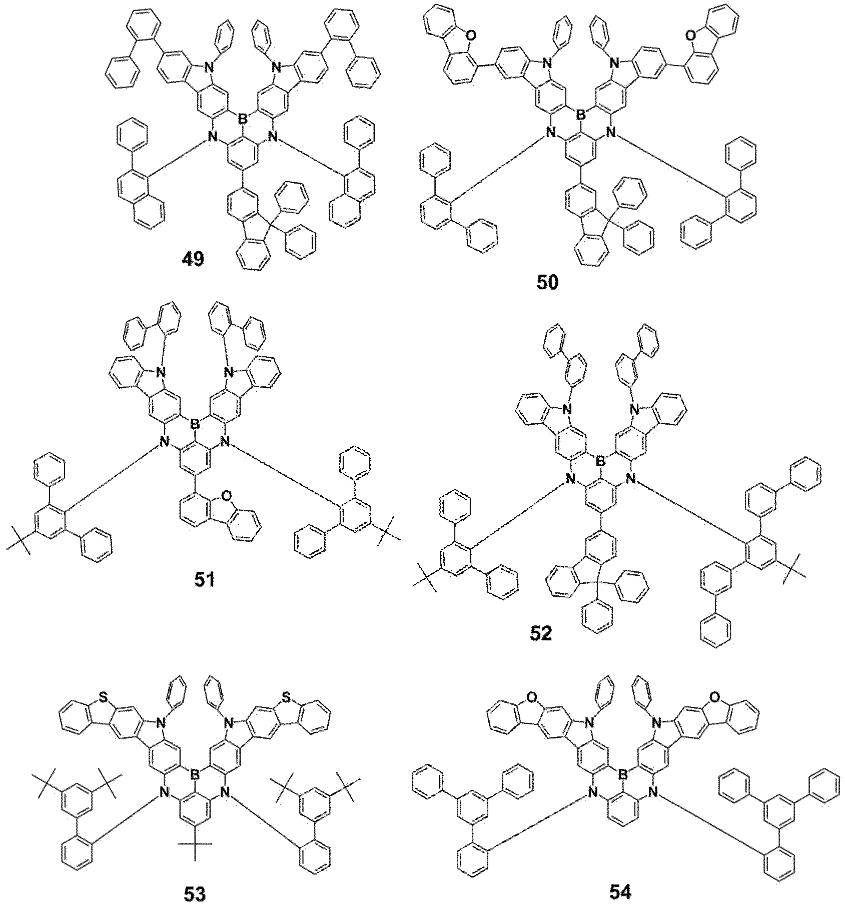 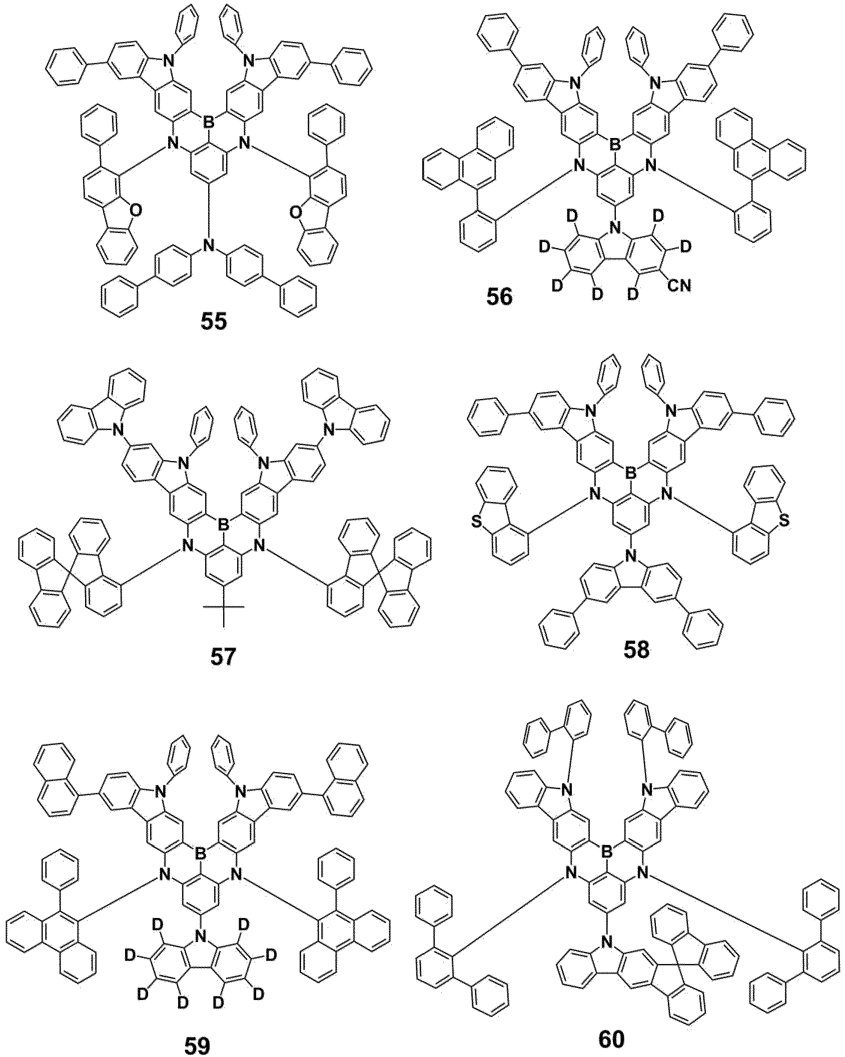 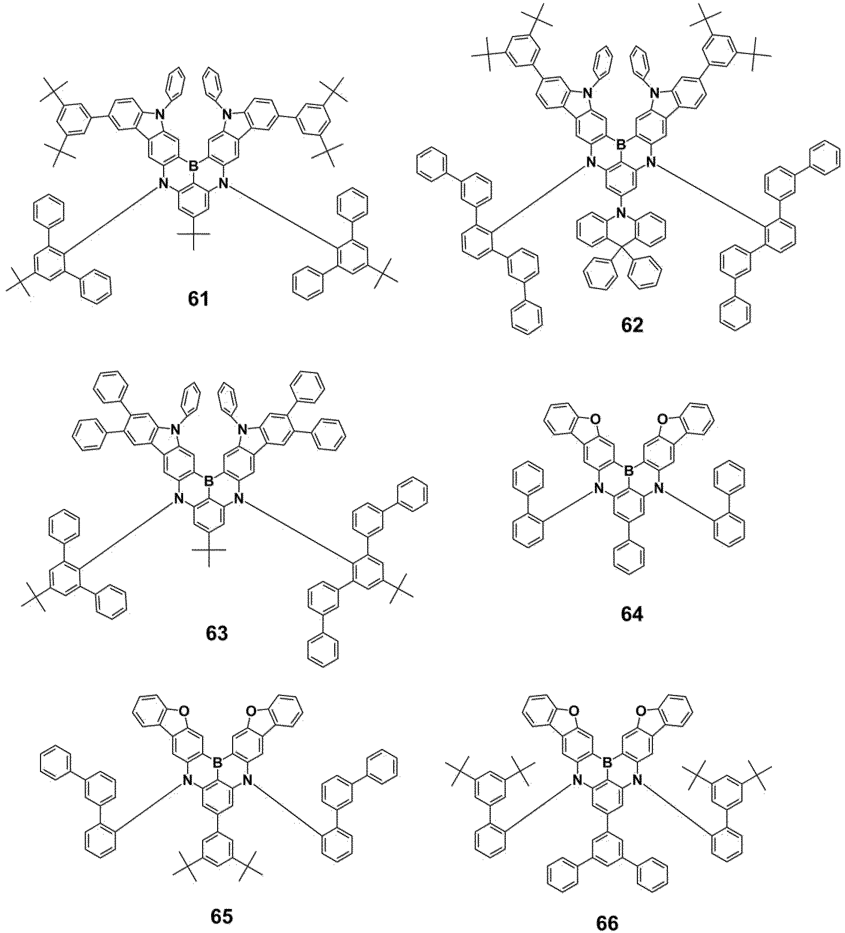 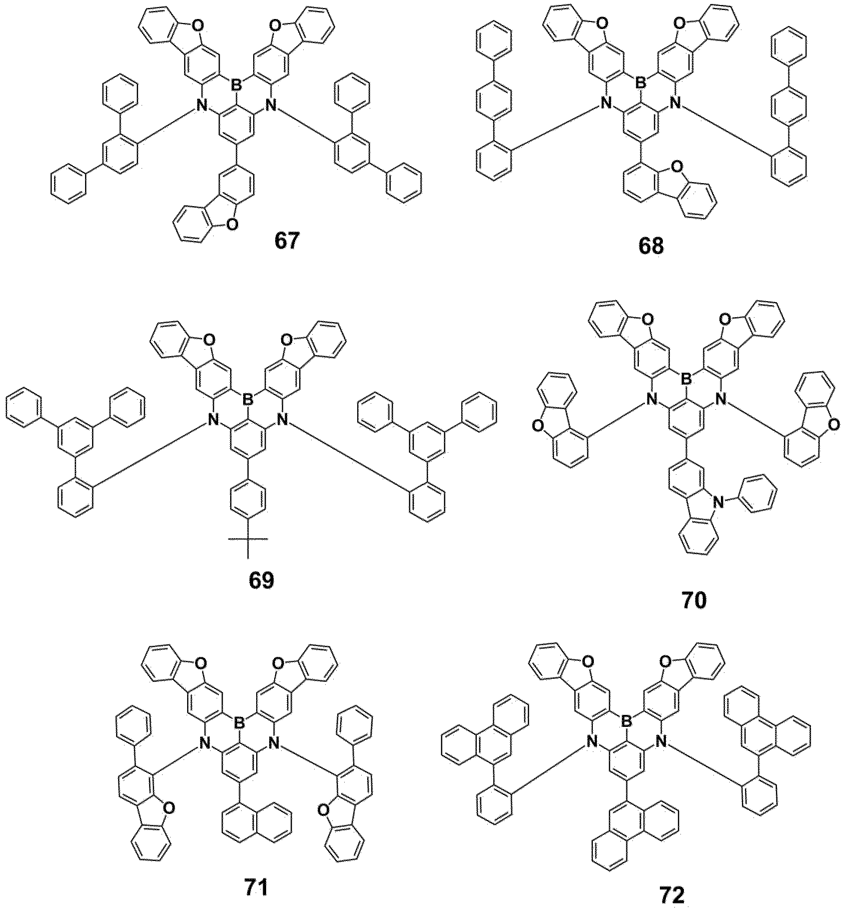 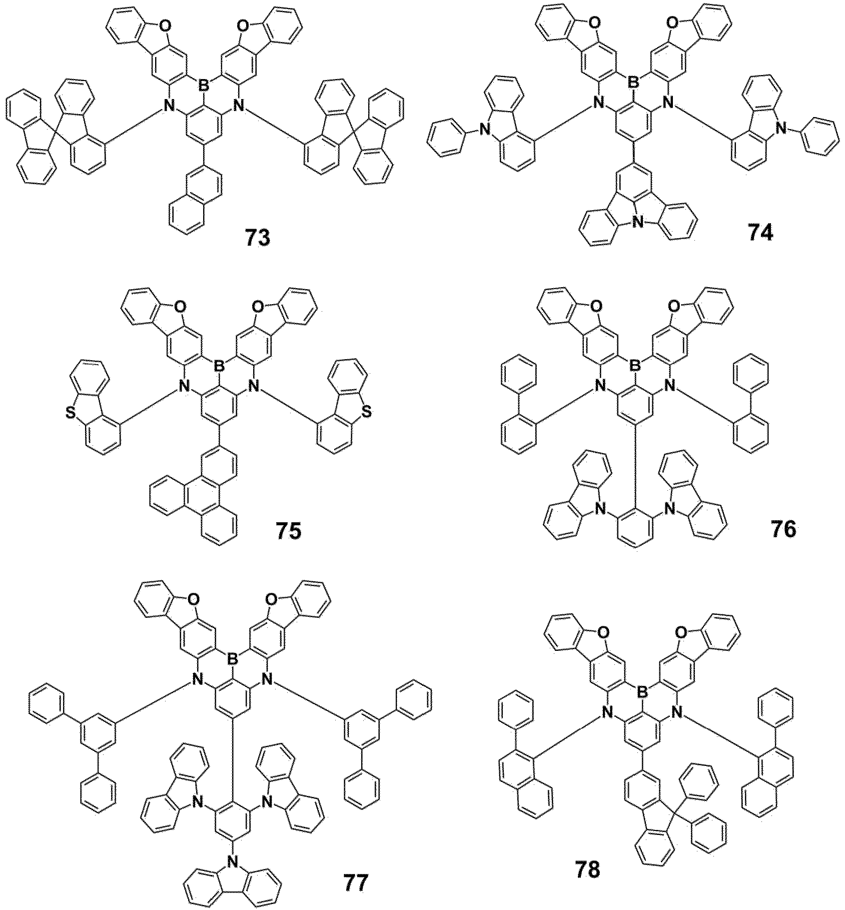 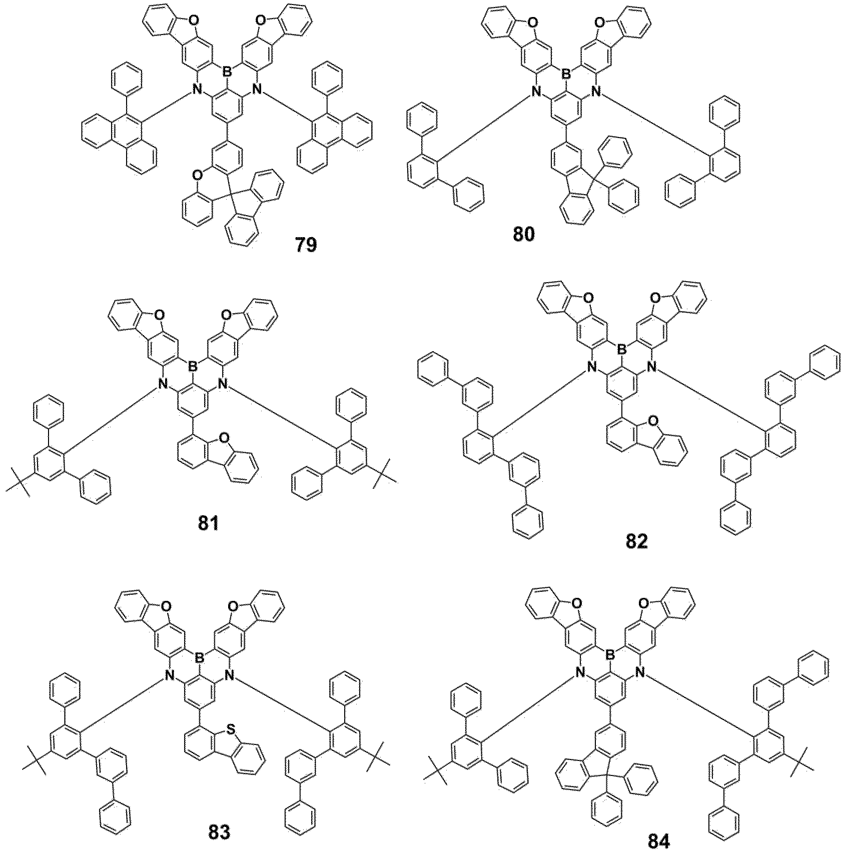 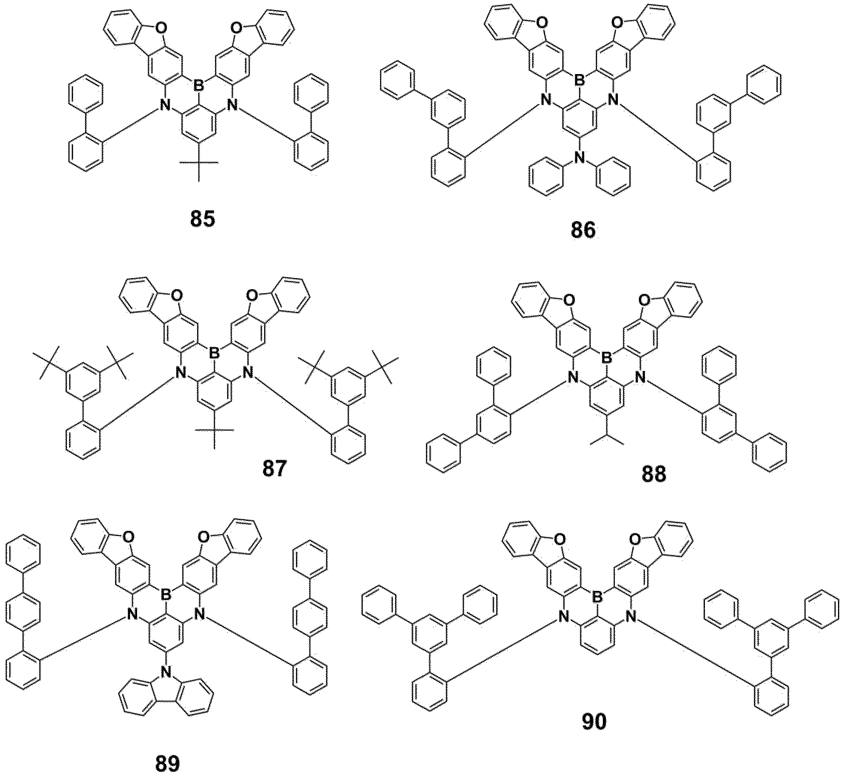 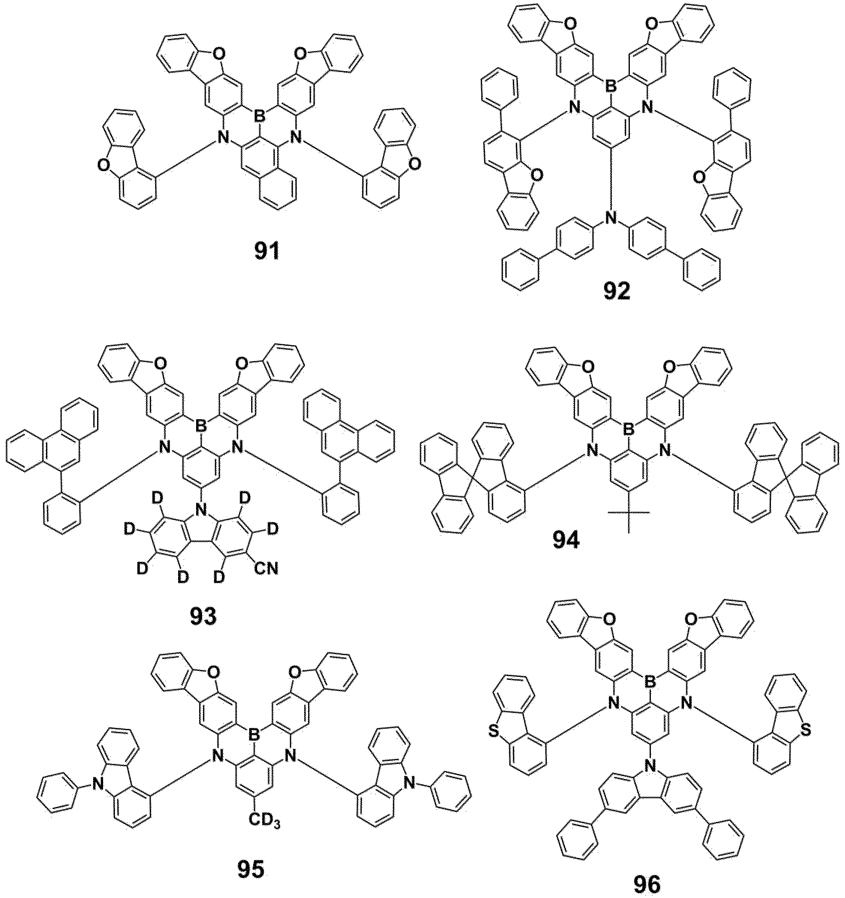 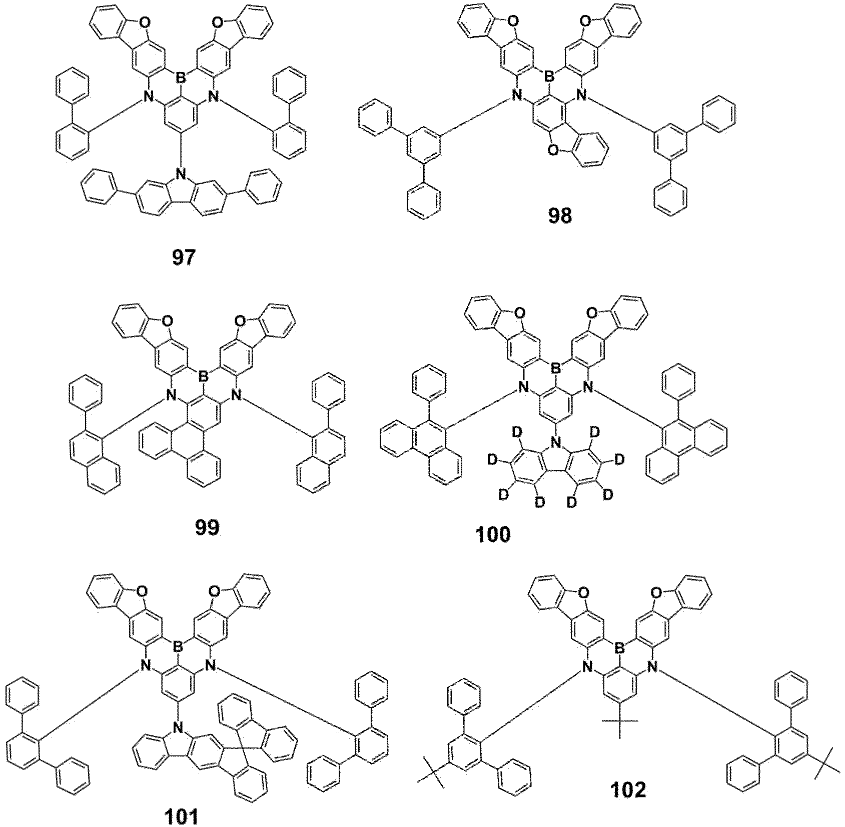 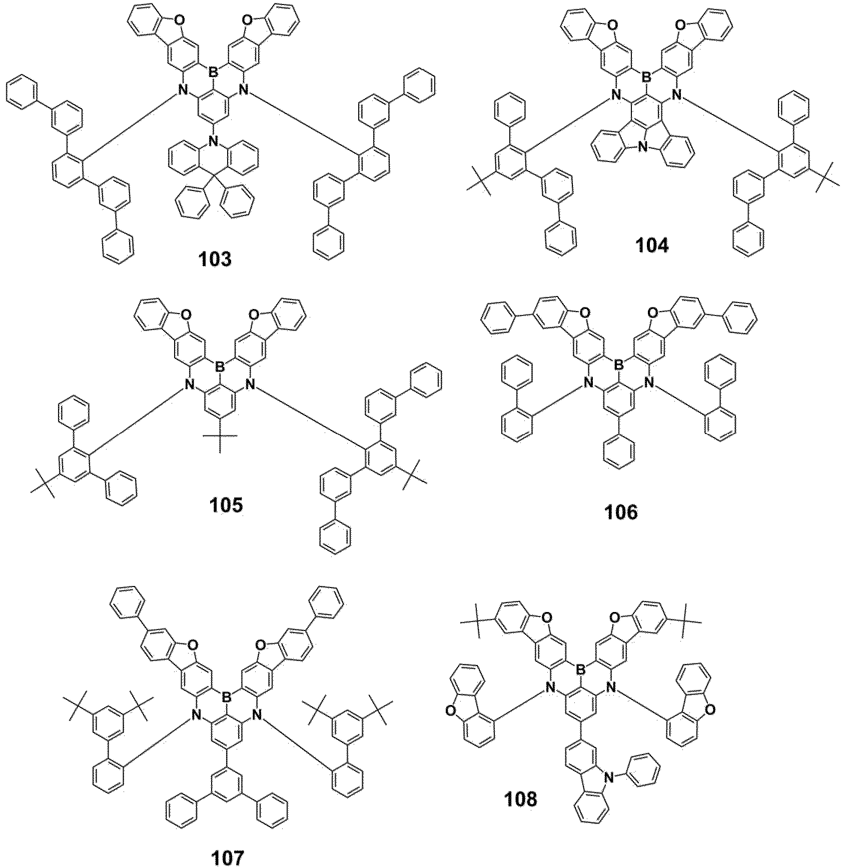 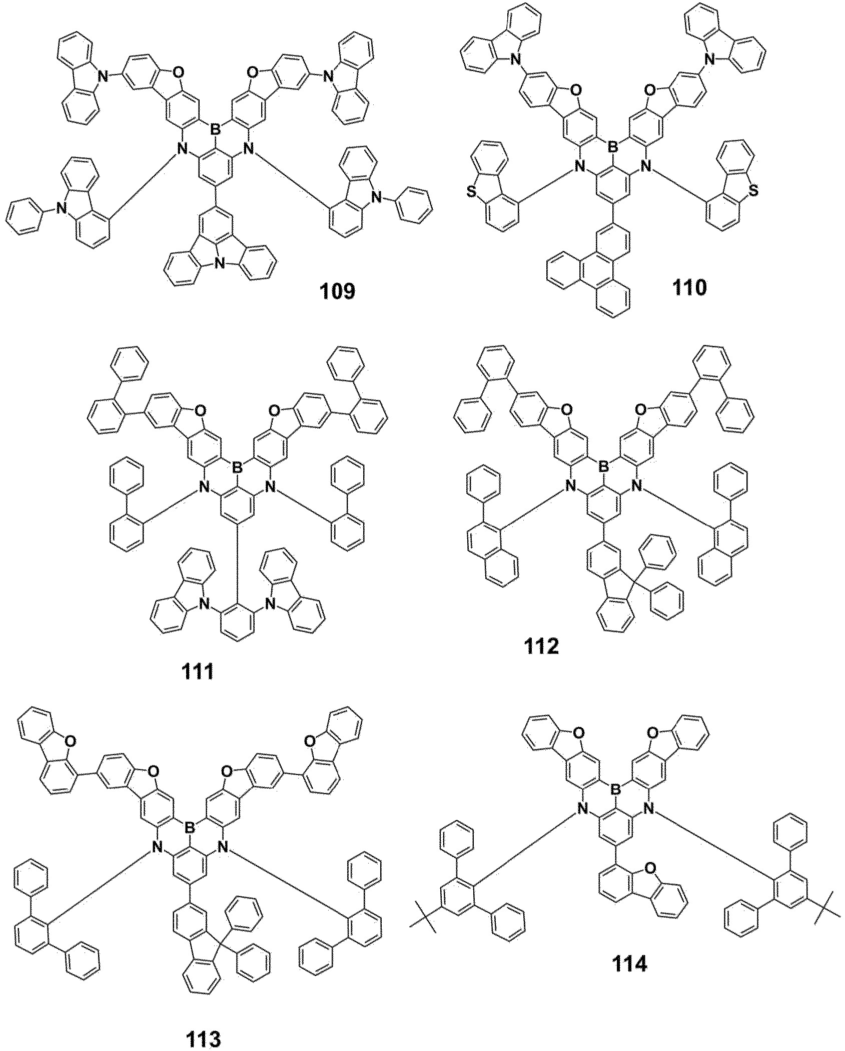 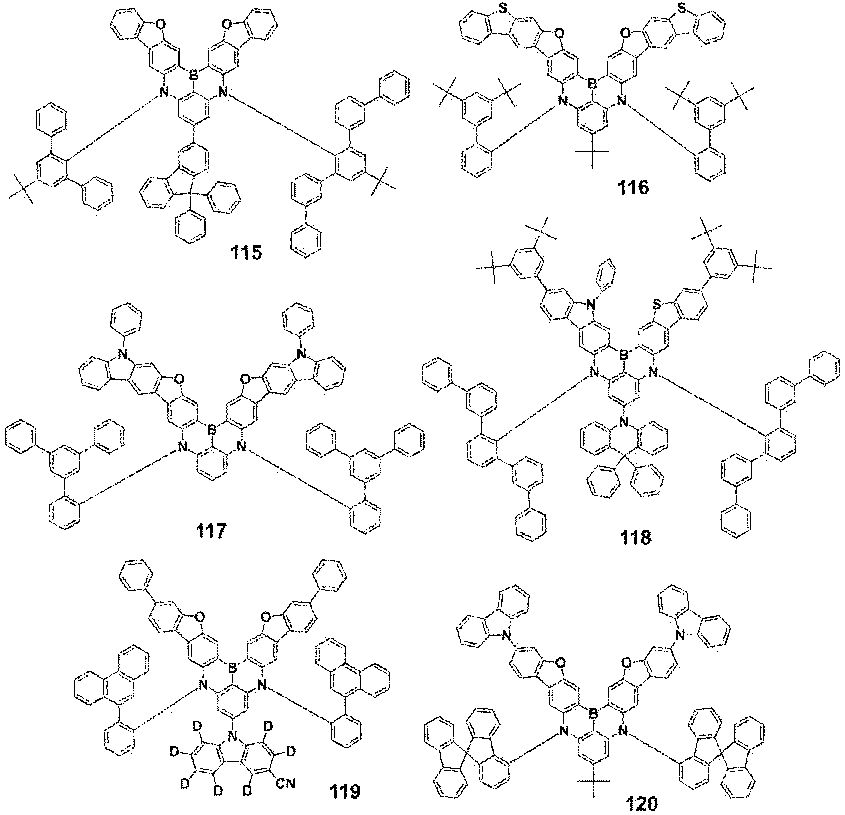 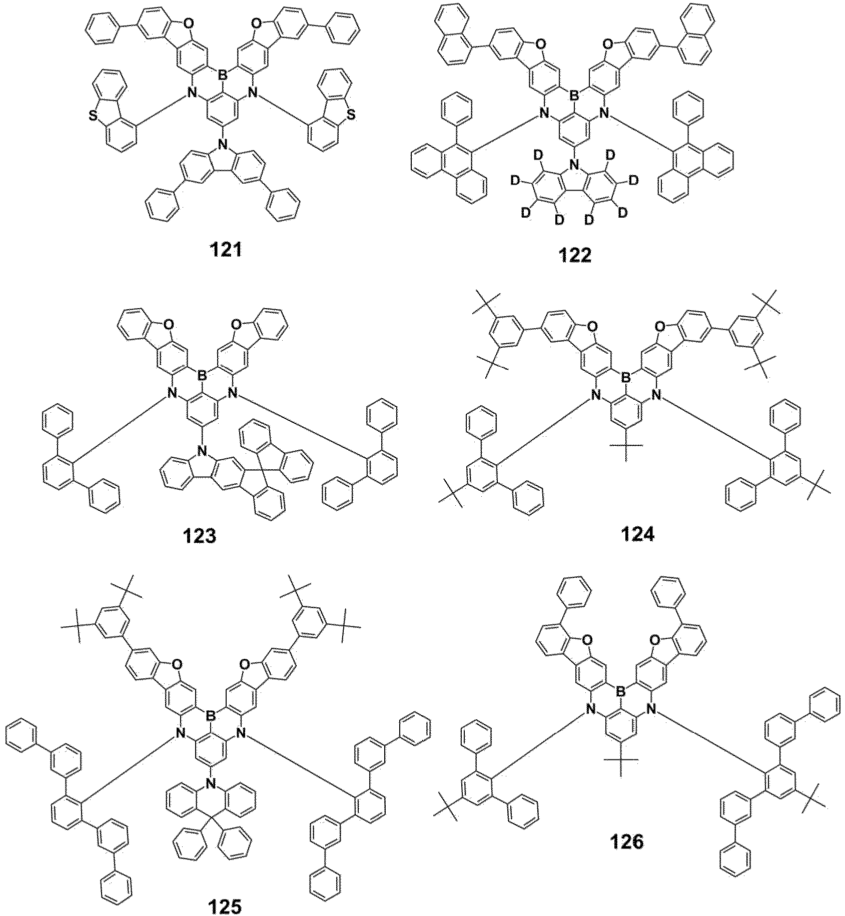 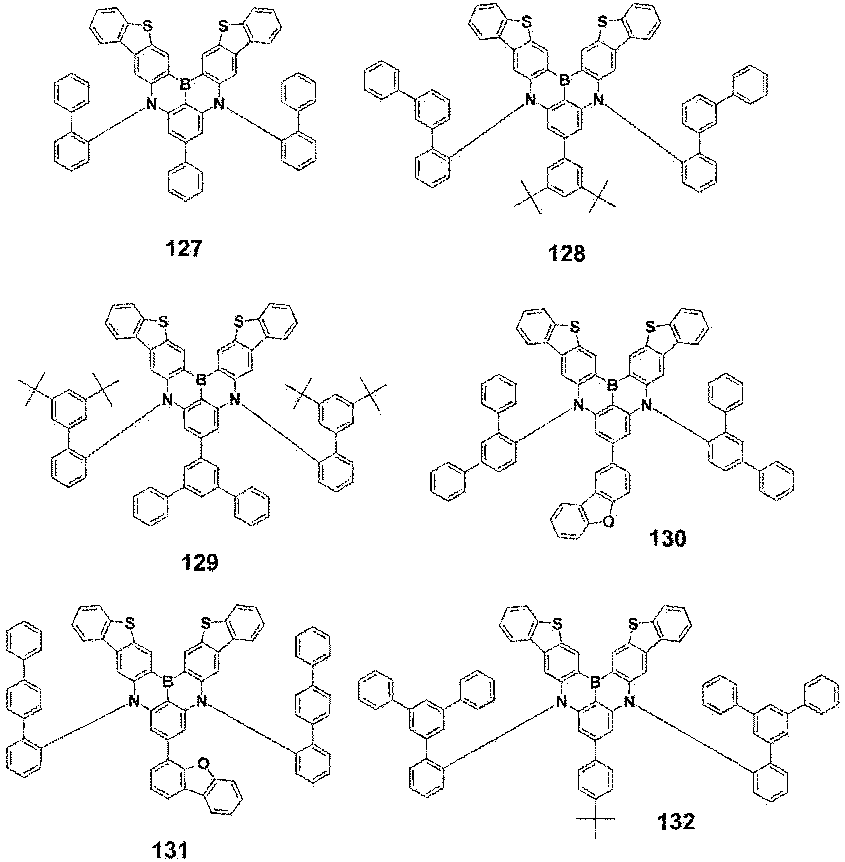 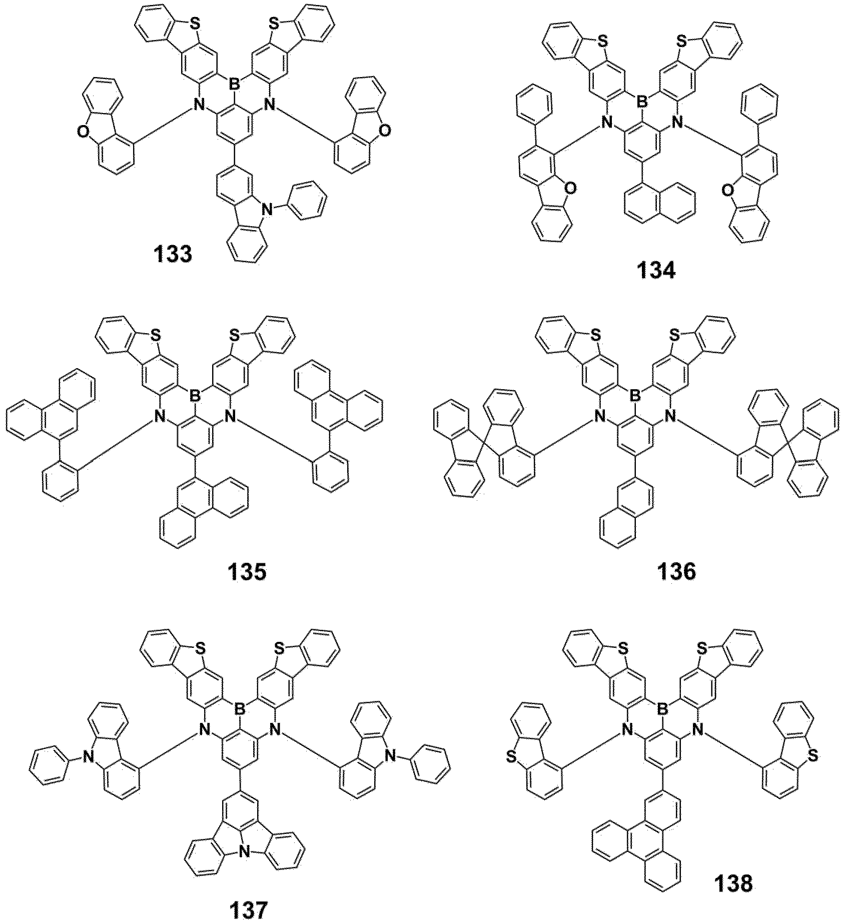 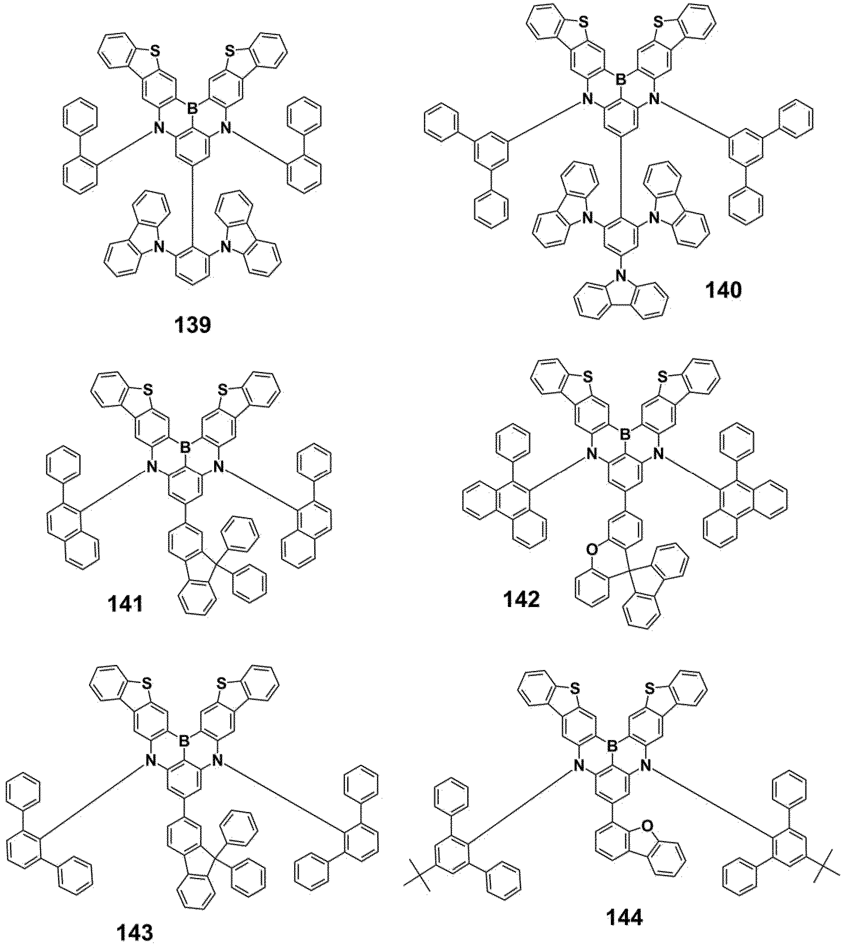 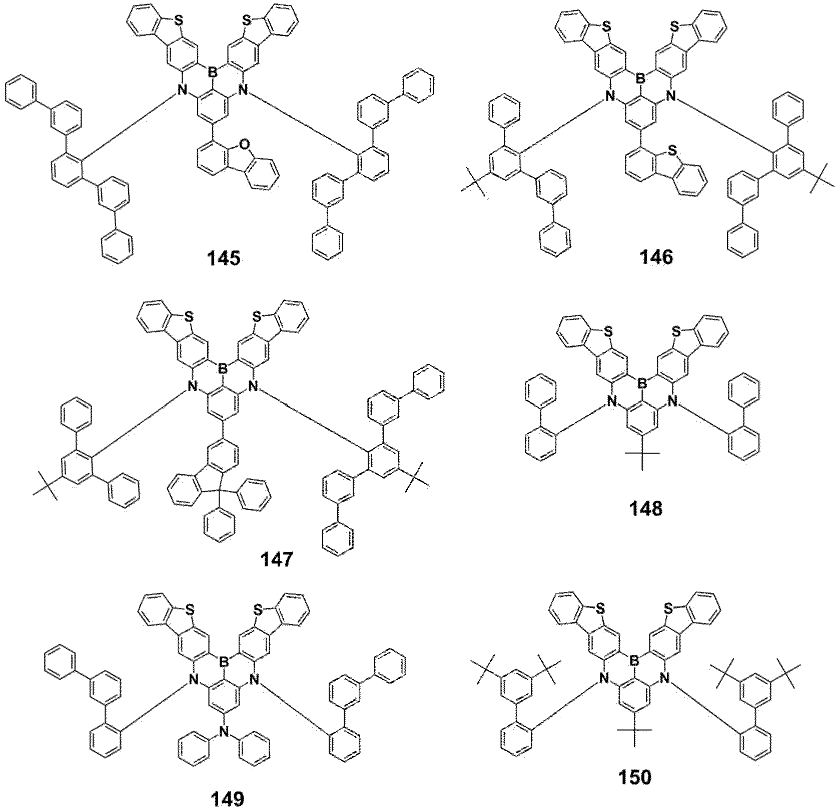 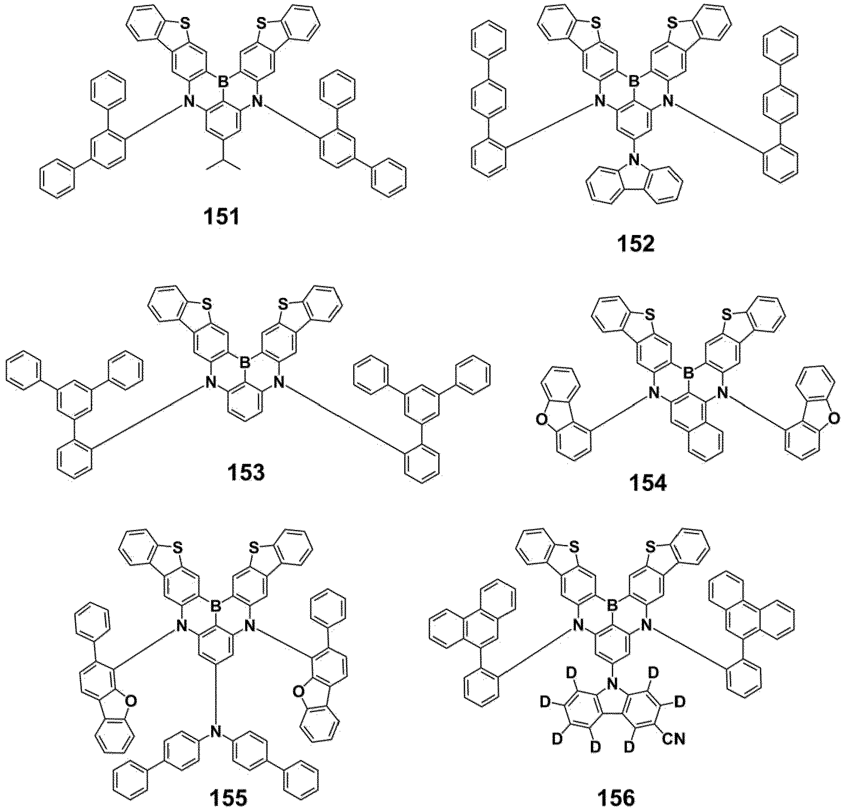 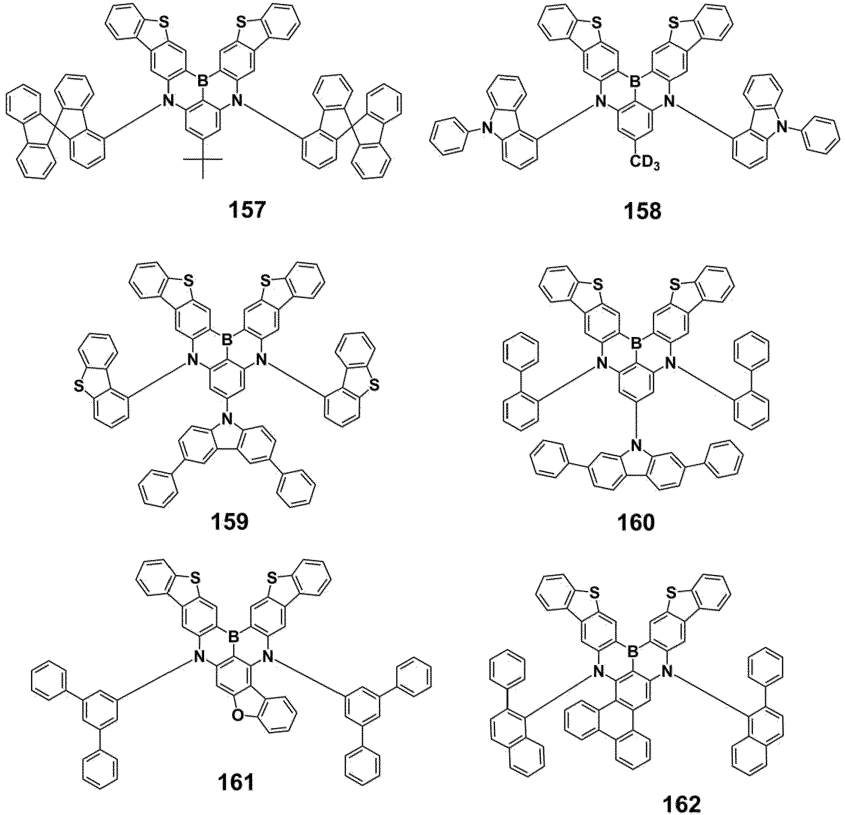 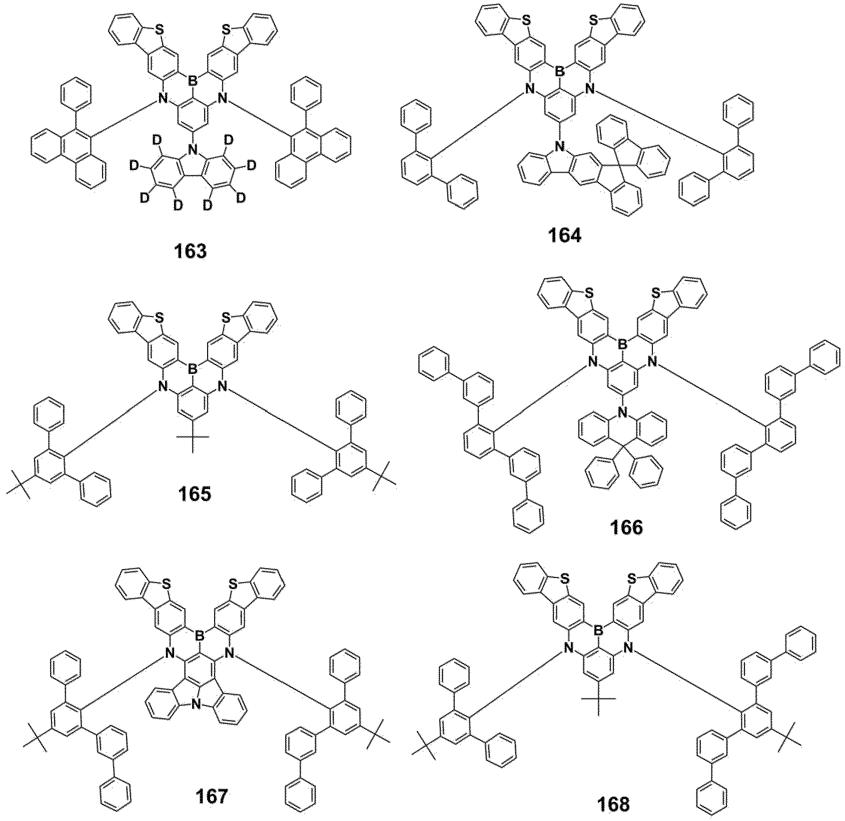 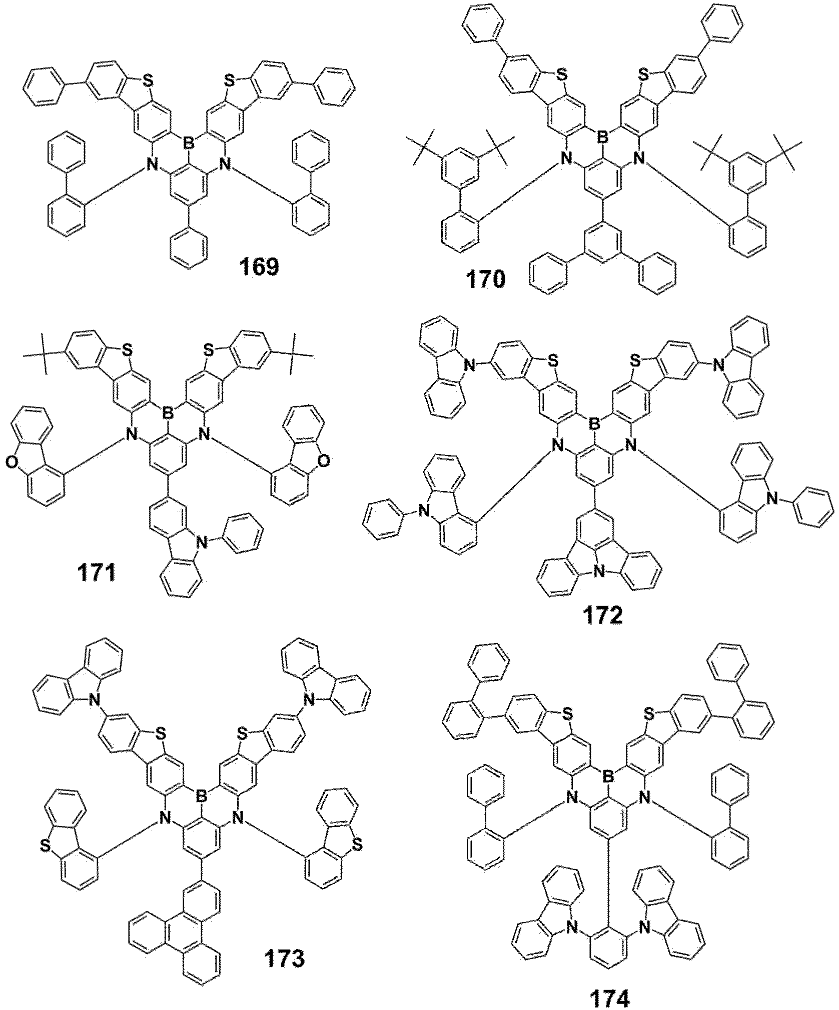 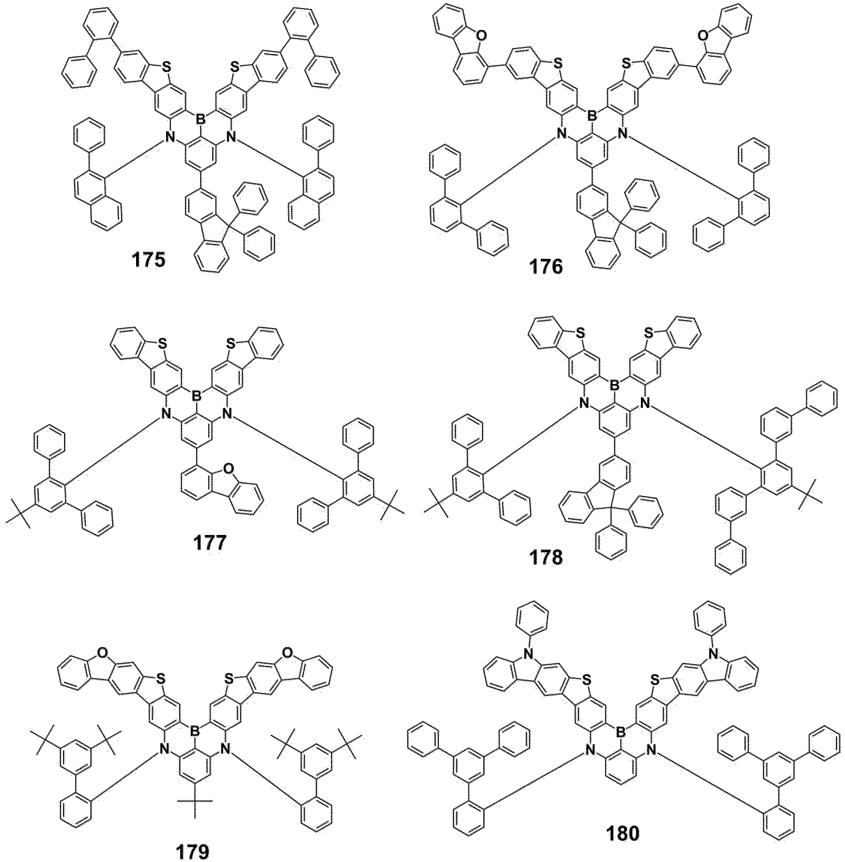 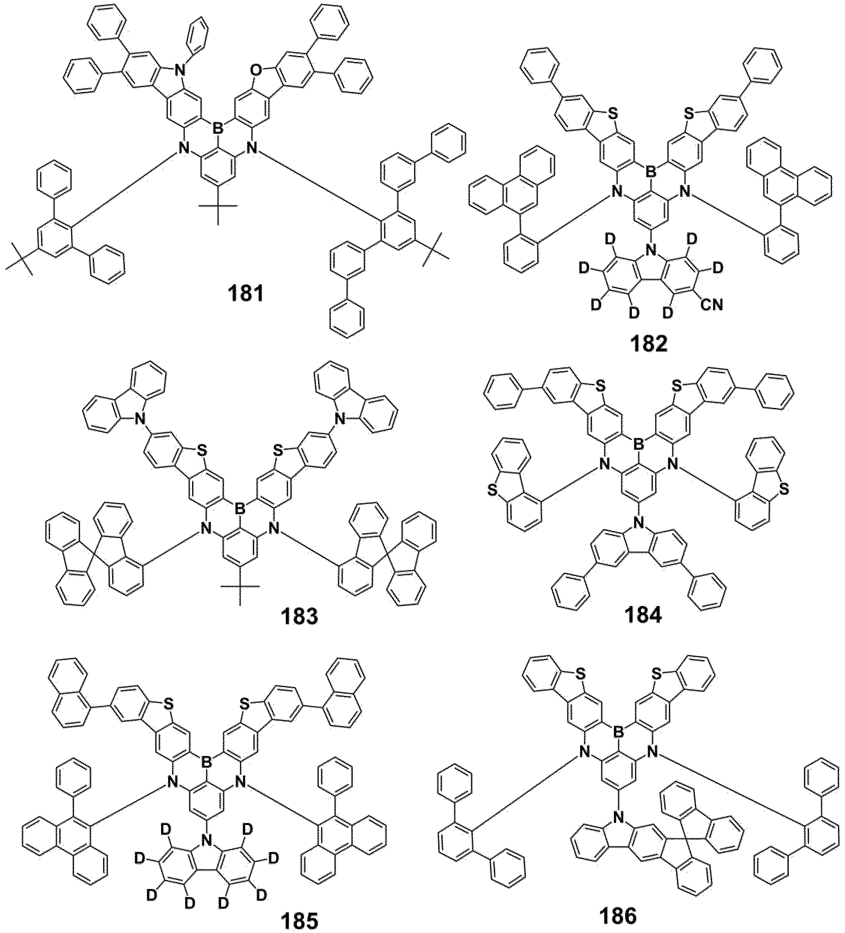 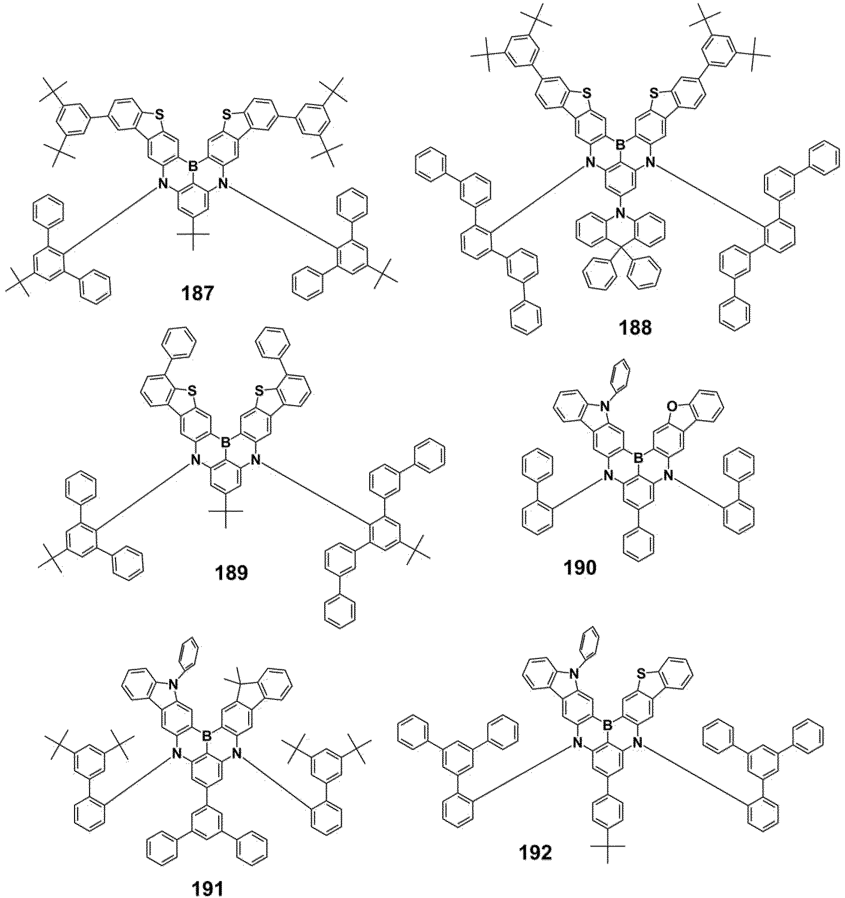 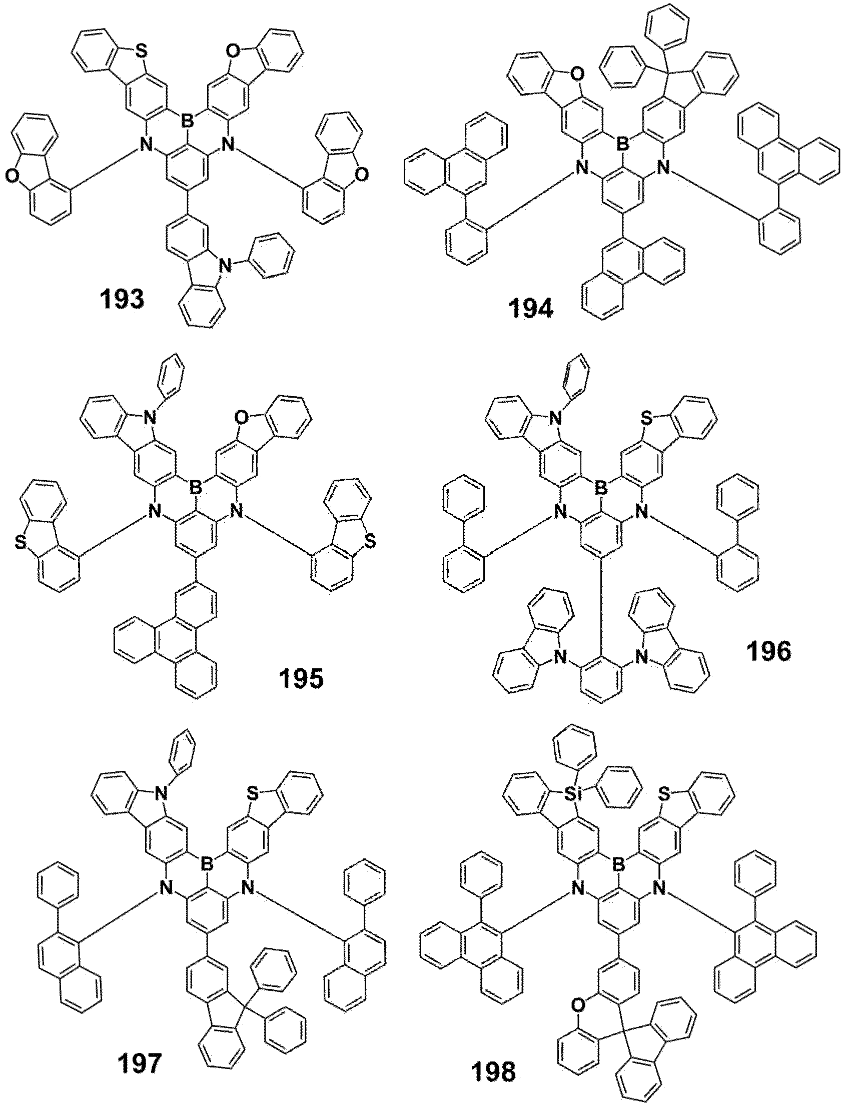 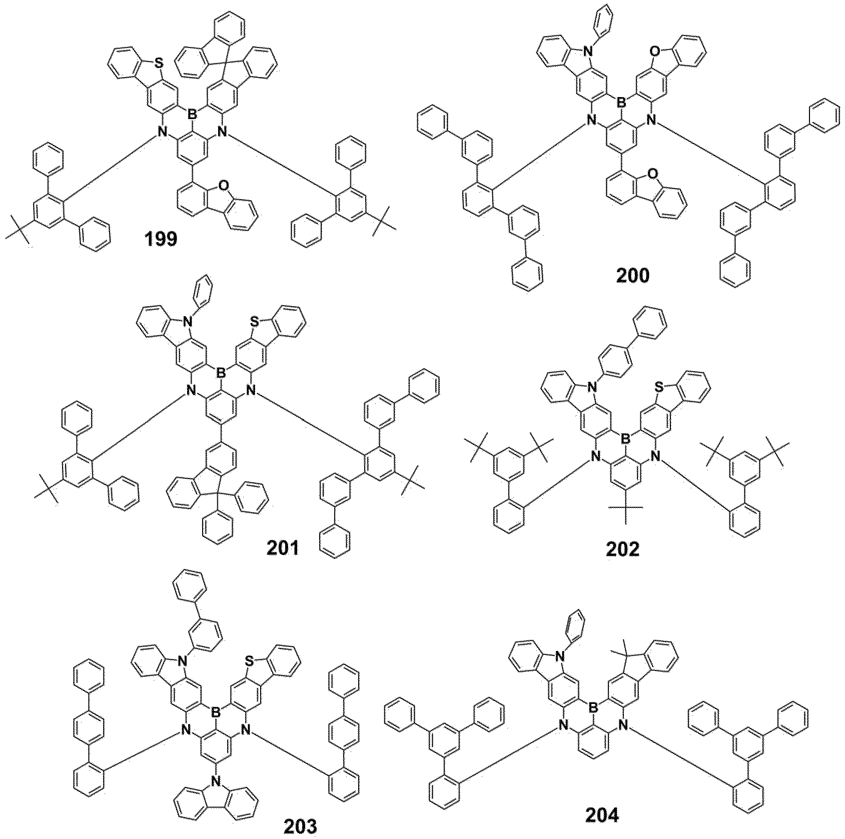 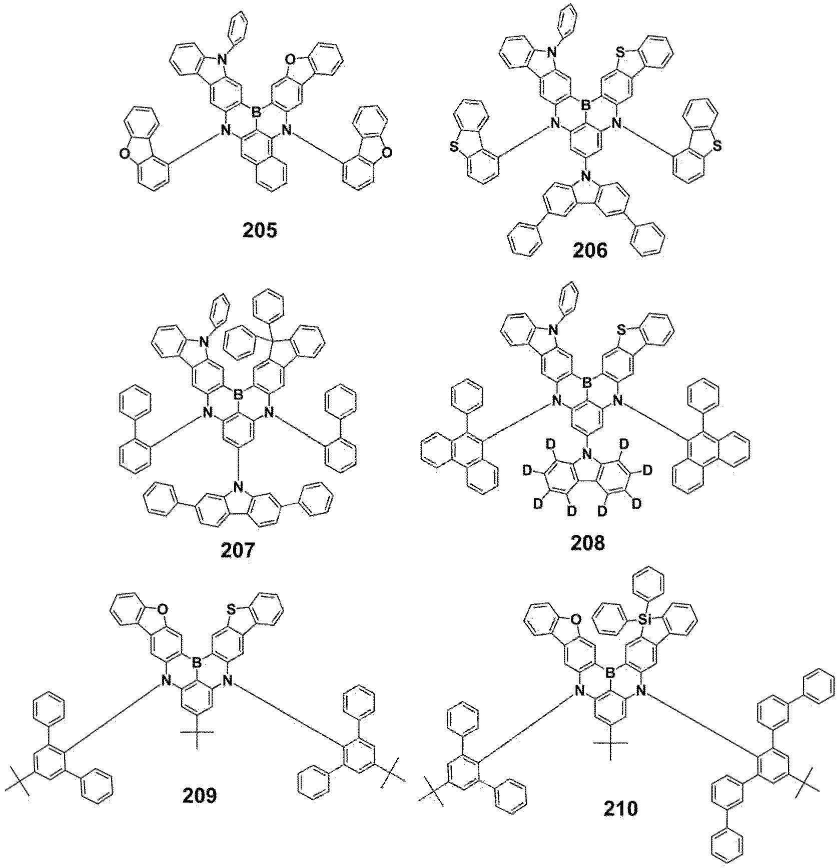 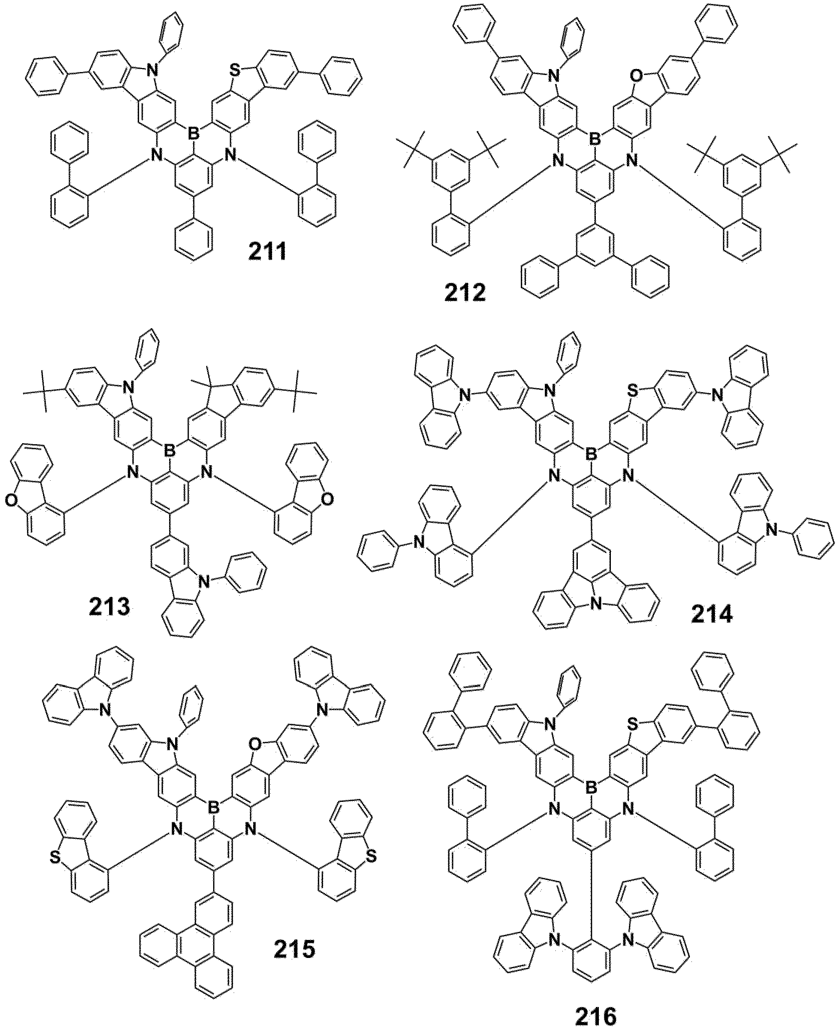 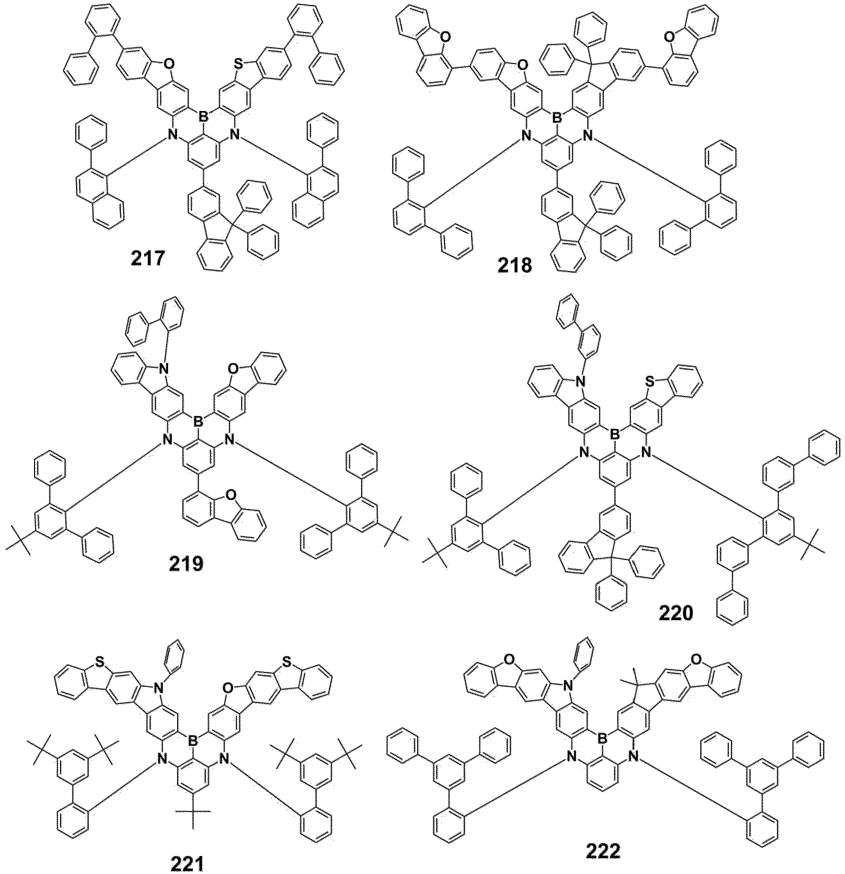 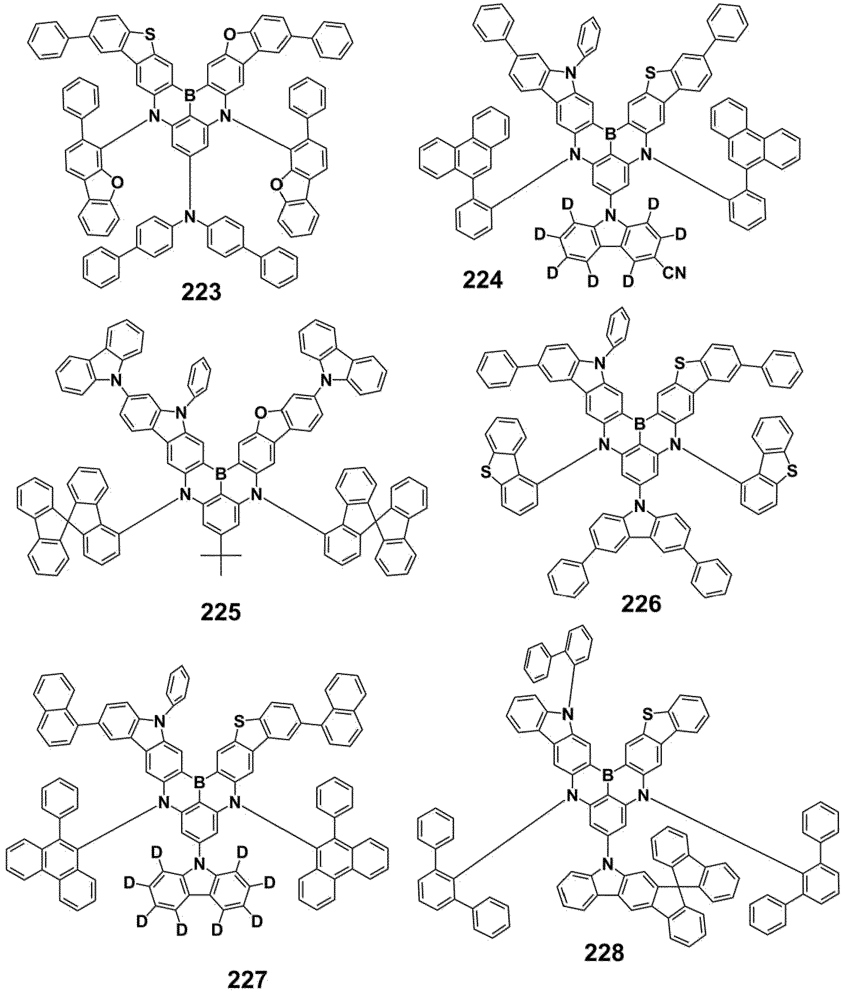 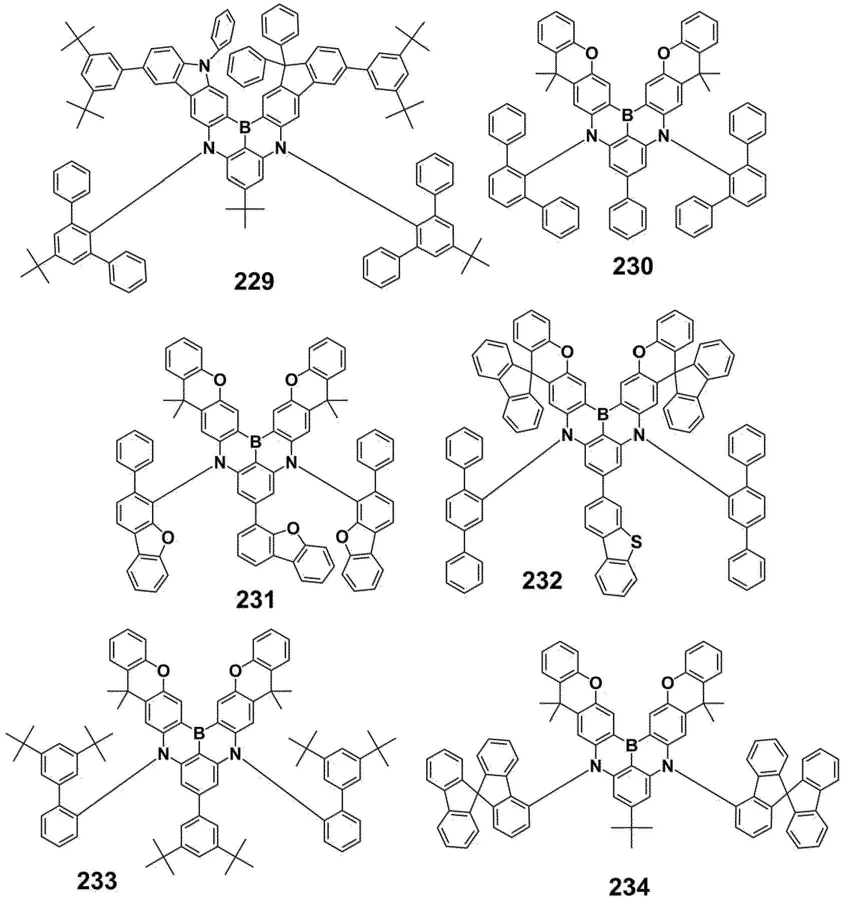 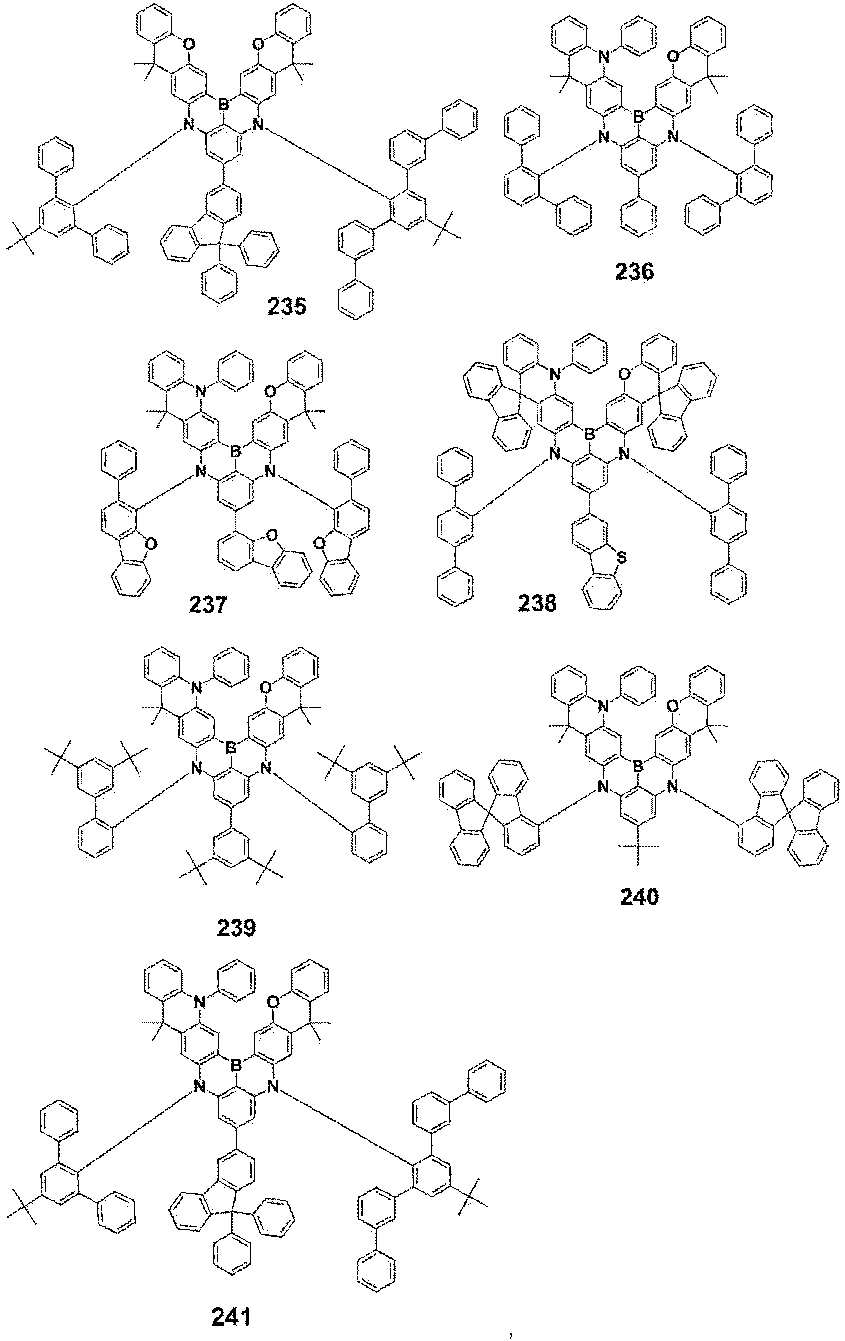 wherein, in Compound Group 1, D is a deuterium atom.

10. A light emitting element (ED) comprising:
a first electrode (EL1);
a second electrode (EL2) on the first electrode; and
an emission layer (EML) between the first electrode and the second electrode and comprising a first compound,
wherein the first compound is the fused polycyclic compound according to any one of claims 1 to 9.

11. The light emitting element (ED) of claim 10, wherein the emission layer (EML) further comprises at least one of a second compound represented by Formula HT-1, a third compound represented by Formula ET-1, or a fourth compound represented by Formula D-1: 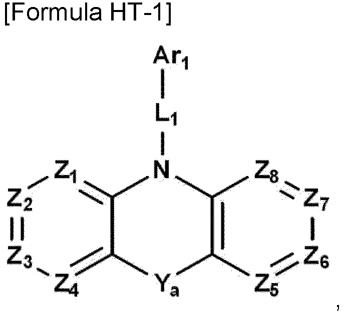 wherein, in Formula HT-1,
Z₁ to Z₈ are each independently N or CR₅₁,
L₁ is a direct linkage, a substituted or unsubstituted arylene group having 6 to 30 ring-forming carbon atoms, or a substituted or unsubstituted heteroarylene group having 2 to 30 ring-forming carbon atoms,
Yₐ is a direct linkage, CR₅₂R₅₃, or SiR₅₄R₅₅,
Ar₁ is a substituted or unsubstituted aryl group having 6 to 30 ring-forming carbon atoms, or a substituted or unsubstituted heteroaryl group having 2 to 30 ring-forming carbon atoms,
R₅₁ to R₅₅ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, and/or are bonded to an adjacent group to form a ring: 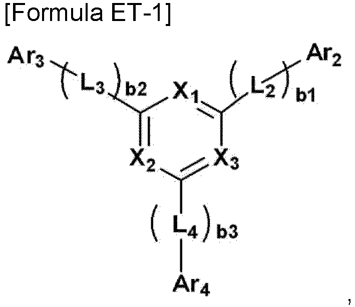
wherein, in Formula ET-1,
at least one selected from among X₁ to X₃ is N, and the rest are CR₅₆,
R₅₆ is a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group of 2 to 60 ring-forming carbon atoms,
b1 to b3 are each independently an integer of 0 to 10,
Ar₂ to Ar₄ are each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and
L₂ to L₄ are each independently a direct linkage, a substituted or unsubstituted arylene group having 6 to 30 ring-forming carbon atoms, or a substituted or unsubstituted heteroarylene group having 2 to 30 ring-forming carbon atoms: 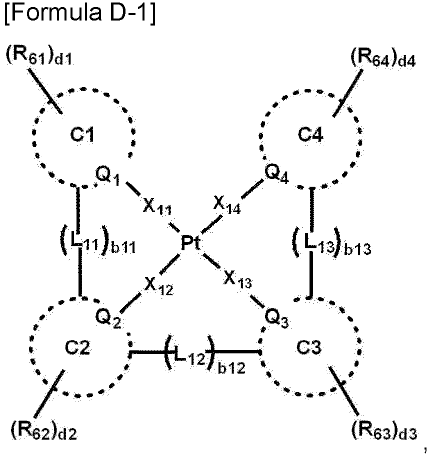
wherein, in Formula D-1,
Q₁ to Q₄ are each independently C or N,
C1 to C4 are each independently a substituted or unsubstituted hydrocarbon ring having 5 to 30 ring-forming carbon atoms, a substituted or unsubstituted aryl group having 6 to 30 ring-forming carbon atoms, or a substituted or unsubstituted heterocycle having 2 to 30 ring-forming carbon atoms,
X₁₁ to X₁₄ are each independently a direct linkage, or *-O-*,
L₁₁ to L₁₃ are each independently a direct linkage, *-O-*, *-S-*, 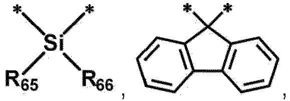
a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms,
b11 to b13 are each independently 0 or 1,
R₆₁ to R₆₆ are each independently a hydrogen atom, a deuterium atom, a halogen atom, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms or are bonded to an adjacent group to form a ring, and
d1 to d4 are each independently an integer of 0 to 4.

12. A display device (DD) comprising:
a base layer (BS);
a circuit layer (DP-CL) on the base layer; and
a display element layer (DP-ED) on the circuit layer and comprising a light emitting element (ED),
wherein the light emitting element comprises a first electrode (EL1), a second electrode (EL2) on the first electrode, and an emission layer (EML) between the first electrode and the second electrode and comprising the fused polycyclic compound according to any one of claims 1 to 9.

13. The display device (DD) of claim 12, wherein the light emitting element (ED) is configured to emit green light.

14. The display device (DD) of claim 12, further comprising a light control layer (CCL) on the display element layer (DP-ED) and comprising quantum dots (QD).
